# EUROPÄISCHE PATENTSCHRIFT

(11) **EP 4 079 742 B1**
(45) Veröffentlichungstag und Bekanntmachung des Hinweises auf die Patenterteilung: **01.04.2026**
(21) Anmeldenummer: 22168057.2
(22) Anmeldetag: 13.04.2022
(51) Int. Cl.: C07F 15/00, H10K 85/30, H10K 101/10, C09K 11/06

(54) **METALLKOMPLEXE**
METAL COMPLEXES
COMPLEXES MÉTALLIQUES

(30) Priorität: 14.04.2021 EP 21168285
(43) Veröffentlichungstag der Anmeldung: 26.10.2022
(73) Patentinhaber: UDC Ireland Limited, Ballycoolin, Dublin 15 (IE)
(72) Erfinder: Stoessel, Philipp, 64293 DARMSTADT (DE); Auch, Armin, 64293 DARMSTADT (DE)
(74) Vertreter: Maiwald GmbH

(56) Entgegenhaltungen:
- WO-A1-2011/053950
- WO-A1-2012/142387
- US-B2- 9 085 579
- DEDEIAN KENNETH ET AL: "Blue Phosphorescence from Mixed Cyano-Isocyanide Cyclometalated Iridium(III) Complexes", INORGANIC CHEMISTRY, vol. 46, no. 5, 1 March 2007 (2007-03-01), Easton , US, pages 1603 - 1611, XP055962238, ISSN: 0020-1669, DOI: 10.1021/ic061513v
- BERNIE J. ANDING ET AL: "Comparative Study of Rhodium and Iridium Porphyrin Diaminocarbene and N-Heterocyclic Carbene Complexes", ORGANOMETALLICS, vol. 33, no. 9, 29 April 2014 (2014-04-29), pages 2219 - 2229, XP055684307, ISSN: 0276-7333, DOI: 10.1021/om500081w

## Beschreibung

Die vorliegende Erfindung betrifft Iridiumkomplexe, welche sich für den Einsatz in organischen Elektrolumineszenzvorrichtungen, insbesondere als Emitter oder als Sensitizer, eignen.

Gemäß dem Stand der Technik werden in phosphoreszierenden organischen Elektrolumineszenzvorrichtungen (OLEDs) als Triplettemitter vor allem bis- und tris-ortho-metallierte Iridiumkomplexe mit aromatischen Liganden eingesetzt. Beispiele für solche Komplexe sind Tris(phenylpyridyl)iridium(III), sowie eine Vielzahl verwandter Komplexe, beispielsweise mit 1- oder 3-Phenylisochinolinliganden, mit 2-Phenylchinolinliganden oder mit Phenyl-carbenliganden.

In WO 2015/091716 A1 und in WO 2016/193243 A1 werden OLEDs offenbart, die in der Emissionsschicht sowohl eine phosphoreszierende Verbindung als auch einen fluoreszierenden Emitter enthalten, wobei die Energie von der phosphoreszierenden Verbindung auf den fluoreszierenden Emitter übertragen wird (Hyperphosphoreszenz). Die phosphoreszierende Verbindung verhält sich in diesem Zusammenhang demnach wie ein Hostmaterial und zeigt selber keine oder zumindest keine wesentliche Emission. Die phosphoreszierende Verbindung wird in einem solchen Deviceaufbau auch als Sensitizer bezeichnet.

Diverse Emitterverbindungen für phosphoreszierende OLEDs sind ebenfalls in US 9085579 B2, WO 2011053950 A1, WO 2012142387 A1, sowie in den Artikeln von K. Dedeian et al., Inorg. Chem. 2007, 46(5):1603-11 und B. Anding et al., Organometallics 2014, 33(9):2219-2229 beschrieben.

Aufgabe der vorliegenden Erfindung ist die Bereitstellung neuer und insbesondere verbesserter Metallkomplexe, welche sich als Emitter für die Verwendung in phosphoreszenten OLEDs oder als Sensitizer für die Verwendung in hyperphosphoreszenten OLEDs eignen und welche eine gute Eigenschaften in der OLED, insbesondere gute Lebensdauer und Effizienz, aufweisen.

Überraschend wurde gefunden, dass die nachfolgend beschriebenen Metallkomplexe, welche einen tetradentaten Liganden und zwei monodentate Liganden enthalten, diese Aufgabe lösen und sich sehr gut für die Verwendung in einer organischen Elektrolumineszenzvorrichtung eignen. Diese Metallkomplexe und organische Elektrolumineszenzvorrichtungen, welche diese Komplexe enthalten, sind daher der Gegenstand der vorliegenden Erfindung.

Gegenstand der Erfindung ist eine Verbindung der Formel (1),

Ir(L)(CN)(CN-R*) Formel (1),

wobei für die verwendeten Symbole gilt:
R* ist eine Alkylgruppe mit 1 bis 20 C-Atomen, die durch einen oder mehrere Reste R¹ substituiert sein kann, oder ein aromatisches oder heteroaromatisches Ringsystem mit 5 bis 30 aromatischen Ringatomen, das durch einen oder mehrere Reste R¹ substituiert sein kann;
L ist ein tetradentater Ligand der folgenden Formel (2), 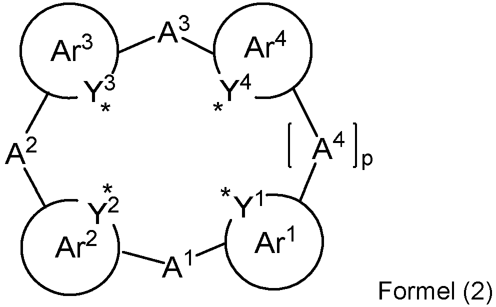
wobei der tetradentate Ligand quadratisch-planar oder näherungsweise quadratisch-planar an das Iridium koordiniert und der Cyanoligand (CN) und der Isonitrilligand (CN-R*)-im (pseudo-)oktaedrischen Komplex trans-ständig oberhalb und unterhalb der Ebene, die durch das
   Iridium und den tetradentaten Liganden gebildet wird, angeordnet sind;
wobei * jeweils die Koordination an das Iridium kennzeichnet und für die weiteren verwendeten Symbole und Indizes gilt:
   Y¹, Y², Y³, Y⁴ ist gleich oder verschieden bei jedem Auftreten gewählt aus der Gruppe bestehend aus C, N oder C-O⁻, mit der Maßgabe, dass mindestens eine der Gruppen Y¹, Y², Y³ und Y⁴ für C steht und dass zwei der Gruppen Y¹, Y², Y³ und Y⁴ über ein anionisches Kohlenstoffatom, ein anionisches Stickstoffatom oder C-O⁻ an das Iridium koordinieren und die anderen beiden der Gruppen Y¹, Y², Y³ und Y⁴ über ein neutrales Stickstoffatom oder ein Carbenkohlenstoffatom an das Iridium koordinieren;
   Ar¹, Ar², Ar³, Ar⁴ ist gleich oder verschieden bei jedem Auftreten und ist zusammen mit der Gruppe Y¹, Y², Y³ bzw. Y⁴ eine Arylgruppe mit 6 bis 16 aromatischen Ringatomen oder eine Heteroarylgruppe mit 5 bis 16 aromatischen Ringatomen oder ein aliphatisches Carben mit 5 bis 10 Ringatomen, wobei die Aryl- bzw. Heteroarylgruppe bzw. das aliphatische Carben jeweils durch einen oder mehrere Reste R substituiert sein kann;
   A¹, A², A³, A⁴ ist gleich oder verschieden bei jedem Auftreten und ist gewählt aus der Gruppe bestehend aus einer Einfachbindung, CR₂, BR, NR, O, S, CR₂-CR₂, CR=CR, einer ortho-verknüpften Phenylengruppe, welche mit einem oder mehreren Resten R substituiert sein kann, C(=CR₂) oder -CR=N-;
   p ist 0 oder 1, wobei p = 0 bedeutet, dass die Gruppe A⁴ nicht anwesend ist und anstelle von A⁴ Reste R in den entsprechenden Positionen von Ar¹ und Ar⁴ gebunden sein können;
   R ist bei jedem Auftreten gleich oder verschieden H, D, F, Cl, Br, I, N(R¹)₂, OR¹, SR¹, CN, NO₂, COOH, C(=O)N(R¹)₂, Si(R¹)₃, Ge(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyloder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann und wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein mono- oder polycyclisches, aliphatisches, heteroaliphatisches, aromatisches oder heteroaromatisches Ringsystem bilden;
   R¹ ist bei jedem Auftreten gleich oder verschieden H, D, F, Cl, Br, I, N(R²)₂, OR², SR², CN, NO₂, Si(R²)₃, Ge(R²)₃, B(OR²)₂, C(=O)R², P(=O)(R²)₂, S(=O)R², S(=O)_{2R}², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein mono- oder polycyclisches, aliphatisches, heteroaliphatisches, aromatisches oder heteroaromatisches Ringsystem bilden;
   R² ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können.

Dabei erfolgt die Bindung von A¹ und, falls vorhanden, A⁴ an Ar¹ jeweils in der ortho-Position zu Y¹. Die Bindung von A¹ und A² an Ar² erfolgt jeweils in der ortho-Position zu Y². Die Bindung von A² und A³ an Ar³ erfolgt jeweils in der ortho-Position zu Y³. Die Bindung von A³ und, falls vorhanden, A⁴ an Ar⁴ erfolgt jeweils in der ortho-Position zu Y⁴.

Bei der erfindungsgemäßen Verbindung handelt es sich um einen Komplex mit einem tetradentaten Liganden, welcher quadratisch-planar oder näherungsweise quadratisch-planar an das Iridium koordiniert, einem monodentaten Cyanoliganden und einem monodentaten Isonitrilliganden, wobei der Cyanoligand und der Isonitrilligand im (pseudo)oktaedrischen Komplex trans-ständig oberhalb und unterhalb der Ebene, die durch das Iridium und den tetradentaten Liganden gebildet wird, angeordnet sind. Die Geometrie des Komplexes ist im Folgenden schematisch dargestellt:

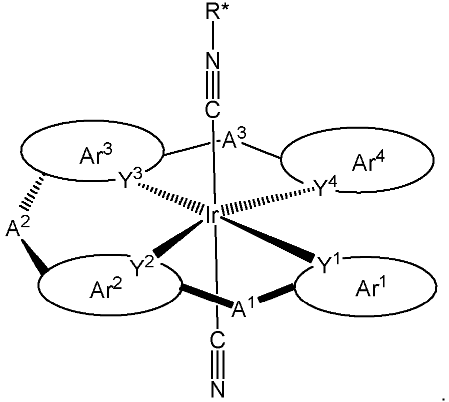

Dabei zeigt beim Aufdampfen des Komplexes der Isonitril-Ligand im Allgemeinen ins Vakuum, während sich der Cyano-Ligand auf der bereits aufgedampften Schicht anordnet, so dass das Iridium mit dem tetradentaten Liganden näherungsweise in der Ebene der Schicht liegt. Dabei handelt es sich bei dieser bevorzugten Orientierung um eine statistische Verteilung. Aus dieser Orientierung ergeben sich mehrere Vorteile: Zum einen liegt das Übergangsdipolmoment, das in der Ebene des tetradentaten Liganden und des Iridiums liegt, in einem signifikanten Anteil parallel oder zumindest näherungsweise parallel zur Schicht. Da die Emission senkrecht zum Übergangsdipolmoment erfolgt, ergibt sich eine Emission senkrecht zur Schichtebene (orientierte Emission), was wiederum die Auskopplung und somit die Effizienz verbessert. Zum anderen weist der Komplex ein signifikantes permanentes Dipolmoment auf, das durch die Anordnung des Komplexes in der Schicht mit Ausrichtung des Cyano-Liganden in Richtung der Anode zu einer vereinfachten Loch- und Elektroneninjektion in die Emissionsschicht führt. Daraus resultiert eine Verringerung der Einsatz- und der Betriebsspannung, woraus sich in der Folge eine Verbesserung der Lebensdauer ergibt.

Die Bindungen der Liganden bzw. koordinierenden Gruppen an das Iridium können Koordinationsbindungen oder kovalente Bindungen sein, bzw. der kovalente Anteil an der Bindung kann je nach Ligand variieren. Wenn in der vorliegenden Anmeldung die Rede davon ist, dass ein Ligand bzw. eine Gruppe an das Iridium koordiniert oder bindet, so bezeichnet dies im Sinne der vorliegenden Anmeldung jede Art der Bindung der Liganden bzw. der Gruppe an das Iridium, unabhängig vom kovalenten Anteil der Bindung.

Wenn zwei Reste R bzw. R¹ miteinander ein Ringsystem bilden, können diese Reste, die miteinander ein Ringsystem bilden, benachbart sein, d. h. dass diese Reste an dasselbe Kohlenstoffatom oder an Kohlenstoffatome, die direkt aneinander gebunden sind, gebunden sind, oder sie können weiter voneinander entfernt sein. So ist beispielsweise auch eine Ringbildung zwischen einem Rest R an A¹ und einem Rest R an Ar¹ und/oder Ar² möglich oder zwischen einem Rest R an A² und einem Rest R an Ar² und/oder Ar³ oder zwischen einem Rest R an A³ und einem Rest R an Ar³ und/oder Ar⁴ oder zwischen einem Rest R an A⁴, falls vorhanden, und einem Rest R an Ar¹ und/oder Ar⁴. Eine solche Ringbildung ist nachfolgend noch genauer ausgeführt.

Unter der Formulierung, dass zwei oder mehr Reste miteinander einen aliphatischen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht:

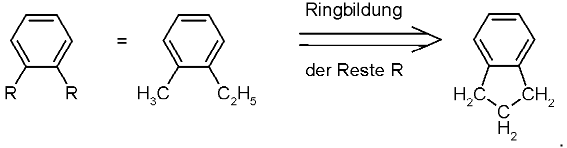

Auch die Bildung einer ankondensierten aromatischen bzw. heteroaromatischen Gruppe ist so möglich, wie durch das folgende Schema verdeutlicht:

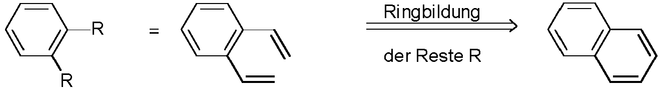

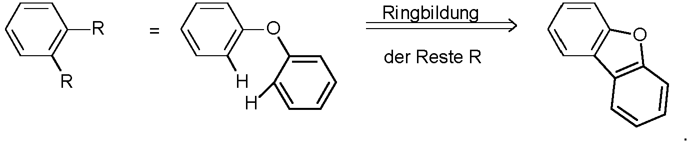

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

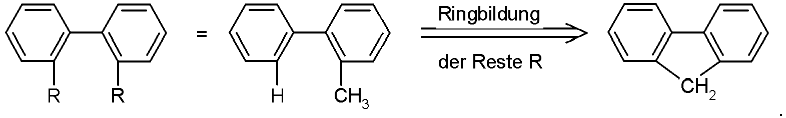

Eine heteroalicyclische Gruppe im Sinne der vorliegenden Erfindung ist eine aliphatische cyclische Gruppe, die mindestens ein Heteroatom als Teil des Cyclus aufweist. Bevorzugt weist sie ein oder zwei Heteroatome als Teil des Cyclus auf, wobei die Heteroatome bevorzugt gewählt sind aus der Gruppe bestehend aus Stickstoff, Sauerstoff und Schwefel.

Eine Arylgruppe im Sinne dieser Erfindung enthält 6 bis 40 C-Atome; eine Heteroarylgruppe im Sinne dieser Erfindung enthält 2 bis 40 C-Atome und mindestens ein Heteroatom, mit der Maßgabe, dass die Summe aus C-Atomen und Heteroatomen mindestens 5 ergibt. Die Heteroatome sind bevorzugt ausgewählt aus **N,** O und/oder S. Dabei enthält die Heteroarylgruppe bevorzugt maximal drei Heteroatome. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryloder Heteroarylgruppe, beispielsweise Naphthalin, Anthracen, Phenanthren, Chinolin, Isochinolin, etc., verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 1 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein C-, N- oder O-Atom oder eine Carbonylgruppe, unterbrochen sein können. So sollen beispielsweise auch Systeme wie 9,9'-Spirobifluoren, 9,9-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkylgruppe oder durch eine Silylgruppe unterbrochen sind. Weiterhin sollen Systeme, in denen zwei oder mehrere Aryl- oder Heteroarylgruppen direkt aneinander gebunden sind, wie z. B. Biphenyl, Terphenyl, Quaterphenyl oder Bipyridin, ebenfalls als aromatisches bzw. heteroaromatisches Ringsystem verstanden werden. Bevorzugte aromatische bzw. heteroaromatische Ringsysteme sind einfache Aryl- bzw. Heteroarylgruppen sowie Gruppen, in denen zwei oder mehr Aryl- bzw. Heteroarylgruppen direkt miteinander verknüpft sind, beispielsweise Biphenyl oder Bipyridin, sowie Fluoren oder Spirobifluoren.

Im Rahmen der vorliegenden Erfindung wird der Begriff Alkylgruppe als Oberbegriff sowohl für lineare oder verzweigte Alkylgruppen wie auch für cyclische Alkylgruppen verwendet. Analog werden die Begriffe Alkenylgruppe bzw. Alkinylgruppe als Oberbegriffe sowohl für lineare oder verzweigte Alkenyl- bzw. Alkinylgruppen wie auch für cyclische Alkenyl- bzw. Alkinylgruppen verwendet. Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁- bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1-yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer Gruppe OR¹ werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Unter einem aromatischen oder heteroaromatischen Ringsystem mit 5 - 40 aromatischen Ringatomen, welches noch jeweils mit den oben genannten Resten substituiert sein kann und welches über beliebige Positionen am Aromaten bzw. Heteroaromaten verknüpft sein kann, werden beispielsweise Gruppen verstanden, die abgeleitet sind von Benzol, Naphthalin, Anthracen, Benzanthracen, Phenanthren, Benzophenanthren, Pyren, Chrysen, Perylen, Fluoranthen, Benzfluoranthen, Naphthacen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, cis- oder trans-Monobenzoindenofluoren, cis- oder trans-Dibenzoindenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Die erfindungsgemäßen Verbindungen sind elektrisch neutral. Ladungsneutralität wird dadurch erreicht, dass die Ladungen der koordinierenden Gruppen die Ladung des dreifach positiv geladenen Iridiums ausgleichen.

Dabei trägt der Cyanoligand eine negative Ladung bei, während der Isonitrilligand neutral ist. Beispiele für geeignete Kombinationen der koordinierenden Gruppen Ar¹, Ar², Ar³ und Ar⁴ innerhalb des Liganden L sind in der folgenden Tabelle aufgeführt, wobei die Varianten 1 und 2 bevorzugt sind:

| Variante | Ar¹ | Ar² | Ar³ | Ar⁴ |
|---|---|---|---|---|
| 1 | neutral | anionisch | anionisch | neutral |
| 2 | anionisch | neutral | neutral | anionisch |
| 3 | anionisch | anionisch | neutral | neutral |
| 4 | anionisch | neutral | anionisch | neutral |

Nachfolgend werden bevorzugte Ausführungsformen des tetradentaten Liganden L ausgeführt.

Für die koordinierenden Atome Y¹ bis Y⁴ gilt, wie oben beschrieben, dass zwei der Gruppen Y¹, Y², Y³ und Y⁴ über ein anionisches Kohlenstoffatom, ein anionisches Stickstoffatom oder C-O⁻ an das Iridium koordinieren und die anderen beiden der Gruppen Y¹, Y², Y³ und Y⁴ über ein neutrales Stickstoffatom oder ein Carbenkohlenstoffatom an das Iridium koordinieren. Bevorzugt steht nicht mehr als eine der Gruppen Y¹ bis Y⁴ für C-O⁻. Wenn eine koordinierende Gruppen für C-O⁻ steht, so ist das bevorzugt Y¹ oder Y⁴. Bevorzugte Kombinationen von Y¹ bis Y⁴ sind in der folgenden Tabelle aufgeführt:

| Y¹ | Y² | Y³ | Y⁴ |
|---|---|---|---|
| C (anionisch) | N (neutral) | N (neutral) | C (anionisch) |
| N (neutral) | C (anionisch) | C (anionisch) | N (neutral) |
| N (neutral) | C (anionisch) | C (anionisch) | C (Carben) |
| C (Carben) | C (anionisch) | C (anionisch) | C (Carben) |
| N (neutral) | C (anionisch) | N (neutral) | C (anionisch) |
| N (neutral) | C (anionisch) | N (neutral) | C-O⁻ |
| C (anionisch) | N (neutral) | N (neutral) | C-O⁻ |
| N (neutral) | N (neutral) | C (anionisch) | C-O⁻ |

Im Folgenden werden die Gruppen Ar¹ bis Ar⁴ beschrieben. In einer bevorzugten Ausführungsform der Erfindung sind Ar¹, Ar², Ar³ und Ar⁴ zusammen mit der Gruppe Y¹, Y², Y³ bzw. Y⁴ gleich oder verschieden bei jedem Auftreten eine Arylgruppe mit 6 bis 14 aromatischen Ringatomen oder eine Heteroarylgruppe mit 5 bis 14 aromatischen Ringatomen, wobei die Aryl- bzw. Heteroarylgruppe jeweils durch einen oder mehrere Reste R substituiert sein kann. Besonders bevorzugt sind Ar¹, Ar², Ar³ und Ar⁴ zusammen mit der Gruppe Y¹, Y², Y³ bzw. Y⁴ gleich oder verschieden bei jedem Auftreten eine Arylgruppe mit 6 bis 10 aromatischen Ringatomen, insbesondere mit 6 aromatischen Ringatomen, oder eine Heteroarylgruppe mit 5 bis 13 aromatischen Ringatomen, insbesondere mit 5 bis 10 aromatischen Ringatomen, wobei die Aryl- bzw. Heteroarylgruppe jeweils durch einen oder mehrere Reste R substituiert sein kann.

In einer bevorzugten Ausführungsform der Erfindung, sind die Gruppen Ar¹ und Ar⁴ zusammen mit den Gruppen Y¹ bzw. Y⁴ gewählt aus den Gruppen der folgenden Formeln (Ar-1) bis (Ar-44), wobei die Gruppe jeweils an der durch # gekennzeichneten Position an A¹ bzw. A³ bindet und an der durch * gekennzeichneten Position an das Iridium koordiniert, 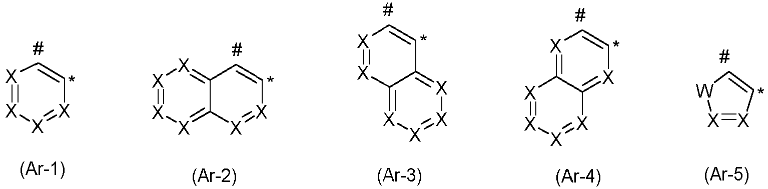 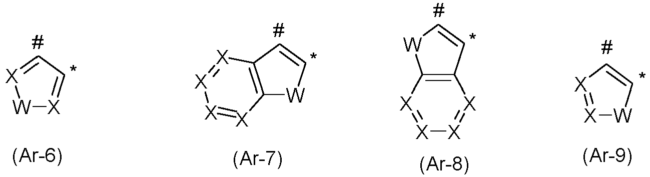 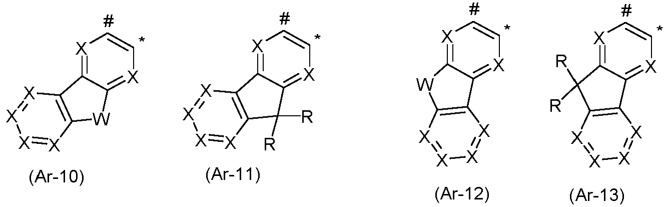 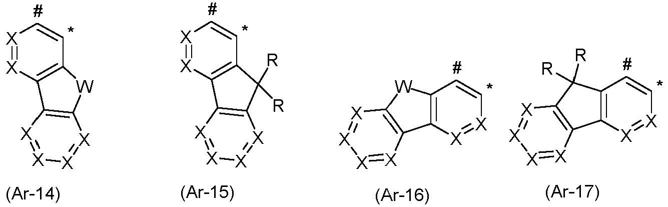 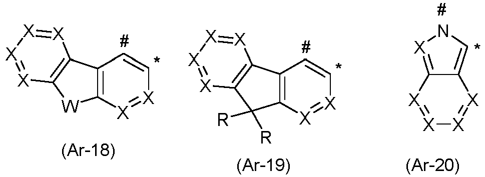 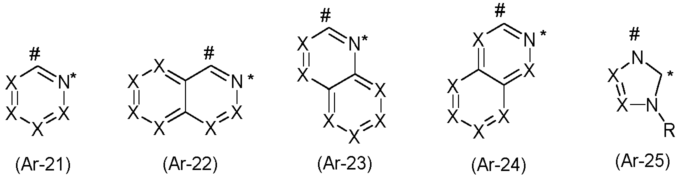 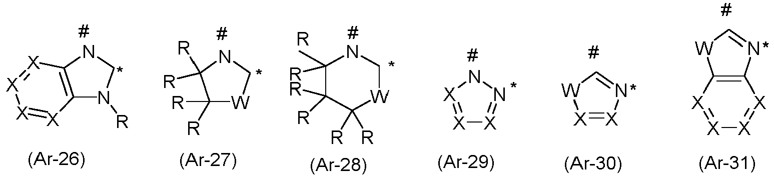 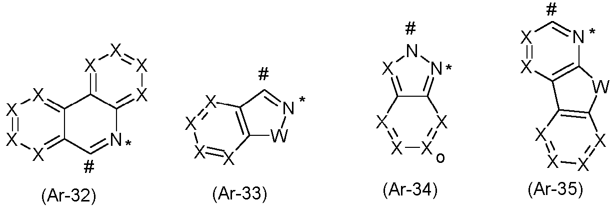 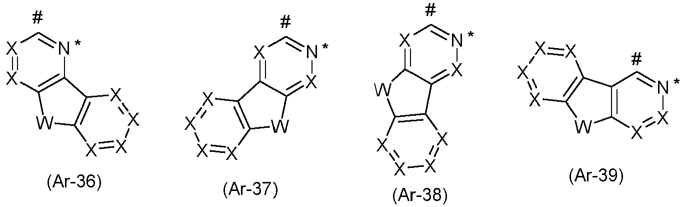 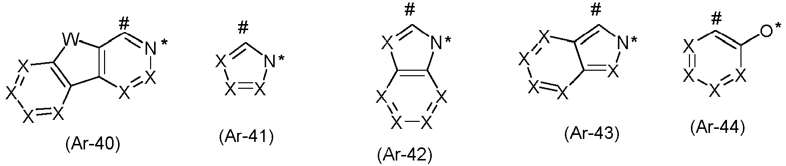 wobei R die oben genannten Bedeutungen aufweist und für die weiteren verwendeten Symbole gilt:
- X: ist bei jedem Auftreten gleich oder verschieden CR oder N mit der Maßgabe, dass maximal zwei Symbole X pro Cyclus für N stehen;
- W: ist bei jedem Auftreten gleich oder verschieden NR, O oder S;

Dabei koordinieren die Gruppen (Ar-1) bis (Ar-20) über ein anionisches Kohlenstoffatom, die Gruppen (Ar-21) bis (Ar-24) und (Ar-29) bis (Ar-40) über ein neutrales Stickstoffatom, die Gruppen (Ar-25) bis (Ar-28) über ein Carben-Kohlenstoffatom, die Gruppen (Ar-41) bis (Ar-43) über ein anionisches Stickstoffatom an das Iridium und die Gruppe (Ar-44) über ein anionisches Sauerstoffatom.

Wenn p = 1 ist, also die Gruppe A⁴ vorhanden ist, erfolgt die Bindung von Ar¹ bzw. Ar⁴ an A⁴ über die ortho-Position zur Koordination an das Iridiumatom, so dass in dieser Position dann die Gruppe A⁴ statt einem Rest R gebunden ist.

Bevorzugt steht maximal ein Symbol X in (Ar-1) bis (Ar-44) für N, und besonders bevorzugt stehen alle Symbole X für CR.

Bevorzugte Ausführungsformen der Gruppen (Ar-1) bis (Ar-44) sind die Gruppen der folgenden Formeln (Ar-1a) bis (Ar-44a), 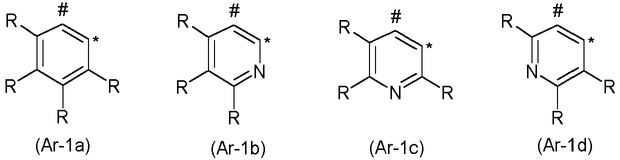 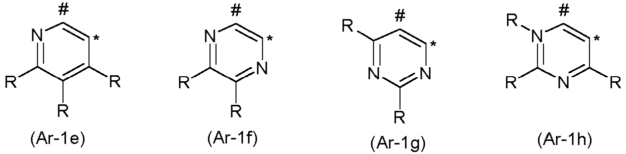 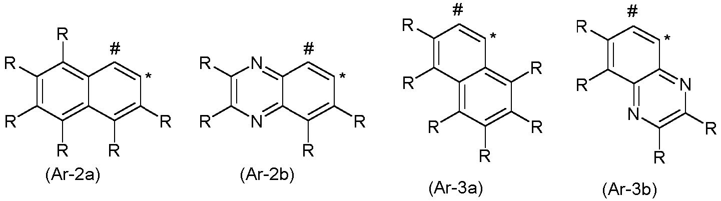 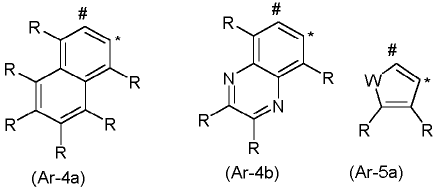 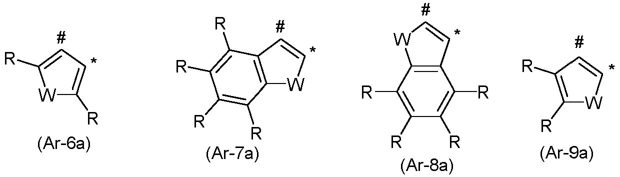 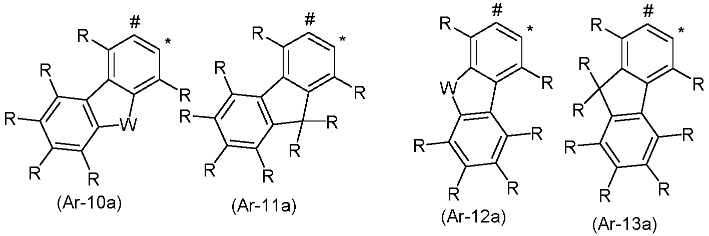 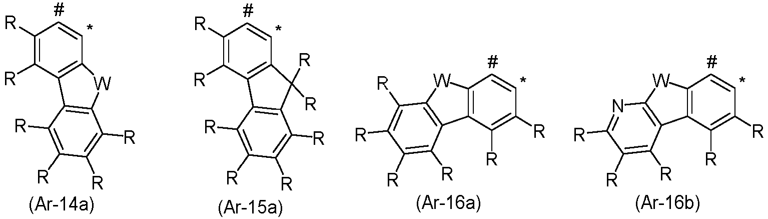 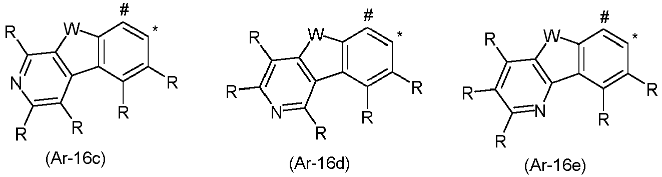 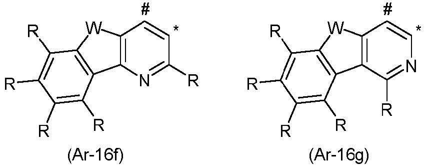 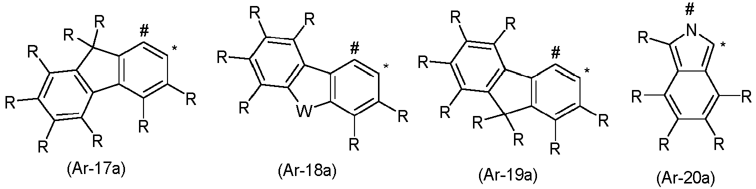 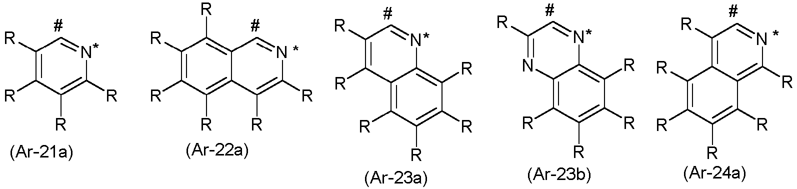 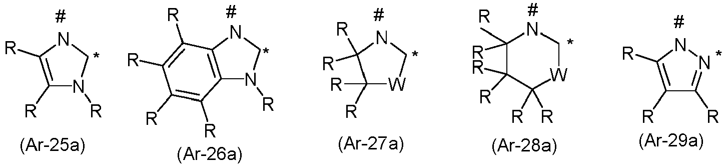 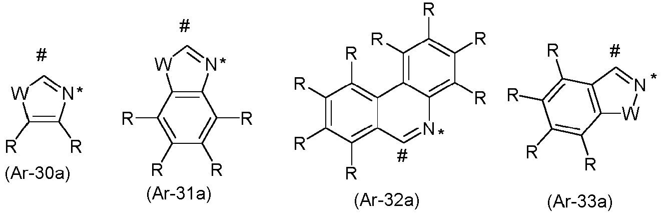 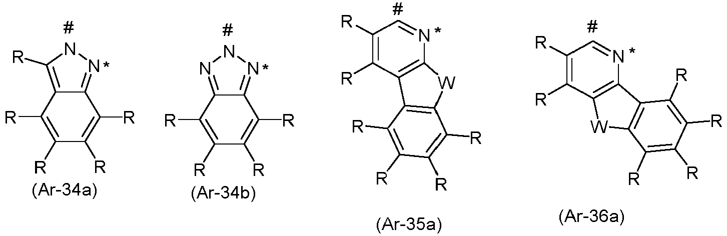 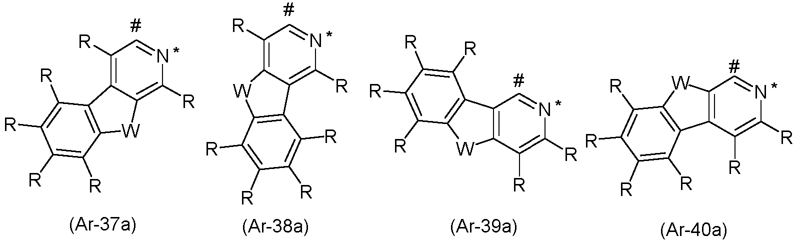 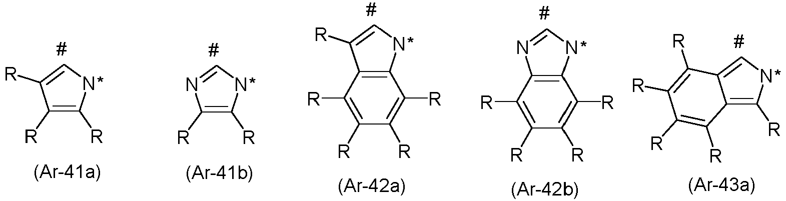 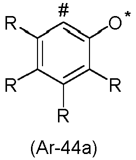 wobei die verwendeten Symbole die oben genannten Bedeutungen aufweisen. Dabei sind bevorzugt maximal drei Substituenten R ungleich H oder D, besonders bevorzugt maximal zwei Substituenten R und ganz besonders bevorzugt maximal ein Substituent R.

In einer bevorzugten Ausführungsform der Erfindung sind die Gruppen Ar² und Ar³ zusammen mit den Gruppen Y² bzw. Y³ gewählt aus den Gruppen der folgenden Formeln (Ar-45) bis (Ar-75), wobei die Gruppe jeweils an der durch # gekennzeichneten Position an A¹ und A² bzw. an A² und A³ bindet und an der durch * gekennzeichneten Position an das Iridium koordiniert, 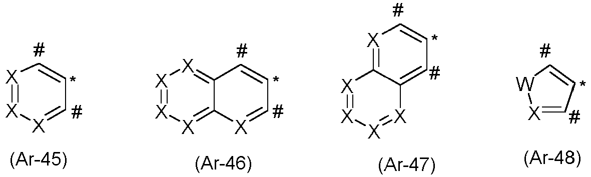 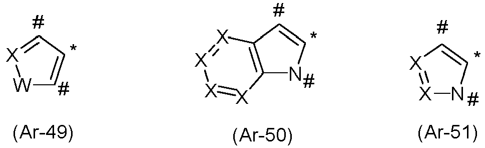 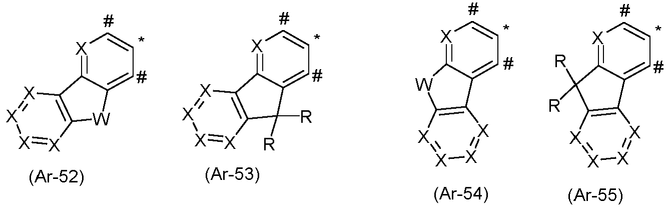 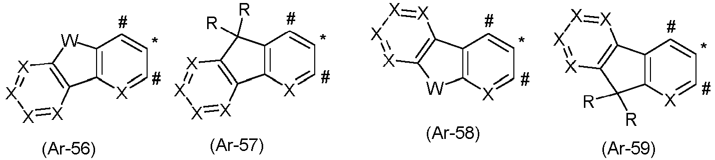 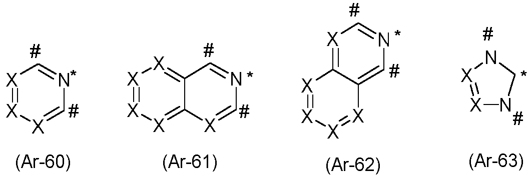 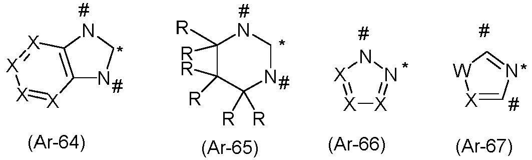 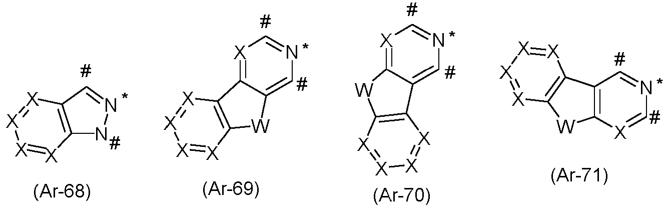 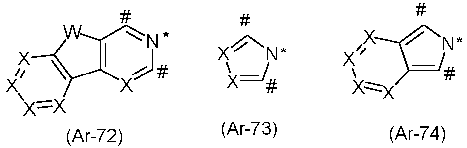 wobei R, X und W die oben genannten Bedeutungen aufweisen.

Dabei koordinieren die Gruppen (Ar-45) bis (Ar-59) über ein anionisches Kohlenstoffatom, die Gruppen (Ar-60) bis (Ar-62) und (Ar-66) bis (Ar-72) über ein neutrales Stickstoffatom, die Gruppen (Ar-63) bis (Ar-65) über ein Carben-Kohlenstoffatom und die Gruppen (Ar-73) und (Ar-74) über ein anionisches Stickstoffatom an das Iridium.

Bevorzugt steht maximal ein Symbol X in (Ar-45) bis (Ar-74) für N und besonders bevorzugt stehen alle Symbole X für CR.

Bevorzugte Ausführungsformen der Gruppen (Ar-45) bis (Ar-74) sind die Gruppen der folgenden Formeln (Ar-45a) bis (Ar-74a), 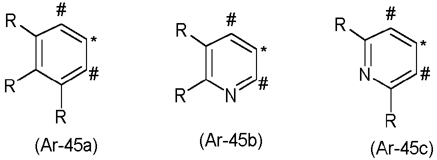 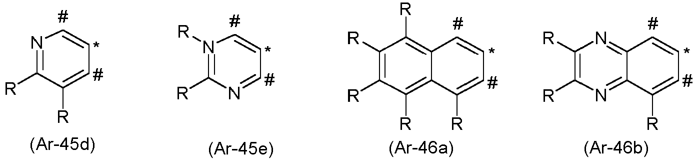 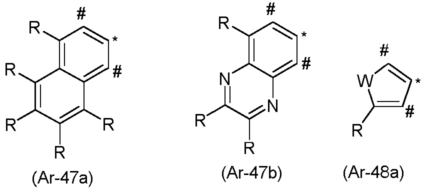 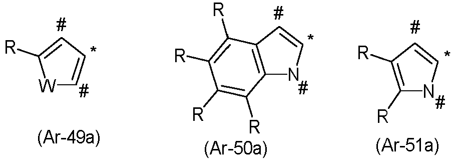 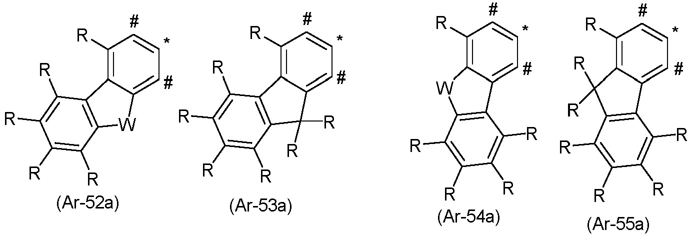 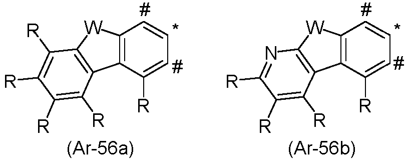 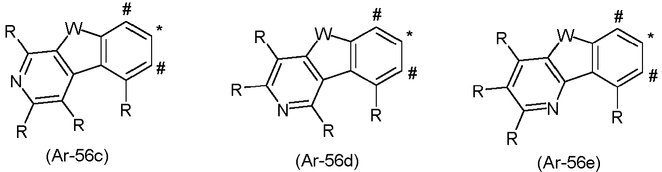 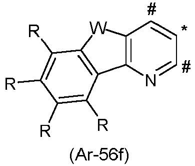 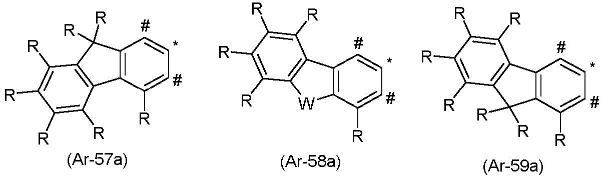 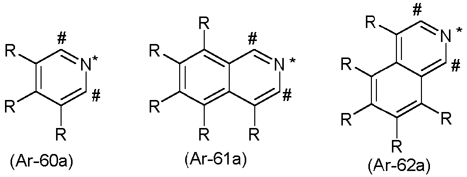 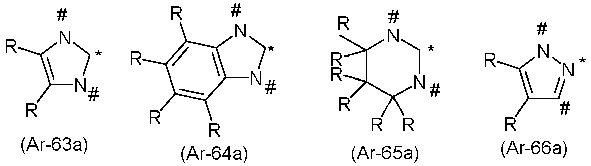 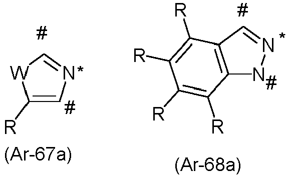 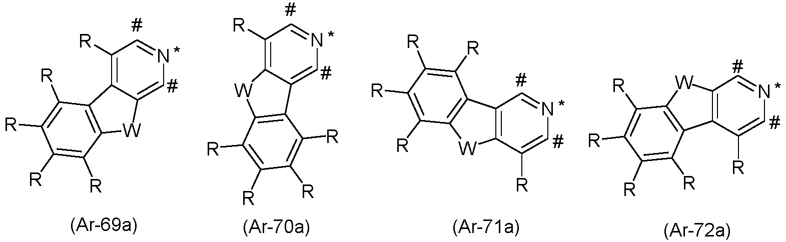 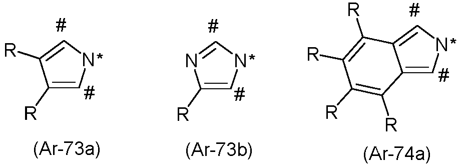 wobei die verwendeten Symbole die oben genannten Bedeutungen aufweisen. Dabei sind bevorzugt maximal drei Substituenten R ungleich H oder D, besonders bevorzugt maximal zwei Substituenten R und ganz besonders bevorzugt maximal ein Substituent R.

Wenn A¹ für eine Einfachbindung steht, dann sind in dem Teilliganden Ar¹-Ar² zwei Aryl- bzw. Heteroarylgruppen direkt aneinander gebunden, und wenn A³ für eine Einfachbindung steht, dann sind in dem Teilliganden Ar³-Ar⁴ zwei Aryl- bzw. Heteroarylgruppen direkt aneinander gebunden. Wenn in diesen Einheiten mehrere der Substituenten R miteinander ein Ringsystem bilden, so ist auch die Bildung eines Ringsystems aus Substituenten, die an Ar¹ und Ar² gebunden sind bzw. die an Ar³ und Ar⁴ gebunden sind, möglich, wodurch Ar¹ und Ar² miteinander bzw. Ar³ und Ar⁴ miteinander durch die Substituenten R eine einzige kondensierte Aryl- bzw. Heteroarylgruppe als bidentaten Teilliganden Ar¹-Ar² bzw. Ar³-Ar⁴ bilden können.

Wenn A¹ bzw. A³ für eine Einfachbindung stehen, sind die so gebildeten bidentaten Teilliganden Ar¹-Ar² bzw. Ar³-Ar⁴ bevorzugt ausgewählt aus den Strukturen der folgenden Formeln (L¹-1-1) bis (L¹-1-3) und (L¹-2-1) bis (L¹-2-5), die über die beiden mit * gekennzeichneten Positionen an das Iridium koordinieren, 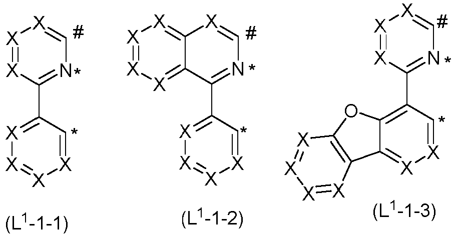 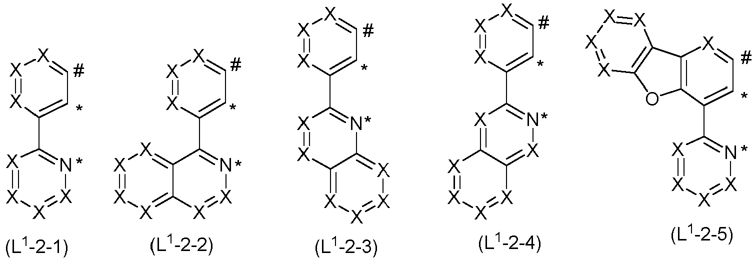 wobei die verwendeten Symbole die oben genannten Bedeutungen aufweisen und # die Position der Bindung an A² darstellt.

Besonders bevorzugte Teilliganden (L¹-1) sind die Strukturen der Formeln (L¹-1-1a) bis (L¹-1-3b), und besonders bevorzugte Teilliganden (L¹-2) sind die Strukturen der Formeln (L¹-2-1a) bis (L¹-2-5a), die über die beiden mit * gekennzeichneten Positionen an das Iridium koordinieren, 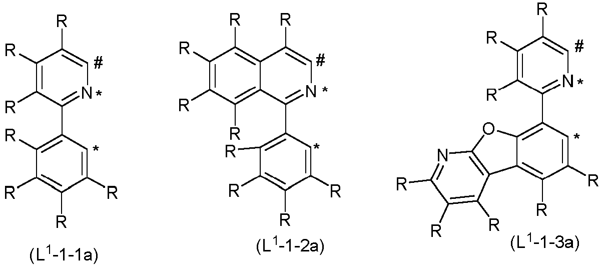 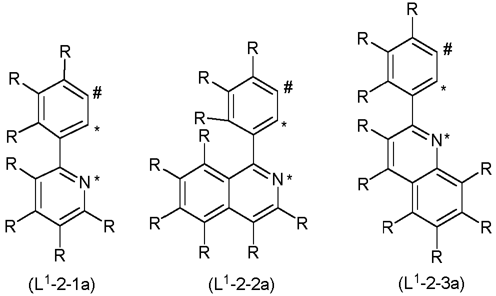 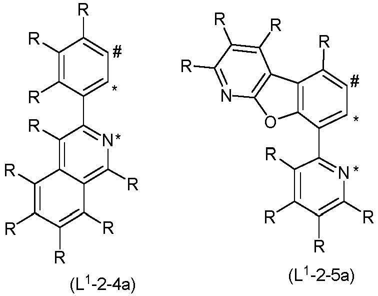 wobei die verwendeten Symbole die oben genannten Bedeutungen aufweisen und # die Position der Bindung an A² darstellt. Dabei sind bevorzugt maximal drei Substituenten R ungleich H oder **D,** besonders bevorzugt maximal zwei Substituenten R und ganz besonders bevorzugt maximal ein Substituent R.

Wenn zwei Reste **R,** von denen einer an Ar¹ und der andere an Ar² gebunden sind, bzw. von denen einer an Ar³ und der andere an Ar⁴ gebunden sind, miteinander ein aromatisches bzw. heteroaromatisches Ringsystem bilden, können sich überbrückte Teilliganden und auch Teilliganden ergeben, die insgesamt eine einzige größere Heteroarylgruppe darstellen. Diese Ringbildung zwischen den Substituenten erfolgt dabei bevorzugt durch eine Gruppe gemäß einer der folgenden Formeln (3) bis (12), 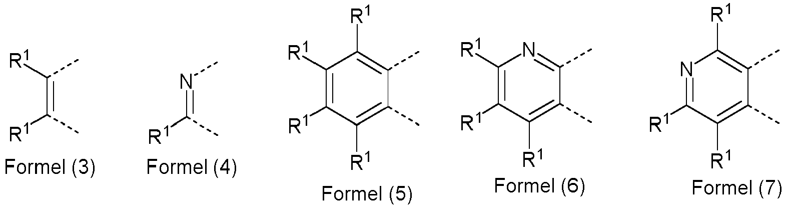 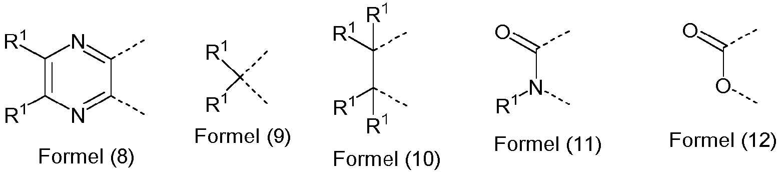 wobei R¹ die oben genannten Bedeutungen aufweist und die gestrichelten Bindungen die Bindungen an Ar¹ und Ar² bzw. an Ar³ und Ar⁴ andeuten. Dabei können die unsymmetrischen der oben genannten Gruppen in jeder der beiden Möglichkeiten eingebaut werden.

Dabei ist die Gruppe der Formel (9) besonders dann bevorzugt, wenn sich dadurch die Ringbildung zu einem Sechsring ergibt, wie beispielsweise unten durch die Formeln (L¹-21) und (L¹-22) dargestellt.

Bevorzugte Liganden, die durch Ringbildung zweier Reste R an Ar¹ und Ar² bzw. an Ar³ und Ar⁴ entstehen, sind die im Folgenden aufgeführten Strukturen der Formeln (L¹-3) bis (L¹-28), 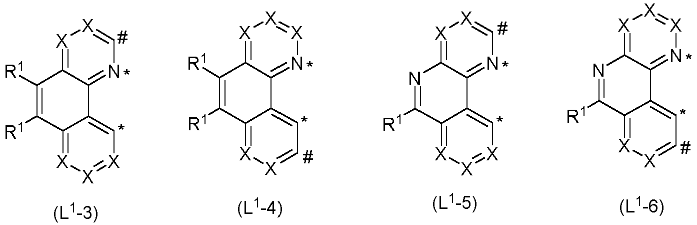 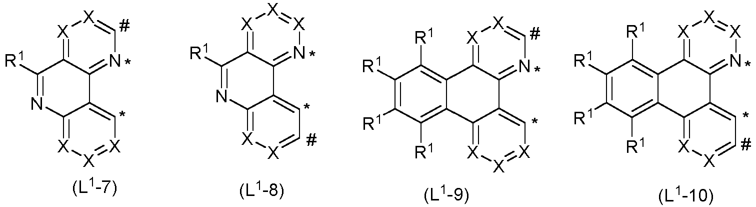 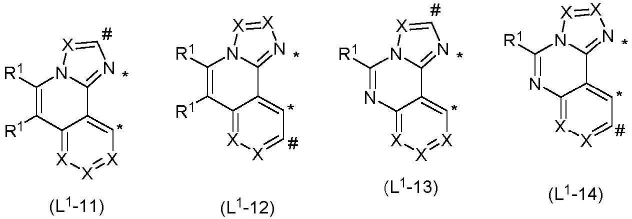 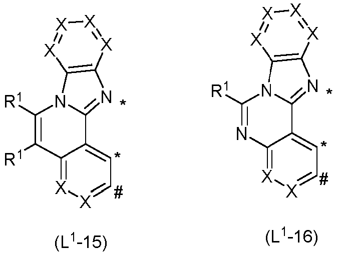 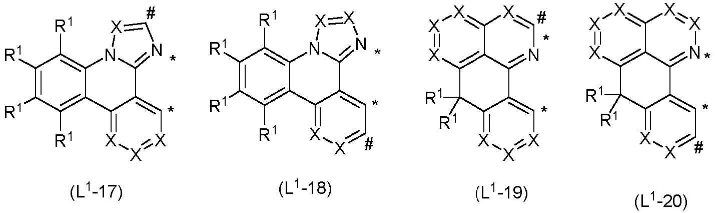 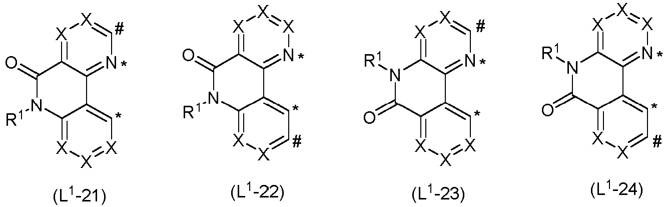 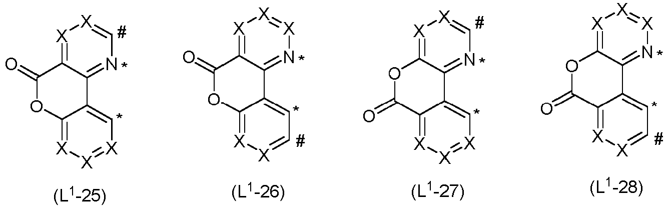 wobei die verwendeten Symbole die oben genannten Bedeutungen aufweisen und # die Position angibt, an denen dieser Teilligand mit A² verknüpft ist.

In einer bevorzugten Ausführungsform der Teilliganden der Formeln (L¹-3) bis (L¹-28) stehen alle Symbole X für CR, oder ein Symbol steht X für N und die anderen Symbole X stehen für CR.

In einer weiteren Ausführungsform der Erfindung ist es bevorzugt, falls in den Gruppen (Ar-1) bis (Ar-73) oder in den Teilliganden (L¹-1) bis (L¹-28) eines der Atome X für N steht, wenn benachbart zu diesem Stickstoffatom eine Gruppe R als Substituent gebunden ist, welche ungleich Wasserstoff oder Deuterium ist. Dies gilt analog für die oben aufgeführten bevorzugten Strukturen, in denen bevorzugt benachbart zu einem nicht koordinierenden Stickstoffatom eine Gruppe R als Substituent gebunden ist, welche ungleich Wasserstoff oder Deuterium ist. Dabei ist dieser Substituent R bevorzugt eine Gruppe, ausgewählt aus CF₃, OCF₃, Alkylgruppen mit 1 bis 10 C-Atomen, insbesondere verzweigten oder cyclischen Alkylgruppen mit 3 bis 10 C-Atomen, OR¹, wobei R¹ für eine Alkylgruppe mit 1 bis 10 C-Atomen, insbesondere eine verzweigte oder cyclische Alkylgruppe mit 3 bis 10 C-Atomen steht, einer Dialkylaminogruppe mit 2 bis 10 C-Atomen, aromatischen bzw. heteroaromatischen Ringsystemen oder Aralkyl- bzw. Heteroaralkylgruppen. Es handelt sich bei diesen Gruppen um sterisch anspruchsvolle Gruppen. Weiterhin bevorzugt kann dieser Rest R auch mit einem benachbarten Rest R einen Cyclus bilden.

In einer bevorzugten Ausführungsform der Erfindung stehen zwei der Gruppen A¹, A² und A³ jeweils für eine Einfachbindung, und die dritte Gruppe steht für eine Gruppe ungleich einer Einfachbindung. Bevorzugte Ausführungsformen des Liganden L, in denen zwei der Gruppen A¹, A² und A³ für eine Einfachbindung stehen, sind die folgenden Liganden (L-1) und (L-2), 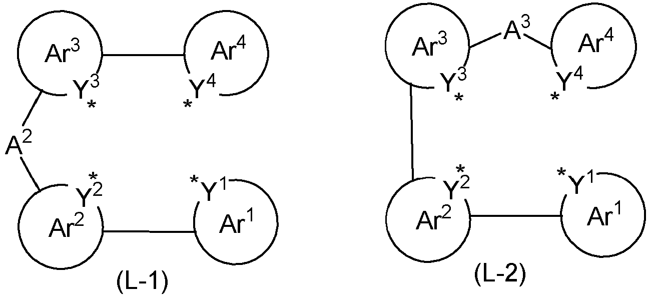 wobei die verwendeten Symbole die oben genannten Bedeutungen aufweisen, Y¹ bis Y⁴ gleich oder verschieden für C oder N stehen und A² in Formel (L-1) bzw. A³ in Formel (L-2) nicht für eine Einfachbindung stehen.

Dabei steht A² in Formel (L-1) bzw. A³ in Formel (L-2) bevorzugt für CR₂, BR, NR, O oder S, und die Gruppen Ar¹, Ar², Ar³ und Ar⁴ koordinieren jeweils über einen Sechsring und über ein Kohlenstoff- oder Stickstoffatom an das Iridium, oder eine der Gruppen Ar¹ oder Ar⁴ koordiniert über einen Fünfring und über ein Kohlenstoff- oder Stickstoffatom an das Iridium und die anderen der Gruppen Ar¹, Ar², Ar³ und Ar⁴ koordinieren jeweils über einen Sechsring und über ein Kohlenstoff- oder Stickstoffatom an das Iridium.

Alternativ steht A² in Formel (L-1) bzw. A³ in Formel (L-2) bevorzugt für CR₂-CR₂, CR=CR oder eine ortho-Phenylengruppe, die durch einen oder mehrere Reste R substituiert sein kann, und mindestens eine bzw. bevorzugt mindestens zwei der Gruppen Ar¹, Ar², Ar³ und/oder Ar⁴ koordinieren jeweils über einen Fünfring an das Iridium.

In einer weiteren bevorzugten Ausführungsform der Erfindung steht eine der Gruppen A¹, A² und A³ für eine Einfachbindung, und die beiden anderen Gruppen stehen gleich oder verschieden für eine Gruppe ungleich einer Einfachbindung. Bevorzugte Ausführungsformen des Liganden L, in denen genau eine der Gruppen A¹, A² und A³ für eine Einfachbindung steht, sind die folgenden Liganden (L-3) und (L-4), 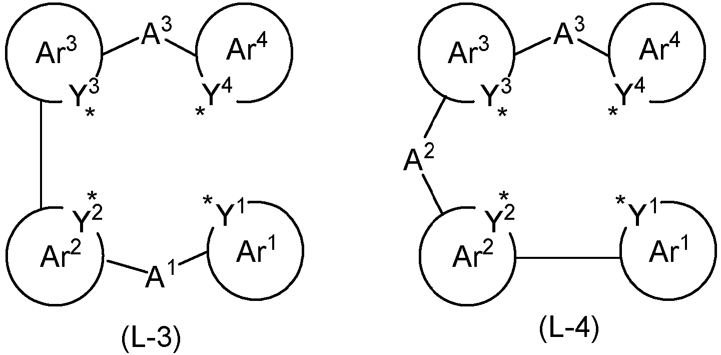 wobei die verwendeten Symbole die oben genannten Bedeutungen aufweisen und A¹ und A³ in Formel (L-3) bzw. A² und A³ in Formel (L-4) nicht für Einfachbindungen stehen.

In einer bevorzugten Ausführungsform stehen A¹ und A³ in Formel (L-3) bzw. A² und A³ in Formel (L-4) bei jedem Auftreten gleich oder verschieden für CR₂, BR, NR, O oder S, besonders bevorzugt für CR₂, NR oder O und ganz besonders bevorzugt für O.

In einer weiteren bevorzugten Ausführungsform der Erfindung steht genau eine der Gruppen Y' oder Y⁴ für C-O⁻. In diesem Fall stehen bevorzugt entweder alle drei Gruppen A¹, A² und A³ für eine Einfachbindung, oder A¹ und A³ stehen für eine Einfachbindung. Es handelt sich bei diesen Liganden somit bevorzugt um die Liganden der folgenden Formeln (L-5) und (L-6), 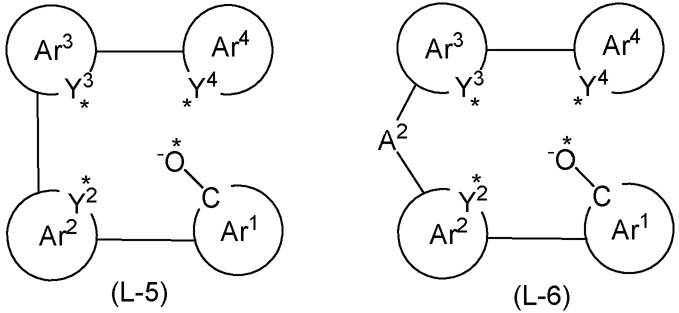 wobei die verwendeten Symbole die oben genannten Bedeutungen aufweisen und A² in Formel (L-6) für C=CR₂ steht, wobei mindestens ein Rest R mit Ar² oder Ar³ ein aromatisches oder heteroaromatisches Ringsystem bildet, oder für CR₂, NR oder O steht, besonders bevorzugt für O.

In nochmal einer weiteren bevorzugten Ausführungsform der Erfindung steht keine der Gruppen A¹, A² und A³ für eine Einfachbindung, so dass sich bevorzugt der Ligand (L-7) ergibt, 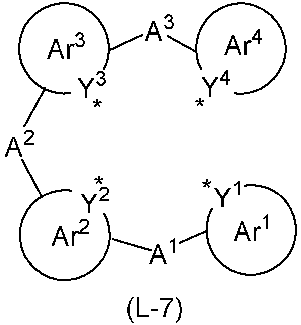 wobei die verwendeten Symbole die oben genannten Bedeutungen aufweisen und A¹, A² und A³ nicht für Einfachbindungen stehen.

Bevorzugt sind die Liganden L gewählt aus den Strukturen (L-1), (L-4), (L-6) und (L-7).

Bevorzugte Ausführungsformen des Liganden (L-1) sind die Liganden der folgenden Formeln (L-1-1) bis (L-1-4), 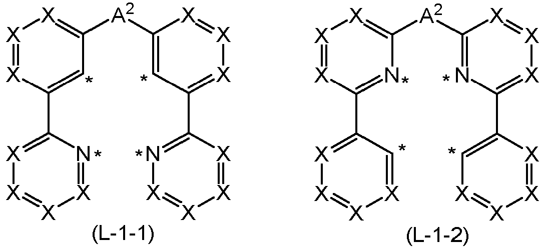 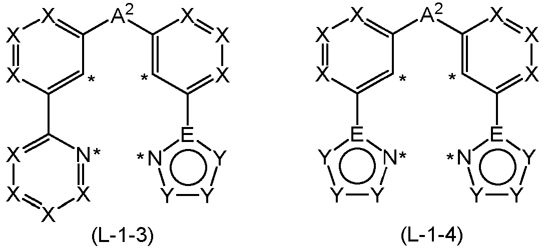 wobei X und A² die oben genannten Bedeutungen aufweisen und entweder E für N steht und die Gruppen Y in demselben Cyclus gleich oder verschieden bei jedem Auftreten für CR oder N stehen oder E für C steht und die Gruppen Y in demselben Cyclus gleich oder verschieden bei jedem Auftreten für CR, N, NR, O oder S stehen mit der Maßgabe, dass genau eine Gruppe Y für NR, O oder S steht, bevorzugt für NR, und die anderen Gruppen Y gleich oder verschieden für CR oder N. Dabei steht A² in Formel (L-1-1) und (L-1-2) bevorzugt für CR₂, BR, NR, O oder S, besonders bevorzugt für CR₂, NR oder O. Weiterhin steht A² in Formel (L-1-3) und (L-1-4) bevorzugt für CR₂-CR₂, CR=CR oder eine ortho-Phenylengruppe, besonders bevorzugt für CR₂-CR₂.

Besonders bevorzugt sind die Liganden (L-1-1a) bis (L-1-4c), 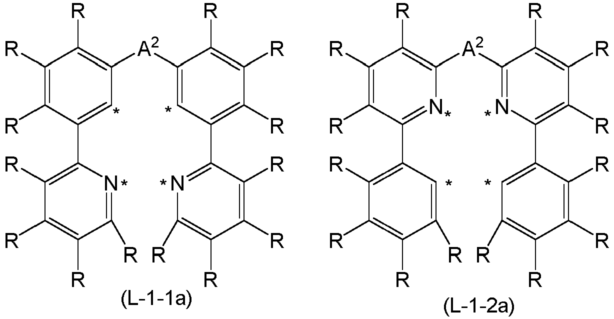 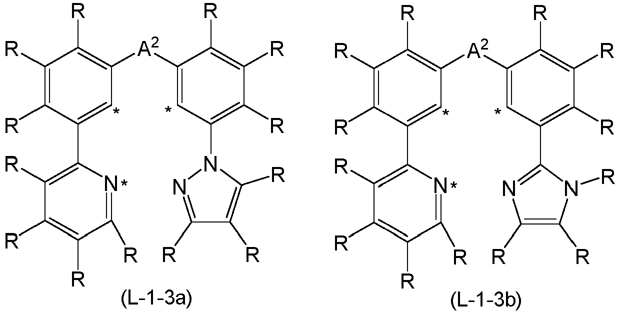 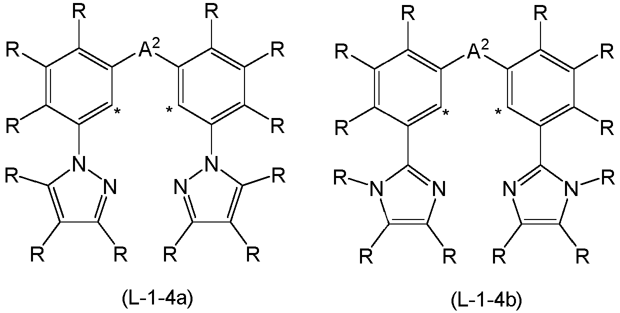 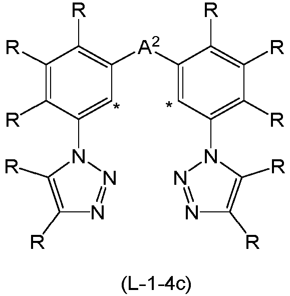 wobei die verwendeten Symbole die oben genannten Bedeutungen aufweisen.

Bevorzugte Ausführungsformen der Liganden (L-4) sind die Liganden (L-4-1) bis (L-4-3), 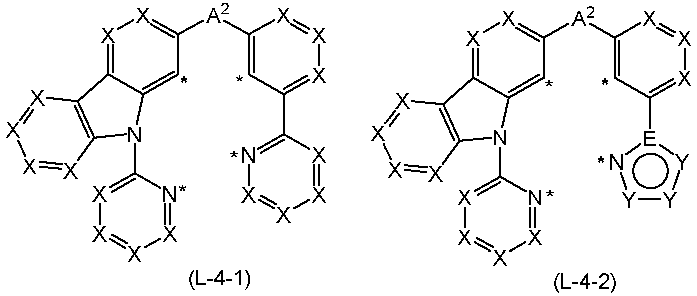 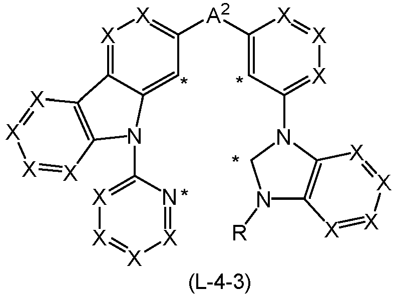 wobei die verwendeten Symbole die oben genannten Bedeutungen aufweisen und A² nicht für eine Einfachbindung steht. Bevorzugt steht A² für CR₂, BR, NR, O oder S. Weiterhin bevorzugt steht in Formel (L-4-3) der Rest R am Stickstoffatom for ein aromatisches oder heteroaromatisches Ringsystem mit 6 bis 13 aromatischen Ringatomen, bevorzugt mit 6 bis 12 aromatischen Ringatomen, das jeweils mit einem oder mehreren Resten R¹ substituiert sein kann.

Besonders bevorzugte Ausführungsformen des Liganden (L-4) sind die Liganden (L-4-1a) bis (L-4-3a), 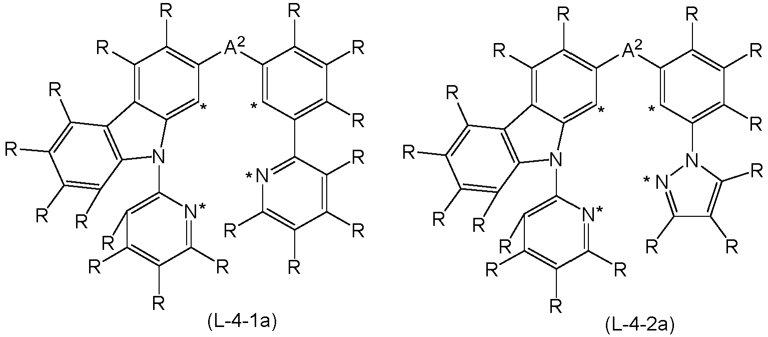 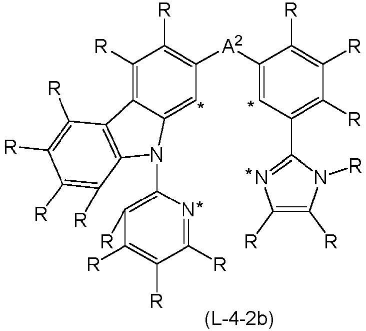 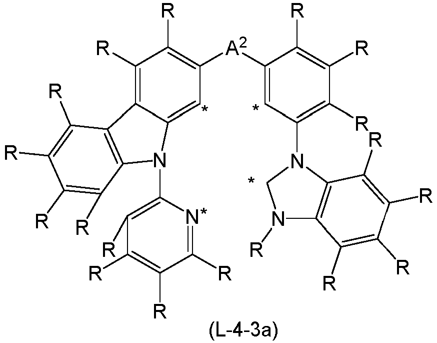 wobei die Symbole die oben genannten Bedeutungen aufweisen und A² nicht für eine Einfachbindung steht und bevorzugt für CR₂, BR, NR, O oder S steht. Weiterhin bevorzugt steht in Formel (L-4-3a) der Rest R am Stickstoffatom for ein aromatisches oder heteroaromatisches Ringsystem mit 6 bis 13 aromatischen Ringatomen, bevorzugt mit 6 bis 12 aromatischen Ringatomen, das jeweils mit einem oder mehreren Resten R¹ substituiert sein kann.

Wenn A² in Formel (L-4) bzw. den bevorzugten Ausführungsformen für NR steht, ist es auch möglich und bevorzugt, dass der Rest R für eine Arylgruppe steht, beispielsweise für eine Phenylgruppe und diese mit der benachbarten koordinierenden Gruppe Ar³ einen Ring bildet, beispielsweise ein Carbazol, ein Phenazin oder ein Phenoxazin. Daraus ergeben sich beispielsweise die folgenden Liganden (L-4-2c), (L-4-2d), (L-4-2e) bzw. (L-4-2f), 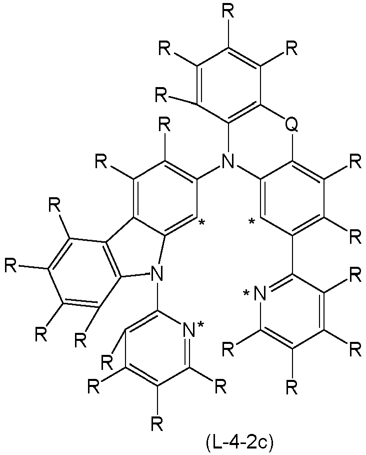 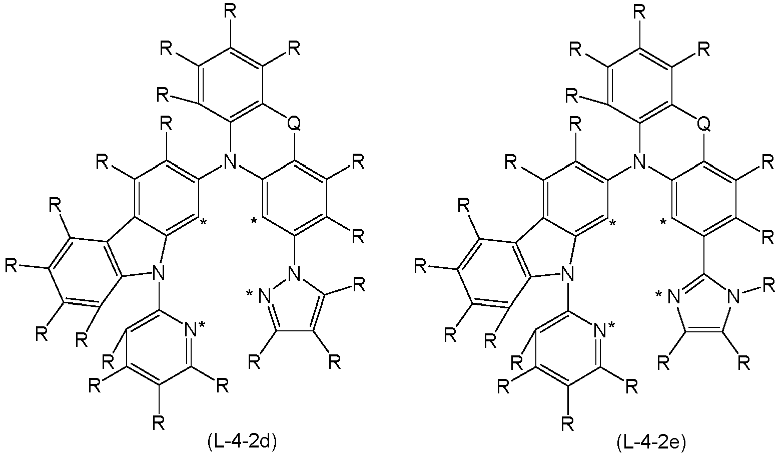 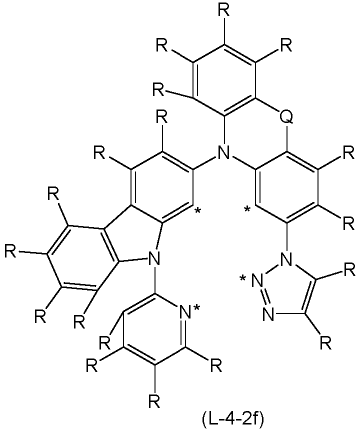 wobei die verwendeten Symbole die oben genannten Bedeutungen aufweisen und Q für eine Einfachbindung, C(R¹)₂, NR² oder O steht, insbesondere für eine Einfachbindung.

In einer bevorzugten Ausführungsform des Liganden (L-6) steht A² für C=CR₂ und einer der Substituenten R bildet mit der benachbarten Gruppe Ar² ein aromatisches Ringsystem, wodurch bevorzugt ein Ligand der folgenden Formel (L-6-1) bzw. (L-6-2) gebildet wird, 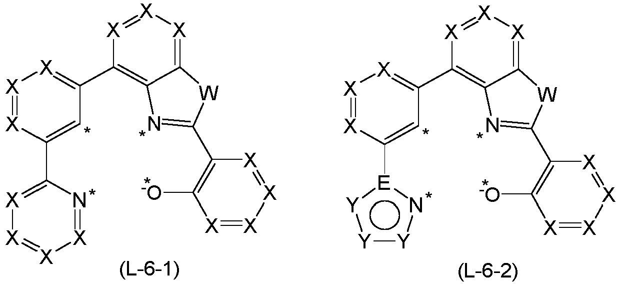 wobei die verwendeten Symbole die oben genannten Bedeutungen aufweisen und W bevorzugt für NR steht.

Eine bevorzugte Ausführungsform des Liganden (L-6-1) ist der Ligand der folgenden Formel (L-6-1a), und bevorzugte Ausführungsformen des Liganden (L-6-2) sind die Liganden der folgenden Formeln (L-6-2a) bis (L-6-2c), 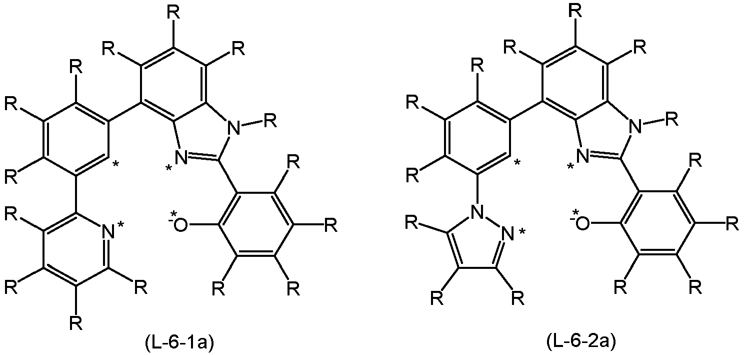 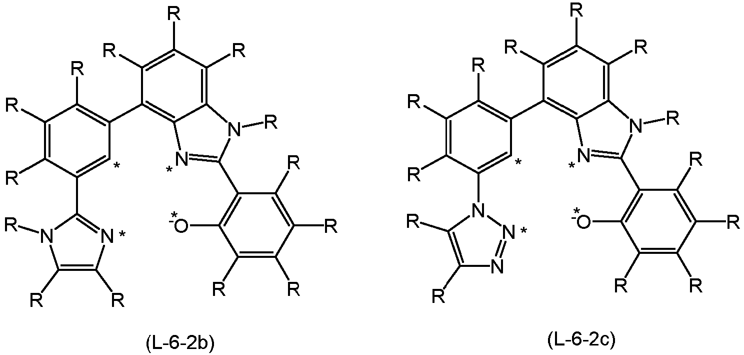 wobei die verwendeten Symbole die oben genannten Bedeutungen aufweisen.

Bevorzugte Ausführungsformen des Liganden (L-7) sind die Liganden der folgenden Formel (L-7-1), 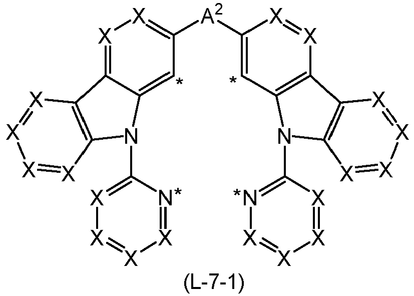 wobei die verwendeten Symbole die oben genannten Bedeutungen aufweisen und A² nicht für eine Einfachbindung steht.

Eine bevorzugte Ausführungsform der Liganden (L-7-1) sind die Liganden der folgenden Formel (L-7-1a), 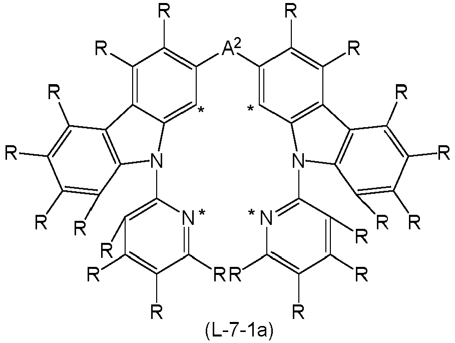 wobei die verwendeten Symbole die oben genannten Bedeutungen aufweisen und A² nicht für eine Einfachbindung steht. Bevorzugt steht A für O, NR oder CR₂, insbesondere für O.

Im Folgenden werden bevorzugte Substituenten beschrieben, wie sie an Ar¹, Ar², Ar³ und Ar⁴, aber auch an A¹, A², A³ und, wenn vorhanden, A⁴ vorliegen können.

In einer Ausführungsform der Erfindung enthält der erfindungsgemäße Metallkomplex zwei Substituenten R oder zwei Substituenten R¹, die an benachbarte Kohlenstoffatome gebunden sind und die miteinander einen aliphatischen Ring gemäß einer der nachfolgend beschriebenen Formeln bilden. Der aliphatische Ring, der durch die Ringbildung von zwei Substituenten R miteinander oder von zwei Substituenten R¹ miteinander gebildet wird, wird bevorzugt durch eine der folgenden Formeln (13) bis (19) beschrieben, 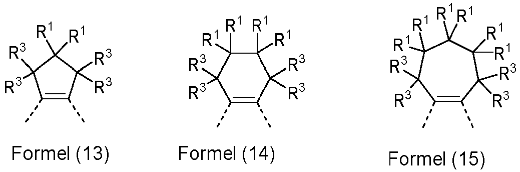 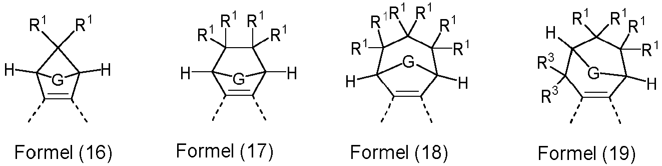 wobei R¹ und R² die oben genannten Bedeutungen aufweisen, die gestrichelten Bindungen die Verknüpfung der beiden Kohlenstoffatome im Liganden andeuten und weiterhin gilt:
- G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 bis 14 aromatischen Ringatomen, welche durch einen oder mehrere Reste R² substituiert sein kann;
- R³: ist gleich oder verschieden bei jedem Auftreten H, F, eine geradkettige Alkyl- oder Alkoxygruppe mit 1 bis 10 C-Atomen, eine verzweigte oder cyclische Alkyl- oder Alkoxygruppe mit 3 bis 10 C-Atomen, wobei die Alkyl- oder Alkoxygruppe jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können, oder ein aromatisches oder heteroaromatisches Ringsystem mit 5 bis 24 aromatischen Ringatomen, das jeweils durch einen oder mehrere Reste R² substituiert sein kann, oder eine Aryloxy- oder Heteroaryloxygruppe mit 5 bis 24 aromatischen Ringatomen, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (13) bis (19) dadurch erreicht, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (16) bis (19) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (16) bis (19) für H steht, handelt es sich dabei daher um ein nicht-azides Proton im Sinne der vorliegenden Anmeldung. In einer bevorzugten Ausführungsform der Erfindung ist R³ ungleich H.

Bevorzugte Ausführungsformen der Gruppen der Formeln (13) bis (19) können den Anmeldungen WO 2014/023377, WO 2015/104045 und WO 2015/117718 entnommen werden.

Weitere bevorzugte Reste R sind bei jedem Auftreten gleich oder verschieden ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einem aromatischen oder heteroaromatischen Ringsystem mit 5 bis 30 aromatischen Ringatomen, das jeweils durch einen oder mehrere Reste R¹ substituiert sein kann; dabei können zwei benachbarte Rest R oder R mit R¹ auch miteinander ein mono- oder polycyclisches, aliphatisches oder aromatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einem aromatischen oder heteroaromatischen Ringsystem mit 5 bis 24 aromatischen Ringatomen, das jeweils durch einen oder mehrere Reste R¹ substituiert sein kann; dabei können zwei benachbarte Reste R oder R mit R¹ auch miteinander ein mono- oder polycyclisches, aliphatisches oder aromatisches Ringsystem bilden.

Bevorzugte Reste R¹, die an R gebunden sind, sind bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder ein aromatisches oder heteroaromatisches Ringsystem mit 5 bis 24 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden **H, F,** CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder ein aromatisches oder heteroaromatisches Ringsystem mit 5 bis 13 aromatischen Ringatomen, das jeweils durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein monooder polycyclisches, aliphatisches Ringsystem bilden.

Beispiele für geeignete tetradentate Liganden der Formel (2), die in den erfindungsgemäßen Verbindungen eingesetzt werden können, sind die nachfolgend abgebildeten Verbindungen.

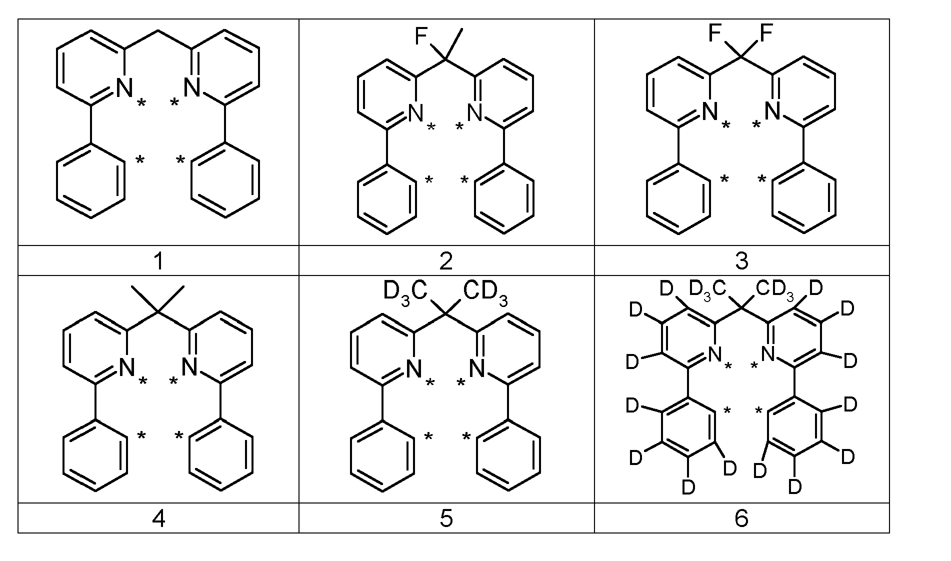

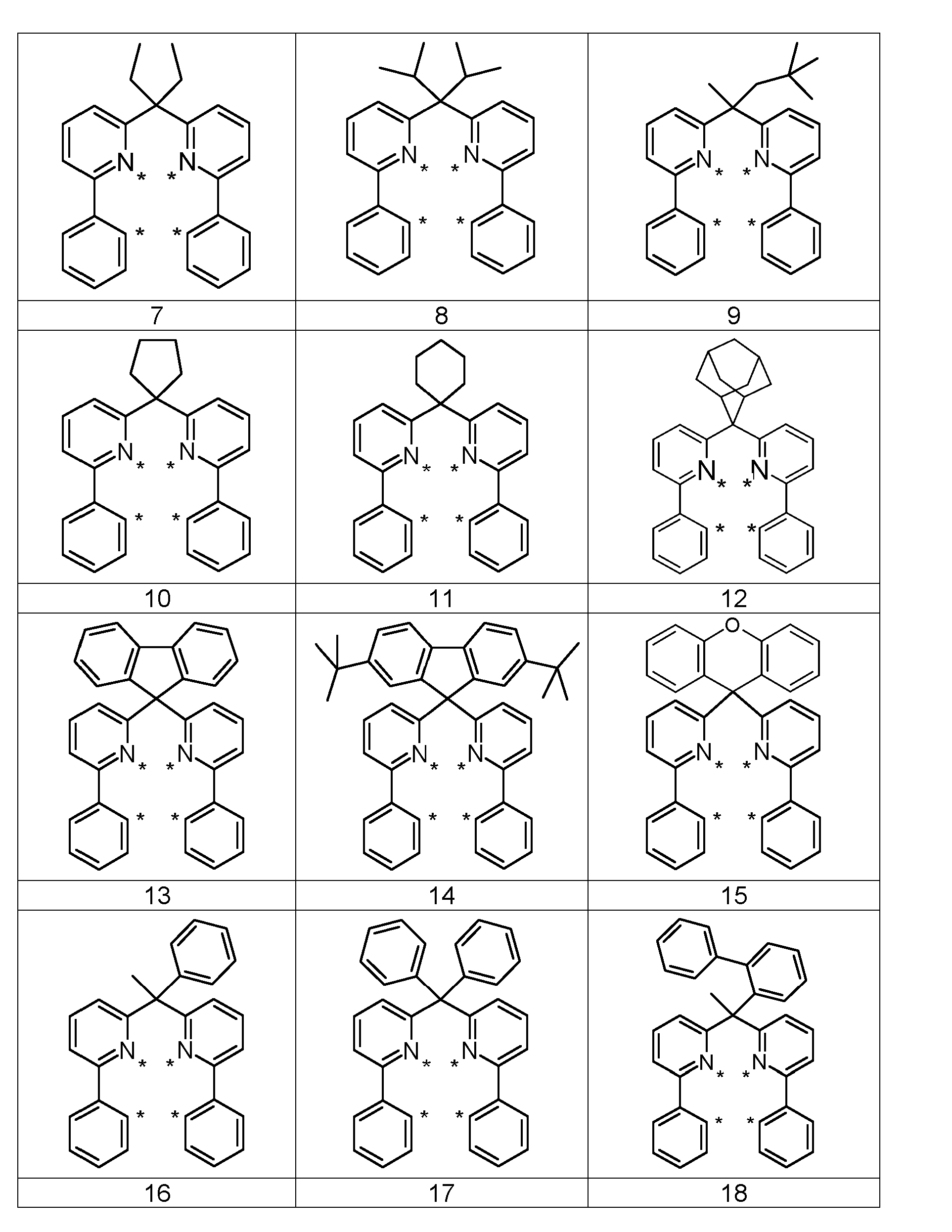

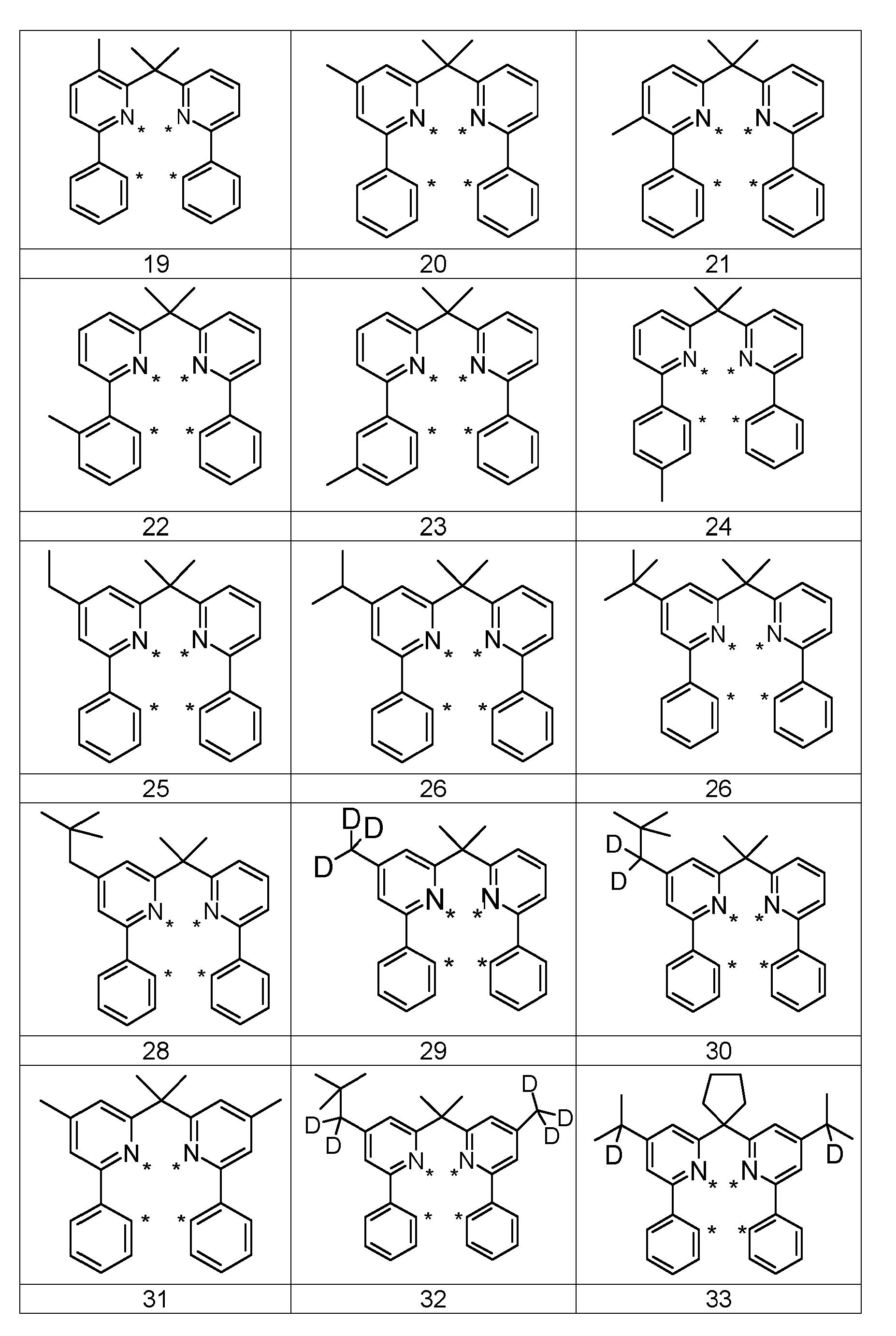

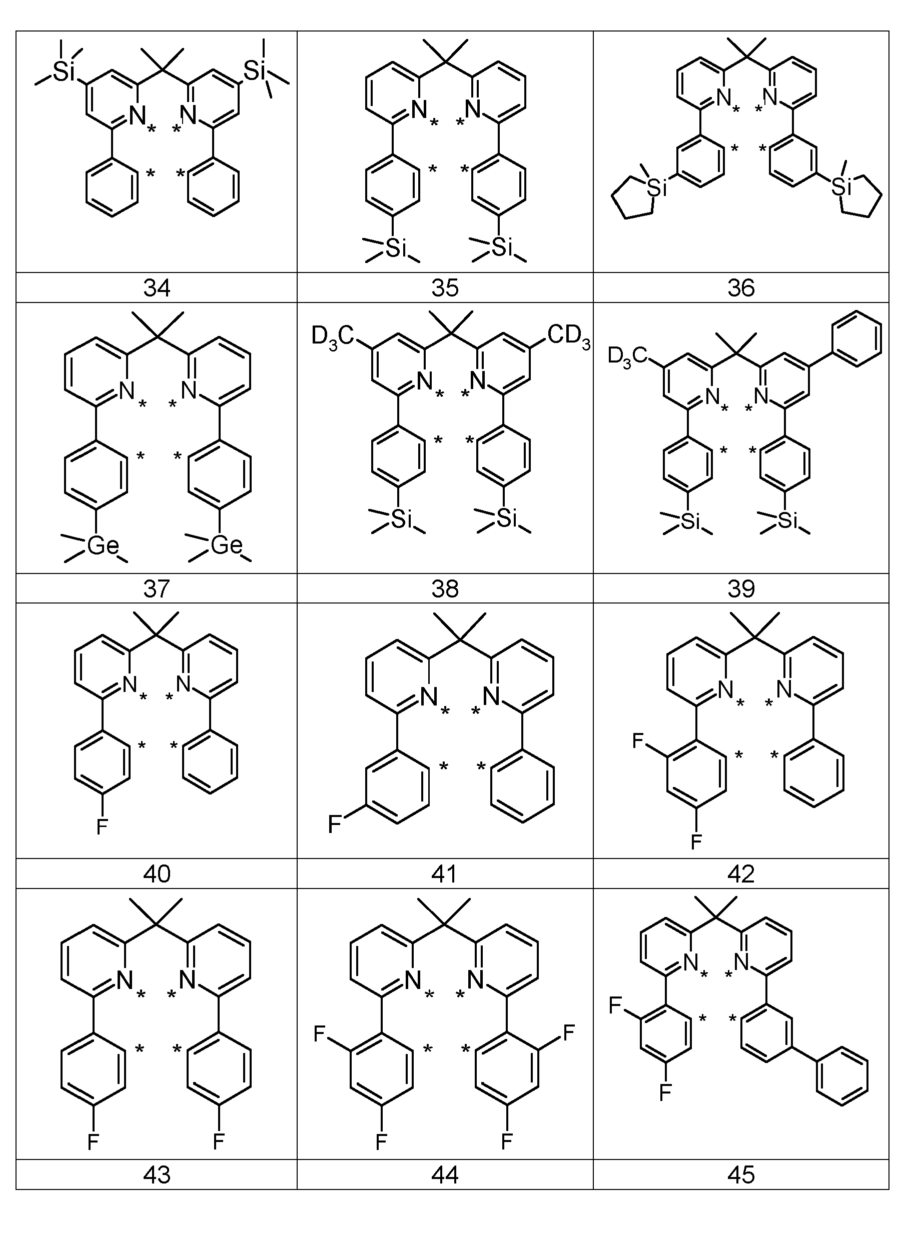

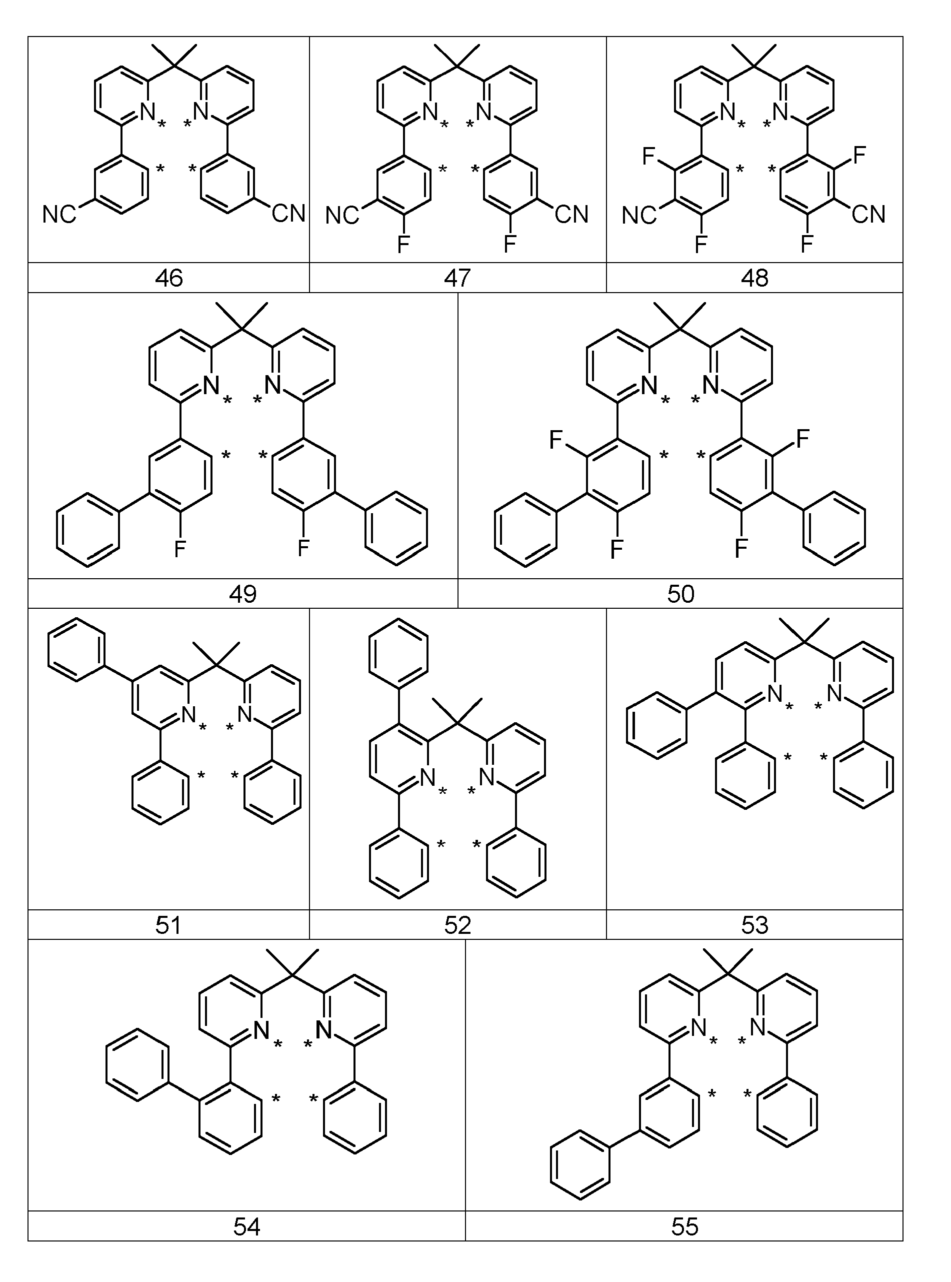

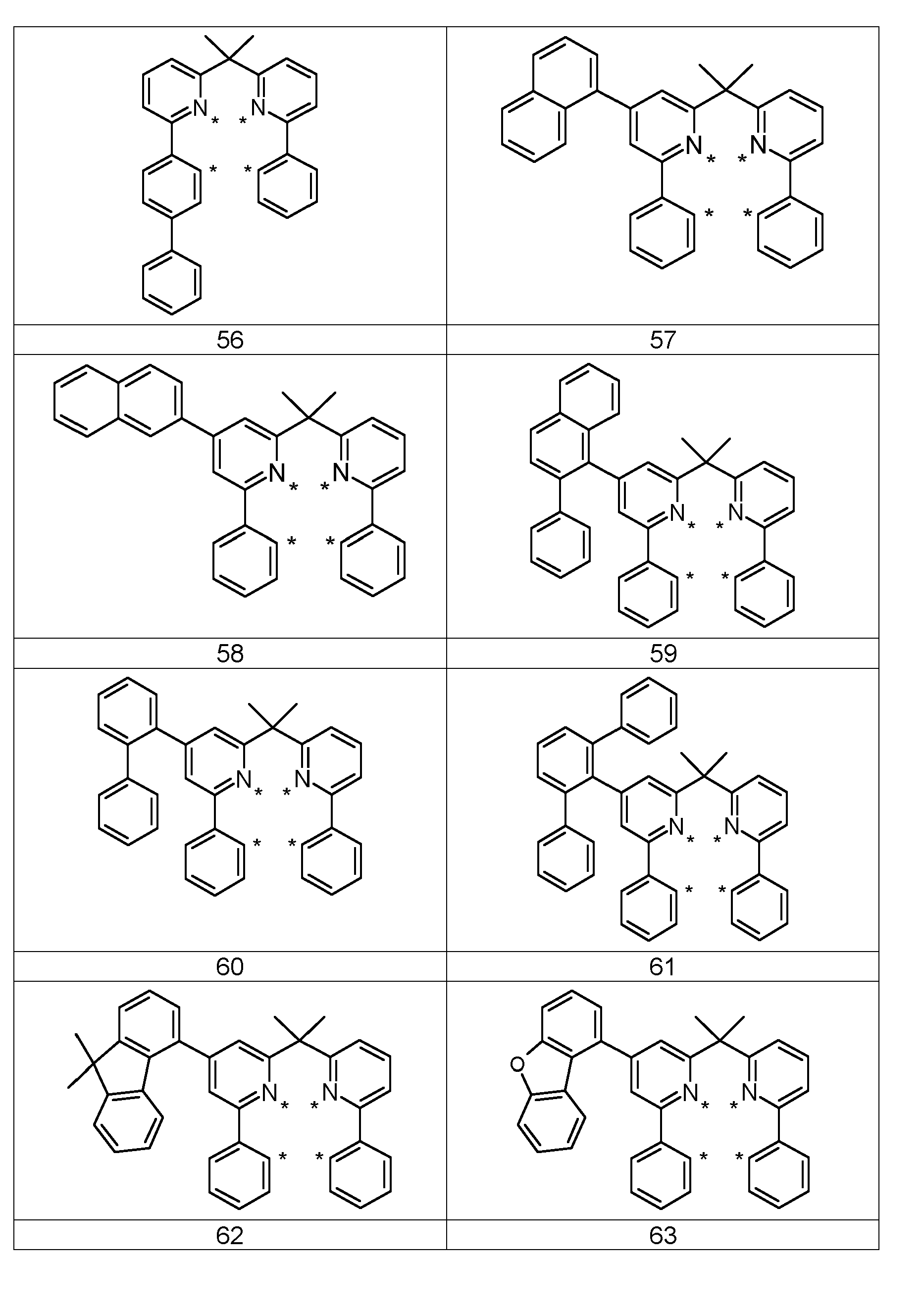

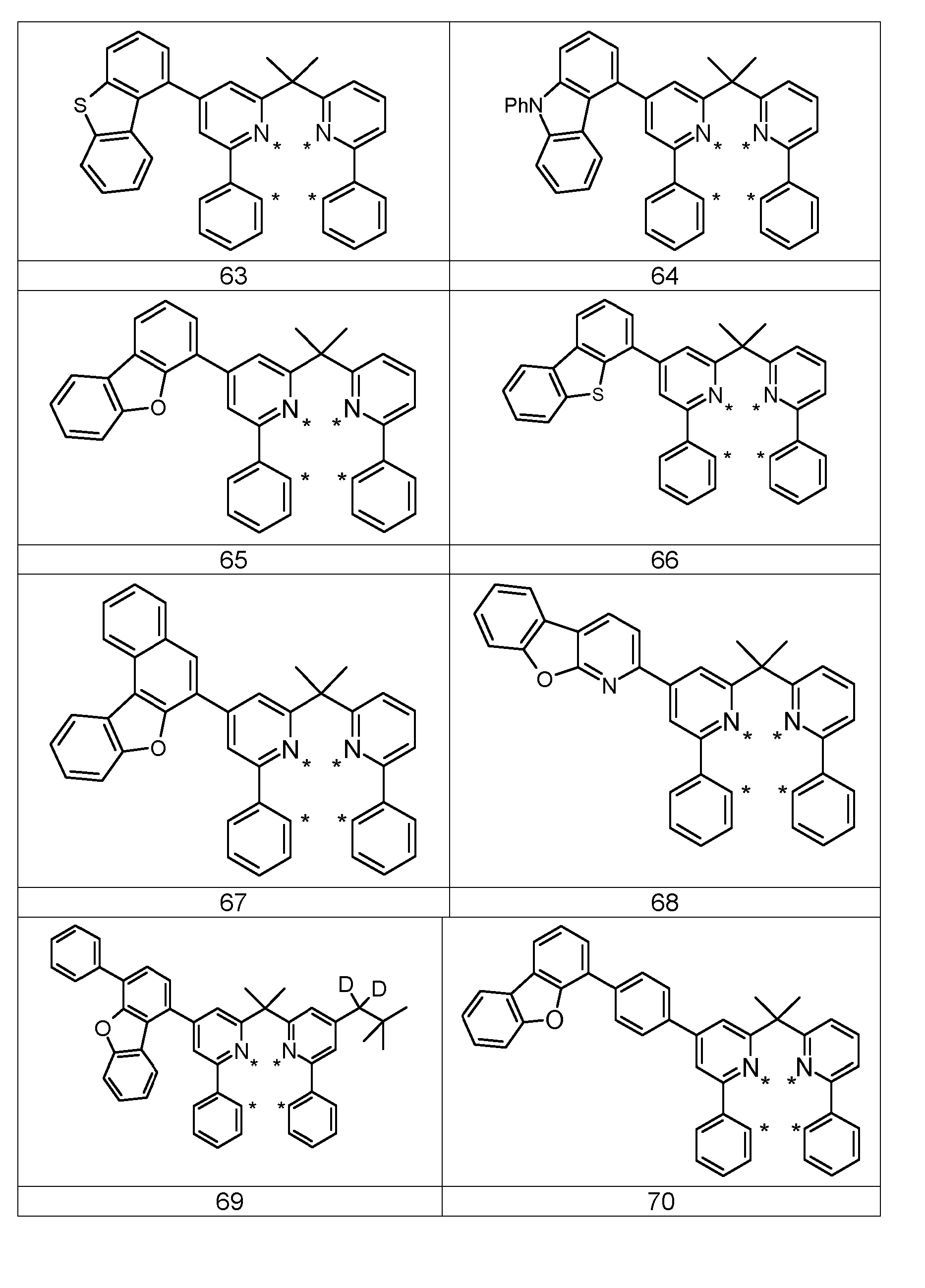

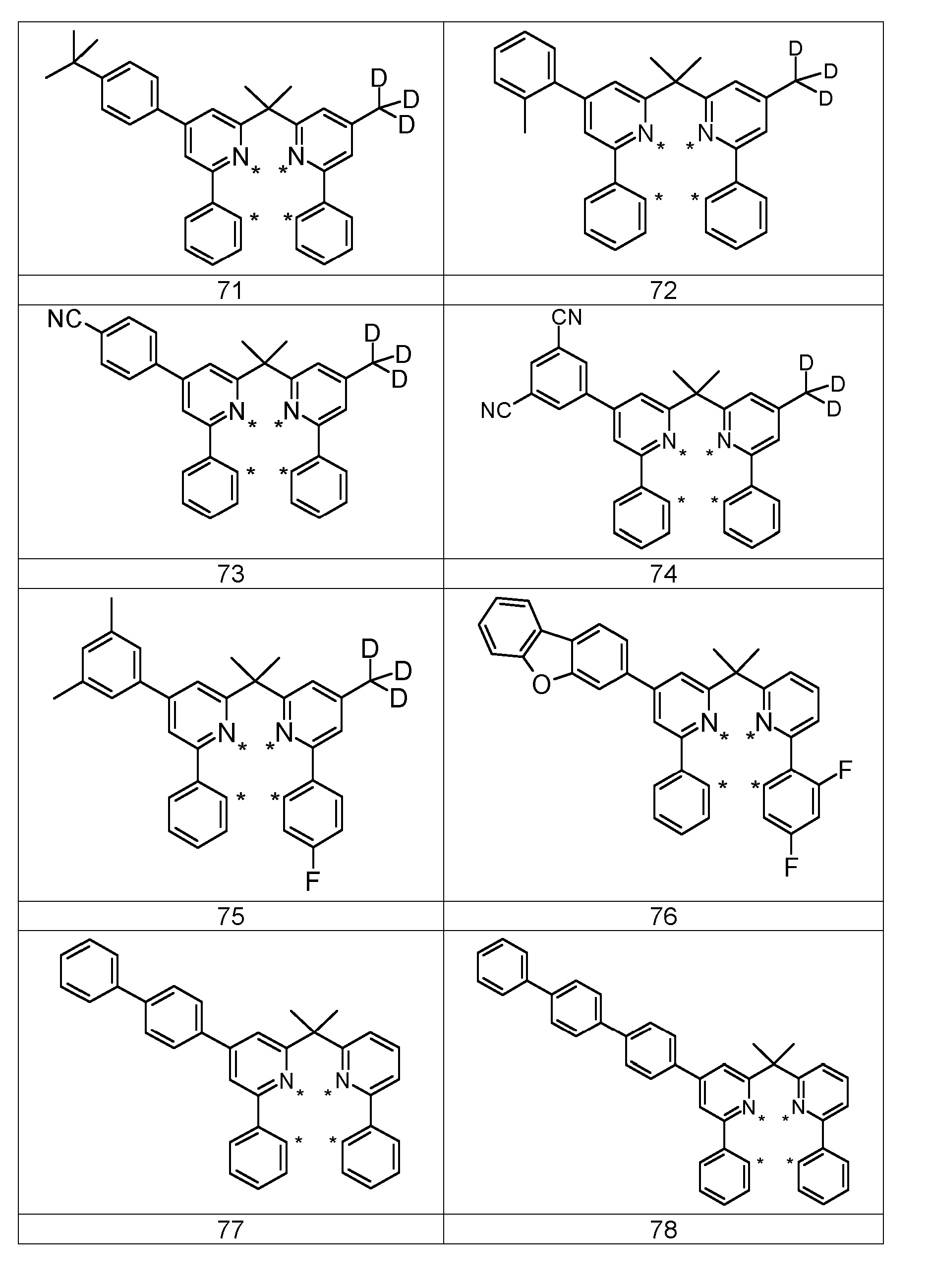

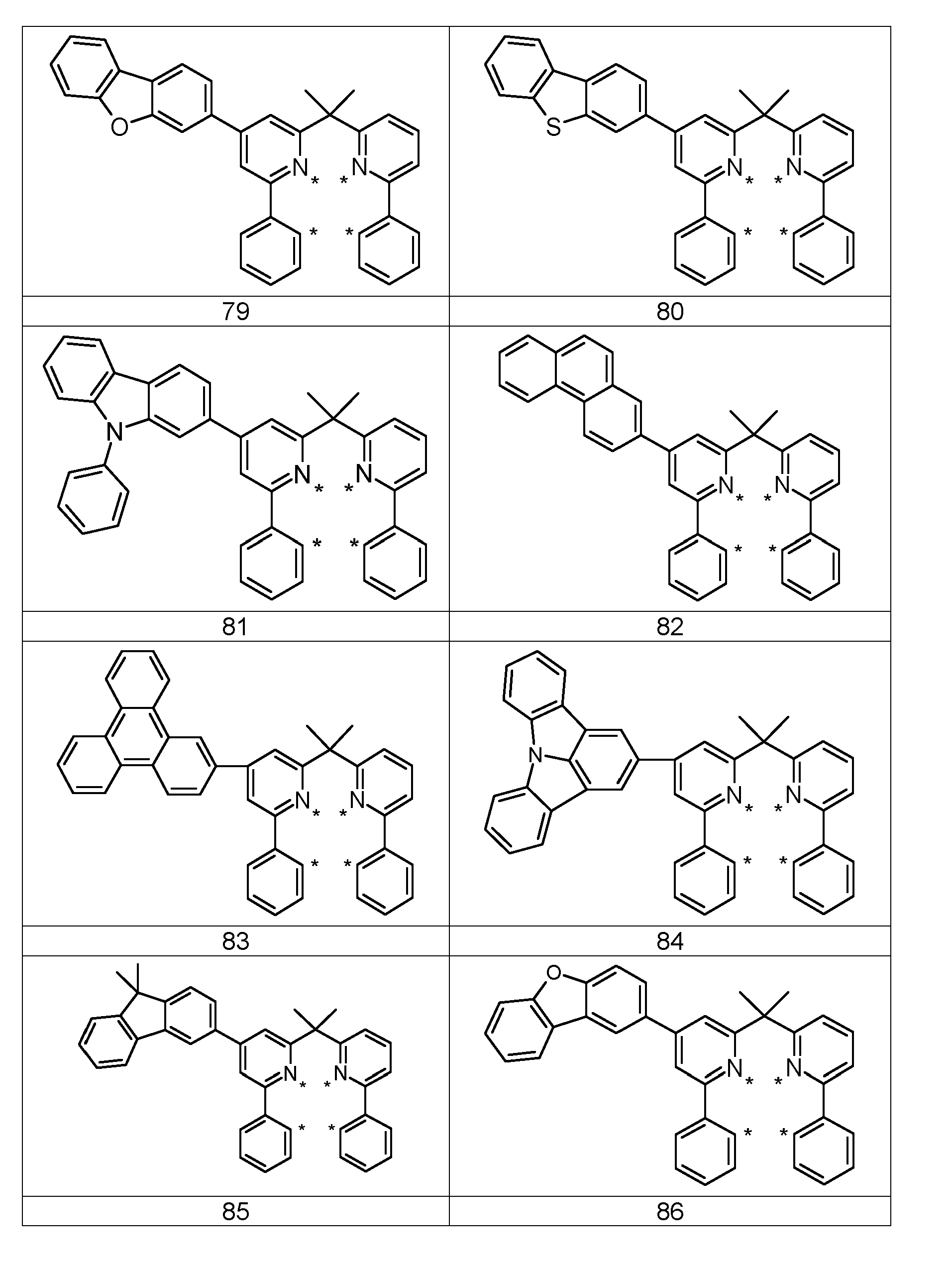

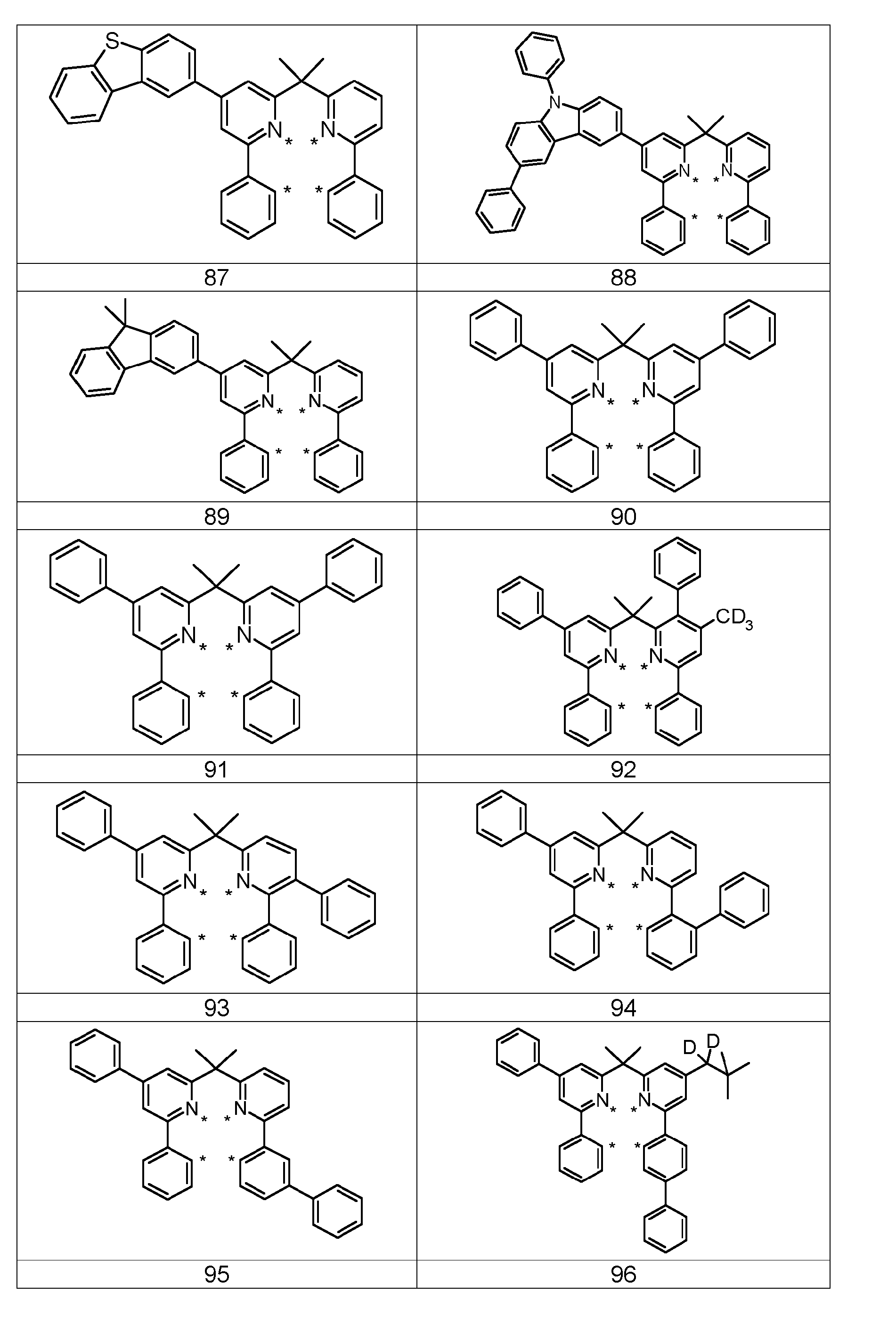

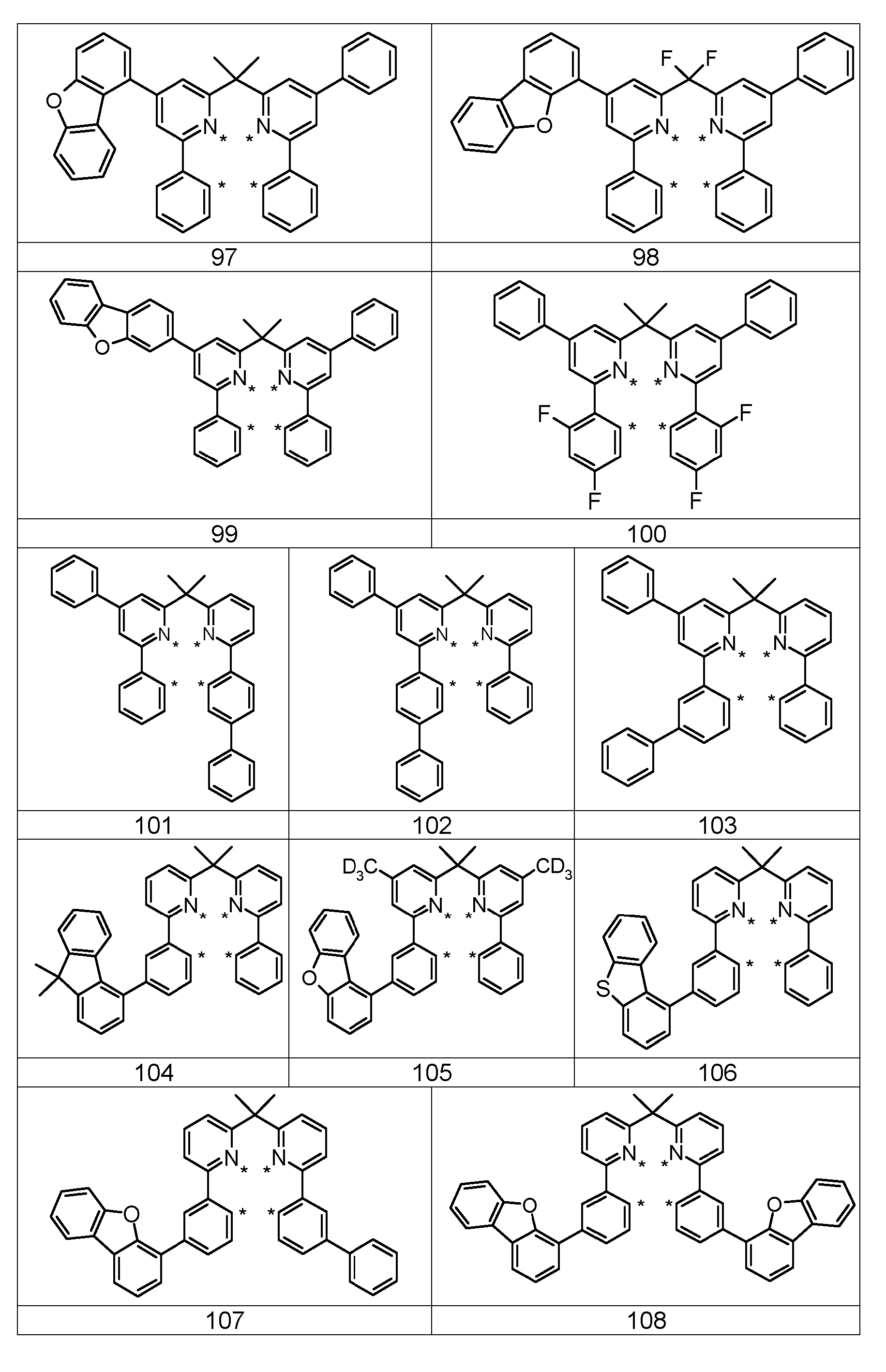

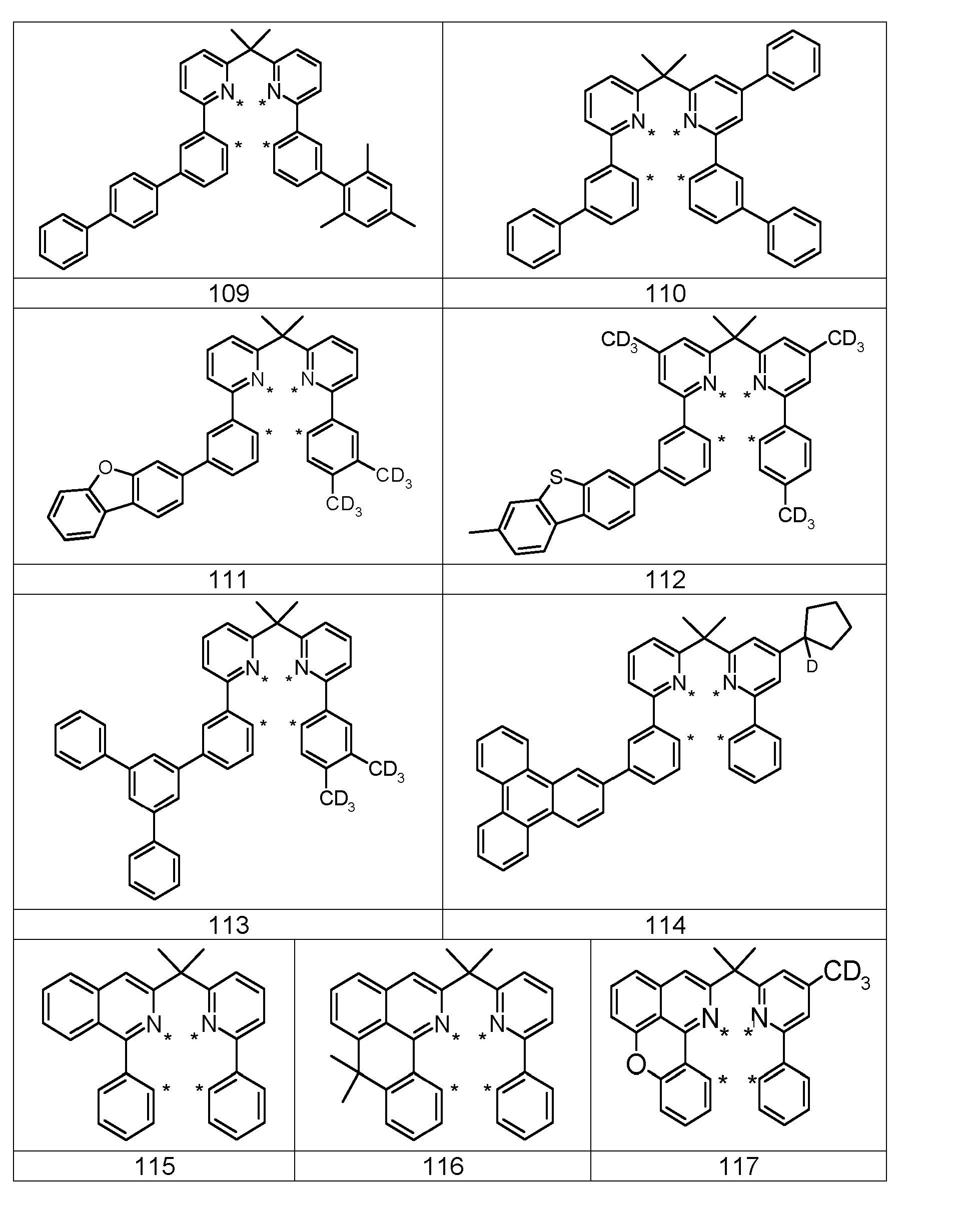

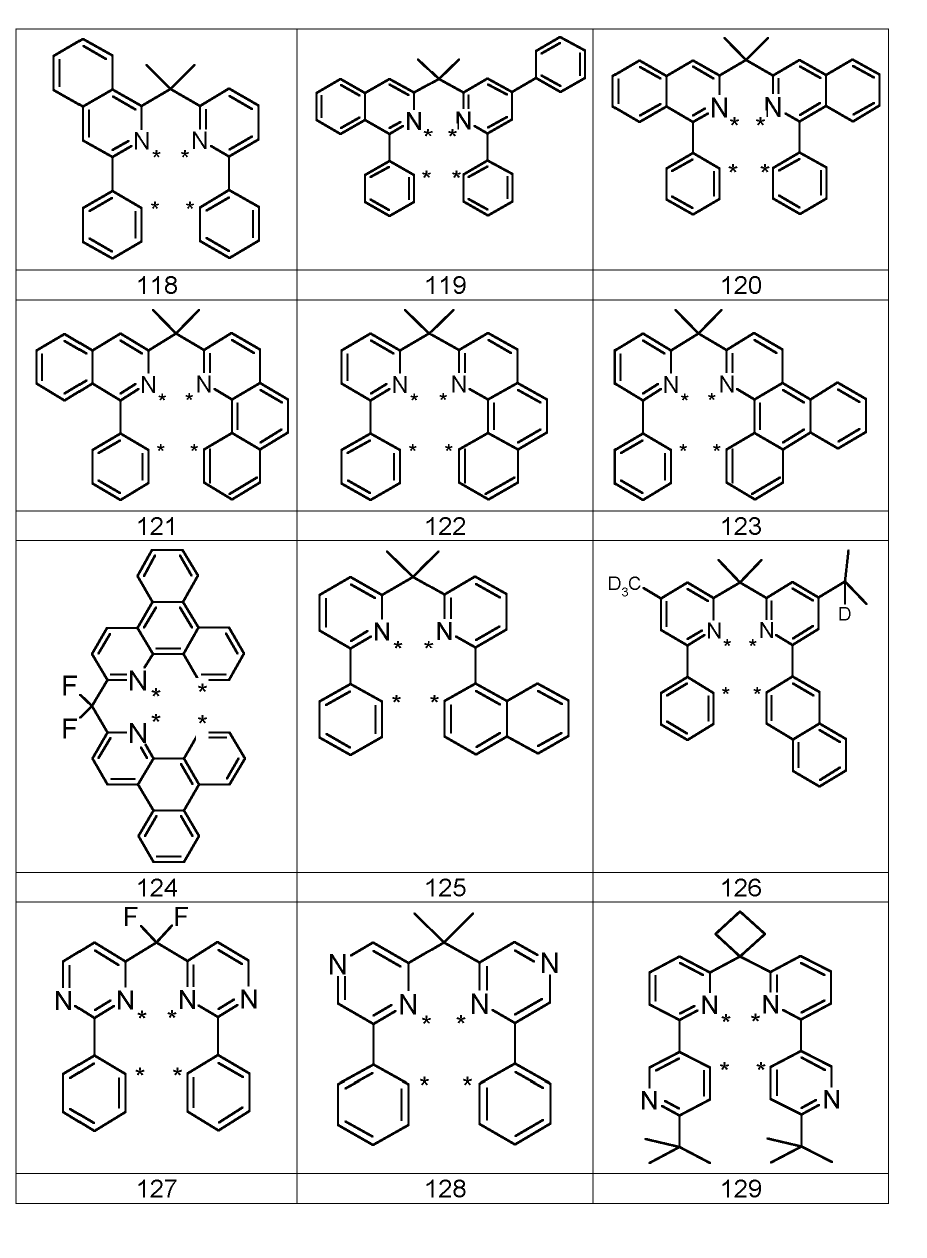

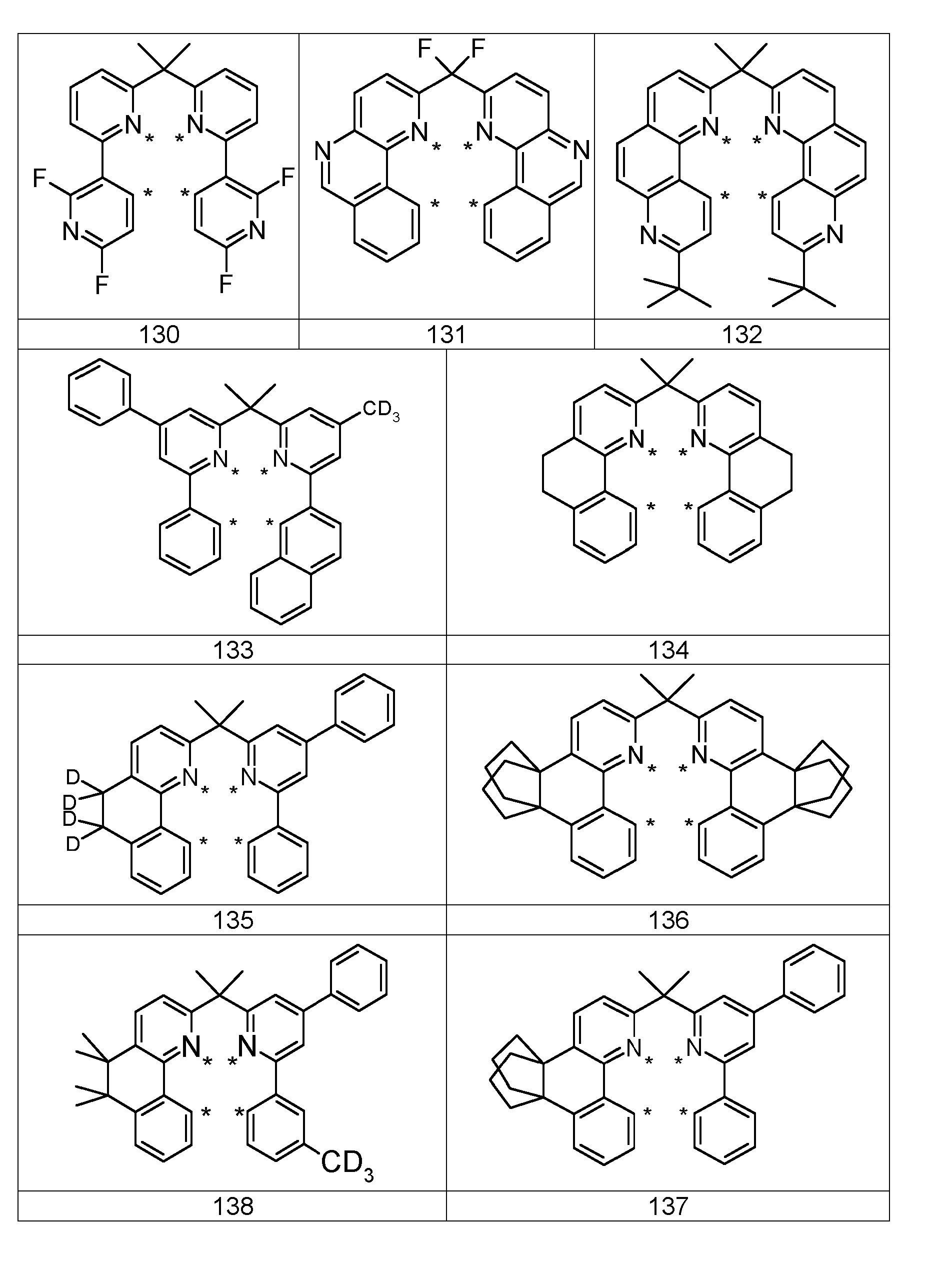

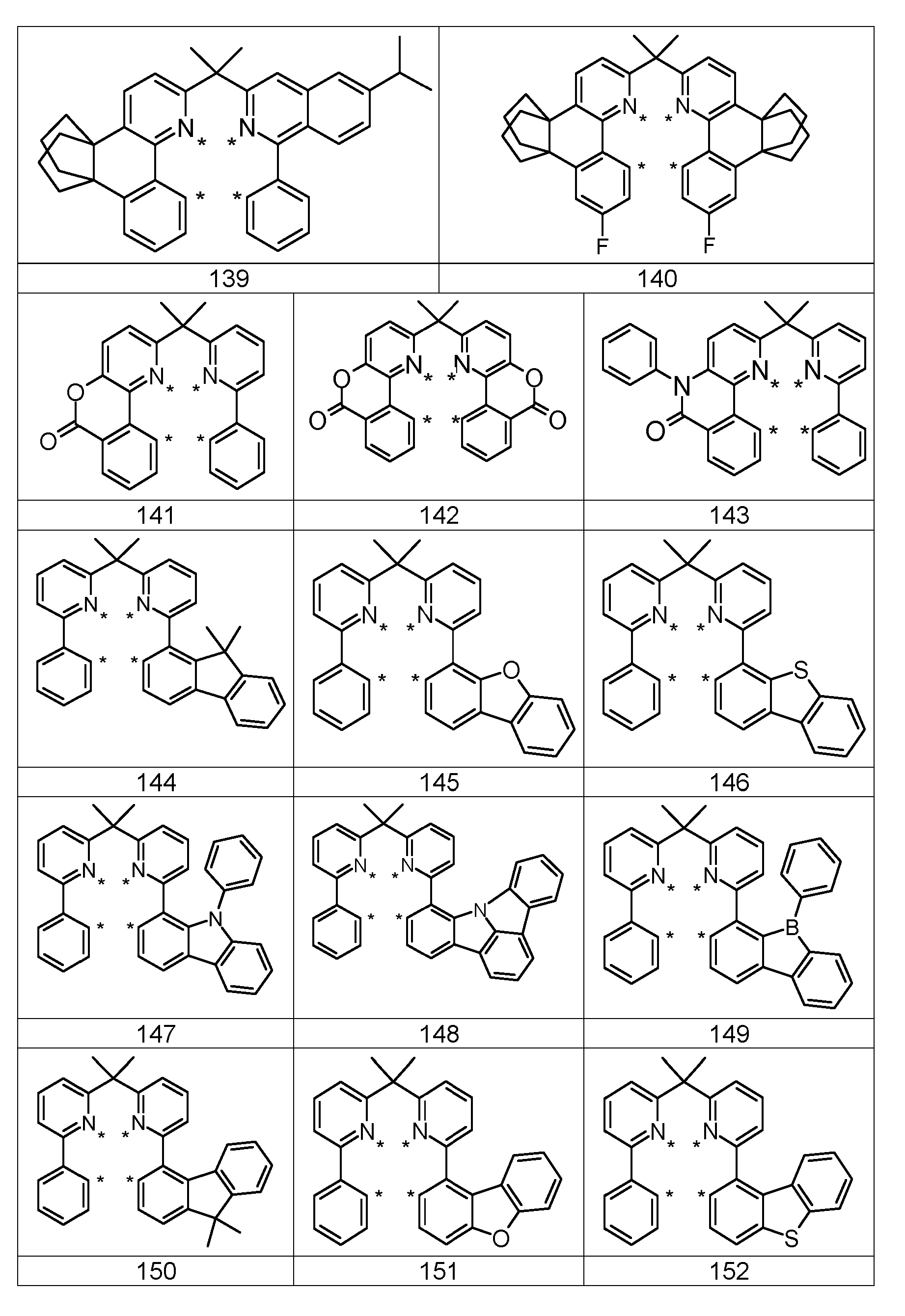

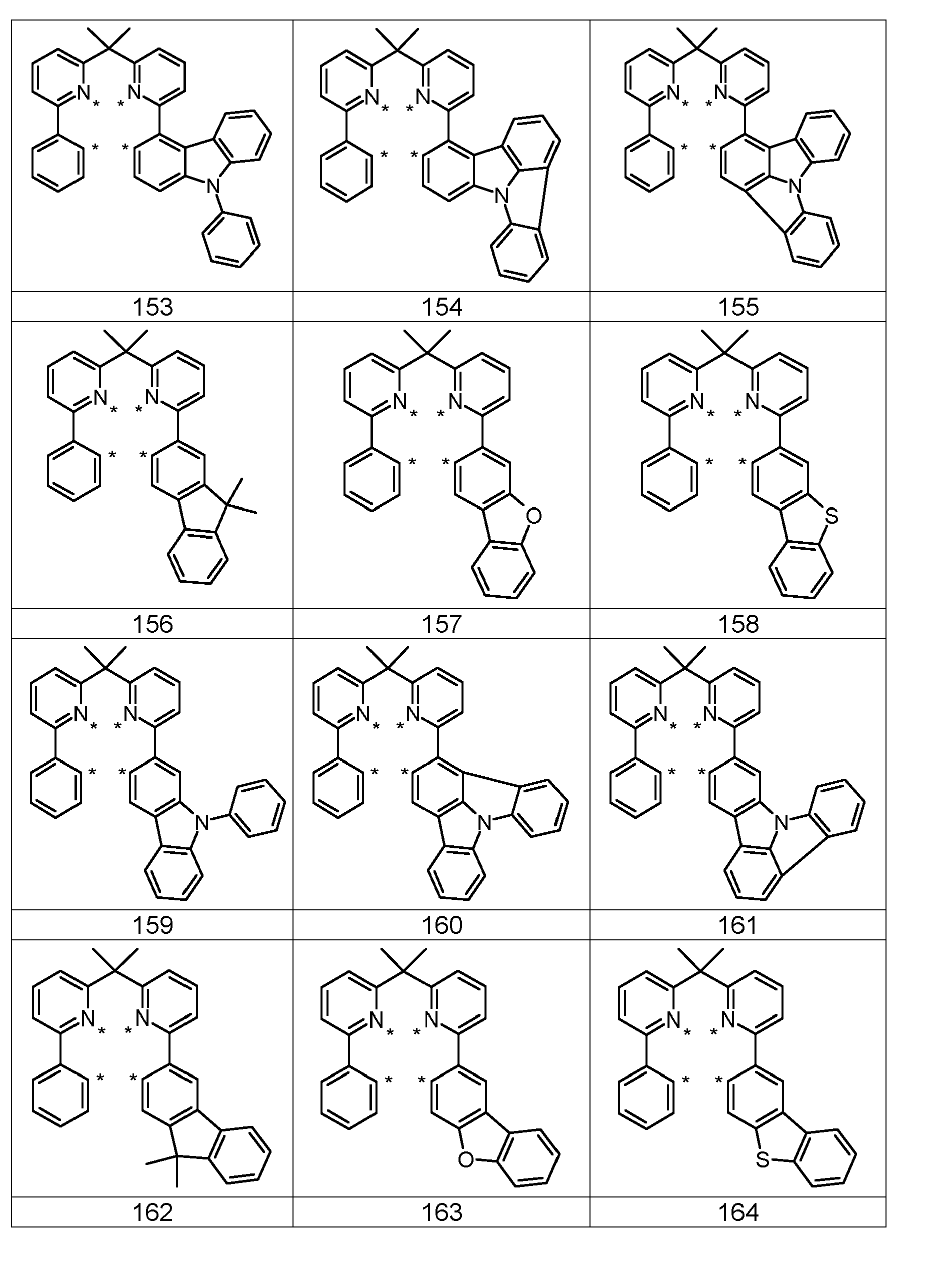

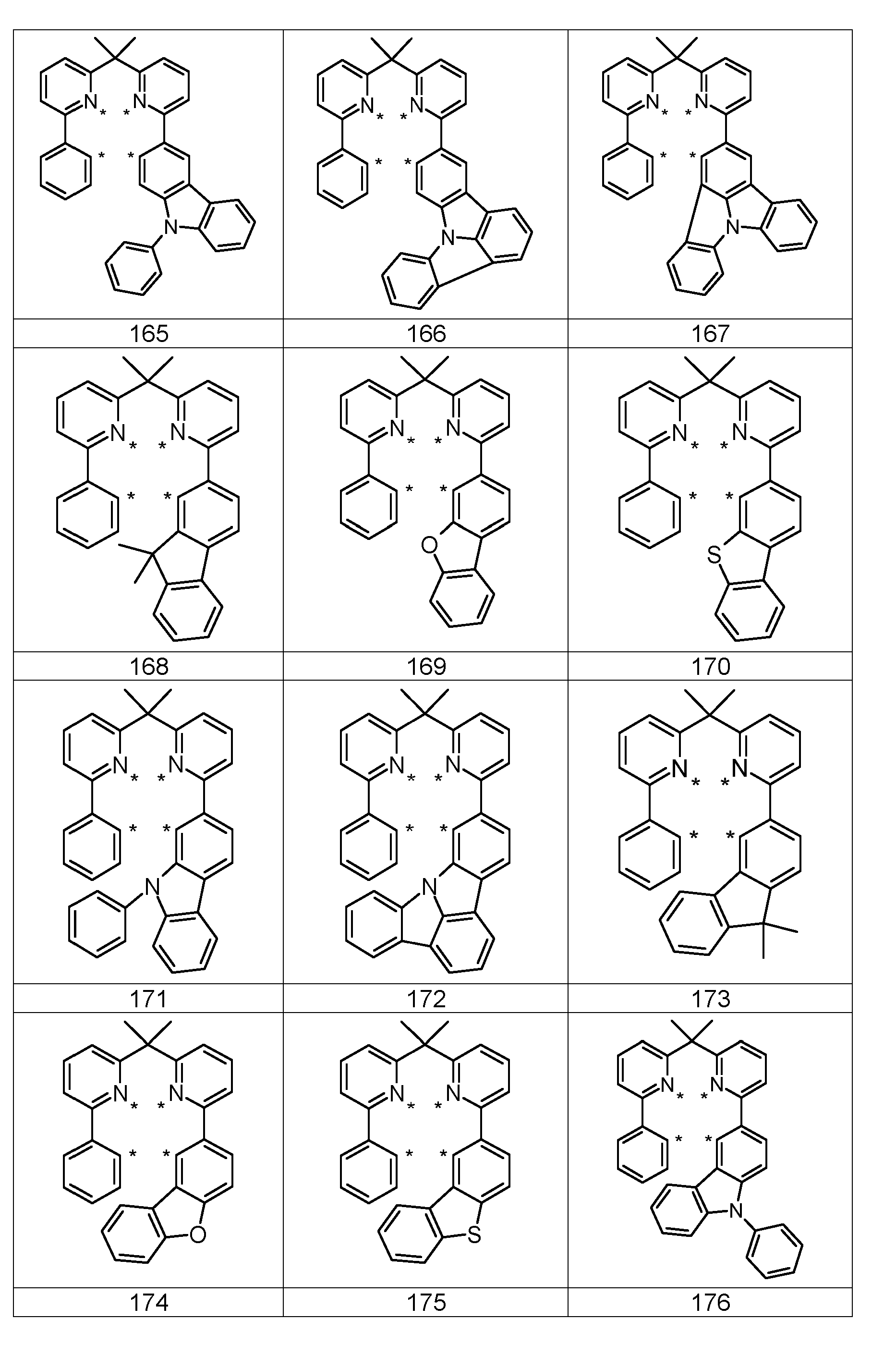

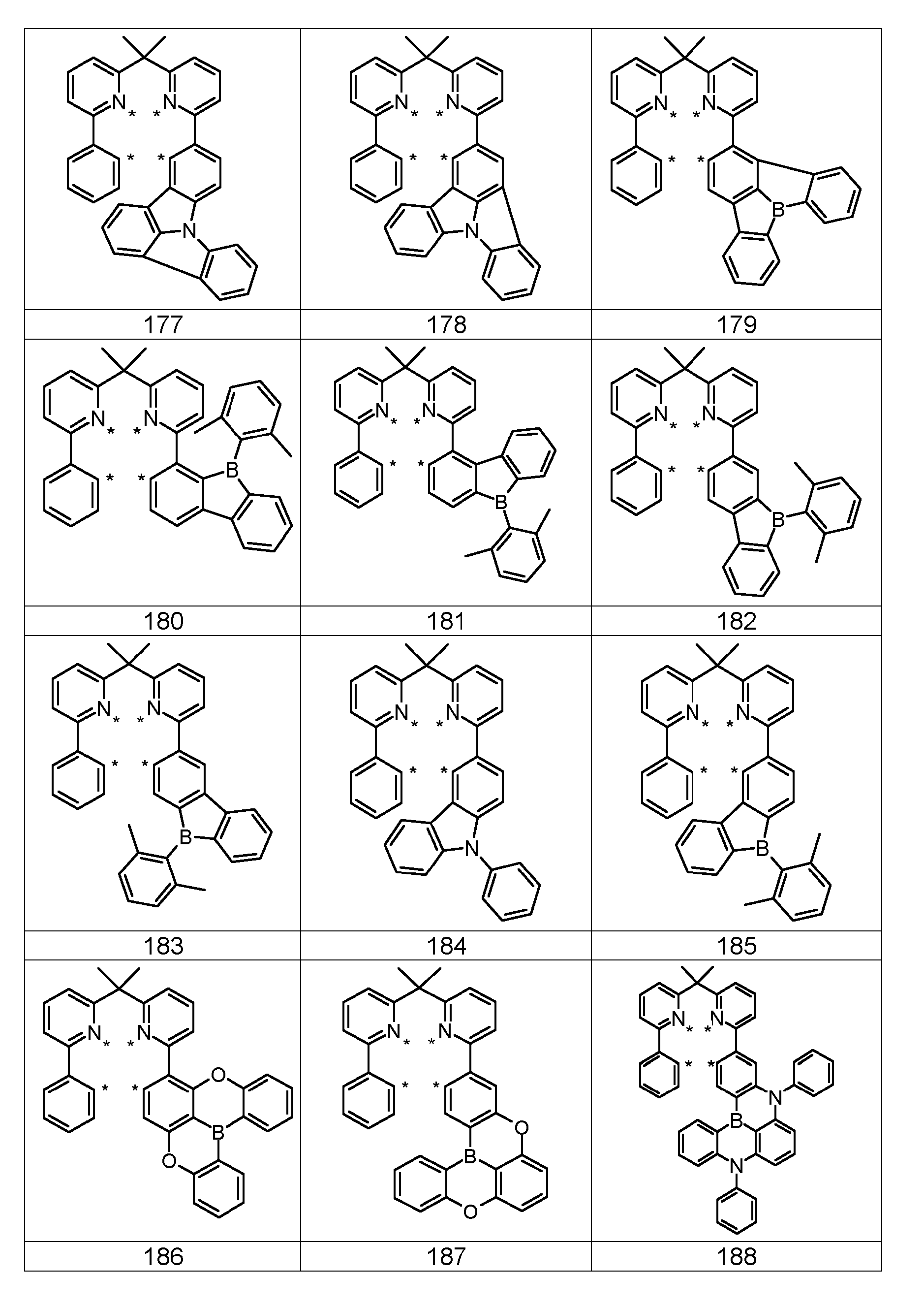

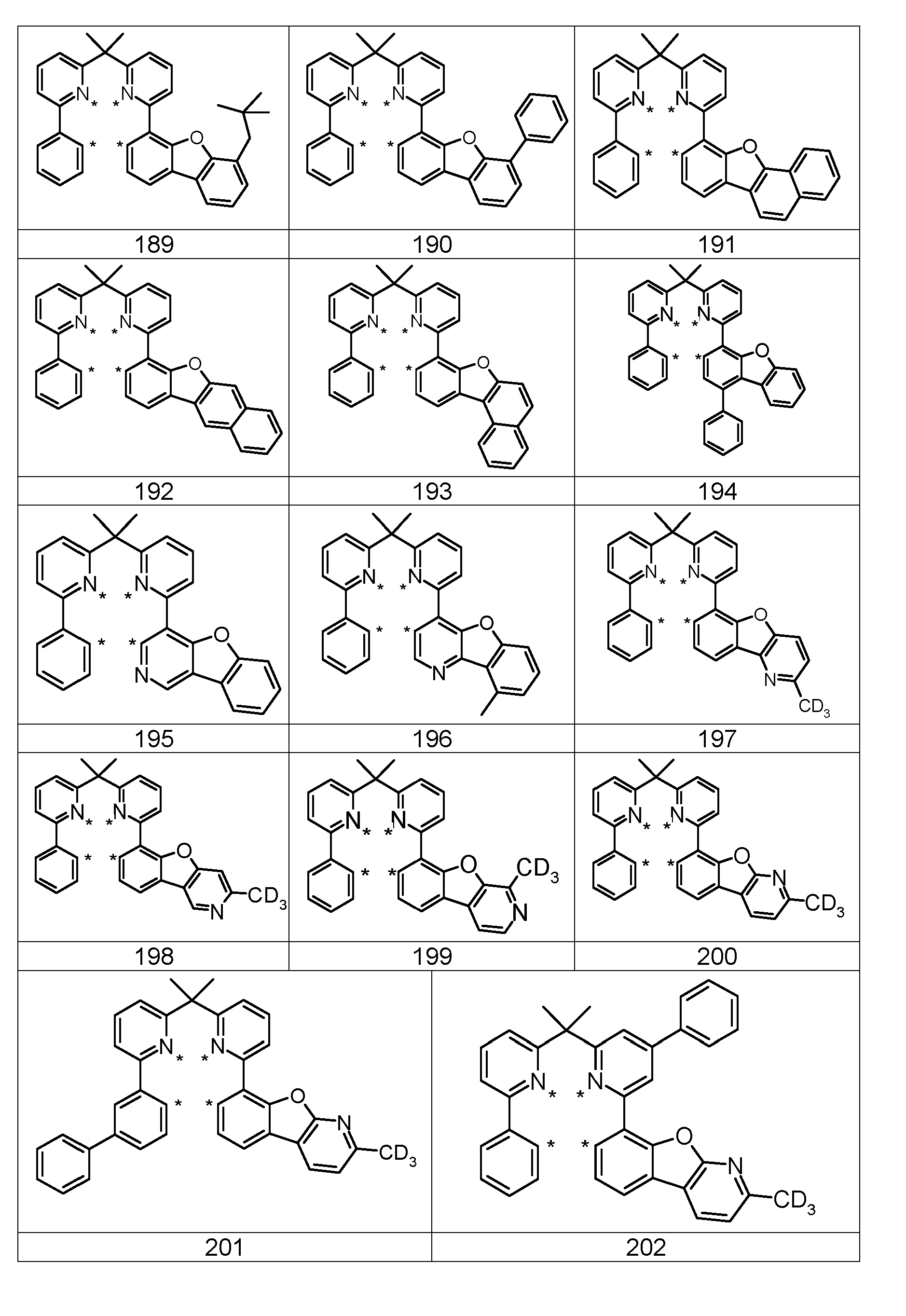

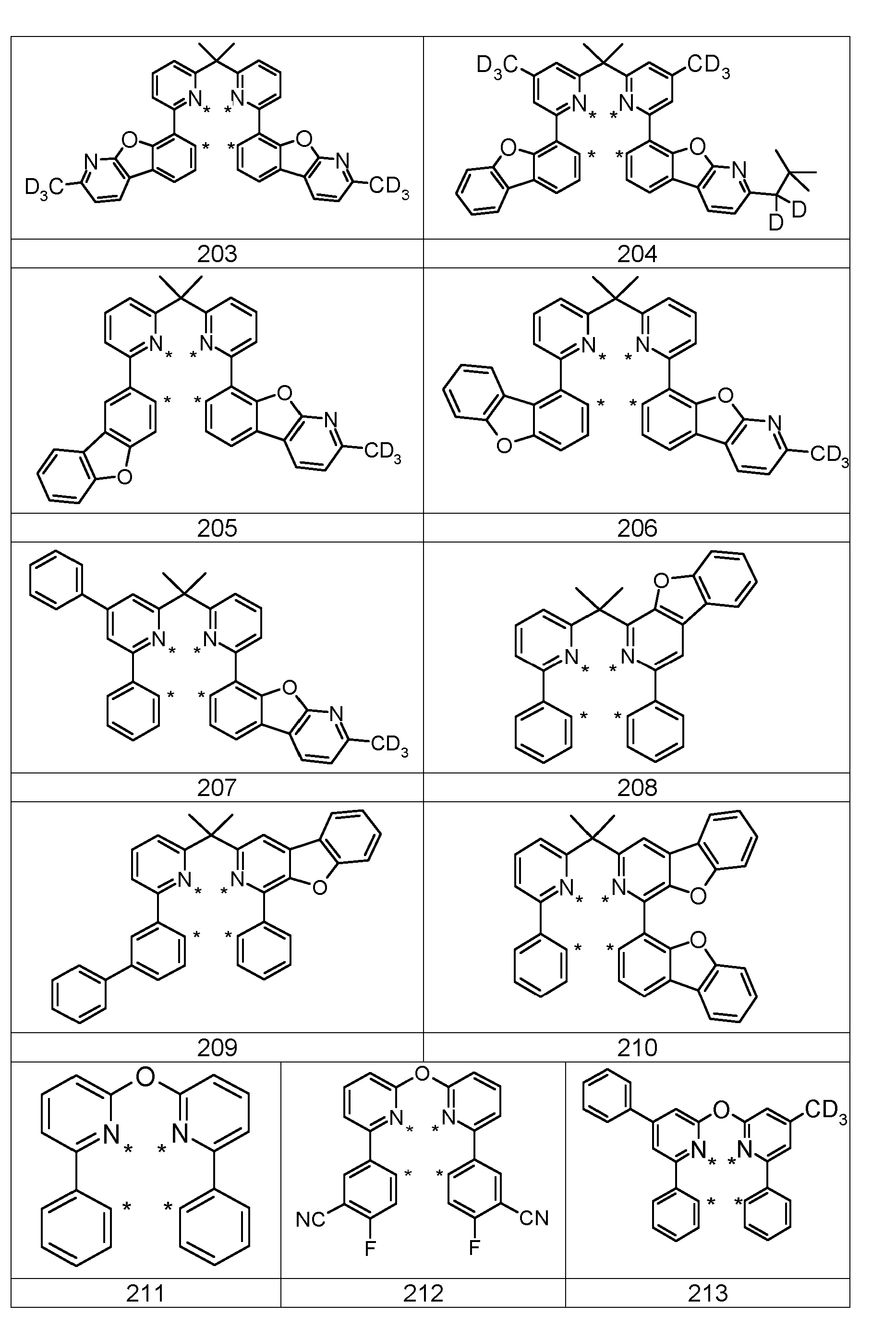

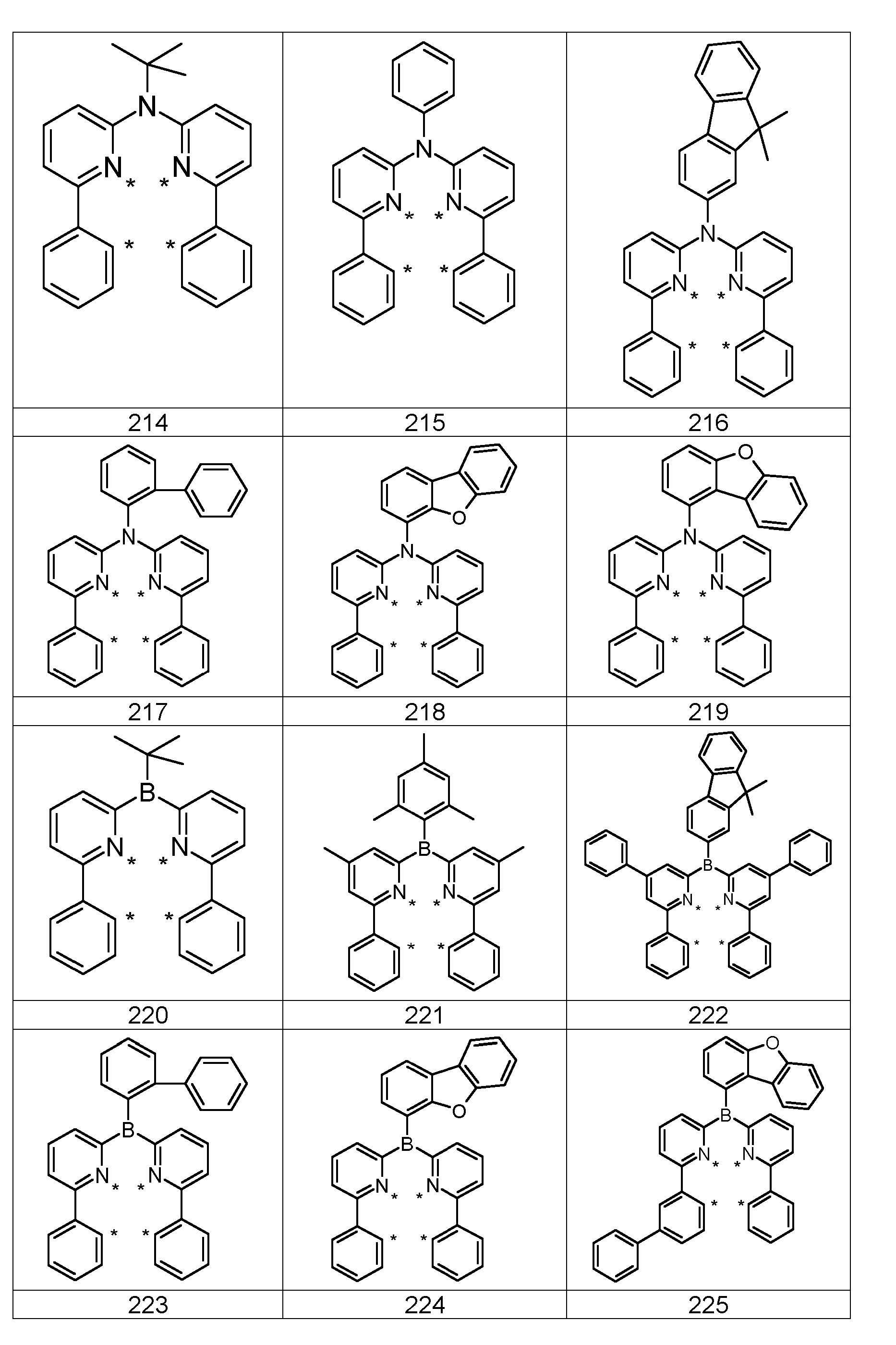

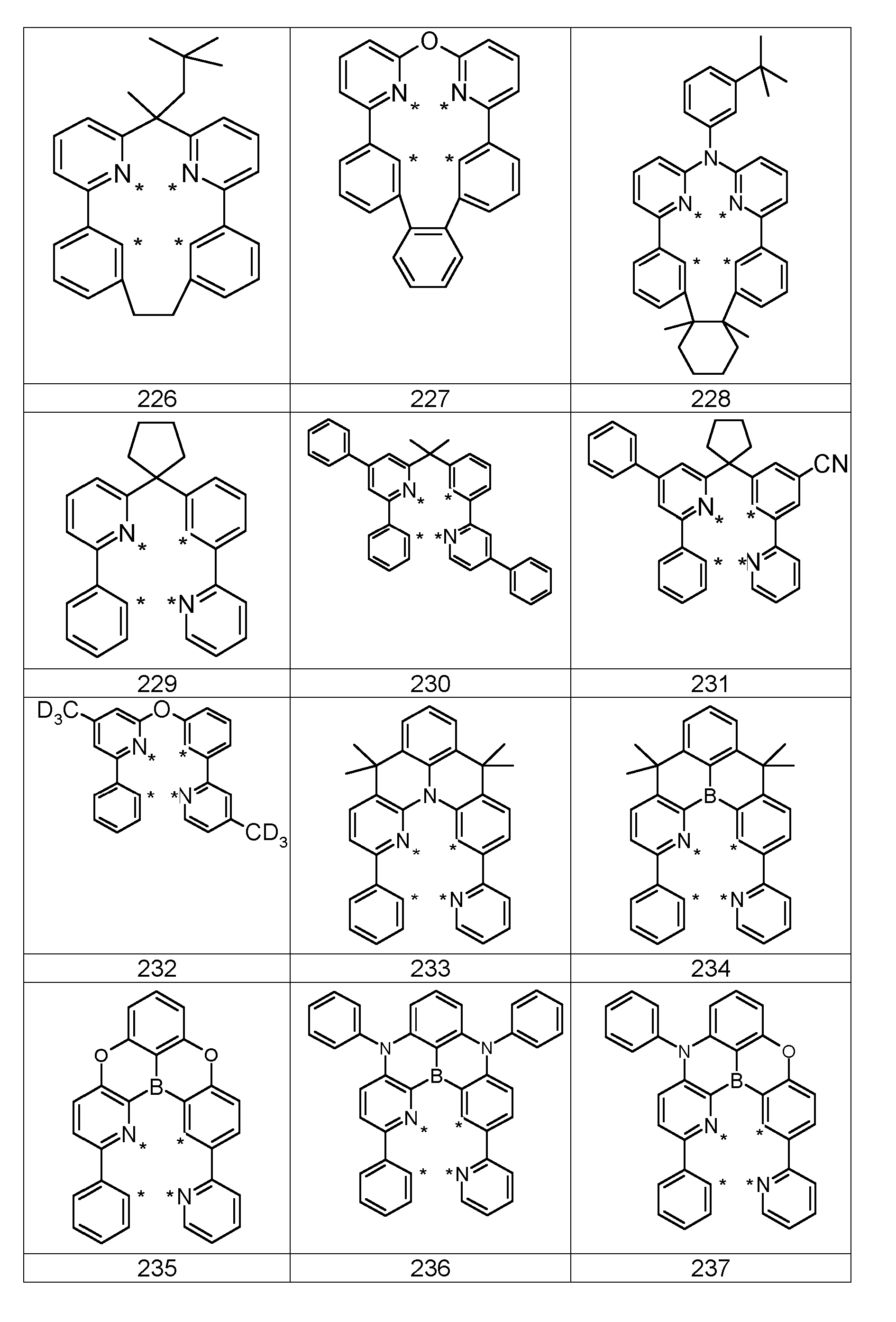

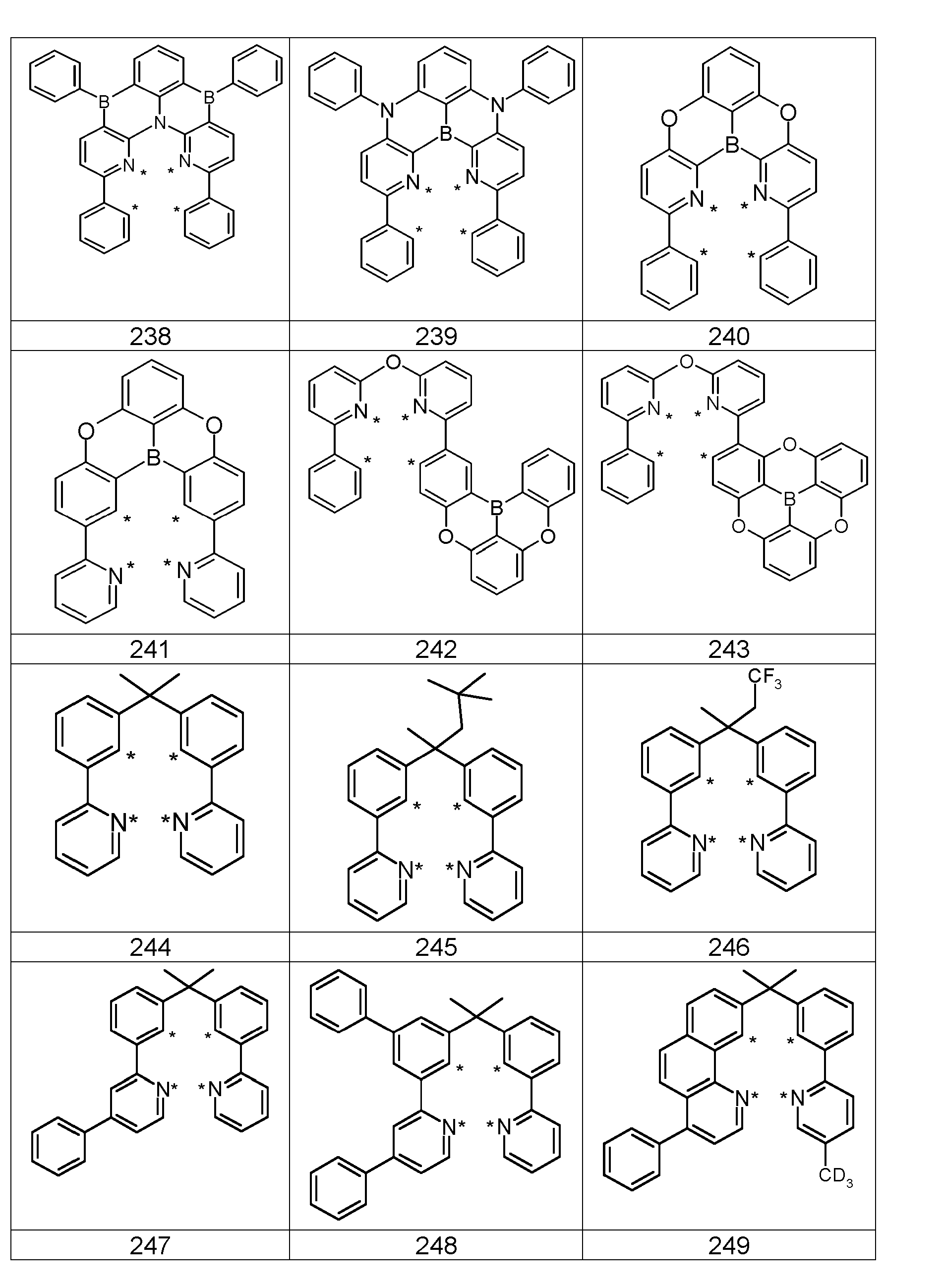

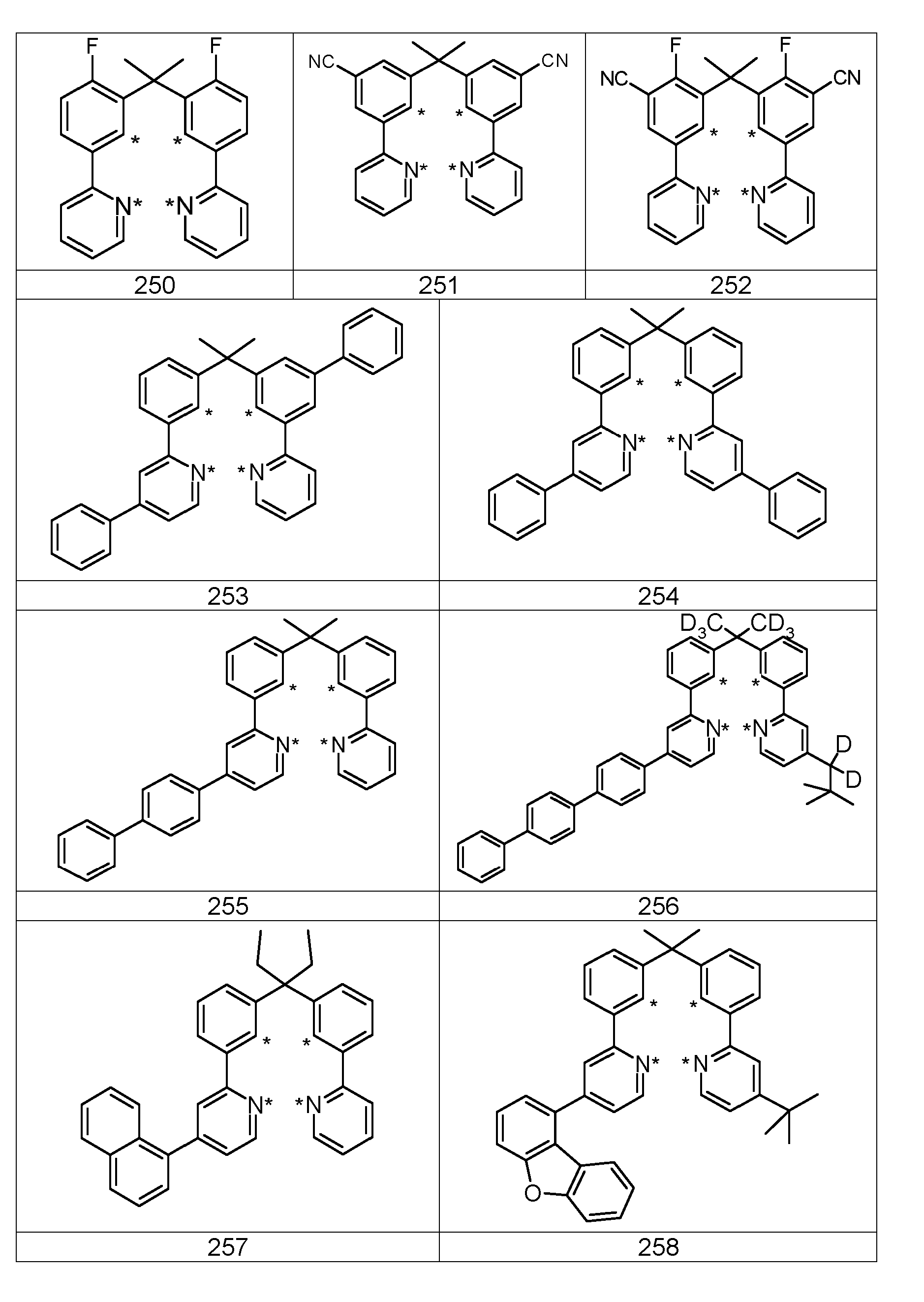

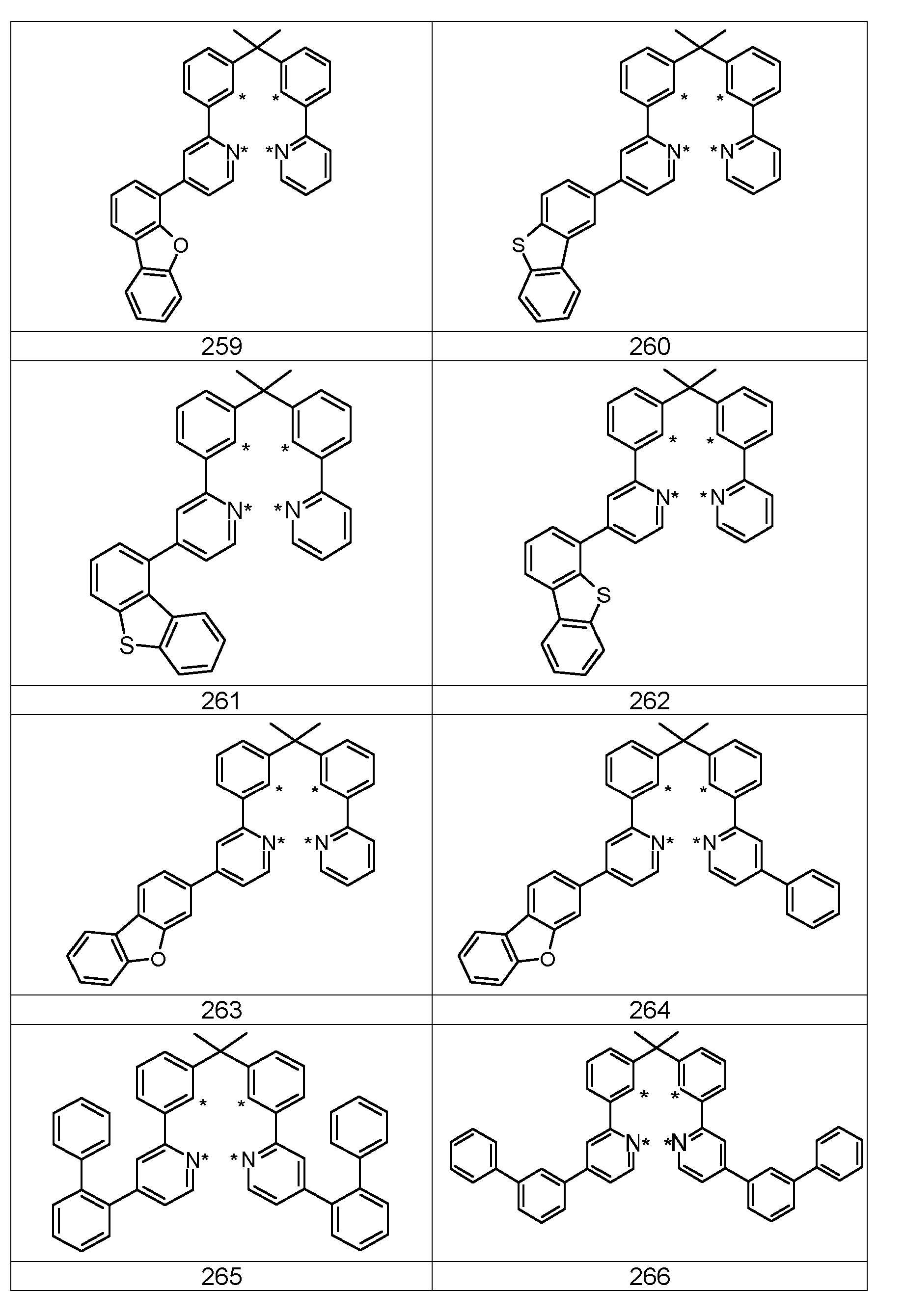

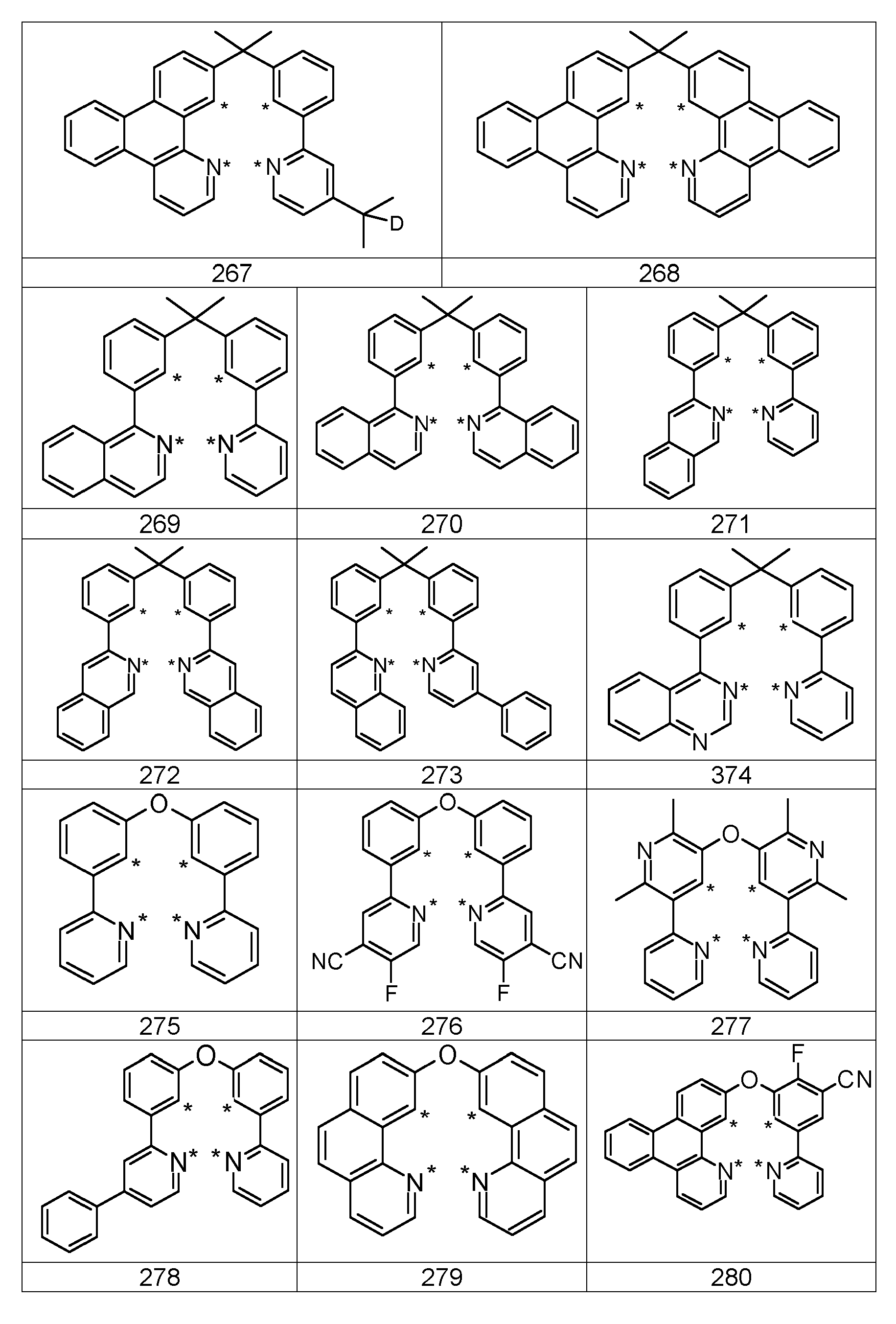

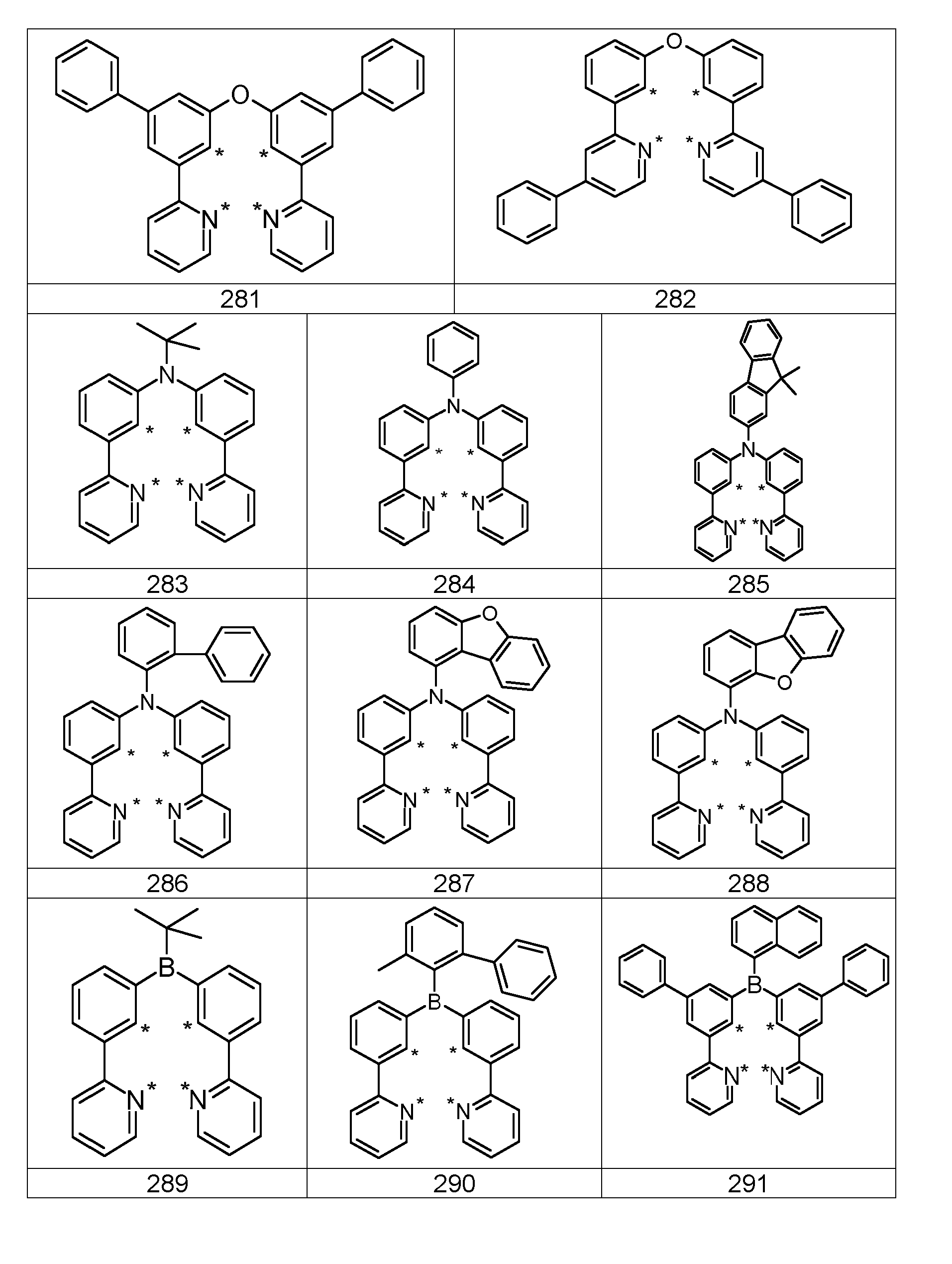

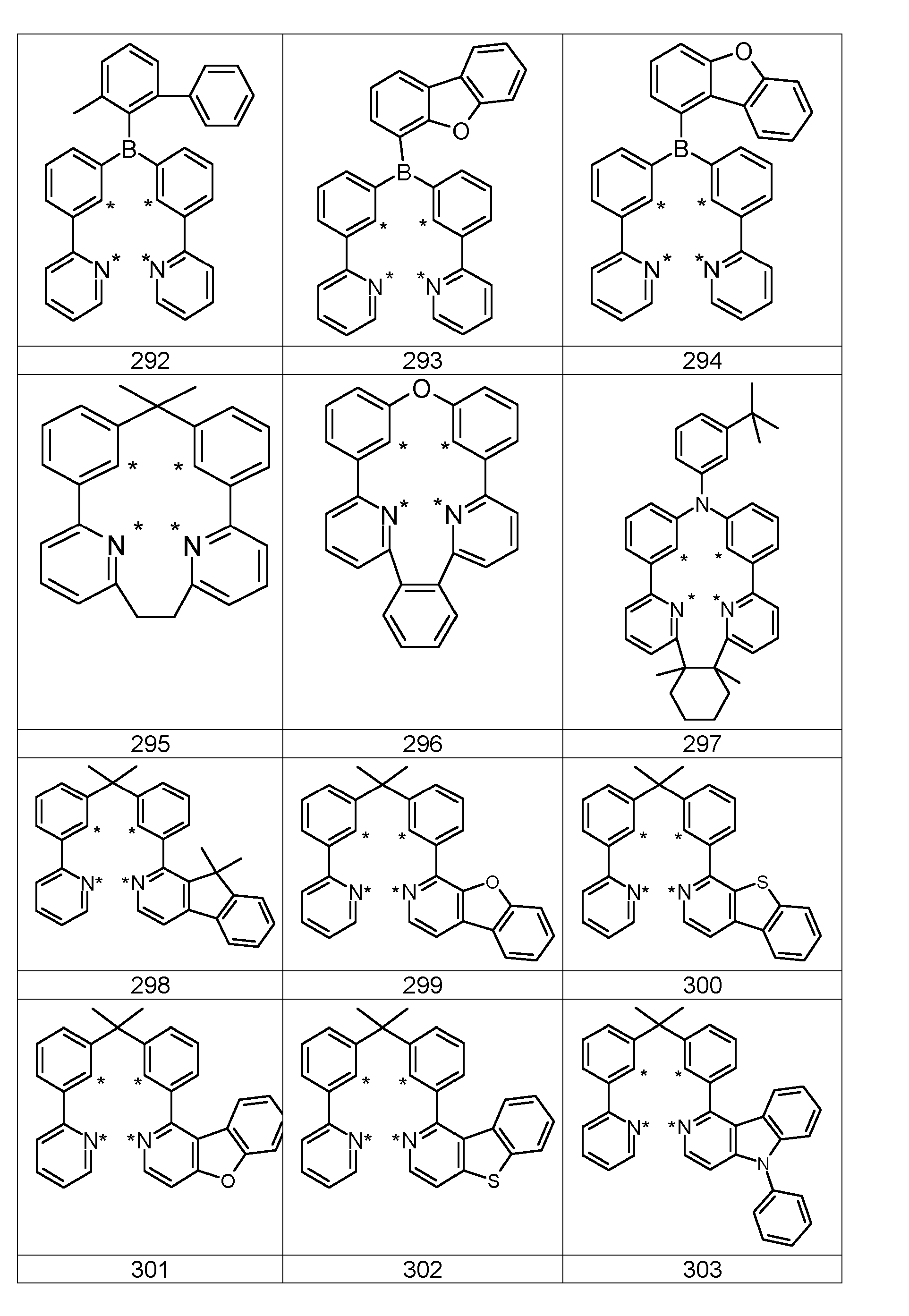

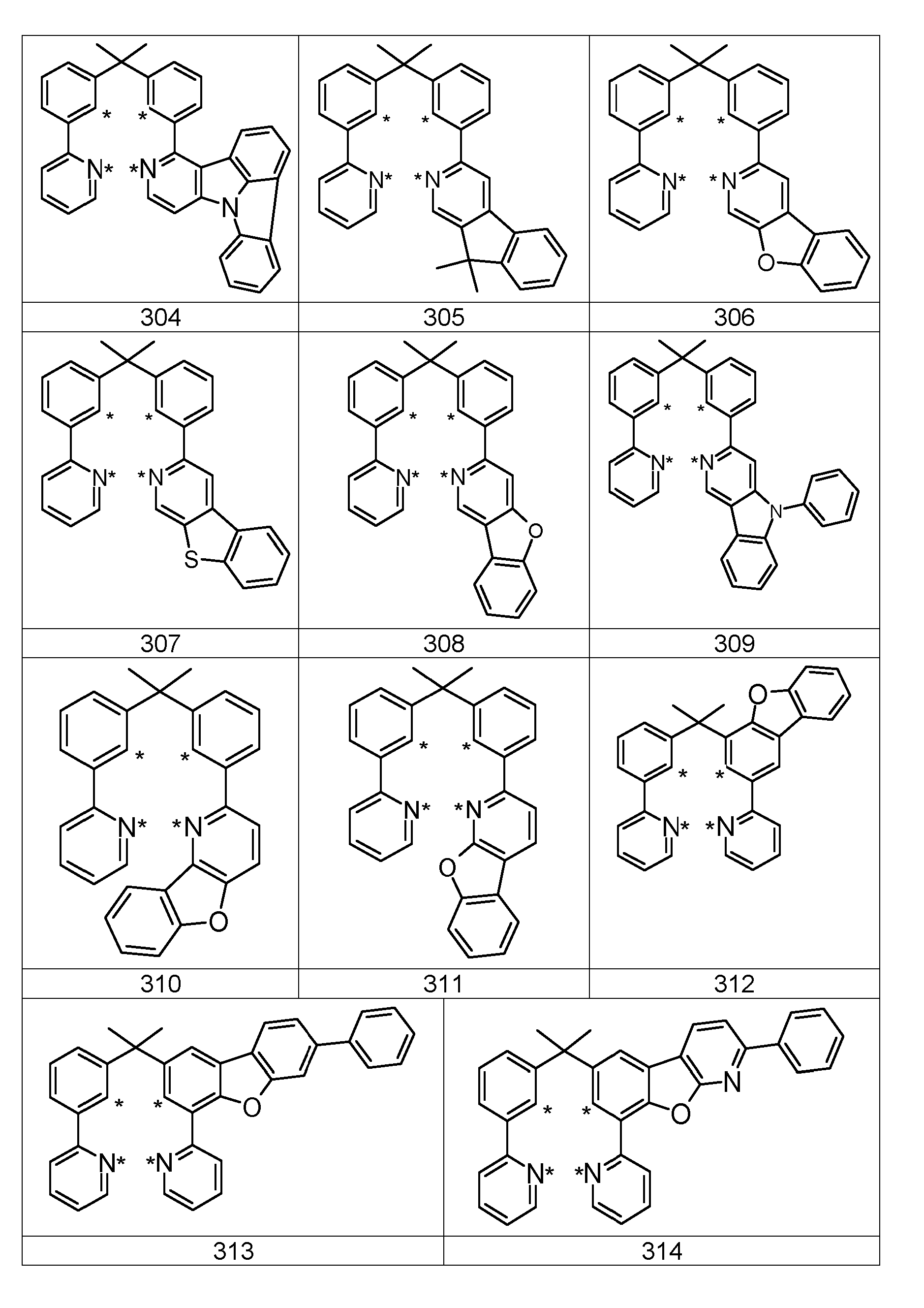

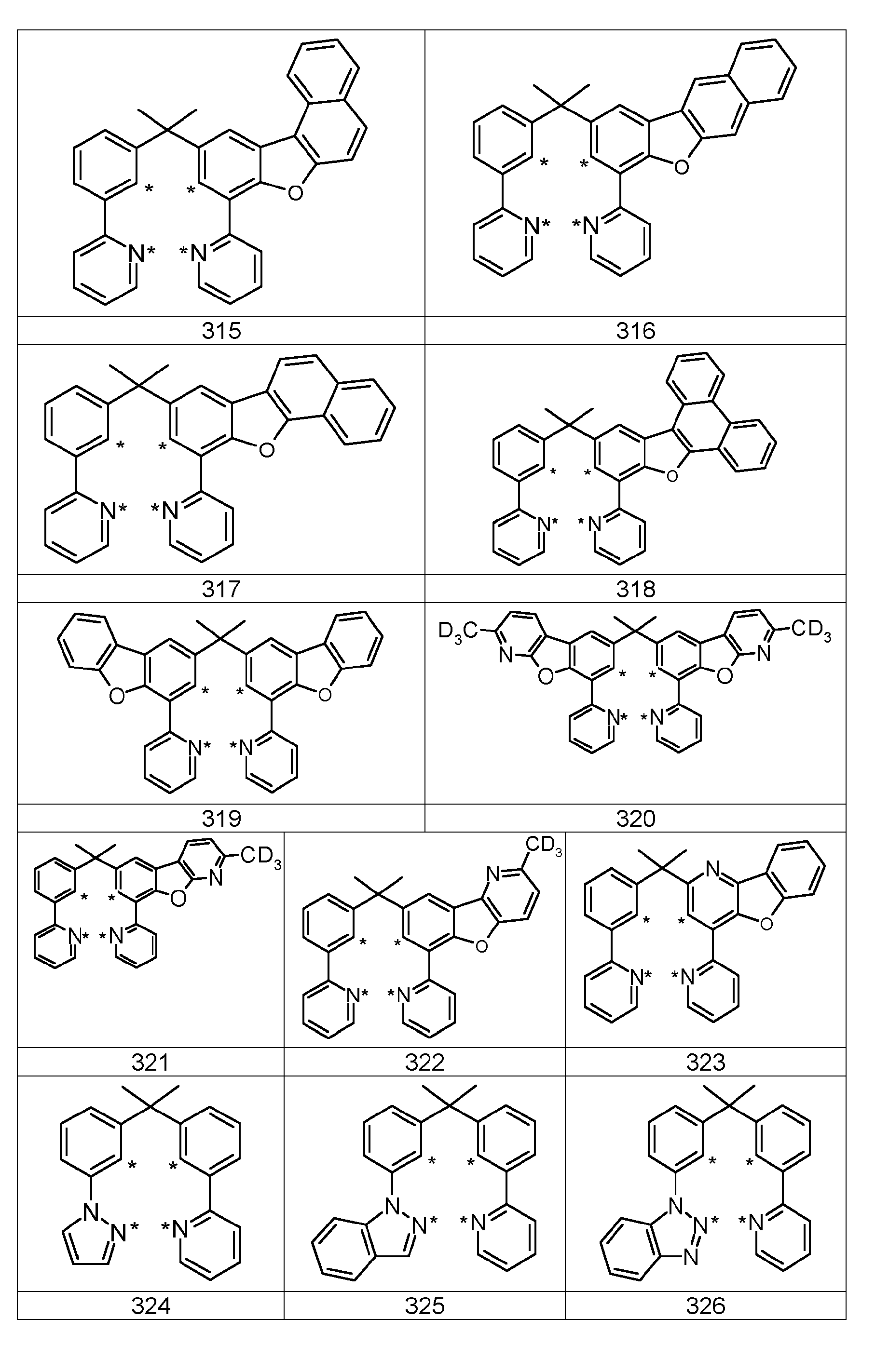

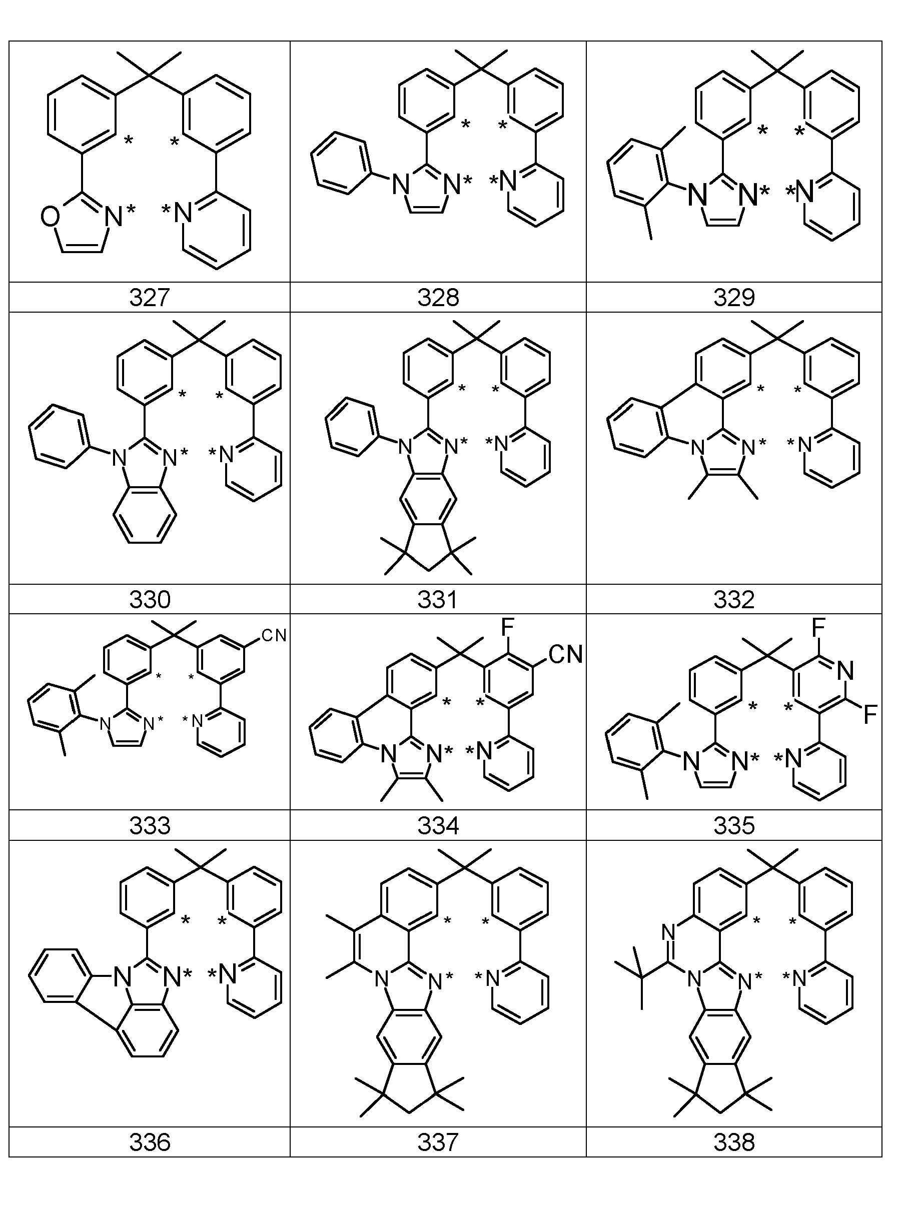

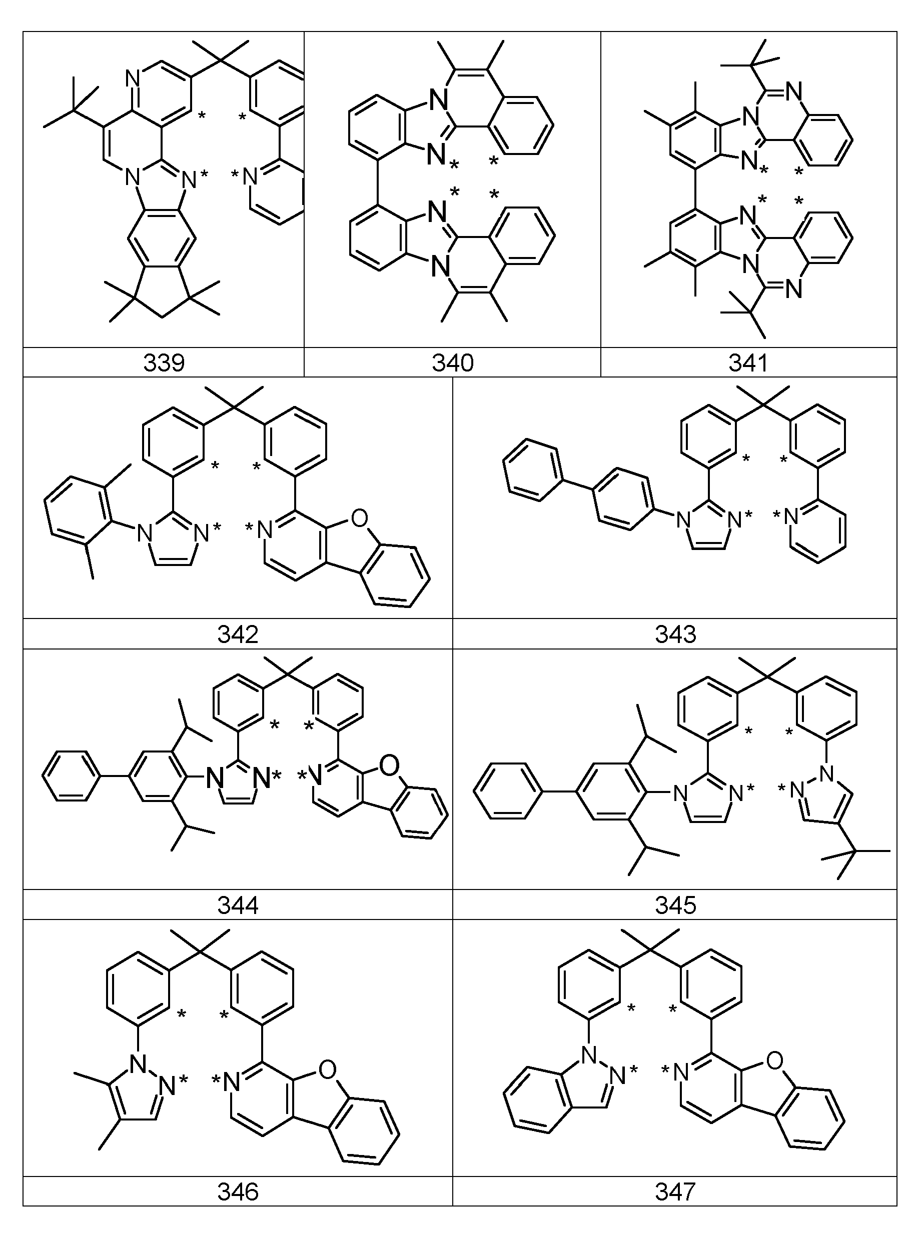

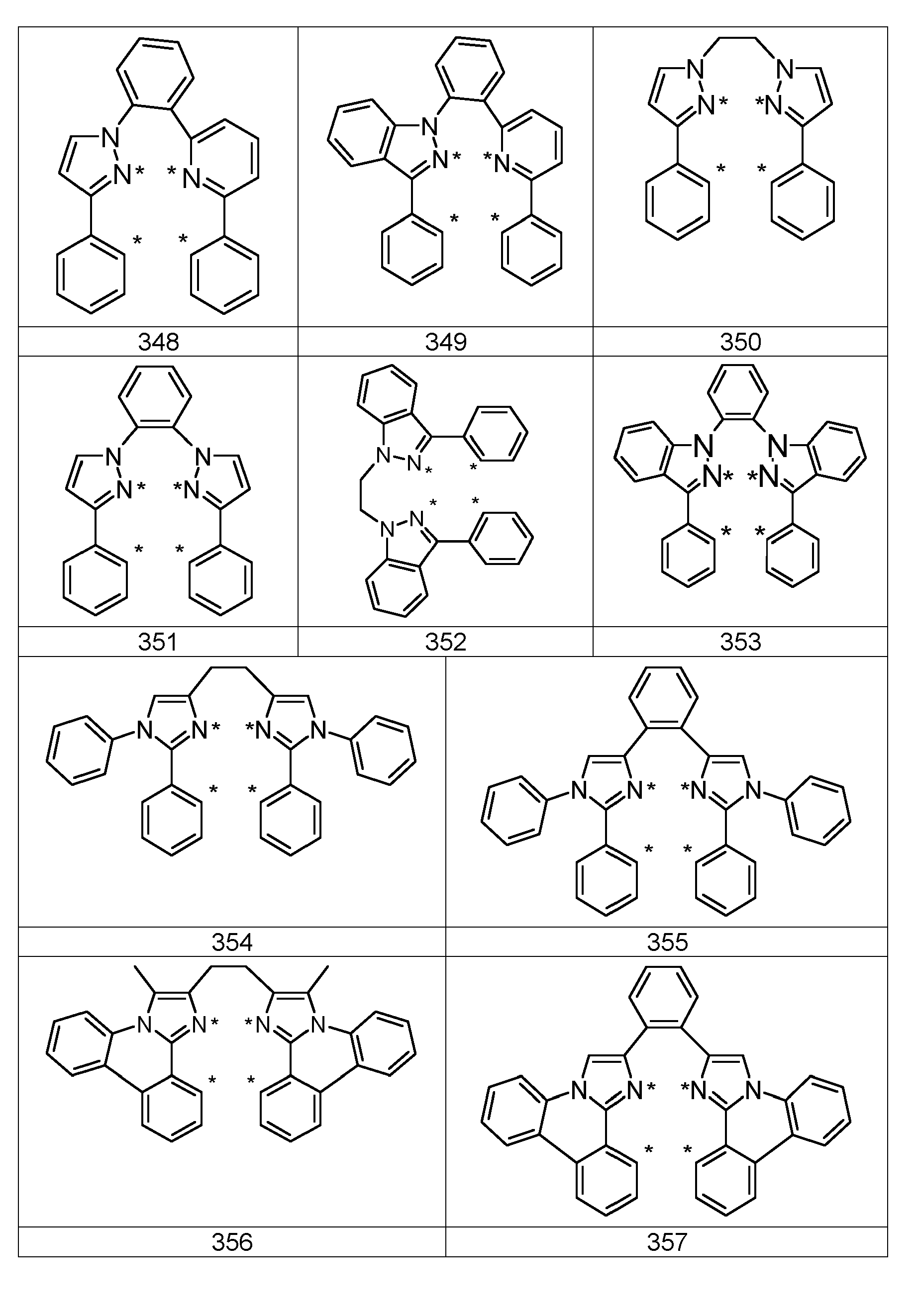

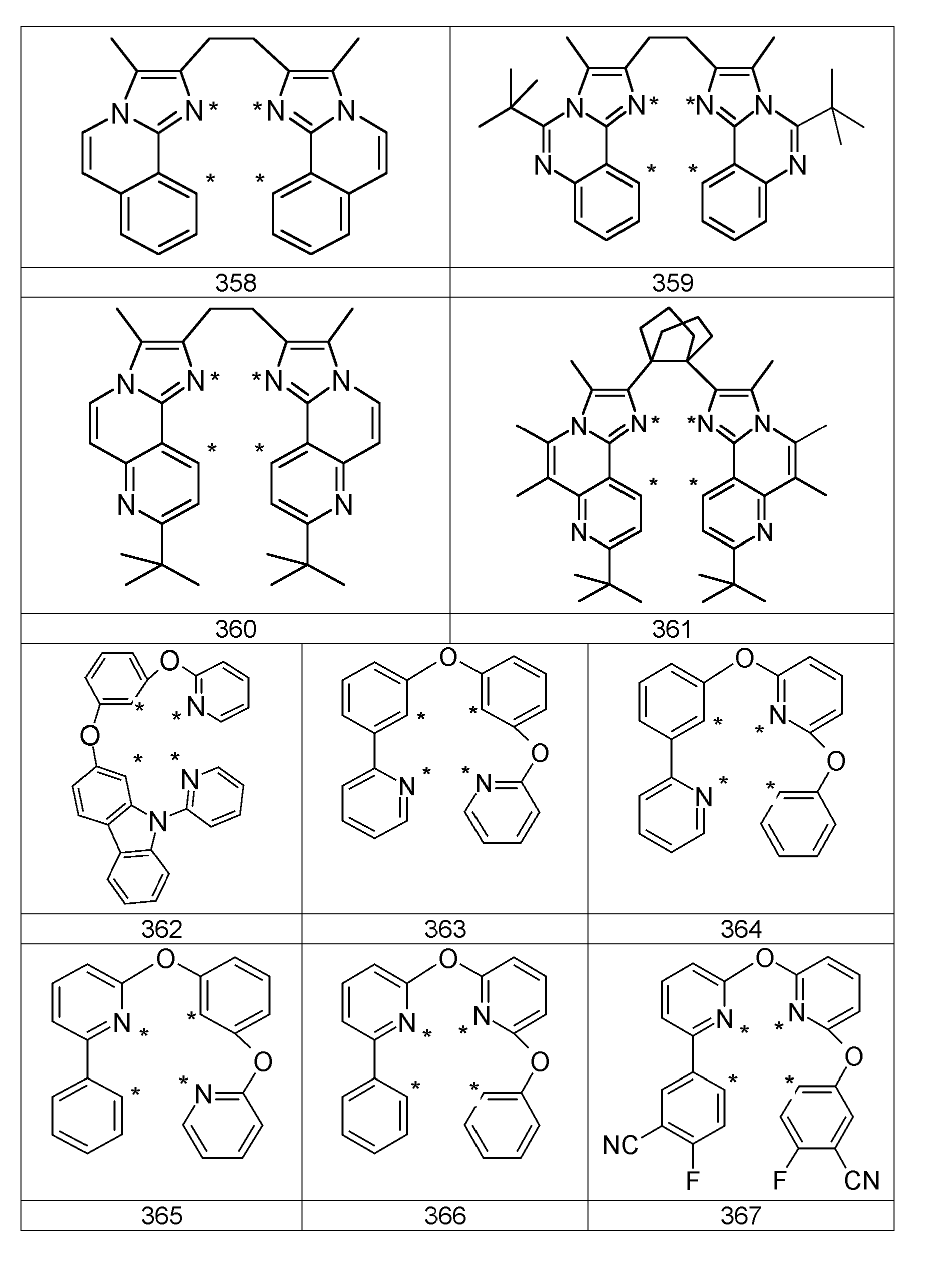

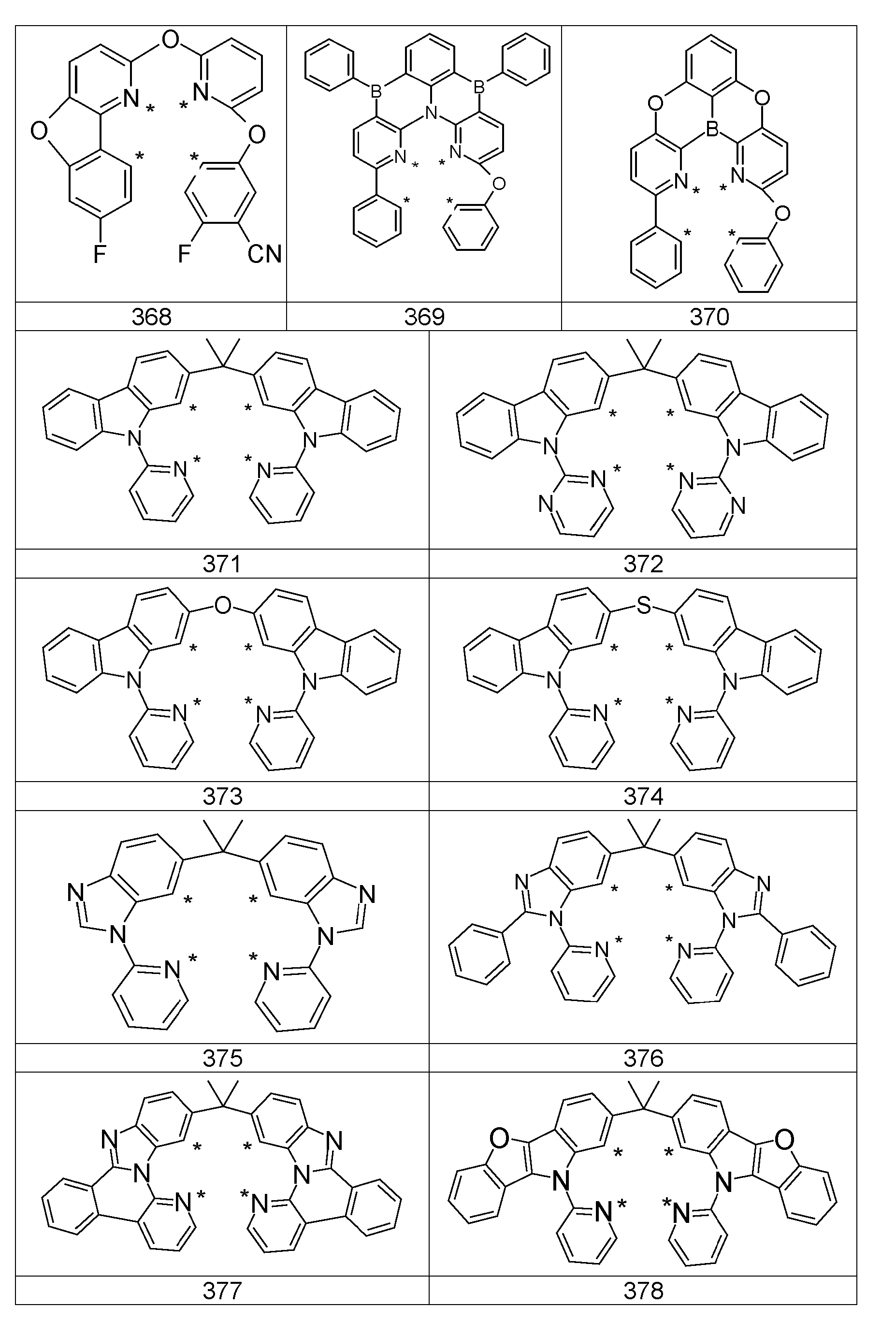

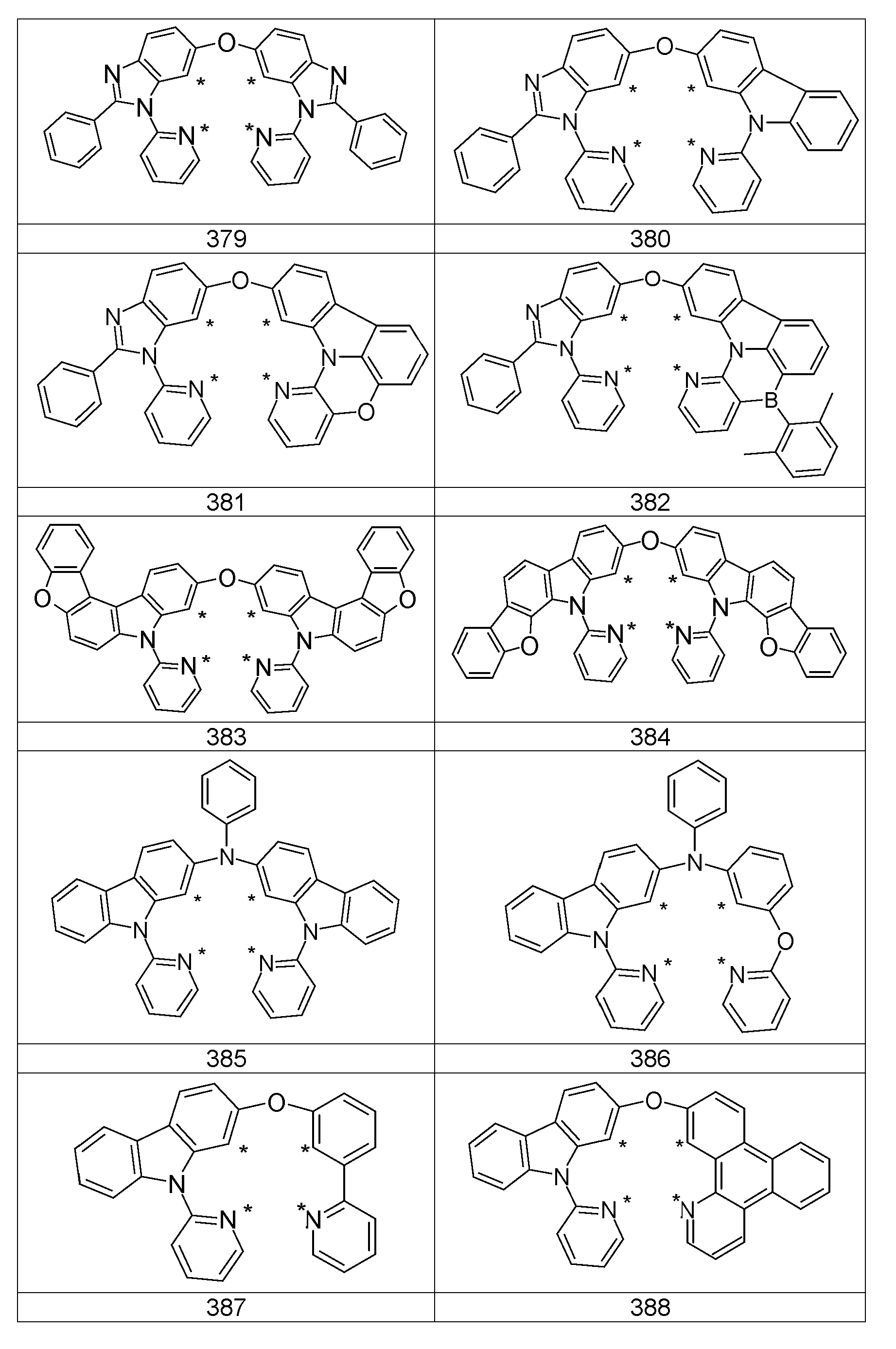

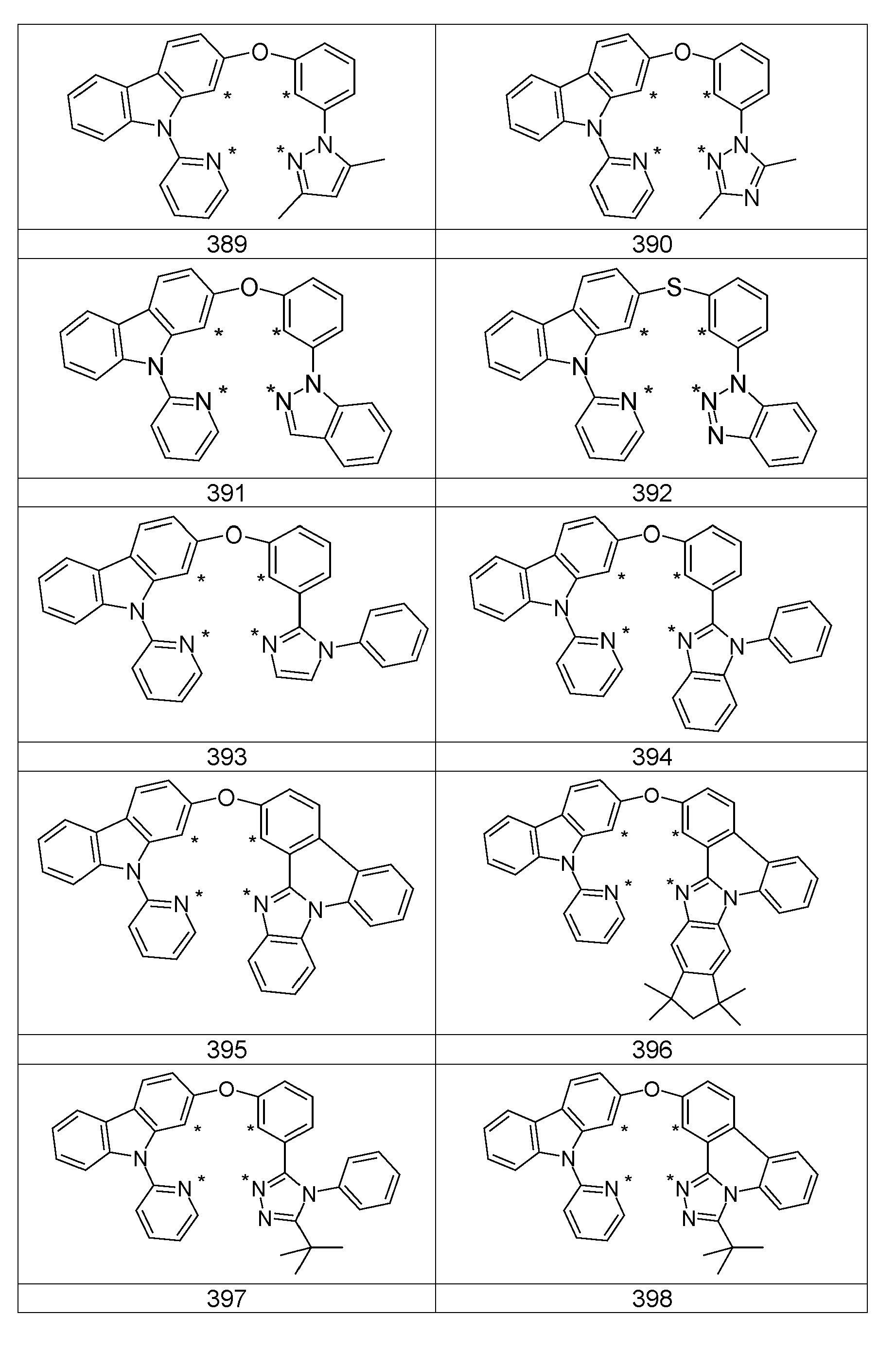

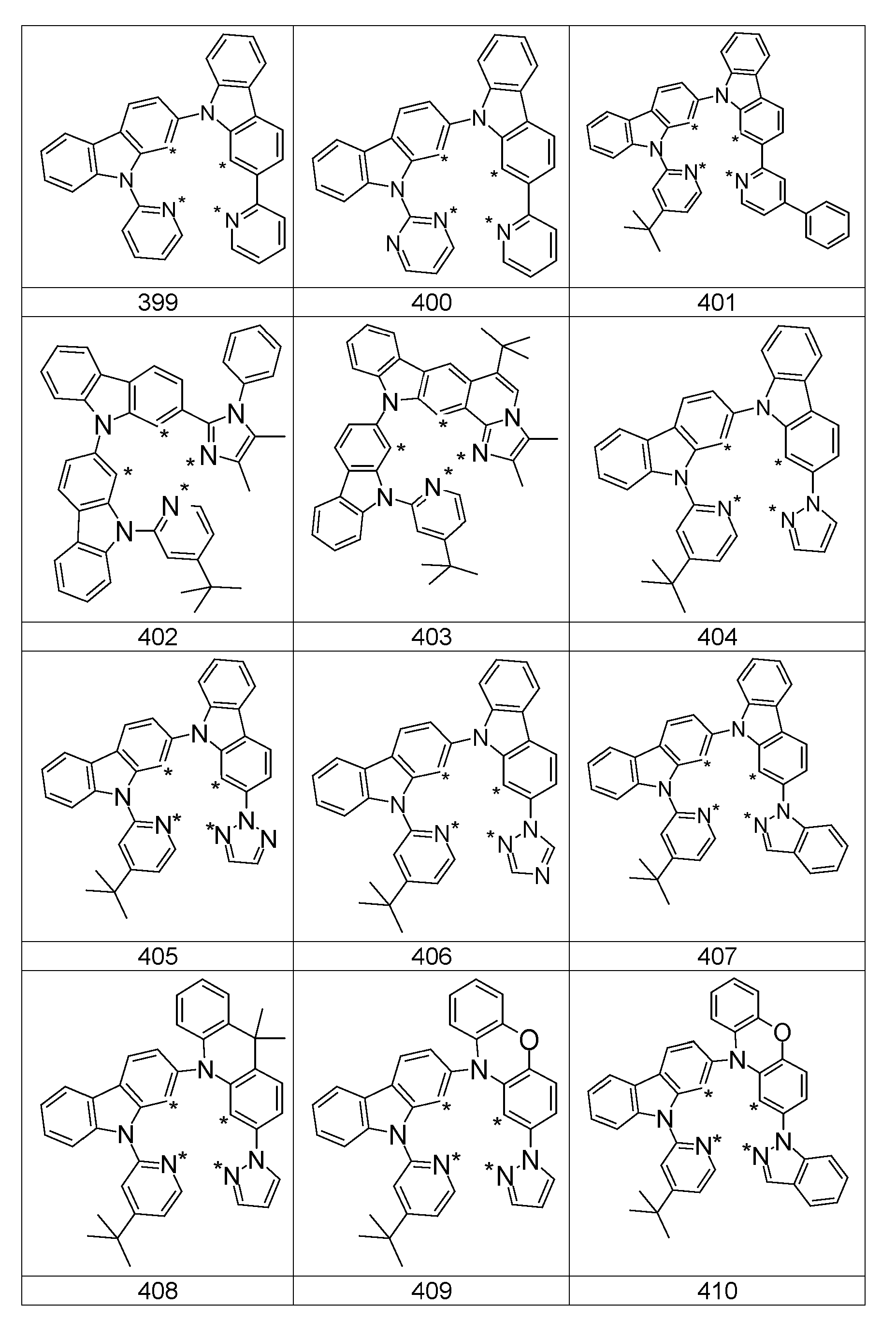

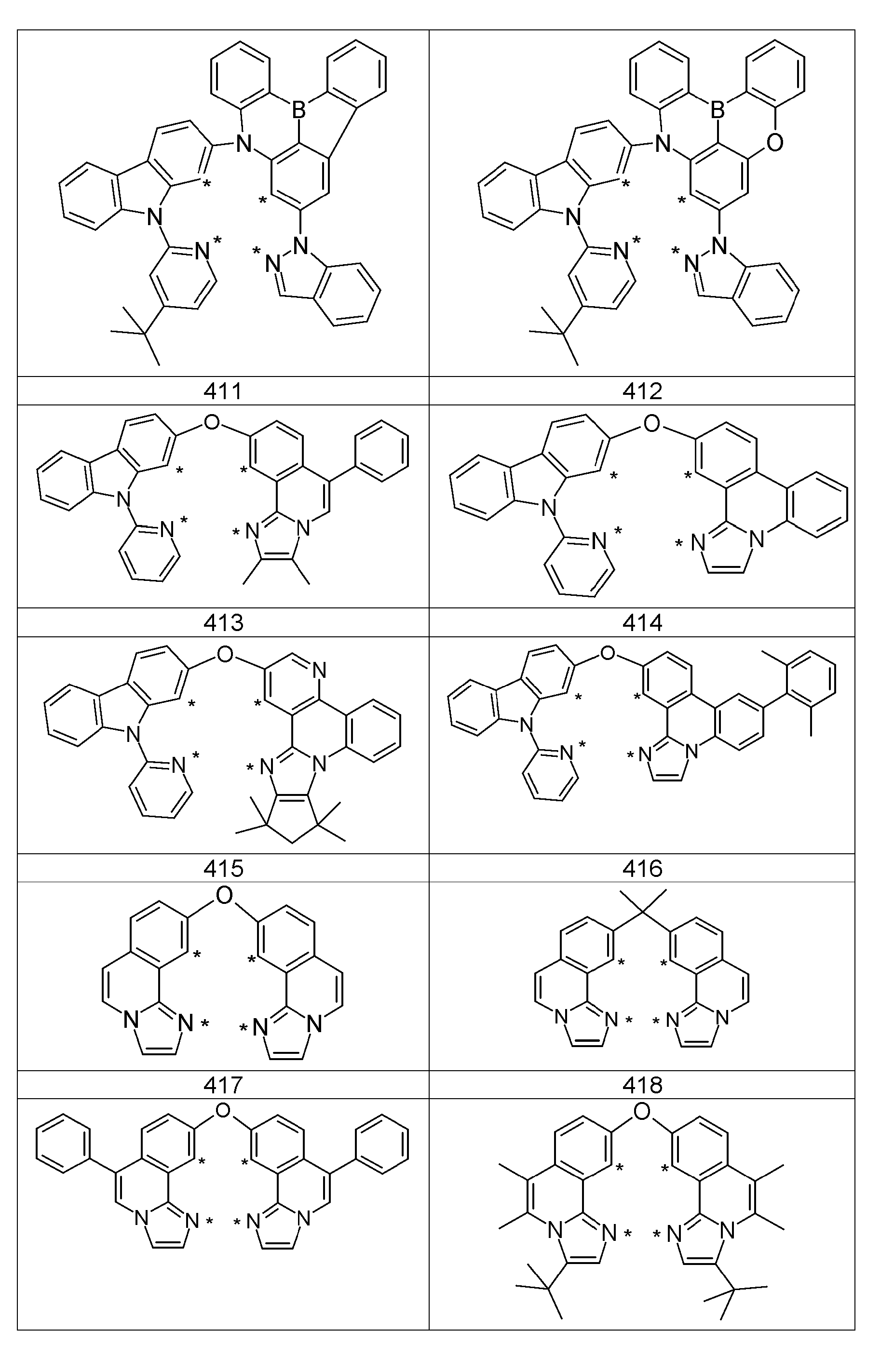

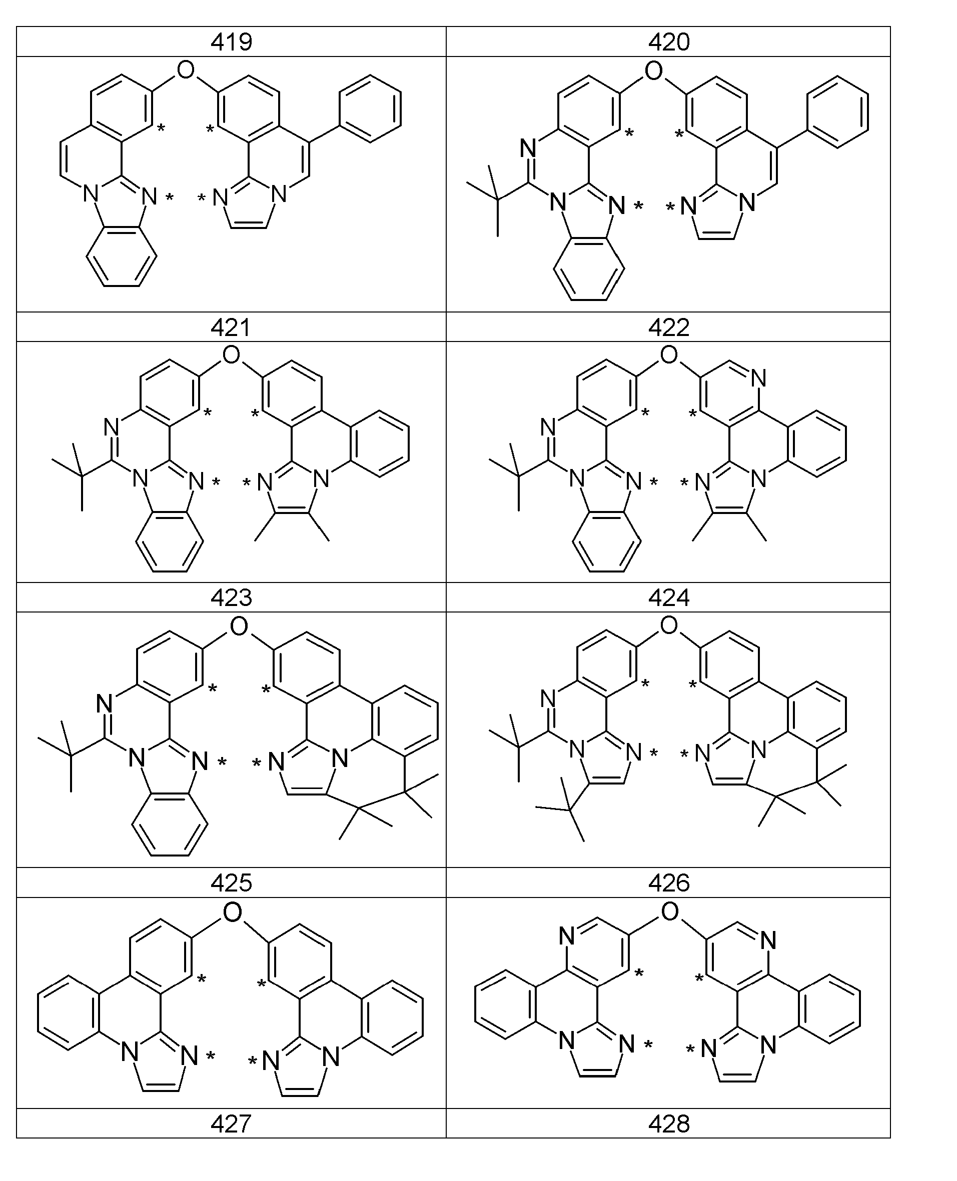

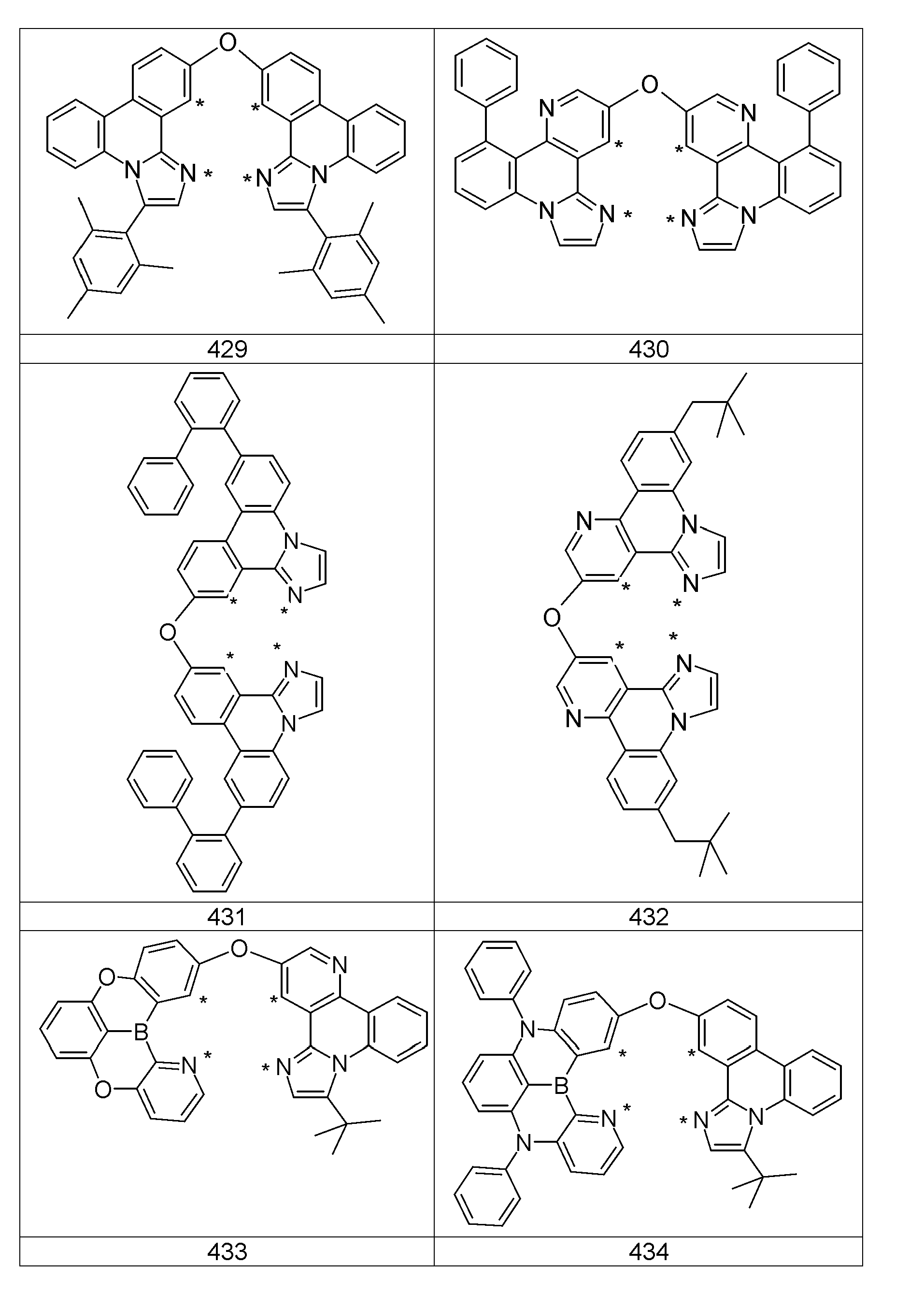

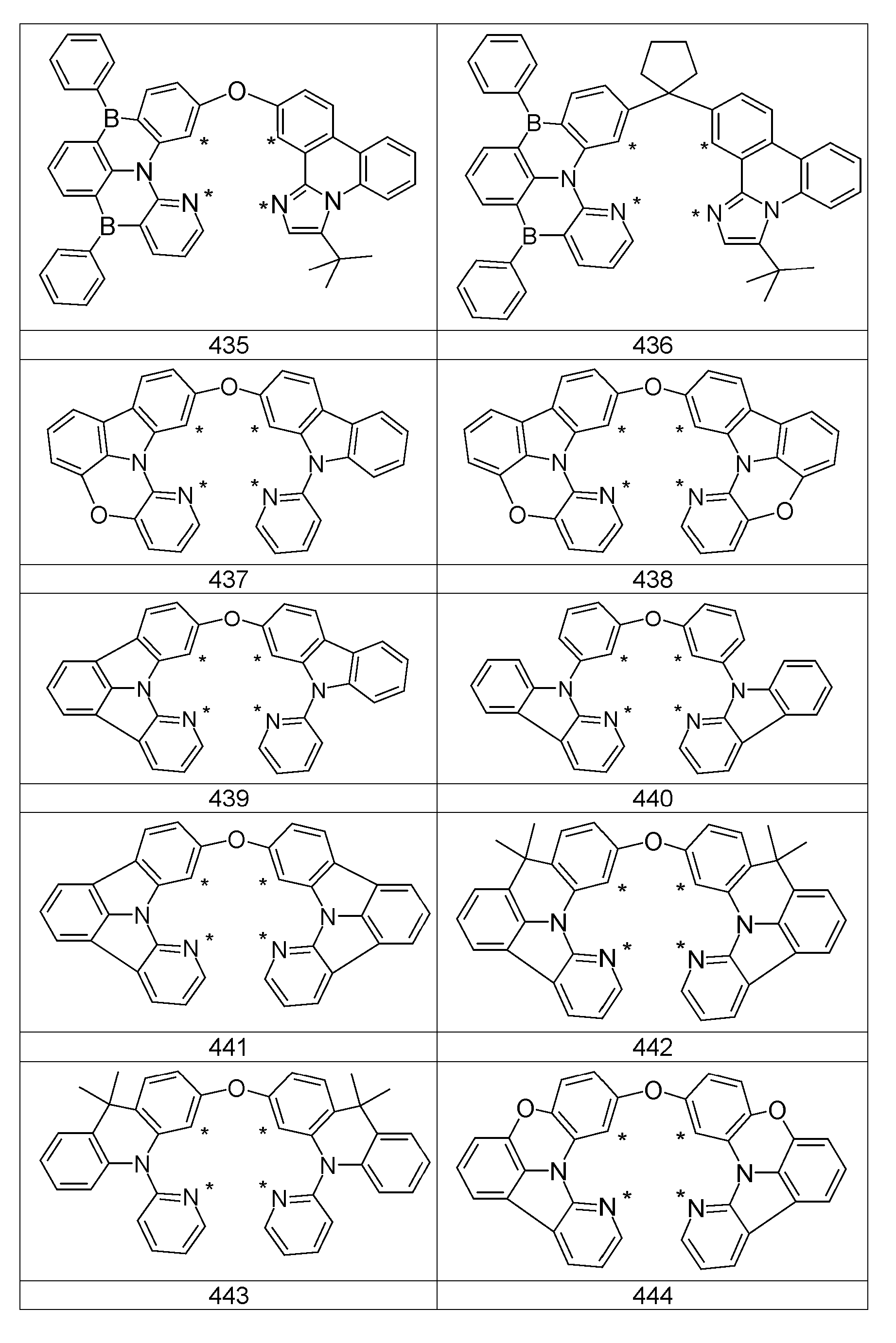

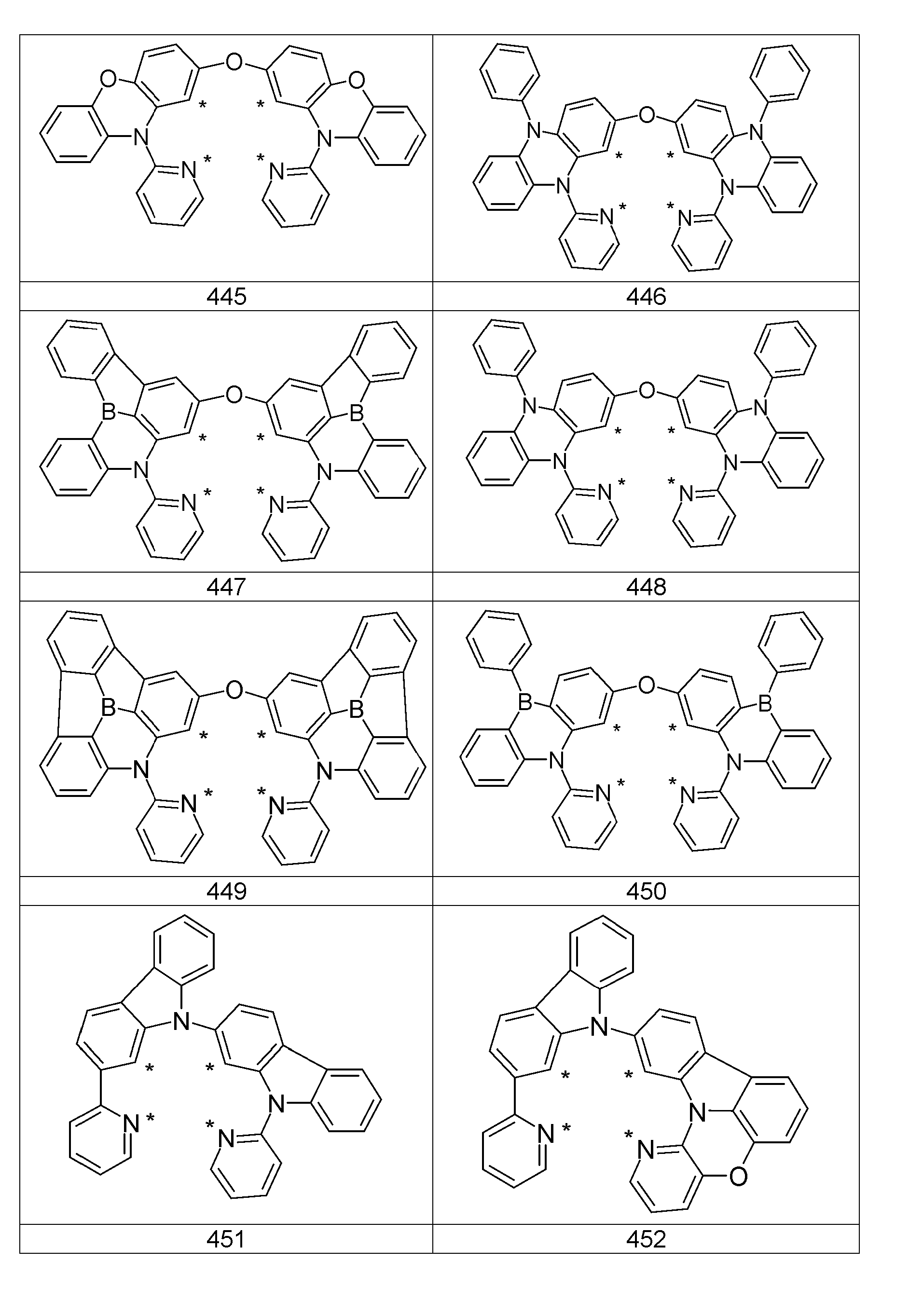

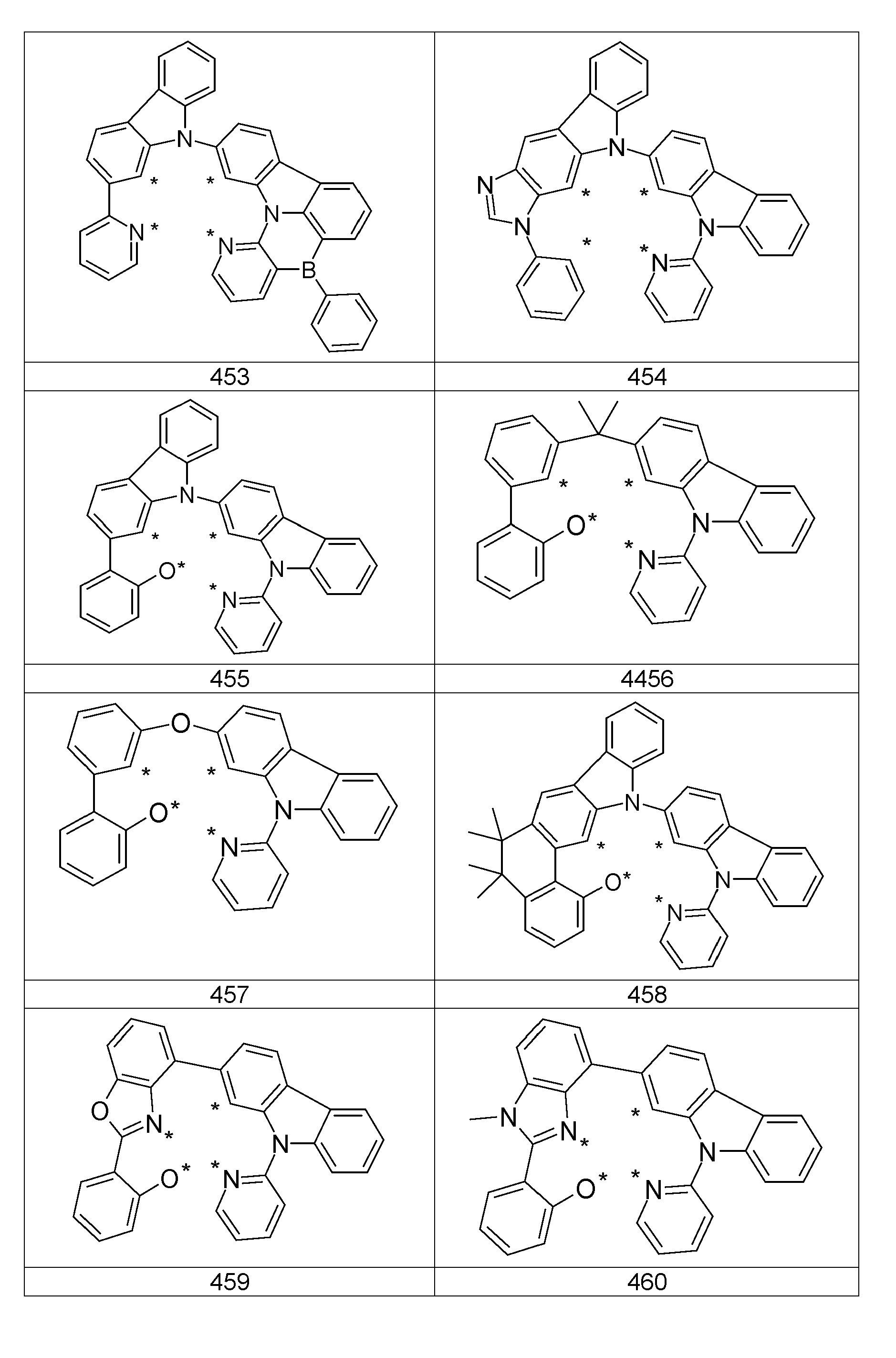

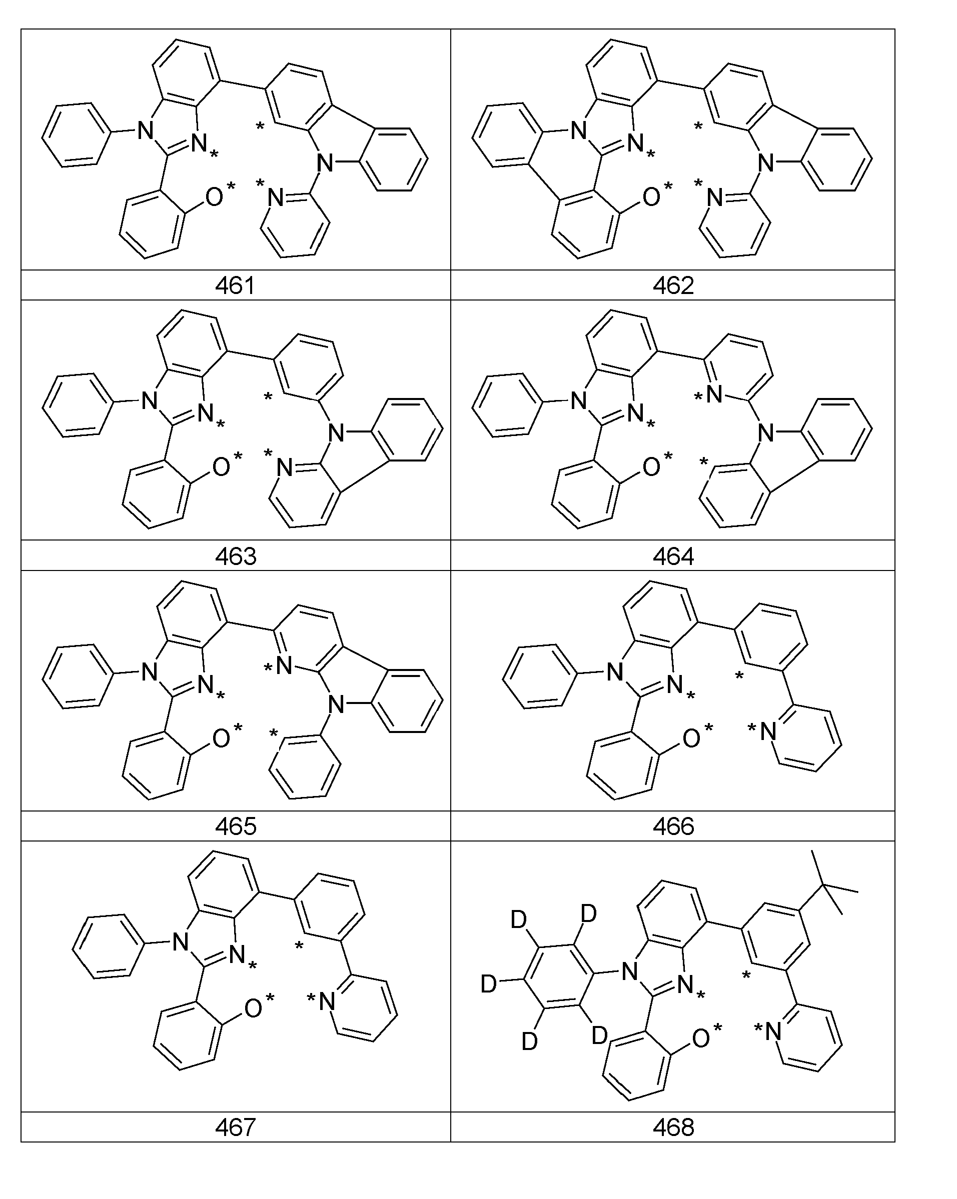

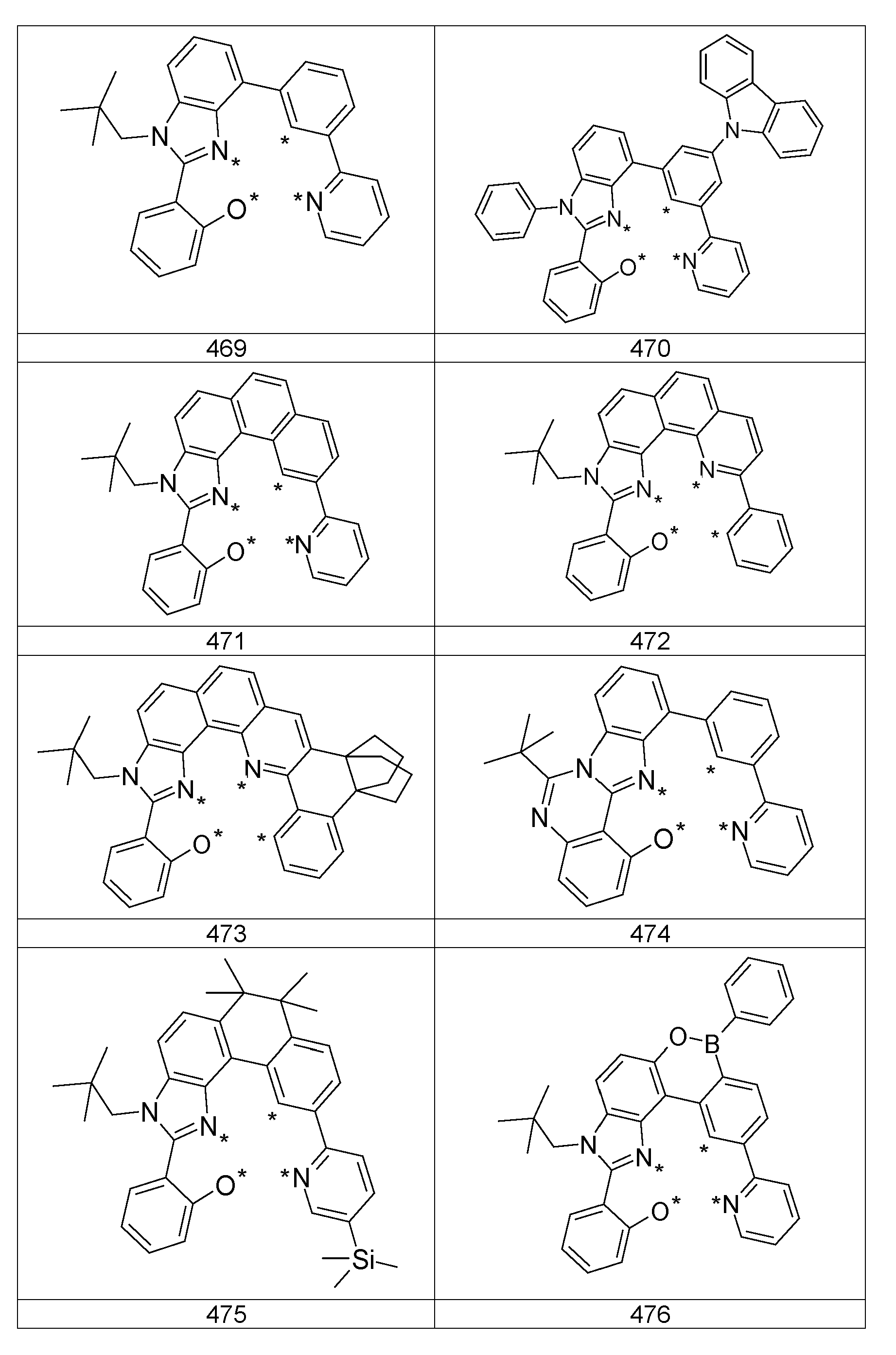

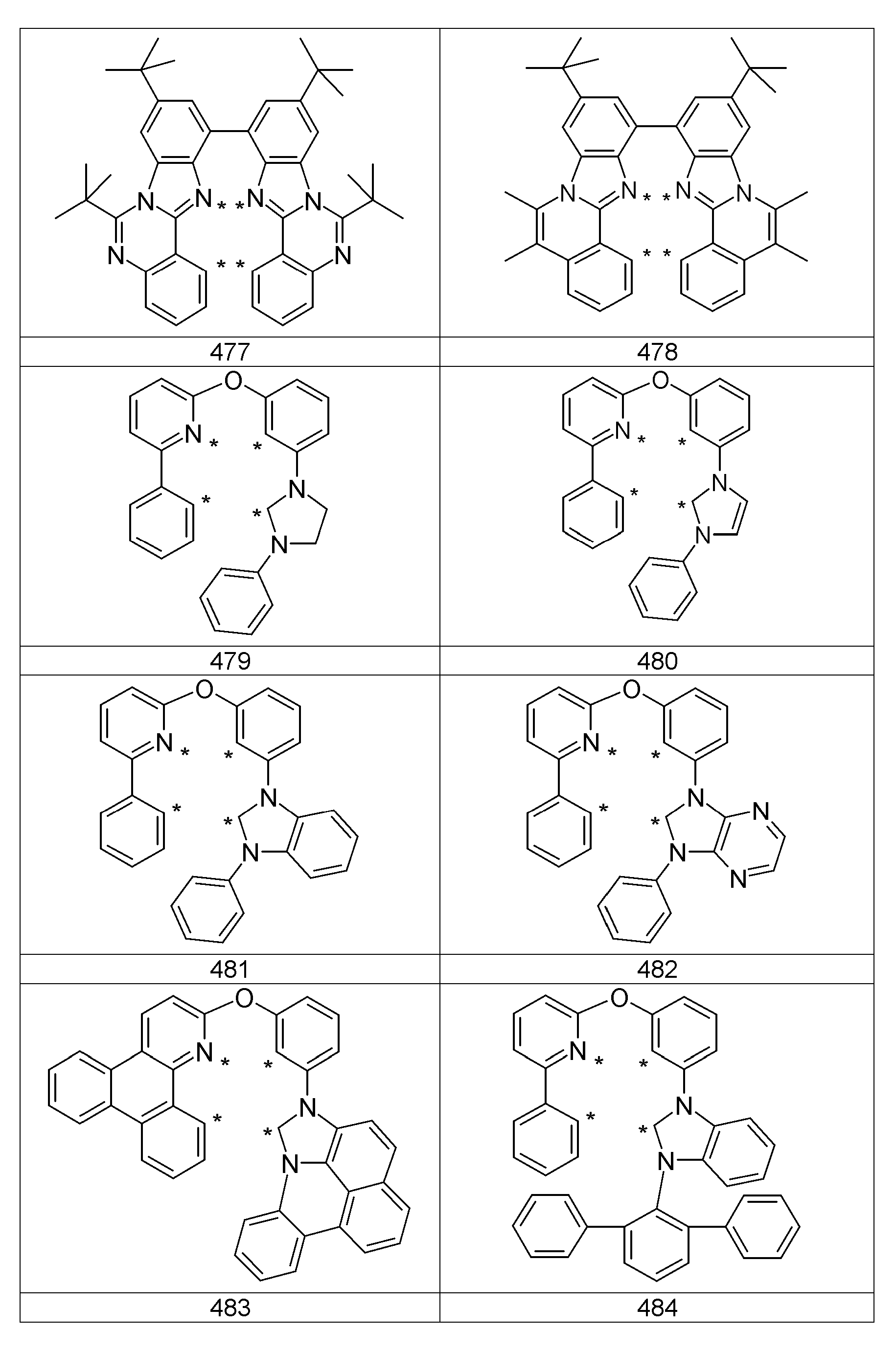

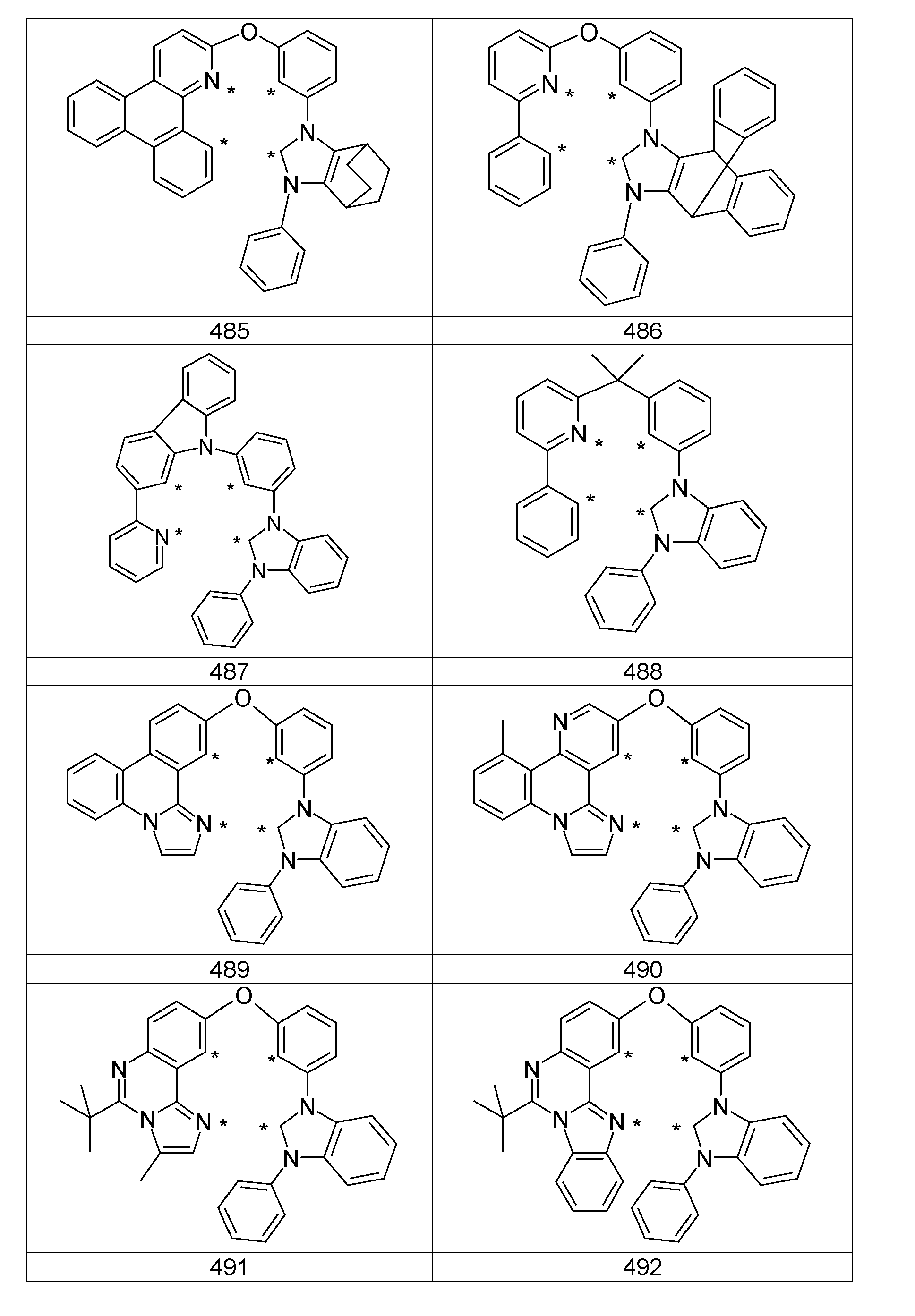

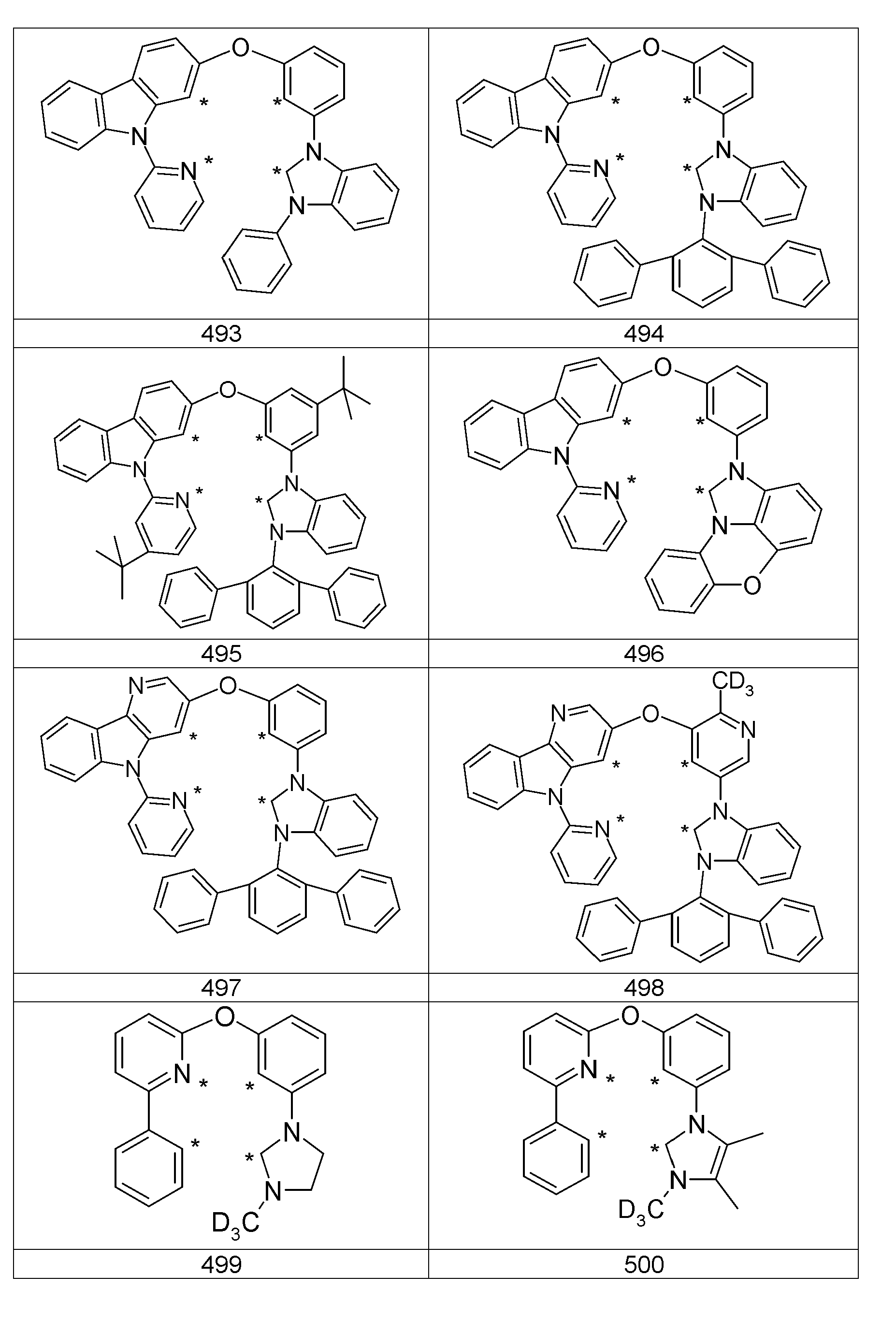

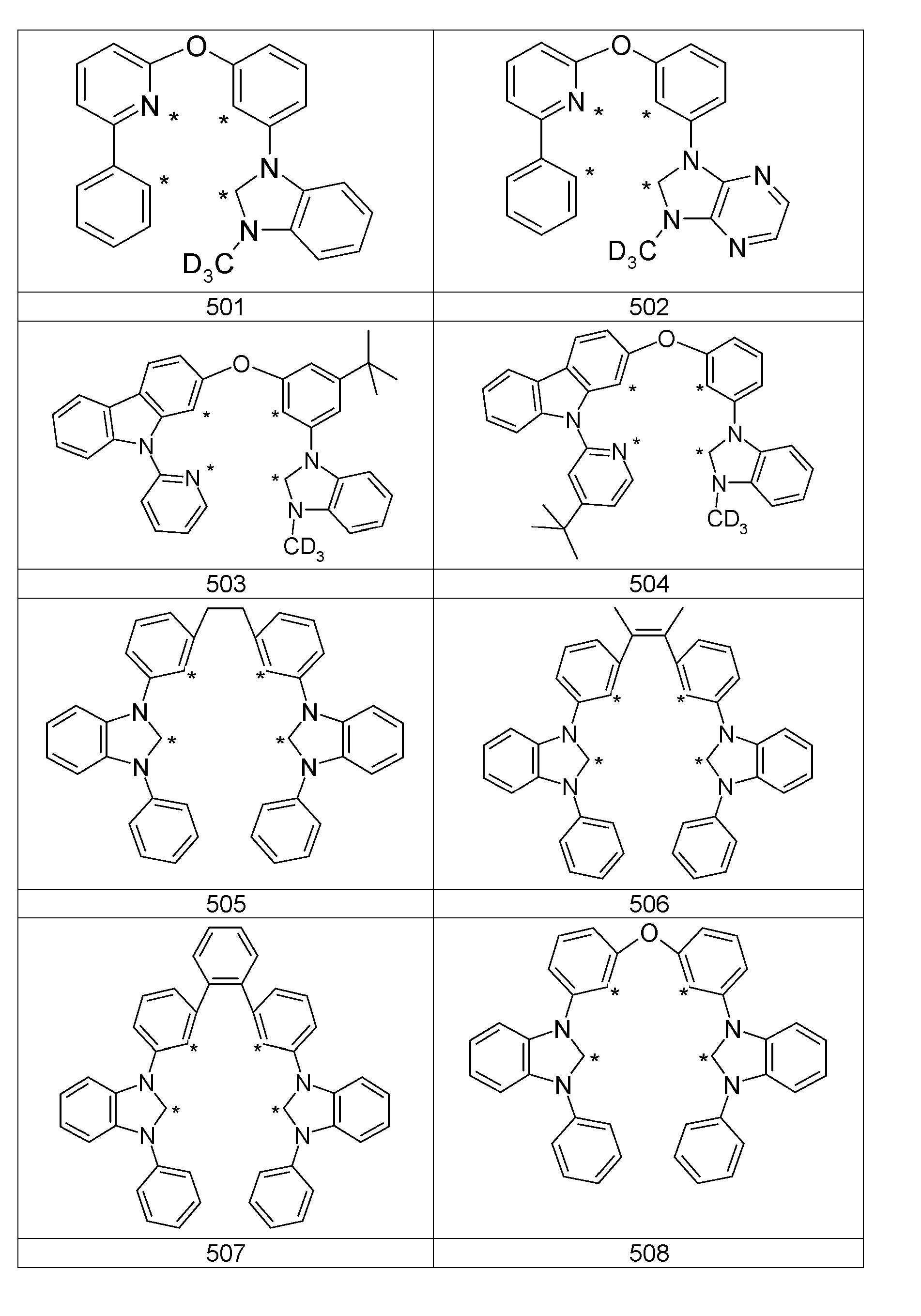

Im Folgenden wird der Isonitrilligand C=N-R* genauer ausgeführt. Wie oben beschrieben, steht R* für eine Alkylgruppe mit 1 bis 20 C-Atomen, die auch einen oder mehrere Reste R¹ substituiert sein kann, oder ein aromatisches oder heteroaromatisches Ringsystem mit 5 bis 30 aromatischen Ringatomen, das durch einen oder mehrere Reste R¹ substituiert sein kann. Dabei kann die Alkylgruppe linear, verzweigt oder cyclisch sein.

In einer bevorzugten Ausführungsgruppe steht R* für eine Alkylgruppe mit 4 bis 10 C-Atomen, in der auch ein oder mehrere H-Atome durch D oder F ersetzt sein können, oder für ein aromatisches Ringsystem mit 6 bis 12 C-Atomen, bevorzugt für eine Phenylgruppe, wobei das aromatische Ringsystem bzw. die Phenylgruppe durch einen oder mehrere Reste ausgewählt aus F, D oder einer Alkylgruppe mit 1 bis 10 C-Atomen substituiert sein kann, wobei die Alkylgruppe linear, verzweigt oder cyclisch sein kann und wobei ein oder mehrere H-Atome in der Alkylgruppe durch D oder F ersetzt sein können; dabei können mehrere Alkylgruppen, die als Substituenten an dem aromatischen Ringsystem vorliegen, auch miteinander ein Ringsystem bilden.

Wie beschrieben, kann R*, wenn es für eine Alkylgruppe steht, linear, verzweigt oder cyclisch sein. Dabei sind verzweigte und cyclische Alkylgruppen bevorzugt, wobei cyclische Alkylgruppen monocyclisch, bicyclisch oder oligocyclisch sein können und auch weitere Alkylgruppen aufweisen können, wie beispielsweise eine Methyl-substituierte Cyclohexylgruppe. Besonders bevorzugt steht R* für eine lineare Alkylgruppe mit 4 bis 8 C-Atomen, eine verzweigte Alkylgruppe mit 4 bis 8 C-Atomen, eine Cyclopentyl- oder Cyclohexylgruppe, die jeweils mit einer oder zwei Methylgruppen substituiert sein kann, oder eine bi- oder oligocyclische Alkylgruppe mit 7 bis 10 C-Atomen, wie beispielsweise Bicyclo[2.2.1]heptan, Bicyclo[2.2.2]octan oder Adamantyl, wobei in der Alkylgruppe jeweils ein oder mehrere H-Atome durch D oder F ersetzt sein können.

Beispiele für geeignete Isonitrilliganden C=N-R*, in denen R* für eine Alkylgruppe steht, sind die nachfolgend aufgeführten Strukturen:

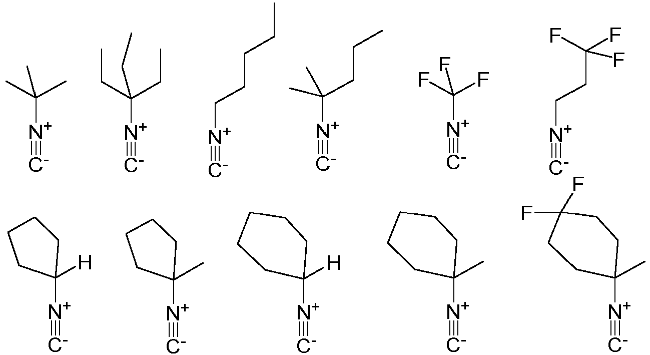

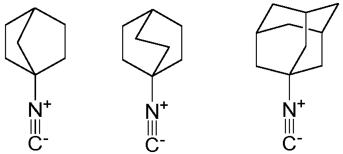

Besonders bevorzugte Ausführungsformen für R*, wenn R* für ein aromatisches Ringsystem steht, ist eine Gruppe der folgenden Formel (20), 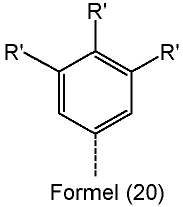 wobei die gestrichelte Bindung die Verknüpfung mit der Isonitrilgruppe andeutet und R' gleich oder verschieden für **H,** F oder eine Alkylgruppe mit 1 bis 10 C-Atomen stehen, wobei benachbarten Alkylgruppen auch miteinander ein Ringsystem bilden können. Dabei sind bevorzugt maximal zwei Gruppen R' ungleich H. Wenn die Substituenten R' für eine Alkylgruppe stehen, dann kann diese Alkylgruppe linear, verzweigt oder cyclisch sein, wobei cyclische Alkylgruppen monocyclisch, bicyclisch oder oligocyclisch sein können und auch weitere Alkylgruppen aufweisen können, wie beispielsweise eine Methyl-substituierte Cyclohexylgruppe. Besonders bevorzugt steht R', wenn es für eine Alkylgruppe steht, für eine lineare Alkylgruppe mit 1 bis 6 C-Atomen oder eine verzweigte Alkylgruppe mit 3 bis 6 C-Atomen, eine Cyclopentyl- oder Cyclohexylgruppe, die jeweils mit einer oder zwei Methylgruppen substituiert sein kann, oder eine bi- oder oligocyclische Alkylgruppe mit 7 bis 10 C-Atomen, wie beispielsweise Bicyclo[2.2.1]heptan, Bicyclo[2.2.2]octan oder Adamantyl, wobei zwei benachbarte Alkylgruppen auch miteinander ein Ringsystem bilden können. Wenn die Gruppe der Formel (20) nur einen Substituenten R' aufweist, der ungleich H ist und für eine Alkylgruppe steht, dann ist dieser besonders bevorzugt in der para-Position zur Verknüpfung der Isonitrilgruppe gebunden.

Beispiele für geeignete Isonitrilliganden C=N-R*, in denen R* für eine optional substituierte Phenylgruppe steht, sind die nachfolgend aufgeführten Strukturen:

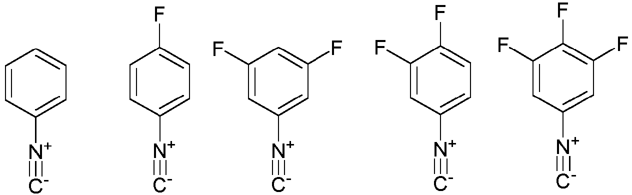

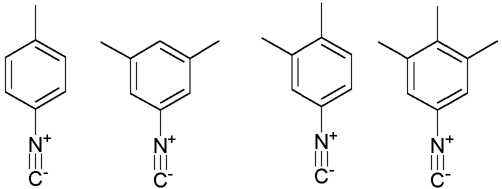

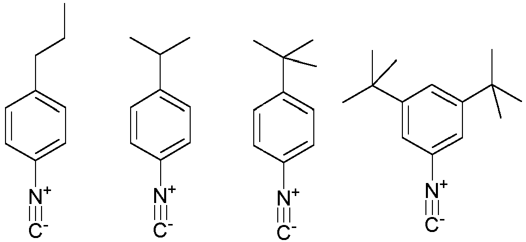

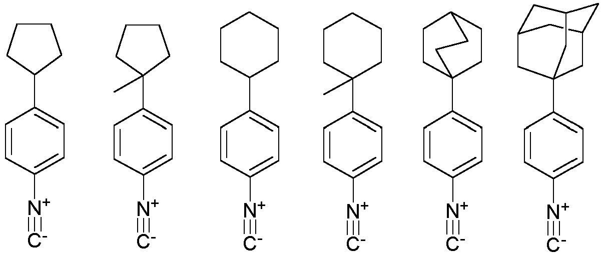

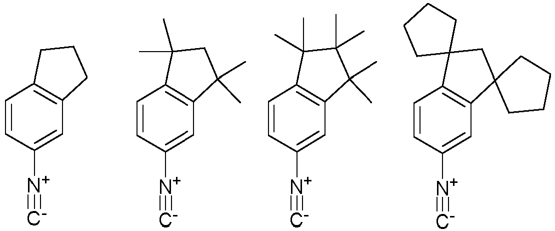

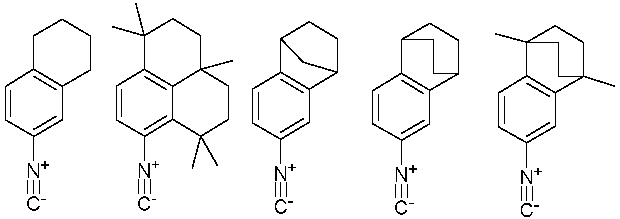

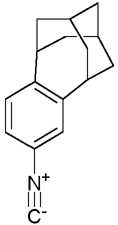

Die oben genannten bevorzugten Ausführungsformen sind beliebig miteinander kombinierbar. In einer besonders bevorzugten Ausführungsform der Erfindung gelten die oben genannten bevorzugten Ausführungsformen gleichzeitig.

Die erfindungsgemäßen Verbindungen sind prinzipiell durch verschiedene Verfahren darstellbar. Generell wird hierzu eine Iridiumverbindung in einem ersten Schritt mit dem entsprechenden freien tetradentaten Liganden umgesetzt (Schritt 1), wobei neben einem Lösungsmittel auch eine Hilfsbase, z. B. 2,6-Dimethylpyridin anwesend sein kann. Das koordinierende Kohlenmonoxid kann dabei aus der thermischen Zersetzung des Lösungsmittels (z. B. Ethylenglykol, DMF) stammen oder der Reaktionsmischung zugesetzt werden. Das so erhaltene Intermediat (Chloro-Carbonyl-Komplex) wird dann einem konsekutiven Austausch der einzähnigen Liganden, entsprechend der Ir-Ligand-Bindungsstärke, unterworfen (Schritte 2 und 3). Dies ist nachfolgend am Beispiel eines einfachen tetradentaten Liganden dargestellt.

### Schritt 1:

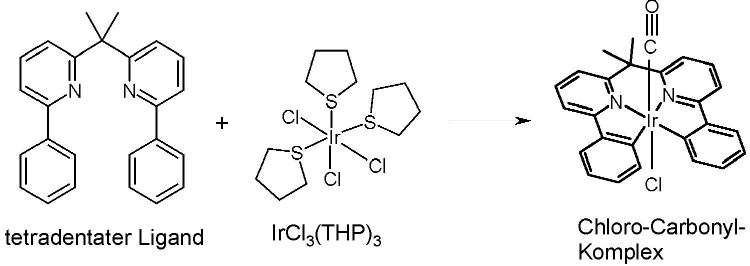

### Schritt 2: Austausch von Chlorid Cl⁻ gegen Cyanid CN⁻

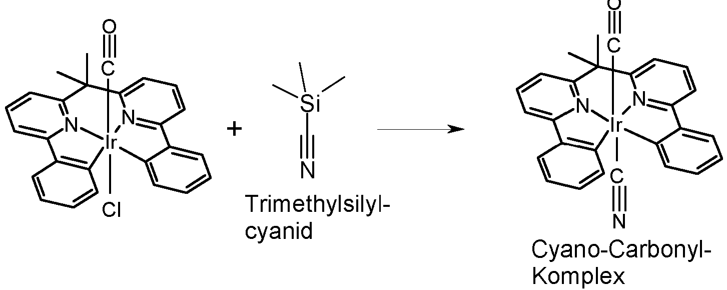

### Schritt 3: Austausch von Kohlenmonoxid CO gegen iso-Nitril R-NC

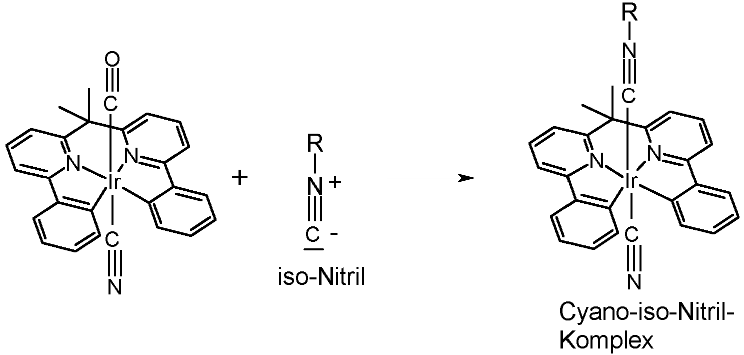

Daher ist ein weiterer Gegenstand der vorliegenden Erfindung ein Verfahren zur Herstellung der erfindungsgemäßen Verbindungen durch Umsetzung der entsprechenden freien tetradentaten Liganden mit Iridiumalkoholaten der Formel (21), mit Iridiumketoketonaten der Formel (22), mit Iridiumhalogeniden der Formel (23), mit Iridiumcarboxylaten der Formel (24), Iridium-Olefin-Cyclopentadienyl-Komplexen der Formel (25) oder mit Iridium-Olefin-Indenyl-Komplexen der Formel (26), 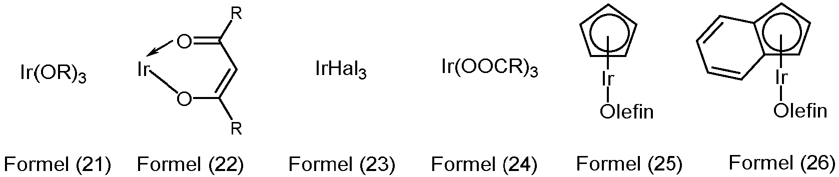 und anschließende Umsetzung des so erhaltenen Intermediats mit dem bzw. den Liganden L⁴. Dabei hat R die oben angegebenen Bedeutungen, Hal = F, Cl, Br oder I und die Iridiumedukte können auch als die entsprechenden Hydrate vorliegen, bzw. es können weitere schwach koordinierende Liganden, wie z. B. Tetrahydrothiophen (THP) an das Iridiumhalogenid koordiniert sein. R steht bevorzugt für eine Alkylgruppe mit 1 bis 4 C-Atomen. Olefin in Formel (25) und (26) steht für ein Diolefin, typischerweise für 1,5-Cyclooctadien, aber auch andere Diolefine wie Cyclohexadien oder Norbornadien.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl₃·xH₂O, wobei x üblicherweise für eine Zahl zwischen 2 und 4 steht.

Die Synthese der Komplexe kann thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu ortho-metallierenden Liganden durchgeführt werden. Gegebenenfalls können auch Lösemittel oder Schmelzhilfen zugesetzt werden. Geeignete Lösemittel sind protische oder aprotische Lösemittel, wie aliphatische und/oder aromatische Alkohole (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, Isochinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Raumtemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3- oder 1,4-Bisphenoxybenzol, Triphenylphosphinoxid, 18-Krone-6, Phenol, 1-Naphthol, Hydrochinon, Brenzcatechin, Resorcin, etc.. Dabei ist die Verwendung von Hydrochinon besonders bevorzugt.

Weiterhin kann die Synthese bevorzugt in wasserfreiem Medium in Anwesenheit einer Carbonsäure durchgeführt werden, wie in WO 2021/013775 beschrieben, wobei als Iridiumedukt bevorzugt ein Iridiumhalogenid, ein Iridiumcarboxylat, eine COD-Iridium(I)-Verbindung, ein Iridium-ketoketonat oder eine Verbindung gemäß einer der oben genannten Formeln (21) bis (26) verwendet wird. Besonders geeignete Carbonsäuren sind gewählt aus der Gruppe bestehend aus Essigsäure, Propionsäure, Pivalinsäure, Benzoesäure, Phenylessigsäure, Adipinsäure oder deren Gemischen. Bei Verwendung eines Hydrats als Iridiumedukt wird bevorzugt ein Wasserfänger zugesetzt, insbesondere ein Carbonsäureanhydrid, ein Carbonsäurehalogenid, ein Trialkyl-ortho-carboxylat, ein Carbodiimid, Phosphorpentoxid, Thionylchlorid oder Phosphorylchlorid. Bei Verwendung eines Halogenids als Iridiumedukt wird bevorzugt ein Halogenidfänger zugesetzt wird, insbesondere ein Alkali-, Erdalkali-, Ammonium- oder Zinksalz einer Carbonsäure.

Dabei können je nach Struktur der Liganden auch chirale Verbindungen entstehen. Dabei sind jeweils sowohl die einzelnen Enantiomere und Diastereomere, wie auch die Racemate Gegenstand der Erfindung.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, oder gegebenenfalls substituierte Arylgruppen, beispielsweise Xylyl-, Mesityl- oder verzweigte Terphenyl- oder Quaterphenylgruppen, löslich gemacht werden. Insbesondere auch die Verwendung von ankondensierten aliphatischen Gruppen, wie sie beispielsweise durch die oben offenbarten Formeln (13) bis (19) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Für die Verarbeitung der erfindungsgemäßen Iridiumkomplexe aus flüssiger Phase, beispielsweise durch Spin-Coating oder durch Druckverfahren, sind Formulierungen der erfindungsgemäßen Iridiumkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, **THF,** Methyl-THF, **THP,** Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäße Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial und/oder ein weiterer Emitter, der fluoreszierend oder phosphoreszierend sein kann.

Die erfindungsgemäße Verbindung kann in einer elektronischen Vorrichtung als aktive Komponente, bevorzugt als Emitter in der emissiven Schicht, als Sensitizer in der emissiven Schicht oder als Loch- oder Elektronentransportmaterial in einer loch- bzw. elektronentransportierenden Schicht, oder als Sauerstoff-Sensibilisatoren oder als Photoinitiator oder Photokatalysator verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator oder als Photoinitiator oder Photokatalysator.

Ein Sensitizer im Sinne der vorliegenden Erfindung ist eine Verbindung, die durch elektrische Anregung in der OLED die Singulett- und Triplettexzitonen sammelt und diese dann als Donor strahlungslos, üblicherweise durch einen Förster-Transfer, auf einen fluoreszierenden Emitter als Akzeptor überträgt, welcher unter Emission von Licht in den Grundzustand relaxiert.

Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Iridiumkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens eine erfindungsgemäße Verbindung. Verbindungen, die im Infraroten emittieren, eignen sich für den Einsatz in organischen Infrarot-Elektrolumineszenzvorrichtungen und Infrorot-Sensoren. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃, oder mit (per)fluorierten elektronenarmen Aromaten oder mit elektronenarmen Cyano-substituieren Heteroaromaten (z. B. gemäß JP 4747558, JP 2006-135145, US 2006/0289882, WO 2012/095143), oder mit chinoiden Systemen (z. B. gemäß EP1336208) oder mit LewisSäuren, oder mit Boranen (z. B. gemäß US 2003/0006411, WO 2002/051850, WO 2015/049030) oder mit Carboxylaten der Elemente der 3. , 4. oder 5. Hauptgruppe (WO 2015/018539) und/oder dass eine oder mehrere Elektronentransportschichten n-dotiert sind.

Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern und/oder Ladungen erzeugen (Charge-Generation-Layer, z. B. in Schichtsystemen mit mehreren emittierenden Schichten, z. B. in weiß emittierenden OLED-Bauteilen) . Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren.

**In** einer bevorzugten Ausführungsform der Erfindung enthält die organische Elektrolumineszenzvorrichtung den erfindungsgemäßen Iridiumkomplex in einer oder mehreren emittierenden Schichten. Dabei sind verschiedene Anwendungsformen möglich, insbesondere als Sensitizer für einen fluoreszierenden Emitter oder als phosphoreszierender Emitter.

Wenn die erfindungsgemäße Verbindung in einer emittierenden Schicht als Sensitizer in Kombination mit einem fluoreszierenden Emitter in einer hyperphosphoreszenten OLED eingesetzt wird, enthält die OLED außer dem Iridiumkomplex noch einen fluoreszierenden Emitter. Dabei ist es erforderlich, dass das Photolumineszenzspektrum des Sensitizers mit dem Absorptionsspektrum des fluoreszierenden Emitters überlappt. Weiterhin werden üblicherweise ein oder mehrere Hostmaterialien (Matrixmaterialien) eingesetzt.

In einer bevorzugten Ausführungsform der Erfindung liegt bei Herstellung der emittierenden Schicht durch Aufdampfen die erfindungsgemäße Verbindung in einer Konzentration von 1 bis 50 Vol.-% in der emittierenden Schicht vor, bevorzugt von 2 bis 40 Vol.-%, besonders bevorzugt von 3 bis 30 Vol.-%, ganz besonders bevorzugt 4 bis 25 Vol.-%, wobei sich die angegebenen Volumen-% (Vol.-%) auf das Gesamtvolumen der emittierenden Schicht beziehen.

Wird die OLED aus Lösung hergestellt, sind die entsprechenden Anteile wie oben beschrieben bevorzugt, wobei es sich dann im Gew.-% statt Vol.-% handelt.

Der fluoreszierende Emitter, der in Kombination mit der erfindungsgemäßen Verbindung in hyperphosphoreszenten OLEDs eingesetzt wird, kann grundsätzlich jede fluoreszierende Verbindung sein. Der Fachmann hat keine Schwierigkeiten, ohne großen Aufwand aus einer Vielzahl fluoreszierender Emitter die geeigneten Emitter auszuwählen.

Die fluoreszierenden Emitter sind vorzugsweise rein organische, metallfreie Verbindungen oder fluoreszierende Metallkomplexe. Bevorzugt sind rein organische fluoreszierende Emitter, wobei diese bevorzugt sterisch abgeschirmt sind.

Eine fluoreszierende Verbindung im Sinne der vorliegenden Erfindung ist eine Verbindung, die in der Lage ist, unter optischer Anregung in einer Umgebung, wie sie in der organischen Elektrolumineszenzvorrichtung vorliegt, bei Raumtemperatur Licht zu emittieren, wobei die Emission aus einem angeregten Singulettzustand erfolgt. Dabei weist die Verbindung bevorzugt eine Lumineszenzquanteneffizienz von mindestens 60 % auf, besonders bevorzugt von mindestens 80 %, ganz besonders bevorzugt von mindestens 90 % und insbesondere bevorzugt von mindestens 95 %. In einer bevorzugten Ausführungsform liegt die Peakemissionswellenlänge zwischen 430 und 650 nm.

In einer bevorzugten Ausführungsform der Erfindung liegt bei Herstellung der emittierenden Schicht durch Aufdampfen die fluoreszierende Verbindung in einer Dotierkonzentration von 0.1 bis 25 Vol.-% in der emittierenden Schicht vor, bevorzugt von 1 bis 20 Vol.-%, besonders bevorzugt von 3 bis 10 Vol.-%, und bei Herstellung der Schicht aus Lösung in einer Dotierkonzentration von 0.1 bis 25 Gew.-%, bevorzugt von 1 bis 20 Gew.-%, besonders bevorzugt von 3 bis 10 Gew.-%.

Als Grundgerüste für die fluoreszierende Verbindung können alle Verbindungen verwendet werden, wie sie gemäß dem Stand der Technik für fluoreszierende OLEDs eingesetzt werden.

Der fluoreszierende Emitter wird vorzugsweise ausgewählt aus den folgenden Gruppe der fluoreszierenden Verbindungen: Styrylamine, Indenofluorene, ppolyaromatische Verbindungen, Anthracene, Tetracene, Xanthene, Perylene, Phenylene, Fluorene, Arylpyrene, Arylenevinylene, Rubrene, Coumarine, Rhodamine, Chinacridone, Dicyanomethylenpyrane, Thiopyrane, Polymethine, Pyrylium und Thiapyrylium Salze, Periflanthene, Indenoperylene, Bis(azinyl)imineborone, Bis(azinyl)methine, Carbostyryle, Monostyrylamine, Distyrylamine, Tristyrylamine, Tetrastyrylamine, Styrylphosphine, Styrylether, Arylamine, Indenofluorenamine und Indenofluorendiamines, Benzoindenofluorenamine, Benzoindenofluorendiamine, Dibenzoindenofluorenamine, Dibenzoindenofluorendiamine, substituierte oder unsubstituierte Tristilbenamine, Distyrylbenzole und Distyrylbiphenyle, Triarylamine, Triazol-Verbindungen, Naphthaline, Phenanthrene, Pyrene, Triazine, Chrysene, Decacyclene, Coronene, Tetraphenylcyclopentadiene, Pentaphenylcyclopentadiene, Spirofluorene, Pyrane, Oxazole, Benzoxazole, Benzothiazole, Benzimidazole, Pyrazine, Zimtsäureester, Diketopyrrolopyrrole und Acridone.

Die sterische Abschirmung dieser Verbindungen erfolgt dabei durch elektronisch inerte, sterisch anspruchsvolle Substituenten, die den elektronisch aktiven Kern der fluoreszierenden Verbindung umgeben und so weitgehend vom Kontakt zu benachbarten Molekülen in der Schicht abschirmen.

Bevorzugt als fluoreszierende Verbindungen sind steife π-Systeme, die mit großen aliphatischen oder cycloaliphatischen Resten substituiert sind. Weiterhin kommen auch aromatische Substituenten, die durch aliphatische oder cycloaliphatische Reste substituiert sein können, in Frage.

Beispiele für geeignete aromatische Grundkörper fluoreszierender Verbindungen sind die im Folgenden aufgeführten Gruppen (1) bis (40),

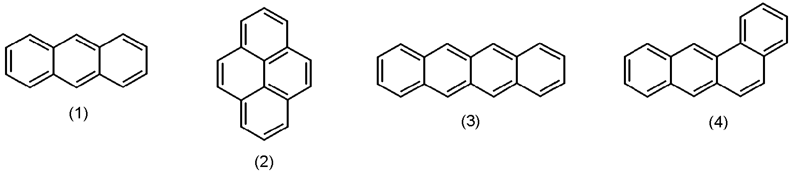

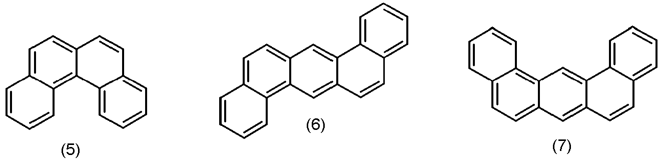

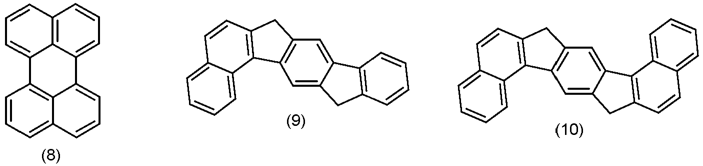

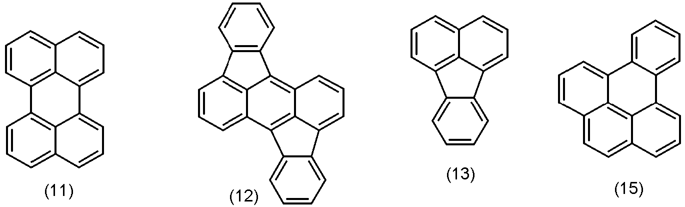

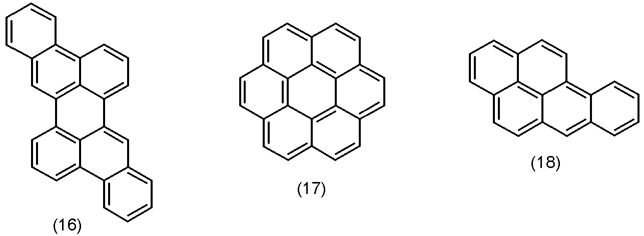

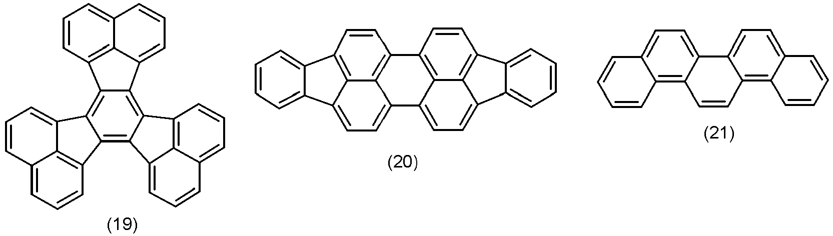

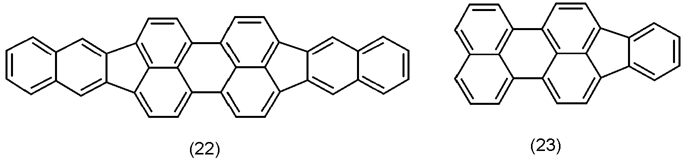

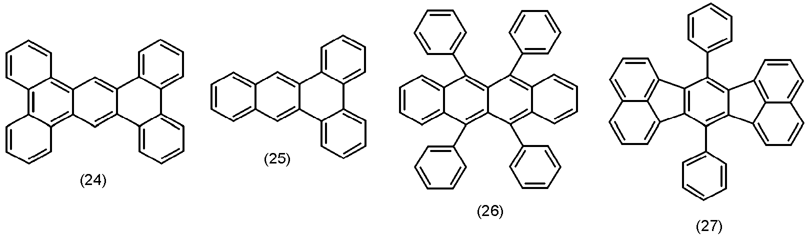

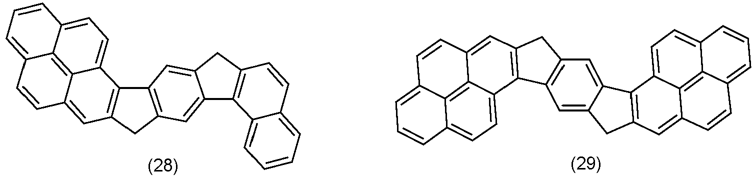

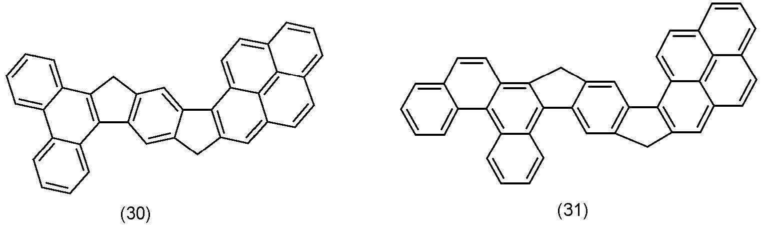

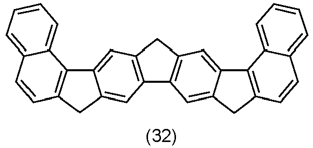

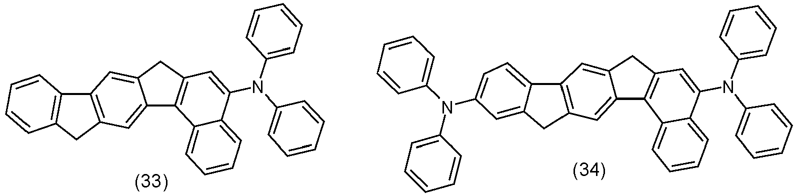

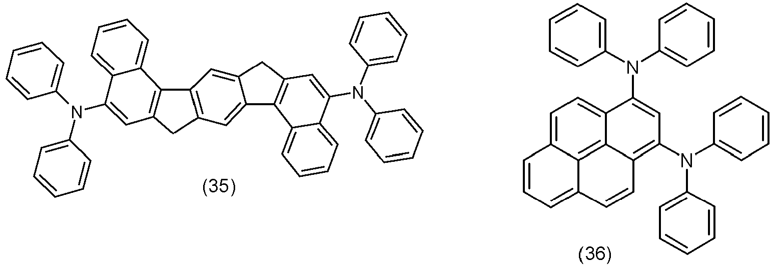

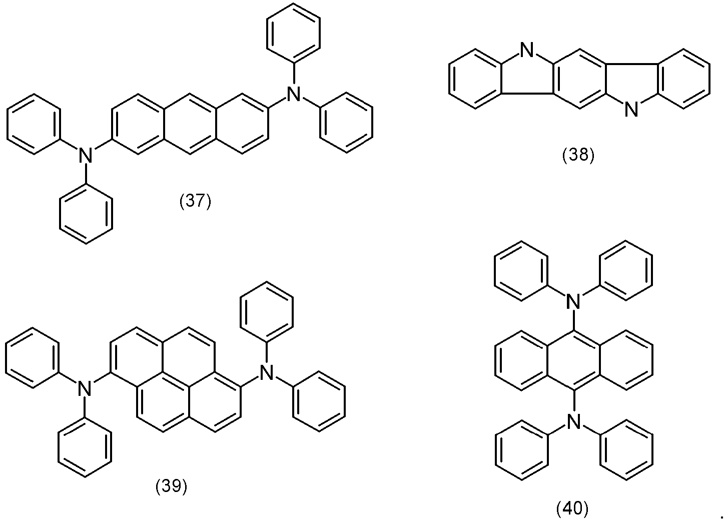

Beispiele für geeignete heteroaromatische Grundkörper fluoreszierender Verbindungen sind die oben genannten Gruppen der Formeln (1) bis (40), in denen ein, zwei, drei oder vier Kohlenstoffatome des kondensierten aromatischen Kerns durch Stickstoff ersetzt sind. Bevorzugt sind ein, zwei oder drei Kohlenstoffatome durch Stickstoff ersetzt, besonders bevorzugt ein oder zwei Kohlenstoffatome und ganz besonders bevorzugt genau ein Kohlenstoffatom.

Beispiele für geeignete heteroaromatische Grundkörper fluoreszierender Verbindungen sind weiterhin die im Folgenden aufgeführten Gruppen der Formeln (41) bis (73),

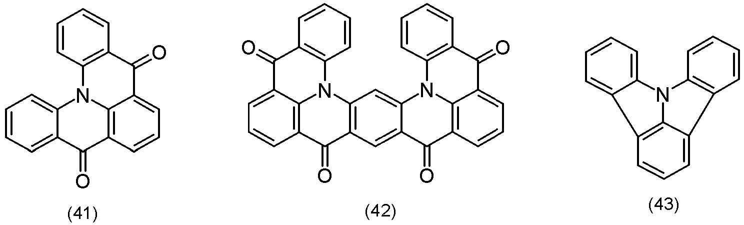

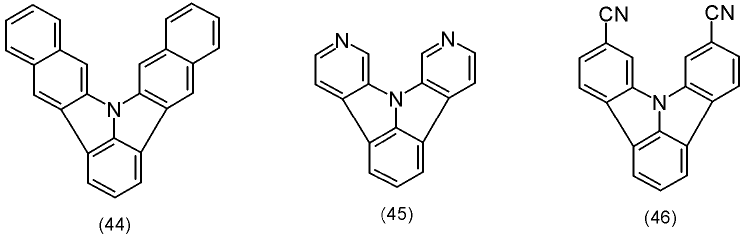

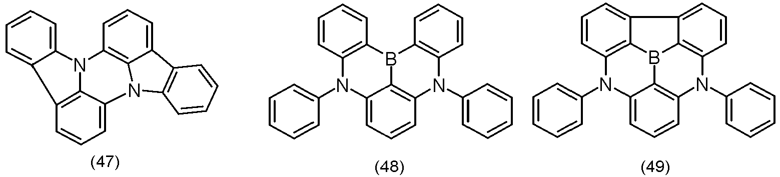

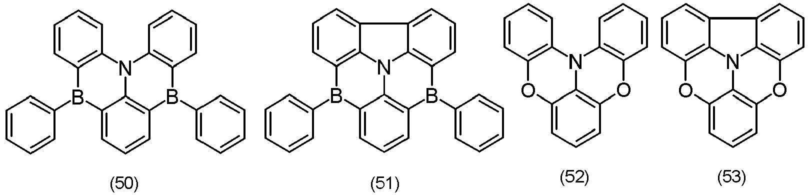

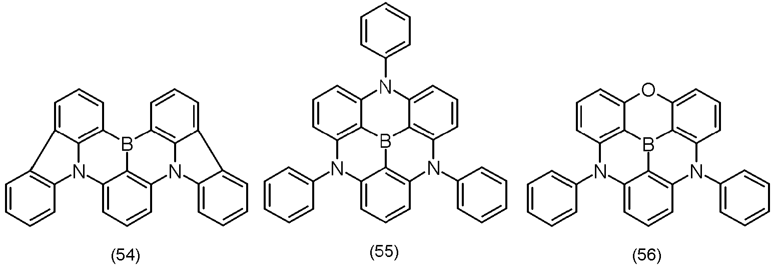

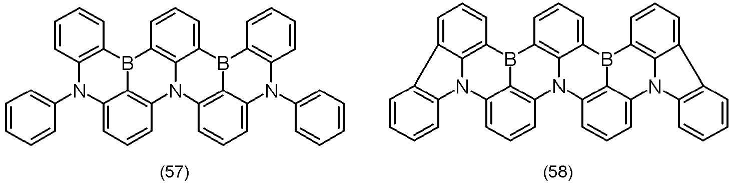

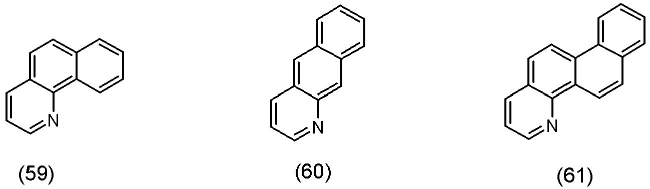

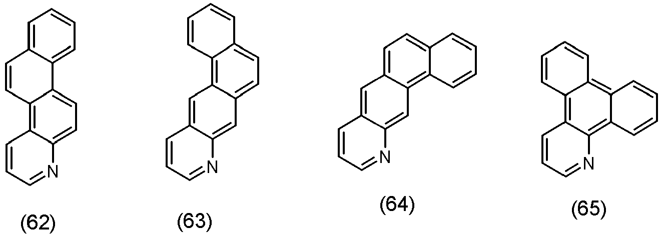

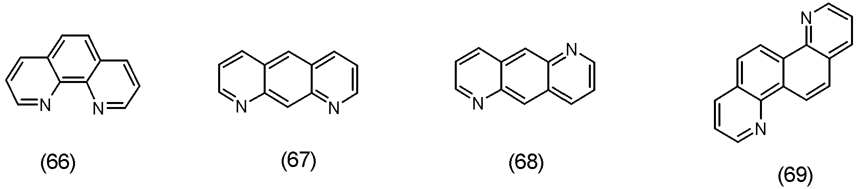

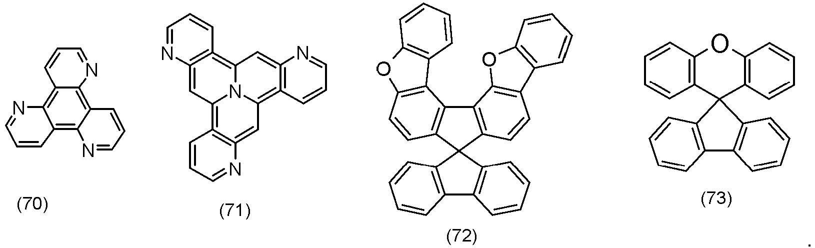

Dabei sind diese Strukturen, wie oben beschrieben, durch sterisch anspruchsvolle Substituenten substituiert und können auch durch weitere Substituenten substituiert sein, sofern diese Substituenten nicht elektronisch aktiv sind bzw. wiederum durch sterisch abgeschirmte Substituenten substituiert sind.

Im Folgenden werden geeignete, sterisch anspruchsvolle Substituenten beschrieben, die verwendet werden können, um die fluoreszierenden Kerne, z. B. die oben genannten Aromaten und Heteroaromaten, zu substituieren und so zu sterisch abgeschirmten fluoreszierenden Verbindungen zu gelangen.

Geeignete sterisch anspruchsvolle Substituenten sind beispielsweise Alkylgruppen, insbesondere mit 3 bis 20 C-Atomen, bevorzugt mit 4 bis 10 C-Atomen, in denen auch H-Atome durch F ersetzt sein können, Alkoxygruppen, insbesondere mit 3 bis 20 C-Atomen, bevorzugt mit 4 bis 10 C-Atomen, Aralkylgruppen, insbesondere mit 7 bis 30 C-Atomen, und aromatische Ringsysteme, insbesondere mit 6 bis 30 C-Atomen, wobei in den Aralkylgruppen und aromatischen Ringsystemen die Arylgruppen auch durch ein oder mehrere Alkylgruppen mit 1 bis 10 C-Atomen substituiert sein können. Dabei können auch mehrere benachbarte Substituenten ein Ringsystem miteinander bilden.

Wenn es sich bei dem Substituenten um eine Aralkylgruppe oder ein aromatisches Ringsystem handelt, so ist es bevorzugt, wenn diese keine kondensierten Arylgruppen mit mehr als 10 Kohlenstoffatomen aufweisen, in denen Arylgruppen über eine gemeinsame Kante direkt aneinander ankondensiert sind. Besonders bevorzugt weist dieses überhaupt keine kondensierten Arylgruppen auf, in denen Arylgruppen über eine gemeinsame Kante direkt aneinander ankondensiert sind. So ist es also bevorzugt, wenn das aromatische Ringsystem beispielsweise keine Anthracen- oder Pyrengruppen aufweist, und besonders bevorzugt, wenn das aromatische Ringsystem auch keine Naphthalingruppen aufweist. Dagegen kann es beispielsweise Biphenyl- oder Terphenylgruppen aufweisen, da diese keine kondensierten Arylgruppen aufweisen. Weiterhin kann es auch beispielsweise Fluoren- oder Spirobifluorengruppen aufweisen, da in diesen Gruppen keine Arylgruppen direkt über eine gemeinsame Kante aneinander ankondensiert sind.

Wenn der sterisch anspruchsvolle Substituent für eine Alkylgruppe steht, dann weist diese Alkylgruppe bevorzugt 4 bis 10 C-Atome auf. Bevorzugt handelt es sich um eine sekundäre, tertiäre oder cyclische Alkylgruppe, bei der das sekundäre oder tertiäre C-Atom entweder direkt an den fluoreszierenden Grundkörper gebunden ist oder über eine CH₂-Gruppe an den fluoreszierenden Grundkörper gebunden ist. Besonders bevorzugt ist diese Alkylgruppe ausgewählt aus den Strukturen der folgenden Formeln (R-1) bis (R-33): 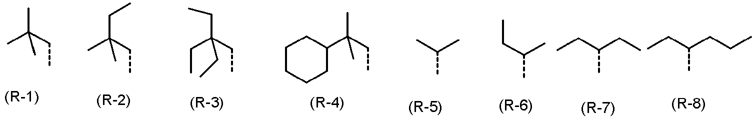 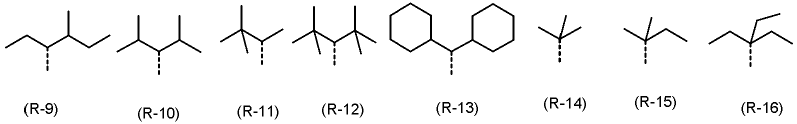 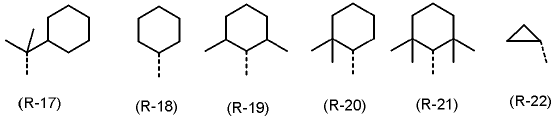 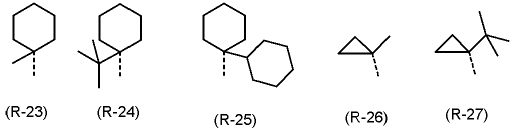 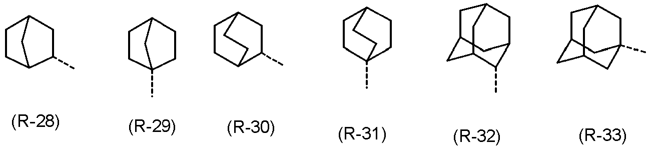 wobei die gestrichelte Bindung die Anknüpfung dieser Gruppen an den fluoreszierenden Grundkörper kennzeichnet.

Wenn der sterisch anspruchsvolle Substituent für eine Alkoxygruppe steht, dann weist diese Alkoxygruppe bevorzugt 3 bis 10 C-Atome auf und ist bevorzugt verzweigt oder cyclisch. Bevorzugt ist diese Alkoxygruppe ausgewählt aus den Strukturen der folgenden Formeln (R-34) bis (R-47): 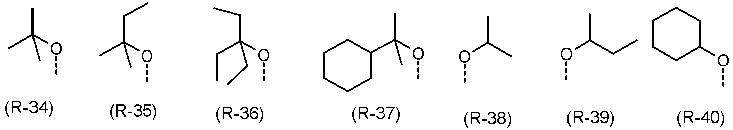 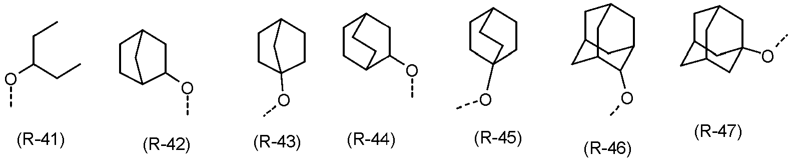 wobei die gestrichelte Bindung die Anknüpfung dieser Gruppen an den fluoreszierenden Grundkörper kennzeichnet.

Wenn der sterisch anspruchsvolle Substituent für eine Aralkylgruppe steht, dann ist diese Aralkylgruppe bevorzugt ausgewählt aus den Strukturen der folgenden Formeln (R-48) bis (R-61): 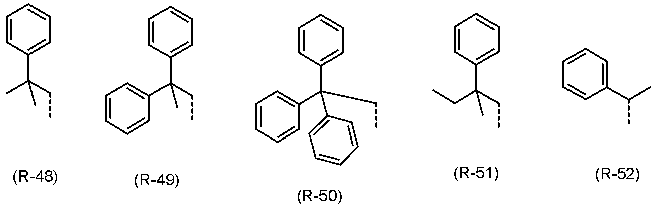 wobei die gestrichelte Bindung die Anknüpfung dieser Gruppen an den fluoreszierenden Grundkörper kennzeichnet und die Phenylgruppen jeweils durch einen oder mehrere Reste R^{a} substituiert sein können, wobei gilt:
- R^{a}: ist bei jedem Auftreten gleich oder verschieden ausgewählt aus der Gruppe bestehend aus H, D, F, einer geradkettigen Alkylgruppe mit 1 bis 40 C-Atomen oder einer verzweigten oder cyclischen Alkylgruppe mit 3 bis 40 C-Atomen, die jeweils mit einem oder mehreren Resten R^{b} substituiert sein kann, einem aromatischen Ringsystem mit 5 bis 60 aromatischen Ringatomen, das jeweils mit einem oder mehreren Resten R^{b} substituiert sein kann, oder einer Aralkylgruppe mit 5 bis 60 aromatischen Ringatomen, die mit einem oder mehreren Resten R^{b} substituiert sein kann, wobei optional zwei oder mehr benachbarte Substituenten R^{a} ein Ringsystem bilden können, das mit einem oder mehreren Resten R^{b} substituiert sein kann;
- R^{b}: ist ausgewählt aus der Gruppe bestehend aus H, D, F, einem aliphatischem Kohlenwasserstoffrest mit 1 bis 20 C-Atomen, einem aromatischem Ringsystem mit 5 bis 30 aromatischen Ringatomen, wobei zwei oder mehr benachbarte Substituenten R^{b} miteinander ein Ringsystem bilden können;

Wenn der sterisch anspruchsvolle Substituent für ein aromatisches Ringsystem steht, dann weist dieses aromatische Ringsystem 6 bis 60 und bevorzugt 6 bis 30 aromatische Ringatome auf, besonders bevorzugt 6 bis 24 aromatische Ringatome. Weiterhin enthält dieses aromatische Ringsystem bevorzugt nur Phenylgruppen. Dabei ist das aromatische Ringsystem bevorzugt ausgewählt aus den Strukturen der folgenden Formeln (R-62) bis (R-76): 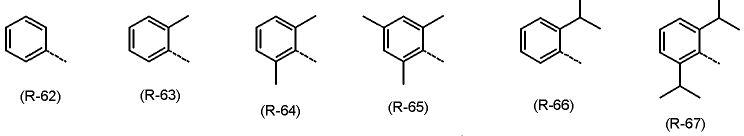 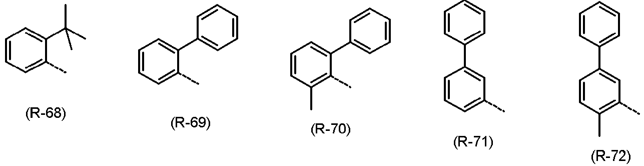 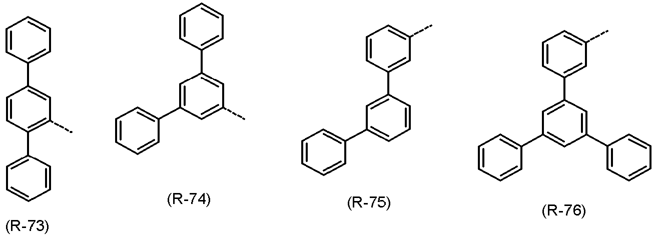 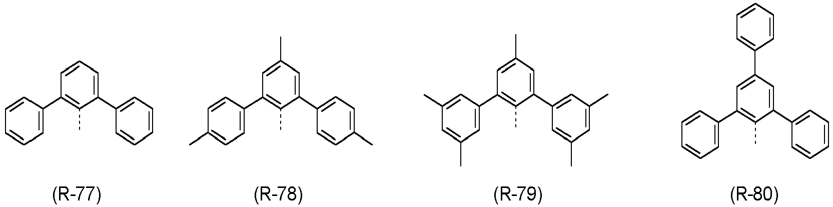 wobei die gestrichelte Bindung die Anknüpfung dieser Gruppen an den fluoreszierenden Grundkörper kennzeichnet und die Phenylgruppen jeweils durch einen oder mehrere Reste R^{a} substituiert sein können, wobei R^{a} wie oben angegeben definiert ist.

Beispiele für fluoreszierende Emitter sind weiterhin aromatische Anthracenamine, aromatische Anthracendiamine, aromatische Pyrenamine, aromatische Pyrendiamine, aromatische Chrysenamine oder aromatische Chrysendiamine. Dabei ist ein aromatisches Anthracenamin eine Verbindung, in der eine Diarylaminogruppe direkt an eine Anthracengruppe gebunden ist, bevorzugt in der 9-Position. Ein Anthracendiamin ist eine Verbindung, in der zwei Diarylaminogruppen direkt an eine Anthracengruppe gebunden sind, beevorzugt in der 9,10-Position. Aromatische Pyrenamine, Pyrendiamine, Chrysenamine und Chrysendiamine sind analog dazu definiert, wobei die Diarylaminogruppe bevorzugt in der 1-Position oder der 1,6-Position des Pyrens gebunden ist. Weitere bevorzugte Emitter sind Indenofluorenamine, Indenofluorendiamine, zum Beispiel gemäß WO 2006/108497 oder WO 2006/122630, Benzindenofluorenamine oder Benzindenofluorendiamine, zum Beispiel gemäß WO 2008/006449, und Dibenzoindenofluorenamine oder Dibenzoindenofluorendiamine, zum Beispiel gemäß WO 2007/140847, und Indenfluorenderivate mit kondensierten Arylgruppe, wie in WO 2010/012328 offenbart. Weitere geeignete Emitter sind die Benzanthracenderivate gemäß WO 2015/158409, die Anthracenderivate gemäß WO 2017/036573, Fluorendimere, welche über Heteroarylgruppen verknüpft sind, zum Beispiel gemäß WO 2016/150544, oder Phenoxazinderivate, zum Beispiel gemäß WO 2017/028940 oder WO 2017/028941. Bevorzugt sind weiterhin die Pyrenylarylamine gemäß WO 2012/048780 oder WO 2013/185871, die Benzindenofluorenamine gemäß WO 2014/037077, die Benzfluorenamine gemäß WO 2014/106522 und die Indenofluorene gemäß WO 2014/111269, WO 2017/036574 oder WO 2018/007421. Weiterhin bevorzugt sind Emitter enthaltend Dibenzofuran- oder Indenodibenzofuran-Einheiten, zum Beispiel gemäß WO 2018/095888, WO 2018/095940, WO 2019/076789, WO 2019/170572, WO 2020/043657, WO 2020/043646 oder WO 2020/043640. Bevorzugt sind weiterhin Borderivate, zum Beispiel gemäß WO 2015/102118, CN 108409769, CN 107266484, WO 2017/195669, US 2018/0069182, WO 2020/208051, sowie gemäß den noch nicht publizierten Anmeldungen EP 19168728.4, EP 19199326.0, EP 19208643.7, EP 19206969.8, EP 19208643.7, EP 19217614.7, EP 19217948.9, EP 20163669.3, EP 20163671.9, EP 20164893.8, EP 20165809.3, EP 20168237.4, EP 20182888.6, EP 20182891.0, EP 20202318.0, EP 20202325.5, EP 20215751.7, EP 20215734.3 und EP 20215718.6. Bevorzugt sind weiterhin Emitter gemäß der Anmeldung WO 2020/064666.

Der Sensitizer, also die erfindungsgemäße Verbindung, und der fluoreszierende Emitter können sich in derselben Schicht einer elektronischen Vorrichtung oder in unterschiedlichen Schichten befinden. In einer bevorzugten Ausführungsform der Erfindung befinden sich der Sensitizer und der fluoreszierende Emitter in derselben Schicht, wobei diese Schicht vorzugsweise die Emissionsschicht der OLED ist.

Beispiele für fluoreszierende Emitter sind die in der nachfolgenden Tabelle abgebildeten Verbindungen.

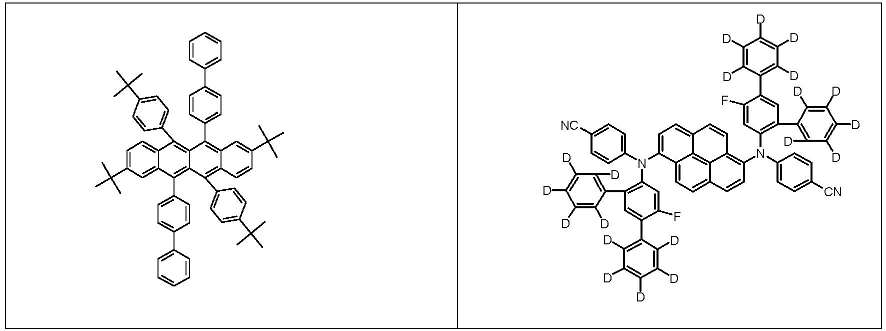

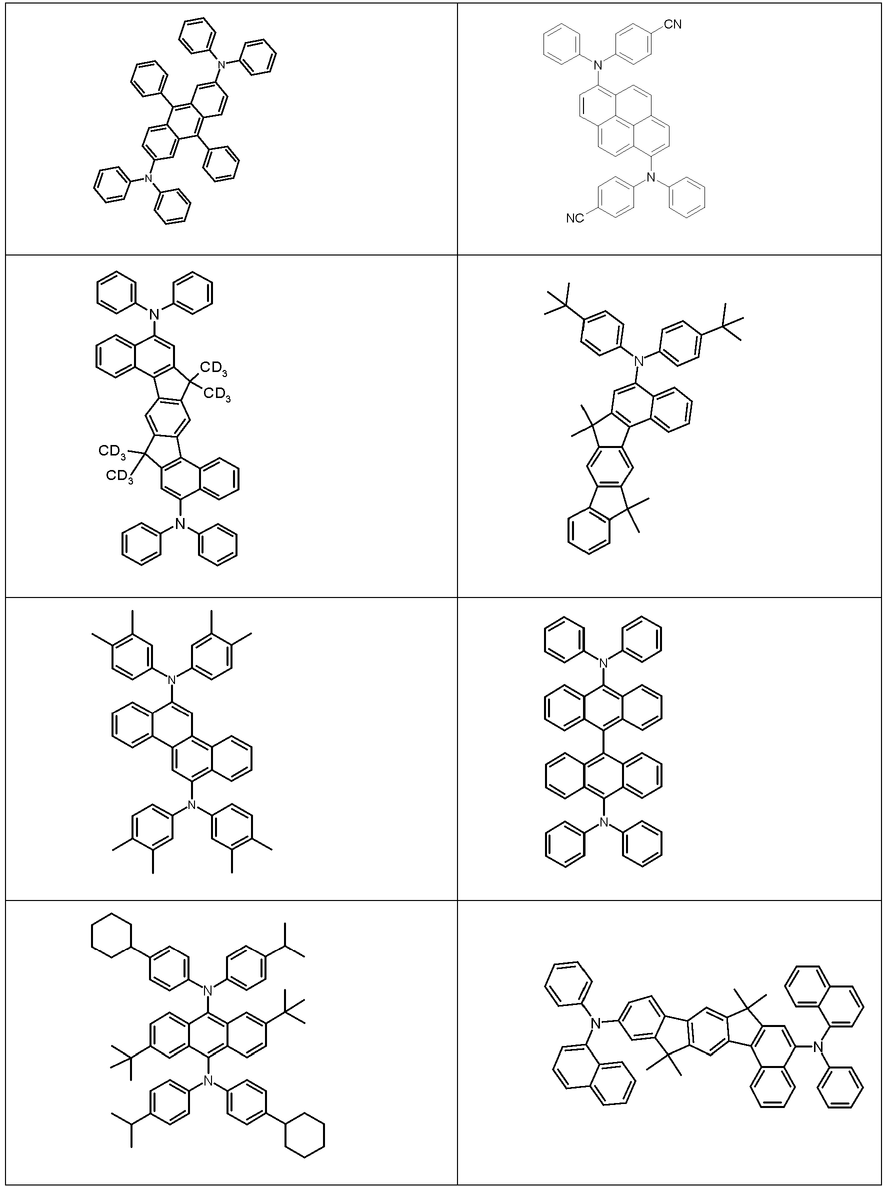

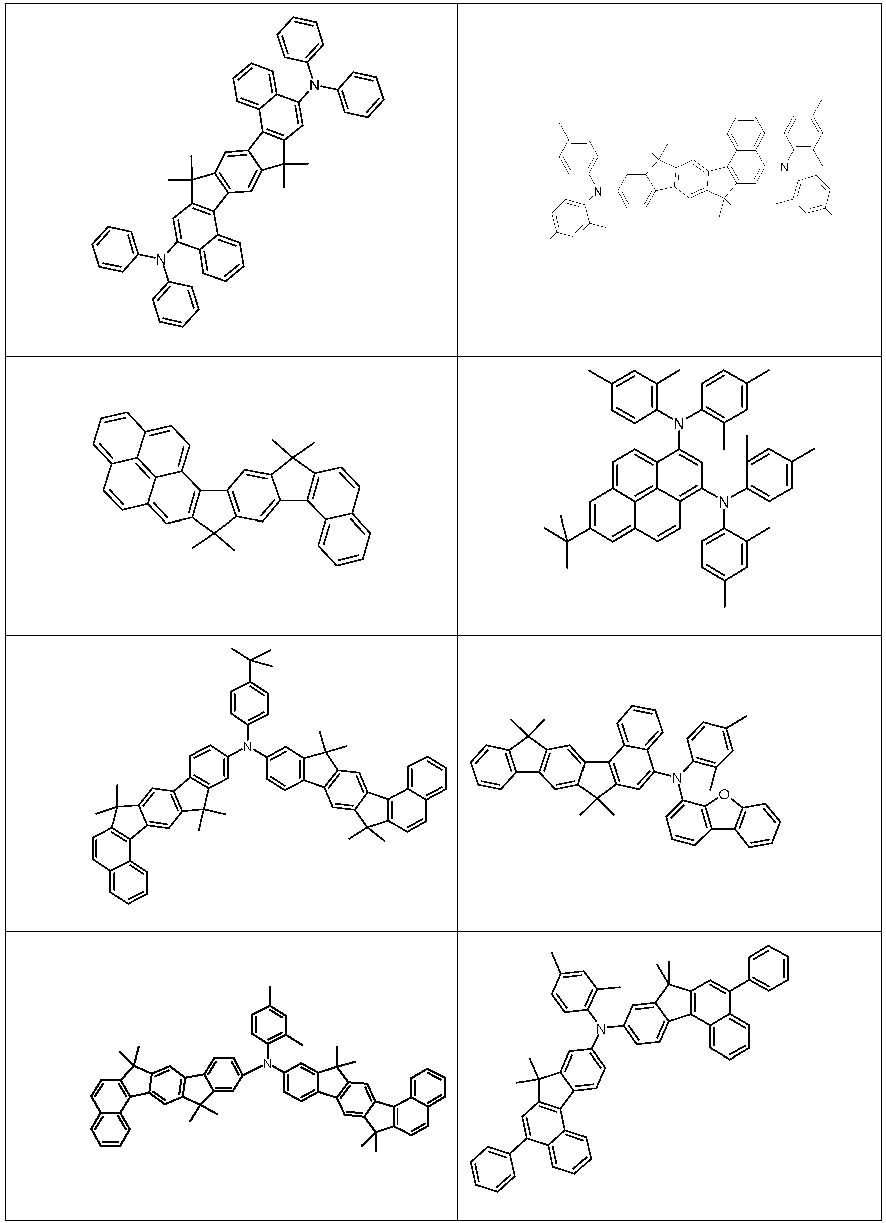

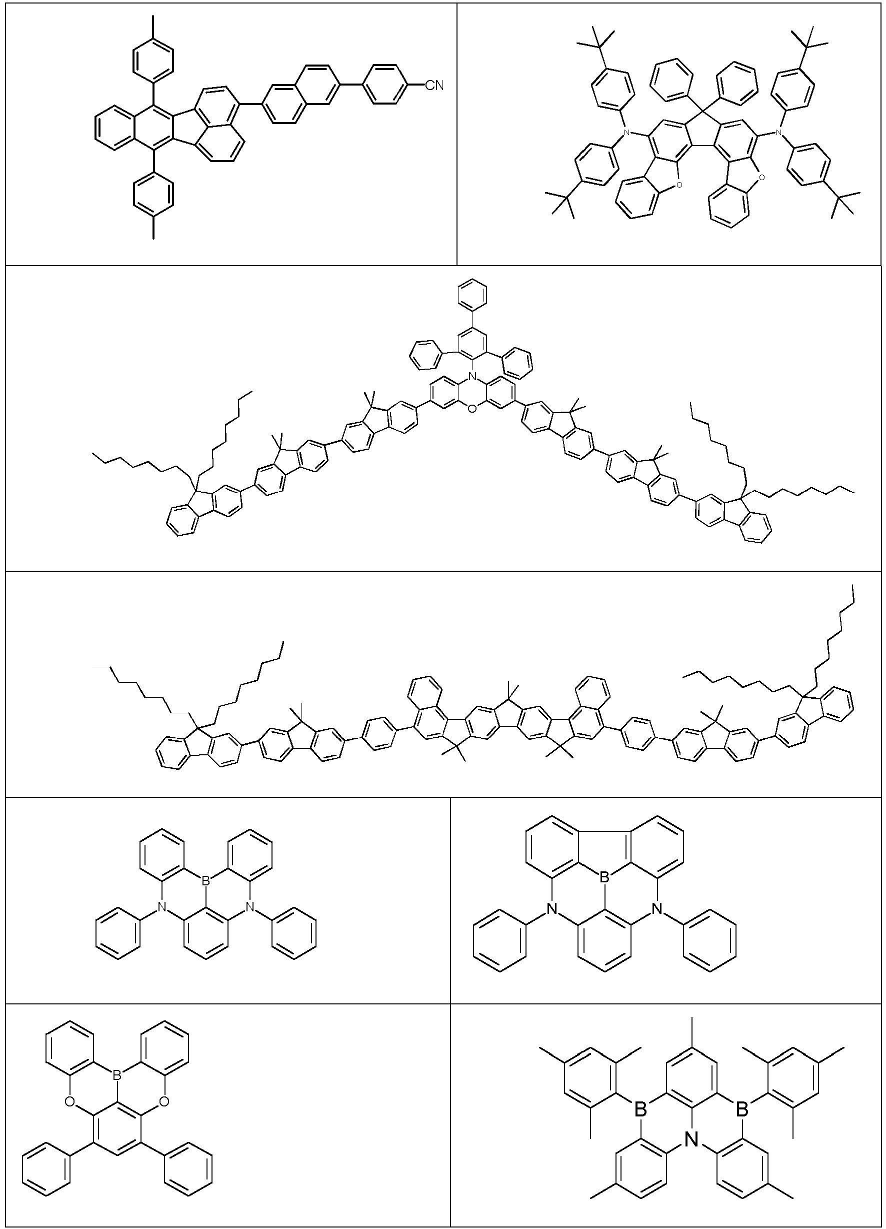

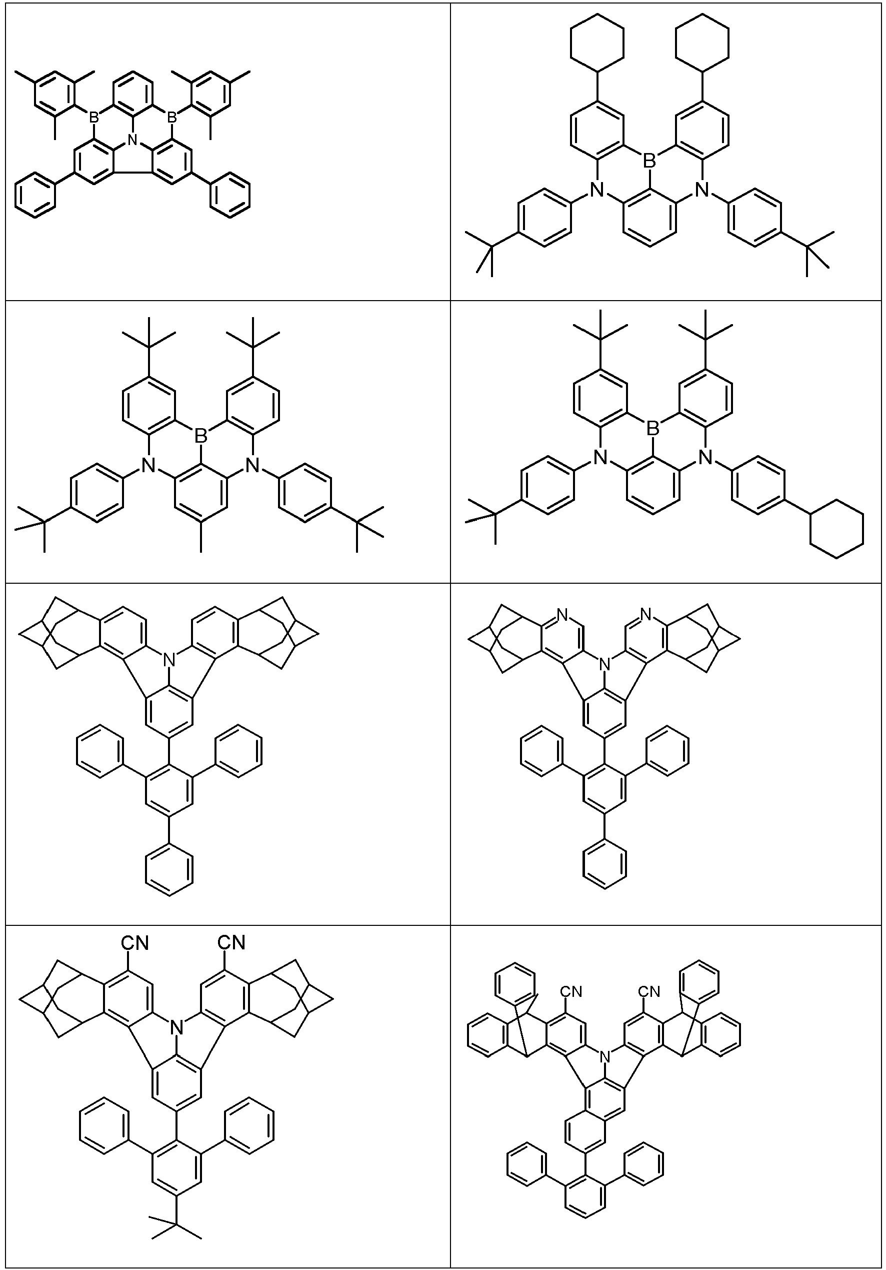

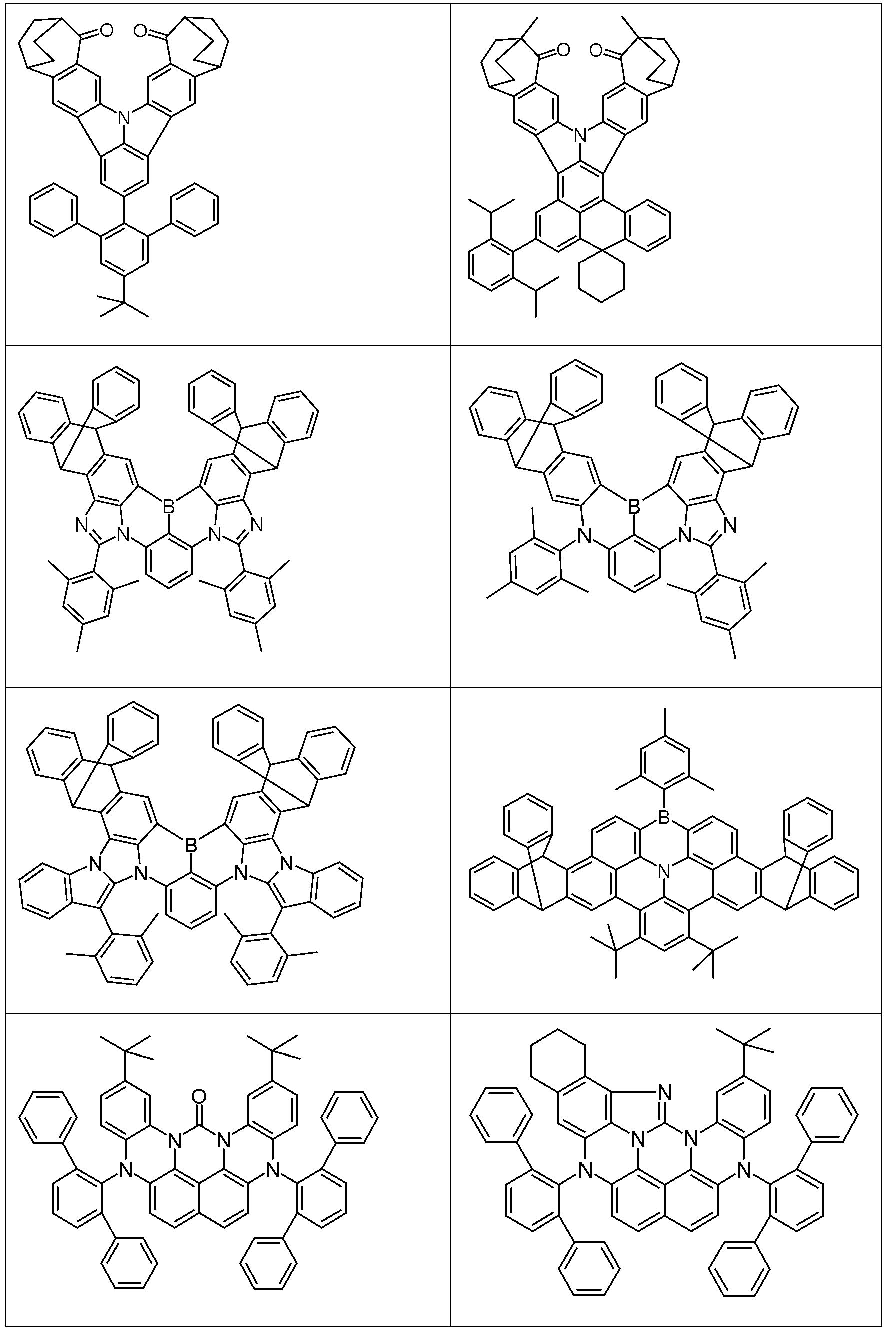

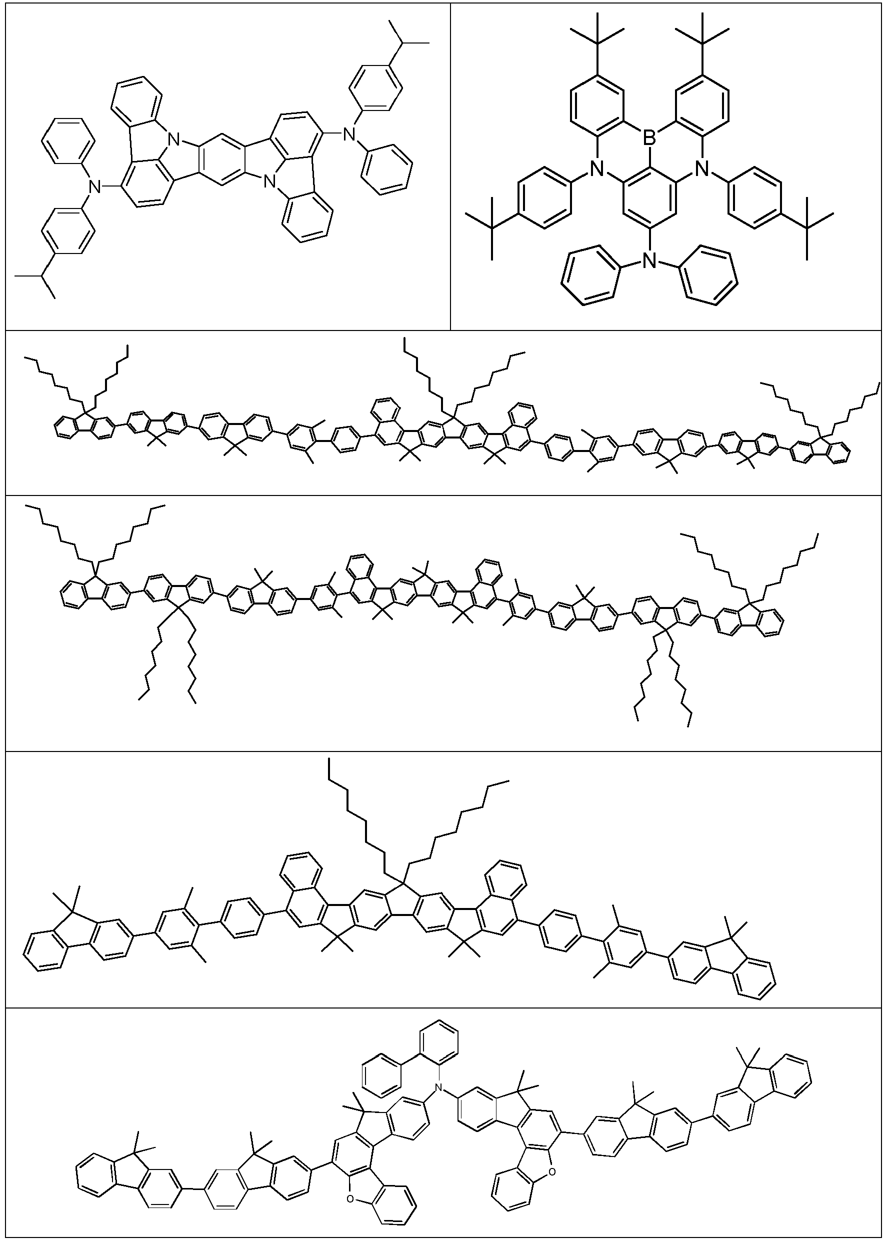

Die Schicht enthaltend den Sensitizer, also die erfindungsgemäße Verbindung, und den fluoreszierenden Emitter enthält vorzugsweise wenigstens ein weiteres Material aus der Gruppe der Elektronentransportmaterialien, Lochleitermaterialien, Quantenmaterialien (vorzugsweise Quantenpunkte), bipolaren Hosts und Hostmaterialien mit großer Bandlücke (wide band gap Materialien), wobei es sich bei wide band gap Materialien um Materialien handelt, die eine Bandlücke von 2.5 eV oder mehr, bevorzugt von 3.0 eV oder mehr und insbesondere bevorzugt von 3.5 eV oder mehr aufweisen.

Geeignete Matrixmaterialien, welche in Kombination mit dem Sensitizer und dem fluoreszierenden Emitter in der Emissionsschicht der elektronischen Vorrichtung eingesetzt werden können, sind dieselben Materialien, die nachfolgend ausführlich als Matrixmaterialien für phosphoreszierende Emitter beschrieben werden. Dabei ist eine Mischung aus einem elektronentransportierenden und einem lochtransportierenden Matrixmaterial besonders bevorzugt.

In einer weiteren Ausführungsform wird dabei die erfindungsgemäße Verbindung als emittierende, phosphoreszierende Verbindung zusammen mit einem oder mehreren Hostmaterialien (Matrixmaterialien) in der emittierenden Schicht einer OLED eingesetzt, wobei die Emission der Schicht dann aus der erfindungsgemäßen Verbindung kommt.

Wenn die erfindungsgemäße Verbindung als emittierende Verbindung in einer emittierenden Schicht eingesetzt wird, wird er bevorzugt in Kombination mit einem oder mehreren Matrixmaterialien eingesetzt. Die Mischung aus der erfindungsgemäßen Verbindung und dem Matrixmaterial enthält bei Herstellung durch Aufdampfen zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% der erfindungsgemäßen Verbindung bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial. Bei Herstellung aus Lösung sind bevorzugte Anteile die oben angegebenen Anteile, wobei es sich dann um Gew.-% statt Vol.-% handelt.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Biscarba-zolylbiphenyl), m-CBP oder die in WO 2005/039246, US 2005/0069729, JP 2004/288381, EP 1205527, WO 2008/086851 oder US 2009/0134784 offenbarten Carbazolderivate, verbrückte Carbazolderivate, z. B. gemäß US 2009/0136779, WO 2010/050778, WO 2011/042107 oder WO 2011/088877, Biscarbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, Dibenzothiophenderivate oder Triphenylenderivate.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial, welches nicht bzw. nicht in wesentlichem Maße am Ladungstransport beteiligt ist, wie z. B. in WO 2010/108579 beschrieben.

Bevorzugte Biscarbazole, die als Matrixmaterialien für die erfindungsgemäßen Verbindungen eingesetzt werden können, sind die Strukturen der folgenden Formeln (27) bis (33), 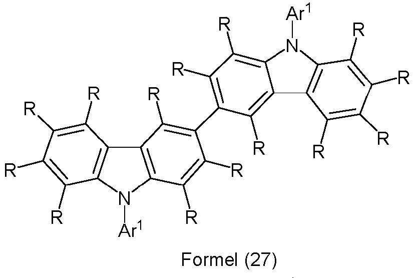 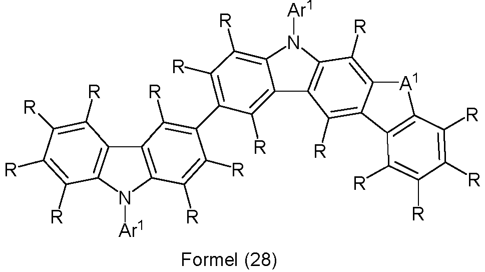 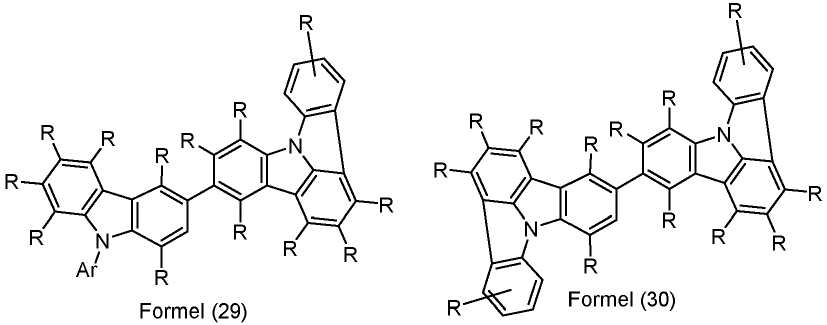 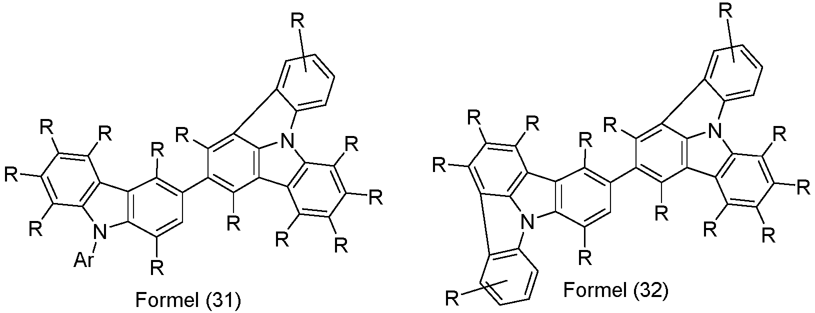 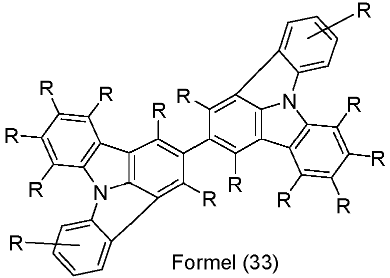 wobei Ar¹ gleich oder verschieden für ein aromatisches oder heteroaromatisches Ringsystem mit 5 bis 40 aromatischen Ringatomen, bevorzugt mit 6 bis 30 aromatischen Ringatomen steht, welches jeweils mit einem oder mehreren Resten R substituiert sein kann, A¹ für NR, CR₂, O oder S steht und R die oben genannten Bedeutungen aufweist. In einer bevorzugten Ausführungsform der Erfindung steht A¹ für CR₂.

Bevorzugte Ausführungsformen sind die Verbindungen der folgenden Formeln (27a) bis (33a), 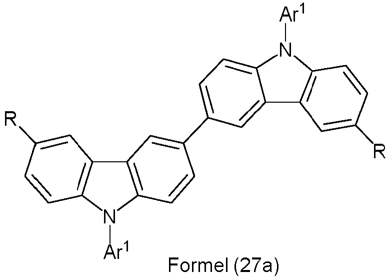 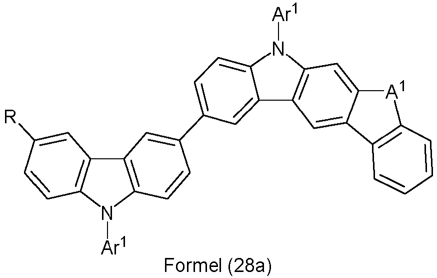 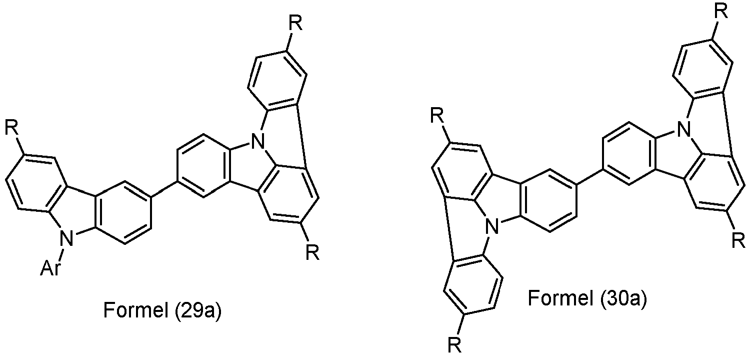 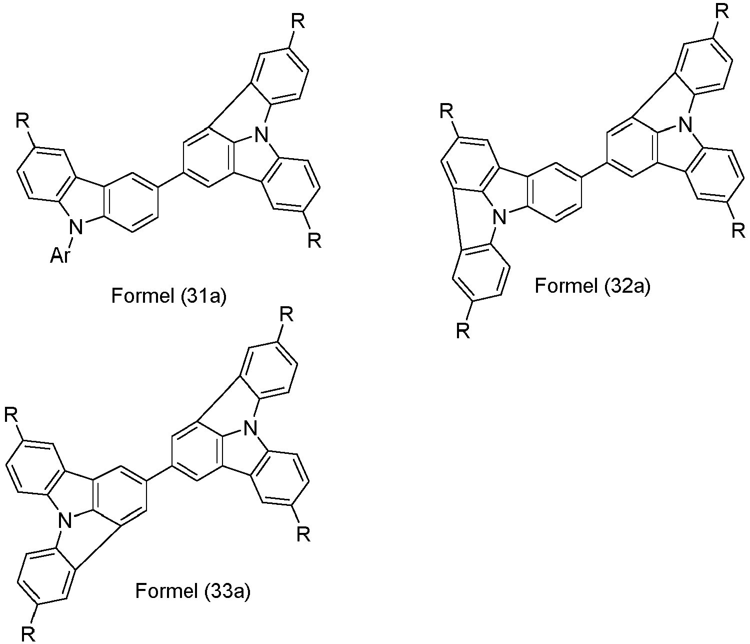 wobei die verwendeten Symbole die oben genannten Bedeutungen aufweisen.

Beispiele für geeignete Verbindungen gemäß Formel (27) bis (33) sind die nachfolgend abgebildeten Verbindungen.

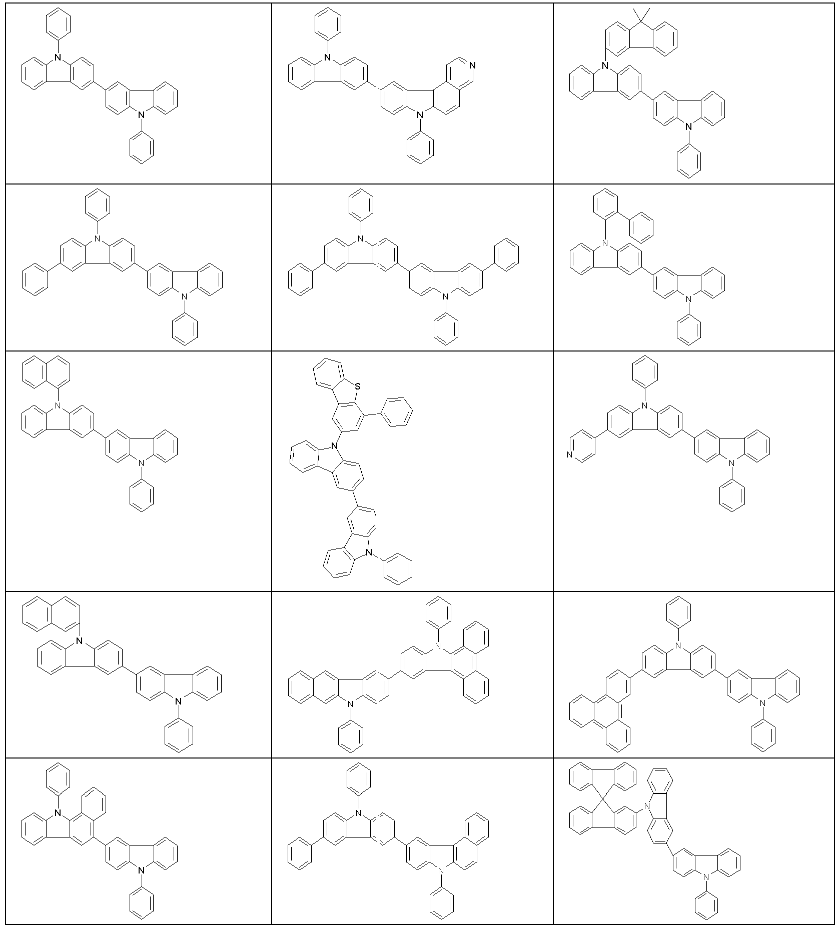

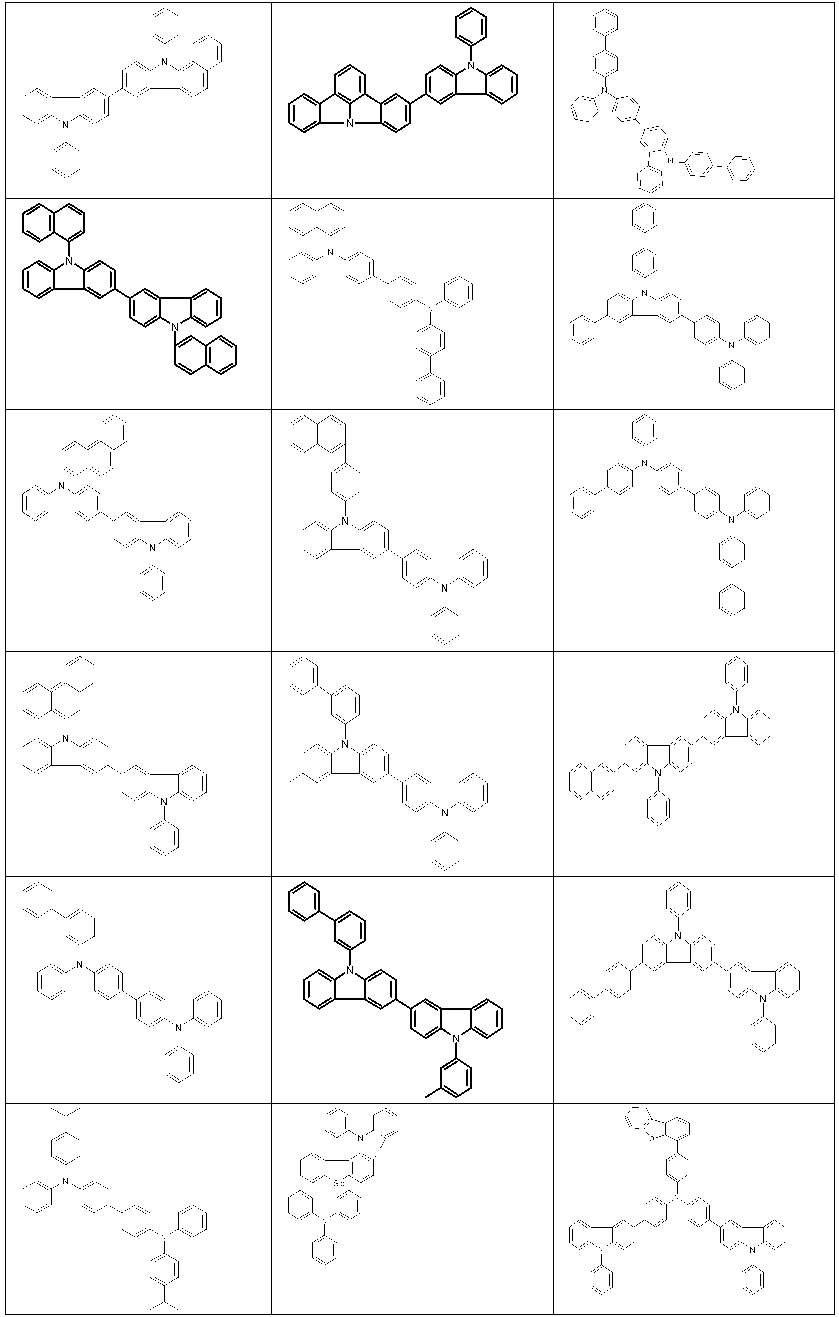

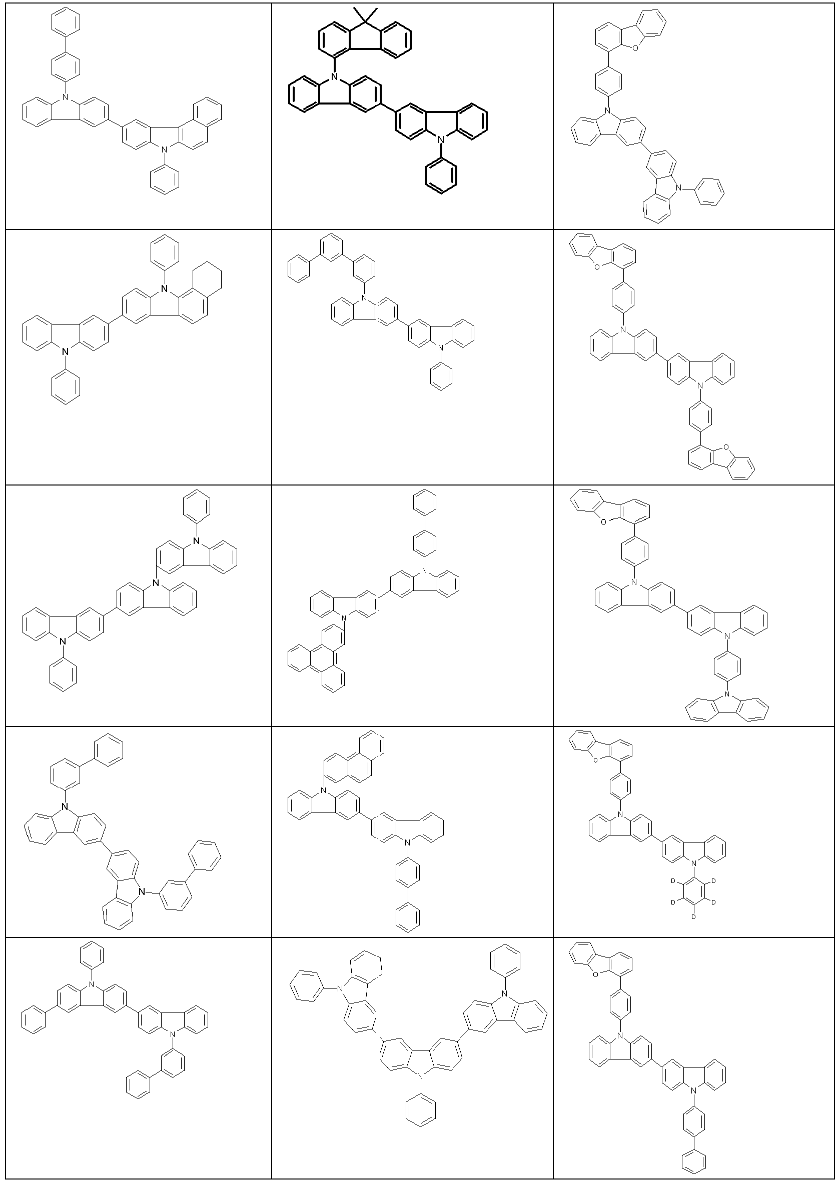

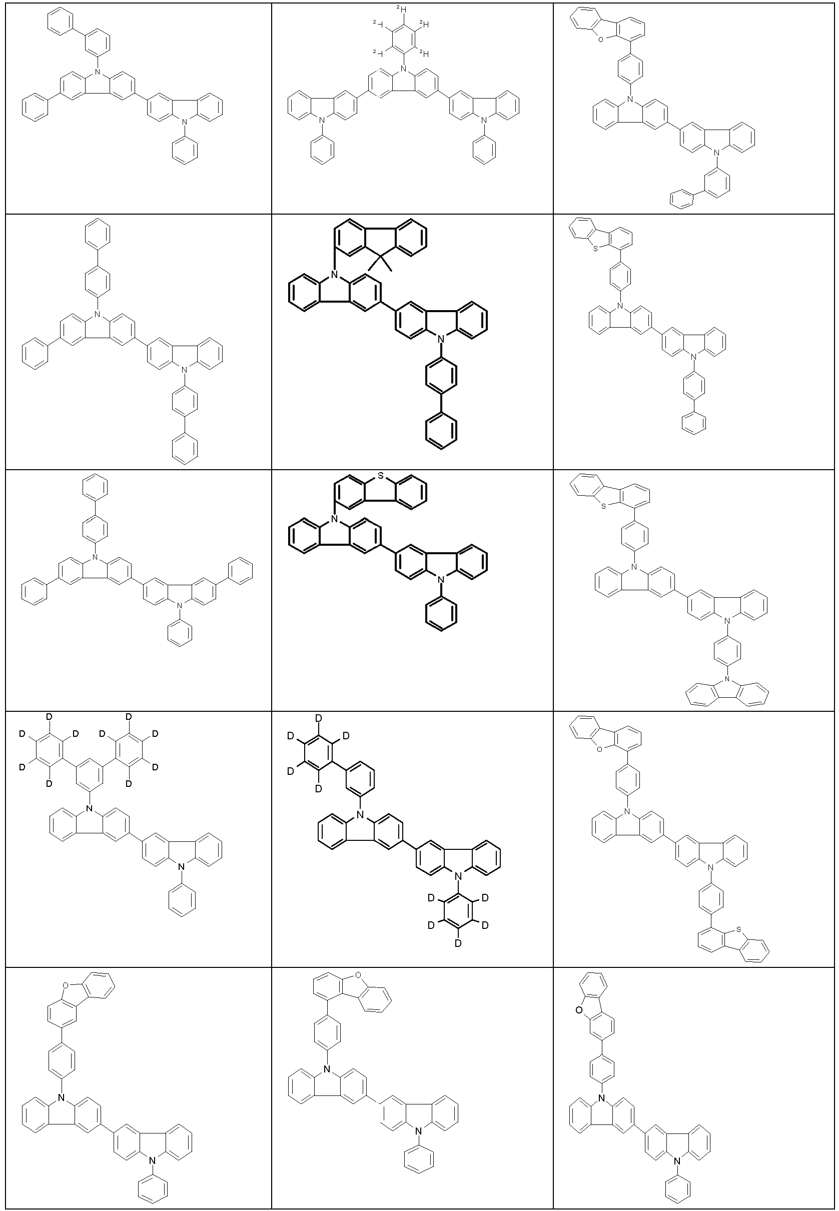

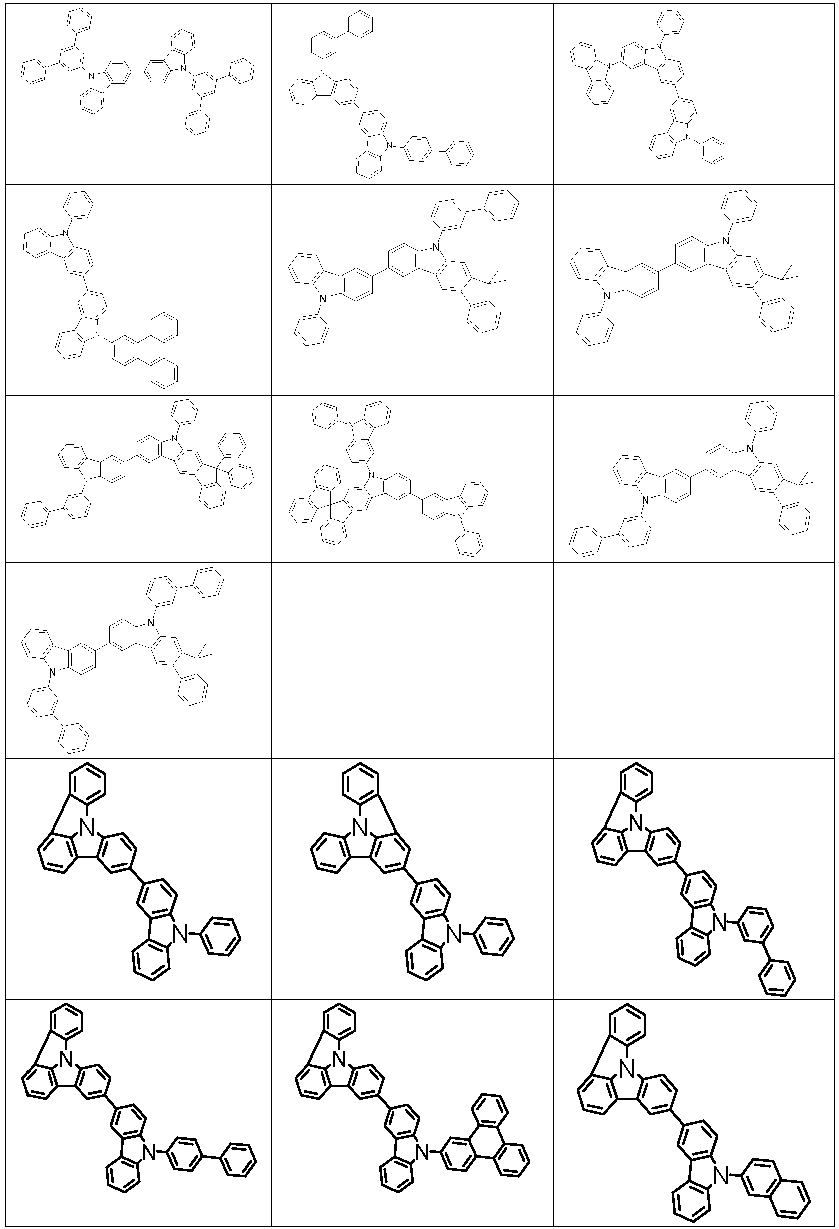

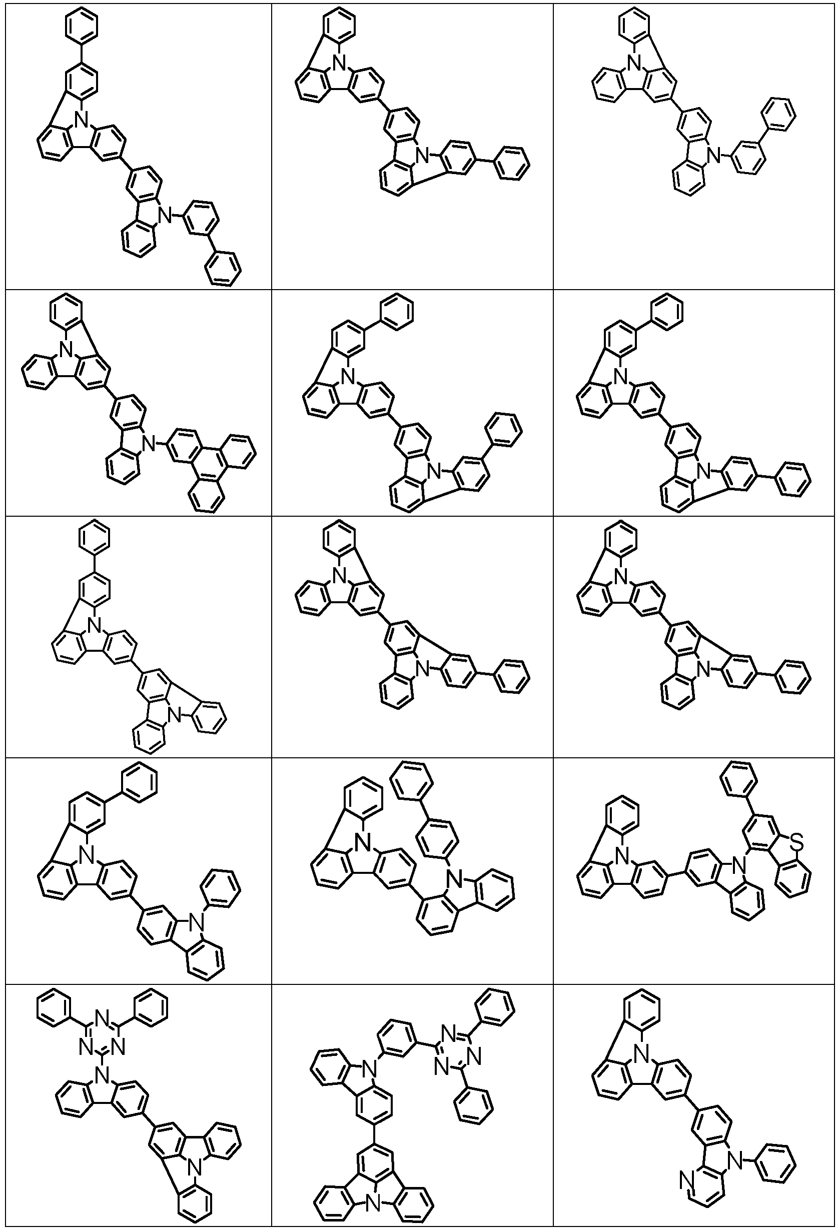

Bevorzugte Dibenzofuran-Derivate sind die Verbindungen der folgenden Formel (34), 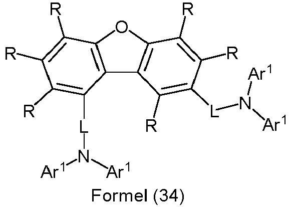 wobei der Sauerstoff auch durch Schwefel ersetzt sein kann, so dass ein Dibenzothiophen entsteht, L für eine Einfachbindung oder ein aromatisches oder heteroaromatisches Ringsystem mit 5 bis 30 aromatischen Ringatomen steht, welches auch durch eine oder mehrere Reste R substituiert sein kann, und R und Ar¹ die oben genannten Bedeutungen aufweisen. Dabei können die beiden Gruppen Ar¹, die an dasselbe Stickstoffatom binden, oder eine Gruppe Ar¹ und eine Gruppe L, die an dasselbe Stickstoffatom binden, auch miteinander verbunden sein, beispielsweise zu einem Carbazol.

Bevorzugte Carbazolamine sind die Strukturen der folgenden Formeln (35), (36) und (37), 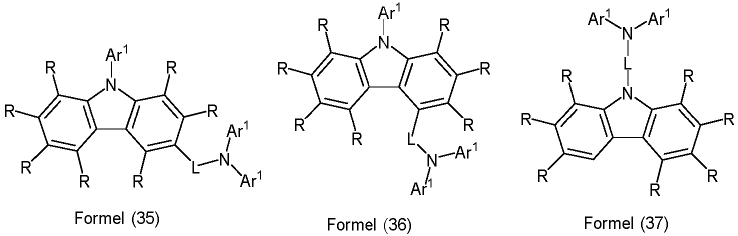 wobei L für ein aromatisches oder heteroaromatisches Ringsystem mit 5 bis 30 aromatischen Ringatomen steht, welches mit einem oder mehreren Resten R substituiert sein kann, und R und Ar¹ die oben genannten Bedeutungen aufweisen.

Bevorzugte Triazin-, Pyrimidin- Chinazolin- bzw. Chinoxalinderivate, welche als Mischung zusammen mit den erfindungsgemäßen Verbindungen eingesetzt werden können, sind die Verbindungen der folgenden Formeln (38), (39), (40) und (41), 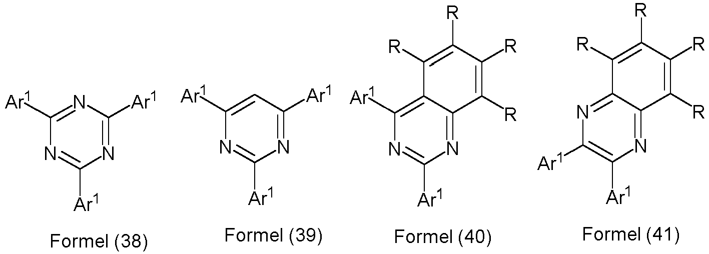 wobei Ar¹ und R die oben genannten Bedeutungen aufweist.

Besonders bevorzugt sind die Triazinderivate der Formel (38) und die Chinazolinderivate der Formel (40), insbesondere die Triazinderivate der Formel (38).

In einer bevorzugten Ausführungsform der Erfindung ist Ar¹ in den Formeln (38) bis (41) bei jedem Auftreten gleich oder verschieden ein aromatisches oder heteroaromatisches Ringsystem mit 6 bis 30 aromatischen Ringatomen, insbesondere mit 6 bis 24 aromatischen Ringatomen, das durch einen oder mehrere Reste R substituiert sein kann. Dabei sind geeignete aromatische bzw. heteroaromatische Ringsysteme Ar¹ die gleichen, wie sie oben als Ausführungsformen für Ar¹, Ar² und Ar³ ausgeführt sind, insbesondere die Strukturen Ar-1 bis Ar-76.

Beispiele für geeignete Triazinverbindungen, welche als Matrixmaterialien zusammen mit den erfindungsgemäßen Verbindungen eingesetzt werden können, sind die in der folgenden Tabelle abgebildeten Verbindungen.

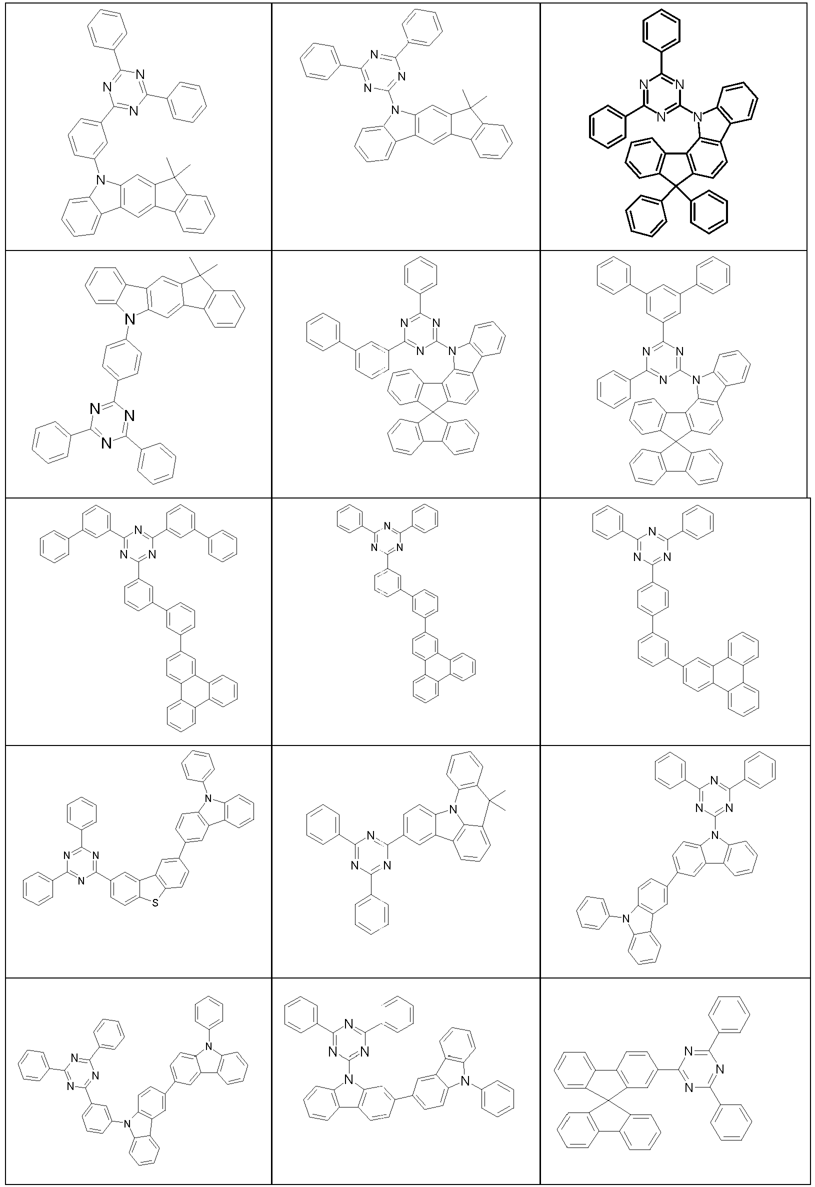

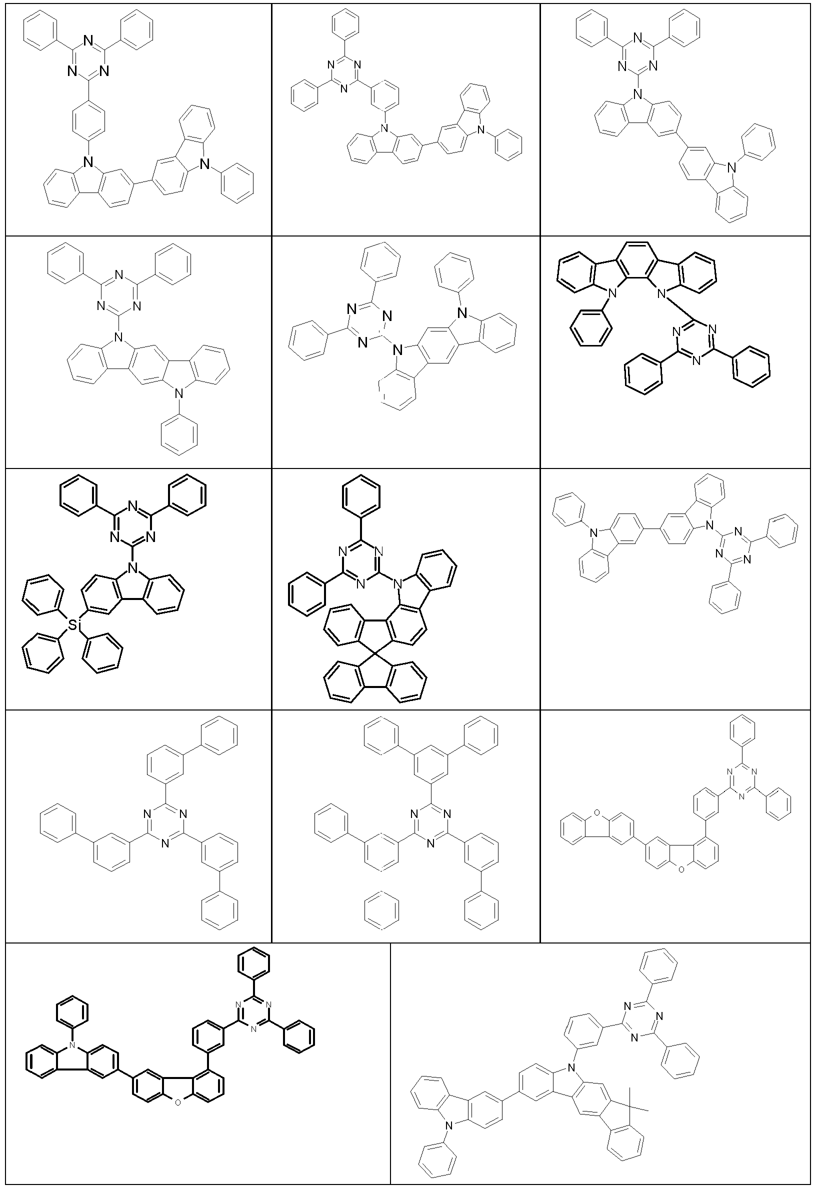

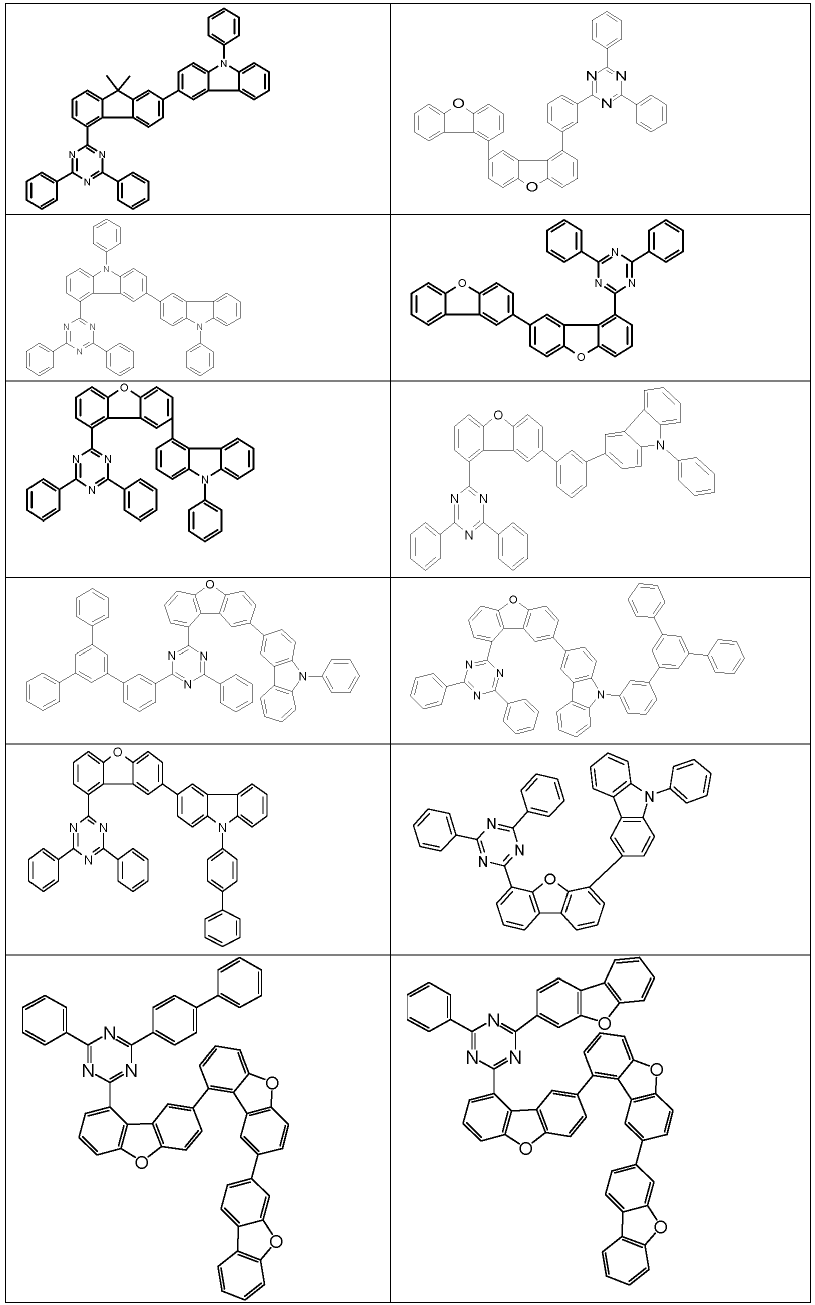

Weiterhin bevorzugt ist es, eine Mischung aus zwei oder mehr Triplett-Emittern, insbesondere zwei oder drei Triplettemittern, zusammen mit einem oder mehreren Matrixmaterialien einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe mit einem kürzerwelligen, z.B. blau, grün oder gelb emittierenden, Metallkomplex als Co-Matrix kombiniert werden. Es können beispislweise auch erfindungsgemäße Metallkomplexe als Co-Matrix für längerwellig emittierende Triplettemitter, beispielsweise für rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist. Eine bevorzugte Ausführungsform bei Verwendung einer Mischung aus drei Triplett-Emittern ist, wenn zwei als Co-Host und einer als emittierendes Material eingesetzt werden. Dabei weisen diese Triplett-Emitter bevorzugt die Emissionsfarben Grün, Gelb und Rot oder Blau, Grün und Orange auf.

Eine bevorzugte Mischung in der emittierenden Schicht enthält ein elektronentransportierendes Hostmaterial, ein so genanntes "wide bandgap" Hostmaterial, das aufgrund seiner elektronischen Eigenschaften nicht oder nicht in wesentlichem Umfang am Ladungstransport in der Schicht beteiligt ist, einen Co-Dotanden, welcher ein Triplettemitter ist, welcher bei einer kürzeren Wellenlänge als die erfindungsgemäße Verbindung emittiert, sowie eine erfindungsgemäße Verbindung.

Eine weitere bevorzugte Mischung in der emittierenden Schicht enthält ein elektronentransportierendes Hostmaterial, ein so genanntes "wide band gap" Hostmaterial, das aufgrund seiner elektronischen Eigenschaften nicht oder nicht in wesentlichem Umfang am Ladungstransport in der Schicht beteiligt ist, ein lochtransportierendes Hostmaterial, einen Co-Dotanden, welcher ein Triplettemitter ist, welcher bei einer kürzeren Wellenlänge als die erfindungsgemäße Verbindung emittiert, sowie eine erfindungsgemäße Verbindung.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht. Ebenso lassen sich die erfindungsgemäßen Verbindungen als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden. Bevorzugt sind als Lochtransportmaterialien, die in einer Lochtransport-, Lochinjektions- oder Elektronenblockierschicht in der erfindungsgemäßen Elektrolumineszenzvorrichtung verwendet werden können, Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627, WO2014/056565), Fluoren-Amine (z. B. gemäß EP 2875092, EP 2875699 und EP 2875004), Spiro-Dibenzopyran-Amine (z. B. EP 2780325) und Dihydroacridin-Derivate (z. B. gemäß WO 2012/150001).

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen Verbindungen und elektronische Vorrichtungen, insbesondere organische Elektrolumineszenzvorrichtungen, enthaltend die erfindungsgemäßen Verbindungen weisen die folgenden Eigenschaften auf:
1) Die Verbindungen eignen sich sehr gut als Sensitizer für fluoreszente (hyperphosphoreszente) OLEDs. Dabei zeigen sie insbesondere einen effizienten Energieübertrag, sowie geringe Einsatzspannungen und eine lange Lebensdauer.
2) Die Verbindungen, eingesetzt als phosphoreszierende Emitter, führen zu einer hohen Effizienz, einer guten Lebensdauer und einer geringen Betriebsspannung auf. Dabei kann je nach Wahl des Liganden tiefblaue bis tiefrote Emission erzielt werden.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen. Bei Verbindungen, die mehrere enantiomere, diastereomere oder tautomere Formen aufweisen können, wird eine Form stellvertretend gezeigt.

### Beispiel Ir1:

### a) Chloro-Carbonyl-Komplex Ir1a

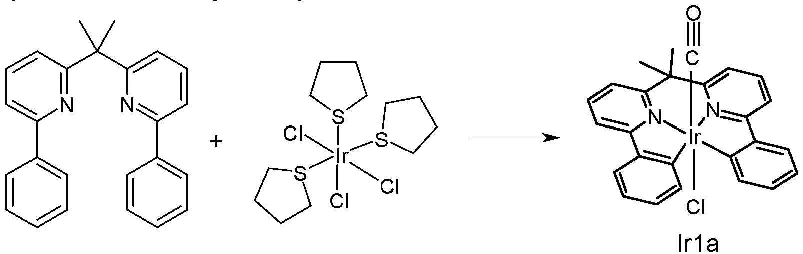

Ein Gemisch aus 3.50 g (10.0 mmol) 2,2'-(1-Methylethylidene)bis-(6-phenyl-pyridin) [1056047-22-3], 5.66 g (10.0 mmol) mer-Trichloro-tris-(tetrahydrothiophen-κS)iridium(III) [35925-64-5], 3.5 ml (30.0 mmol) 2,6-Dimethylpyridin [108-48-5] und 100 ml Ethylenglycol wird 70 h bei 180 °C unter einer Kohlenmonoxid-Atmosphäre gerührt. Man lässt auf 80 °C erkalten, fügt 300 ml Wasser zu und extrahiert die Reaktionsmischung dreimal mit je 200 ml Dichlormethan (DCM). Die vereinigten organischen Phasen werden dreimal mit je 200 ml Wasser und einmal mit 200 ml gesättigter Kochsalzlösung gewaschen und über Magnesiumsulfat getrocknet. Man filtriert vom Trockenmittel ab, wäscht dieses mit etwas DCM nach und engt zur Trockene ein. Der Rückstand wird mit DCM an Kieselgel chromatographiert, gelber Spot, R_{f} ca. 0.4. Die Produktfraktionen werden am Rotationsverdampfer eingeengt, wobei das abrotierte DCM kontinuierlich durch Methanol (MeOH) ersetzt wird. Der gelbe Feststoff wird abfiltriert, dreimal mit je 10 ml MeOH gewaschen und dann im Vakuum getrocknet. Ausbeute: 2.91 g (4.8 mmol), 48 %; Reinheit: 97 %ig nach ¹H-NMR.

### b) Cyano-Carbonyl-Komplex Ir1b

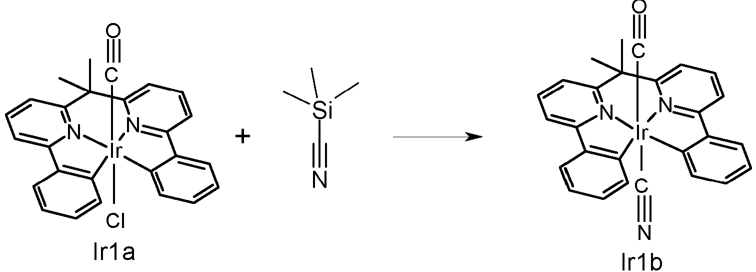

Eine Suspension von 6.04 g (10.0 mmol) Ir1a in 300 ml Acetonitril (MeCN) wird mit 38.0 ml (300 mmol) Trimethylsilylcyanid versetzt und bis zum vollständigen Umsatz (Reaktionskontrolle via ¹H-NMR, ca. 80 h) unter Rückfluss erhitzt. Man entfernt zwei Drittel des Lösungsmittels im Vakuum, erhitzt die Reaktionsmischung noch einmal kurz unter kräftigem Rückfluss, lässt unter Rühren auf Raumtemperatur erkalten und rührt dann unter Kühlung im Eisbad 4 h nach. Man saugt vom ausgefallenen mikrokristallinen Niederschlag ab, wäscht diesen zweimal mit je 20 ml n-Heptan nach und trocknet im Vakuum. Durch Einengen der Mutterlauge lässt sich eine weitere Produktfraktion gewinnen. Ausbeute: 4.64 g (7.8 mmol), 78 %; Reinheit: 97 %ig nach ¹H-NMR.

### c) Cyano-tert-Butyl-isonitril-Komplex Ir1

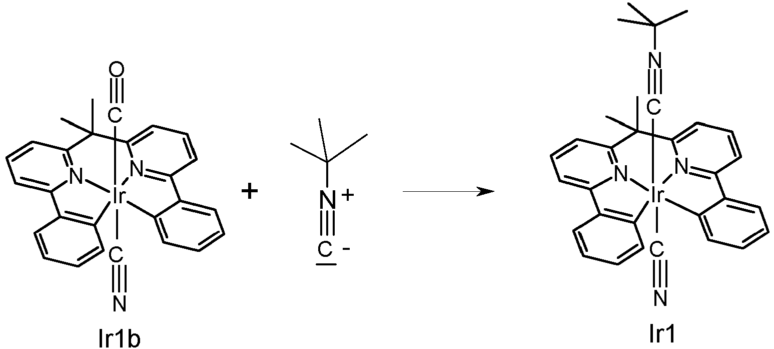

Ein Gemisch aus 5.95 g (10.0 mmol) Ir1b, 8.31 g (100 mmol) tert-Butyliso-nitril [7188-38-7] und 100 ml DMSO wird 18 h im Rührautoklaven auf 140 °C erhitzt. Nach Erkalten werden alle flüchtigen Bestandteile bei 100 °C im Vakuum entfernt. Der Rückstand wird mit DCM/n-Heptan (5:1) an Kieselgel chromatographiert, gelber Spot, R_{f} ca. 0.6. Die Produktfraktionen werden am Rotationsverdampfer eingeengt, bis das DCM entfernt ist. Das Produkt wird abfiltriert, zweimal mit n-Heptan gewaschen und im Vakuum getrocknet. Die weitere Reinigung erfolgt durch wiederholte Heißextraktionskristallisation aus DCM/Acetonitril-Gemischen (1:3 bis 2:1) und anschließende fraktionierte Sublimation bzw. Tempern im Hochvakuum. Ausbeute: 3.38 g (5.2 mmol), 52 %; Reinheit: ca. 99.9 %ig nach ¹H-NMR.

Analog können folgende Verbindungen dargestellt werden:

| Bsp. | Ligand iso-Nitril | Komplex | Ausbeute |
|---|---|---|---|
| Ir2 | 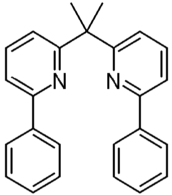 1056047-22-3 | 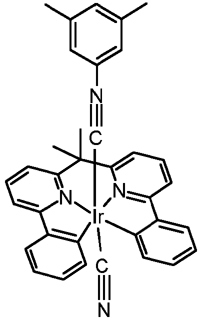 | 23 % |
| | 20600-56-0 | | |
| Ir3 | 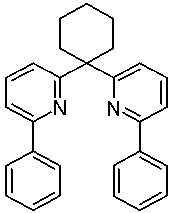 1777013-41-8 | 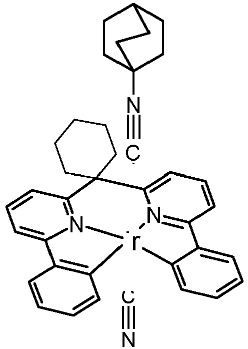 | 25 % |
| | 104876-26-8 | | |
| Ir4 | 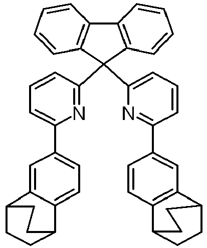 1801620-64-3 | 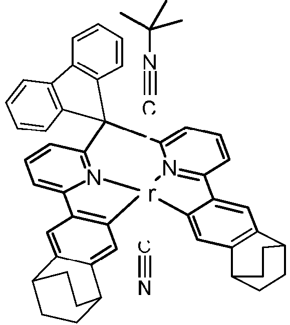 | 20 % |
| | 7188-38-7 | | |
| Ir5 | 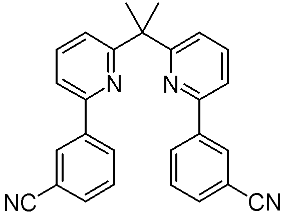 881829-69-2 | 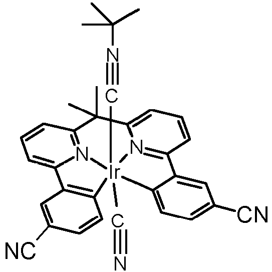 | 22 % |
| | 7188-38-7 | | |
| Ir6 | 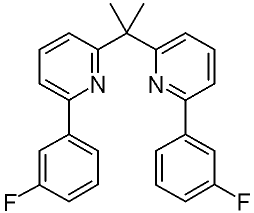 881829-72-7 | 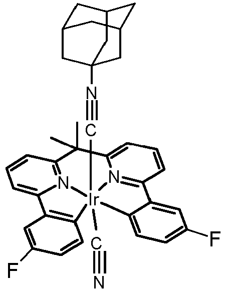 | 28 % |
| | 22110-53-8 | | |
| Ir7 | 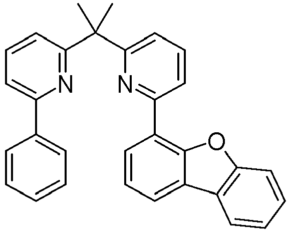 1777013-37-2 | 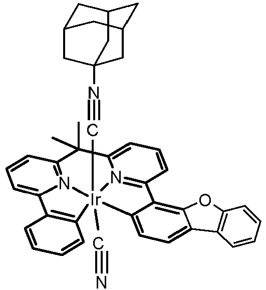 | 30 % |
| | 22110-53-8 | | |
| Ir8 | 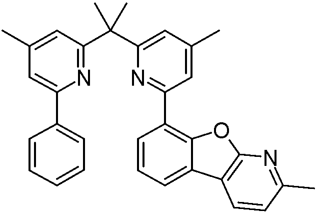 2015994-30-4 | 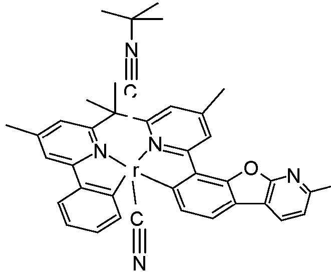 | 28 % |
| | 7188-38-7 | | |
| Ir9 | 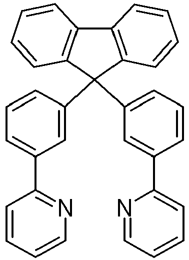 851540-91-5 | 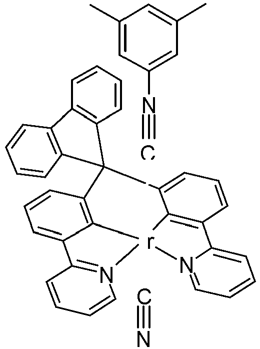 | 19 % |
| | 20600-56-0 | | |
| Ir10 | 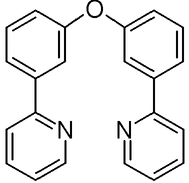 1875090-77-9 | 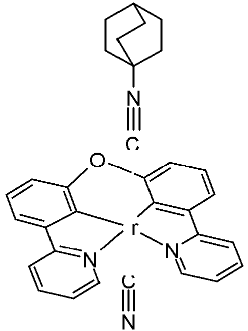 | 33 % |
| | 104876-26-8 | | |
| Ir11 | 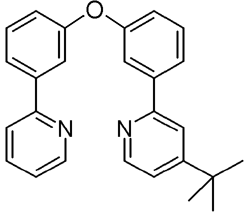 2307698-74-2 | 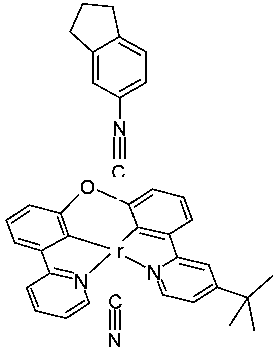 | 30 % |
| | 344933-12-6 | | |
| Ir12 | 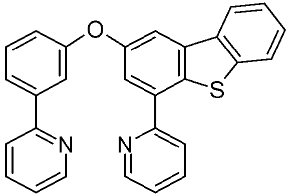 1777013-15-6 | 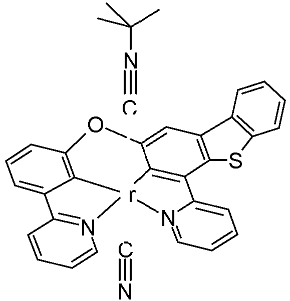 | 25 % |
| | 7188-38-7 | | |
| Ir13 | 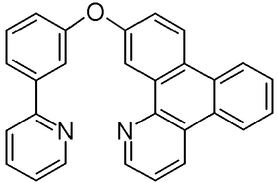 2307699-06-3 | 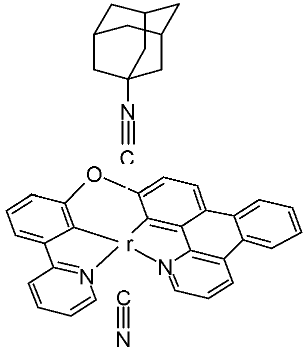 | 27 % |
| Ir14 | 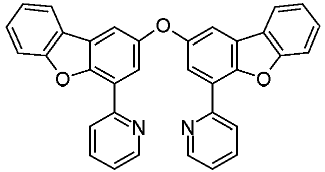 1777013-19-0 | 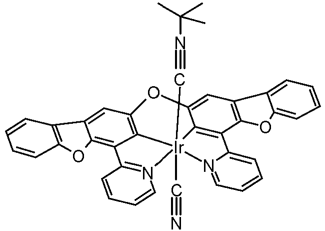 | 29 % |
| | 7188-38-7 | | |
| Ir15 | 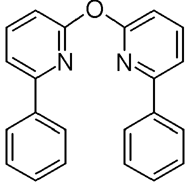 851540-70-0 | 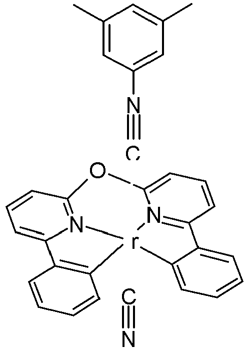 | 34 % |
| | 20600-56-0 | | |
| Ir17 | 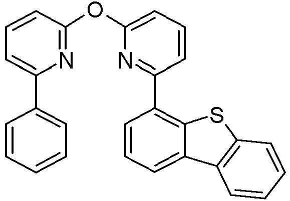 1777012-58-4 | 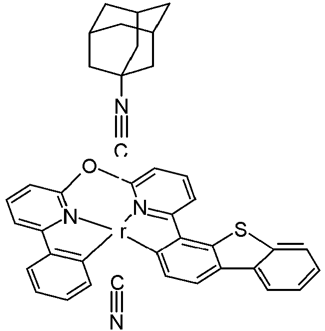 | 30 % |
| Ir18 | 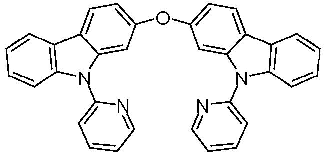 1446096-29-2 | 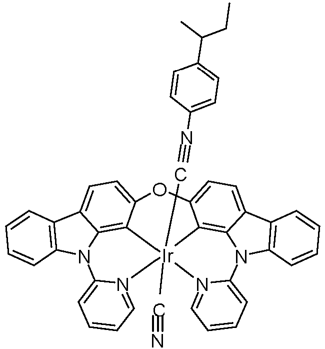 | 28 % |
| | 602262-02-2 | | |
| Ir19 | 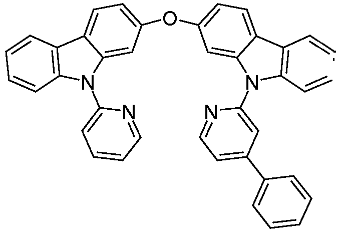 1566579-88-1 | 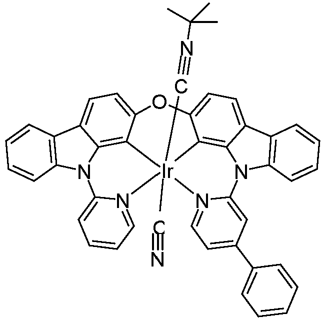 | 27 % |
| | 7188-38-7 | | |
| Ir20 | 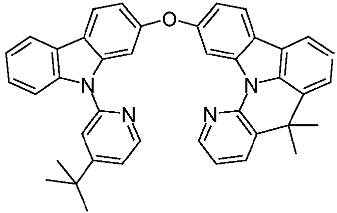 2054934-85-7 | 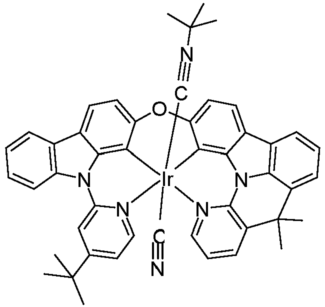 | 24 % |
| | 7188-38-7 | | |
| Ir21 | 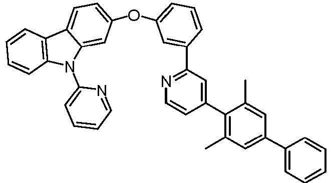 1619937-91-5 | 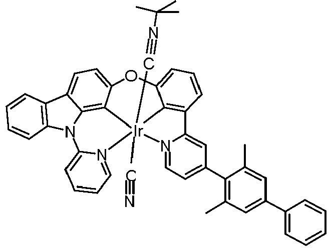 | 27 % |
| | 7188-38-7 | | |
| Ir22 | 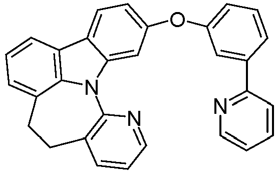 2305841-75-0 | 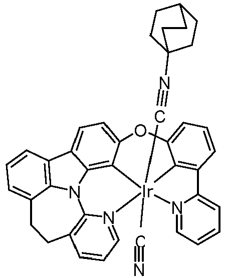 | 30 % |
| | 104876-26-8 | | |
| Ir23 | 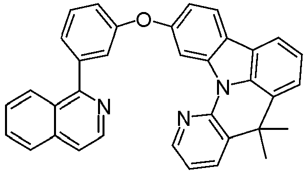 2054934-52-8 | 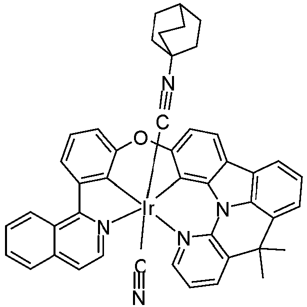 | 25 % |
| | 104876-26-8 | | |
| Ir24 | 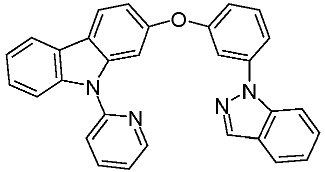 1700619-29-9 | 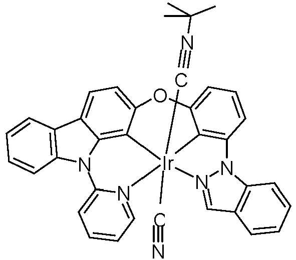 | 31 % |
| | 7188-38-7 | | |
| Ir25 | 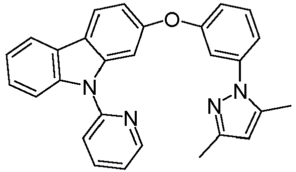 1393812-52-6 | 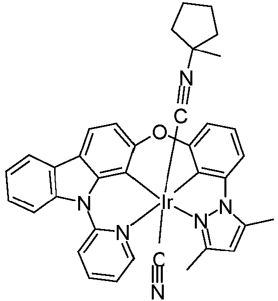 | 26 % |
| | 86559-19-5 | | |
| Ir26 | 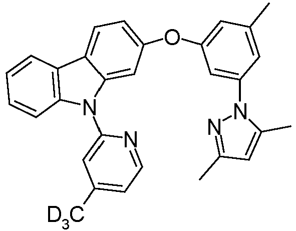 2230981-86-7 | 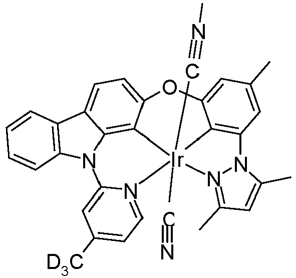 | 23 % |
| Ir27 | 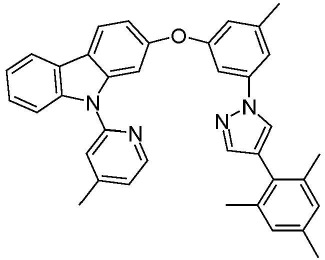 2244957-00-2 | 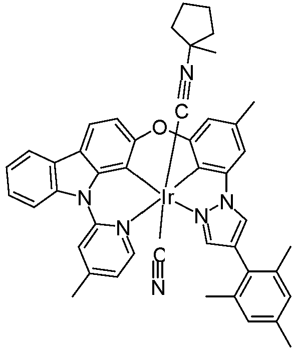 | 24 % |
| | 86559-19-5 | | |
| Ir28 | 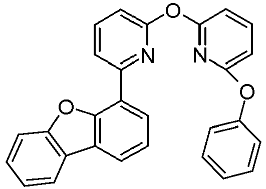 1777013-08-7 | 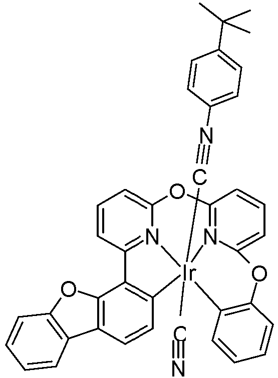 | 19 % |
| | 602262-03-3 | | |
| Ir29 | 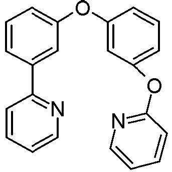 125142-49-9 | 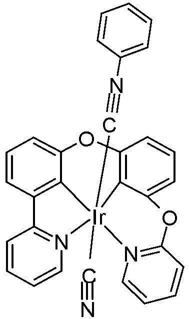 | 21 % |
| | 931-54-4 | | |
| Ir30 | 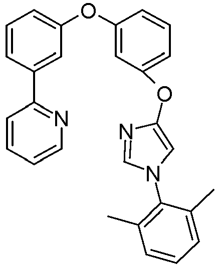 1424362-06-0 | 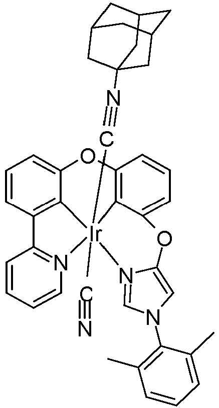 | 23 % |
| | 22110-53-8 | | |
| Ir31 | 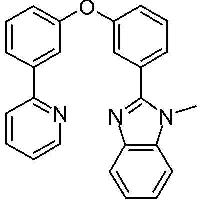 2307699-07-4 | 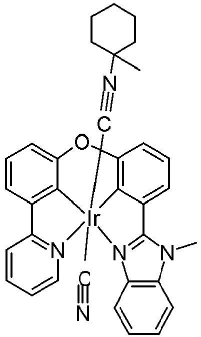 | 26 % |
| | 86559-21-9 | | |
| Ir32 | 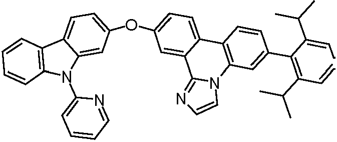 2459309-96-5 | 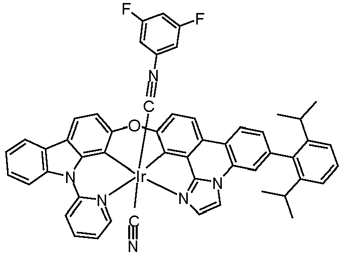 | 25 % |
| | 1603834-13-4 | | |
| Ir33 | 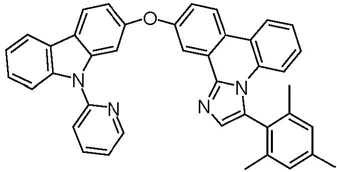 2133338-99-3 | 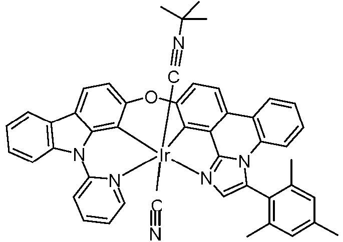 | 28 % |
| | 7188-38-7 | | |
| Ir34 | 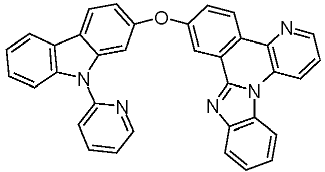 2252376-55-7 | 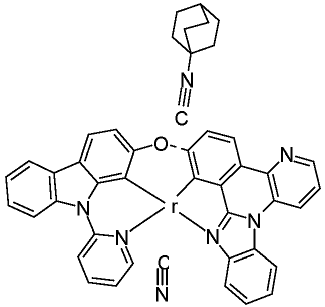 | 25 % |
| | 104876-26-8 | | |
| Ir35 | 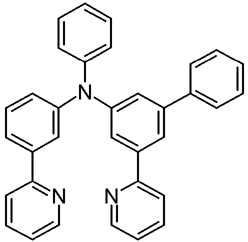 1546890-05-4 | 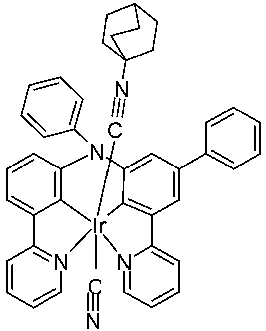 | 32 % |
| | 104876-26-8 | | |
| Ir36 | 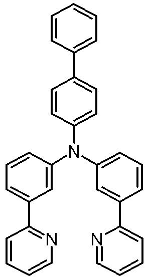 1366293-31-3 | 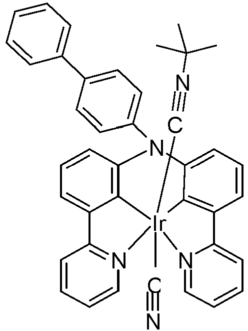 | 33 % |
| | 7188-38-7 | | |
| Ir37 | 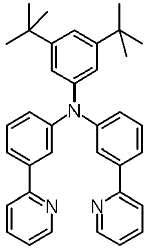 851540-64-2 | 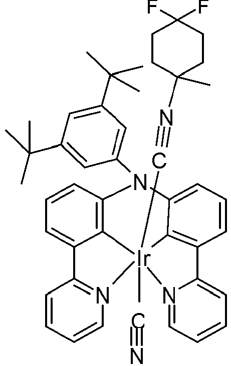 | 31 % |
| | 1000698-98-5 | | |
| Ir38 | 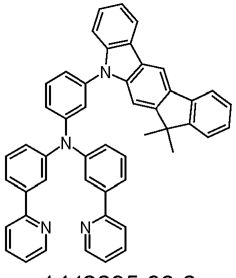 14458295-96-2 | 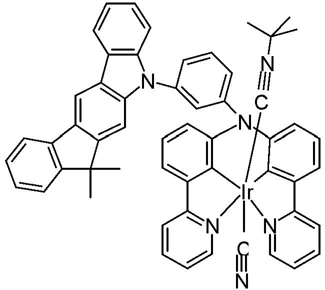 | 30 % |
| | 7188-38-7 | | |
| Ir39 | 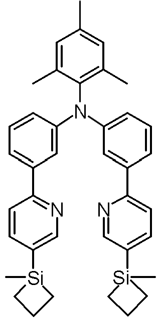 2084131-70-2 | 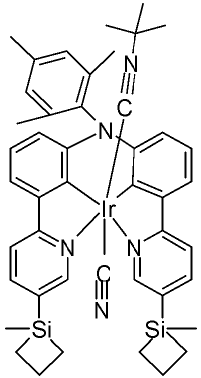 | 18 % |
| | 7188-38-7 | | |
| Ir40 | 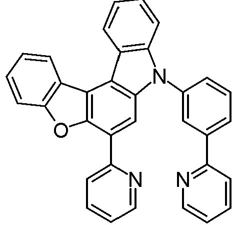 1777013-53-2 | 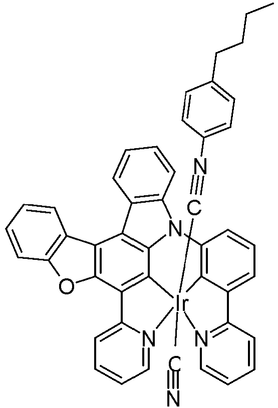 | 25 % |
| | 141399-15-7 | | |
| Ir41 | 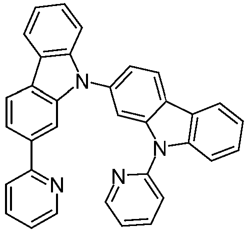 1619937-87-9 | 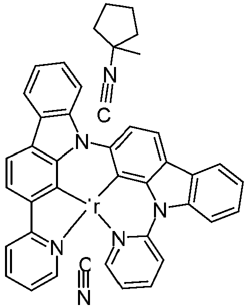 | 24 % |
| | 86559-19-5 | | |
| Ir42 | 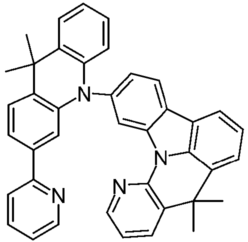 2054935-53-2 | 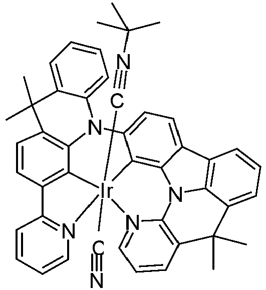 | 23 % |
| | 7188-38-7 | | |
| Ir43 | 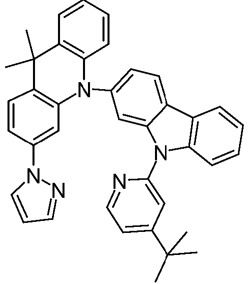 1835794-90-5 | 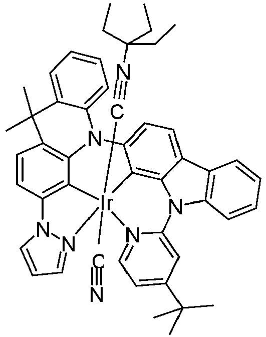 | 27 % |
| | 86559-23-1 | | |
| Ir44 | 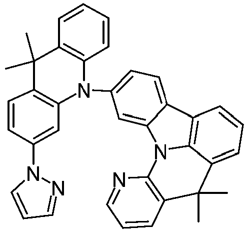 2054935-50-9 | 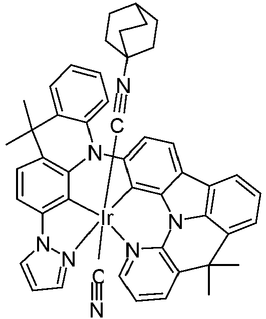 | 22 % |
| | 104876-26-8 | | |
| Ir45 | 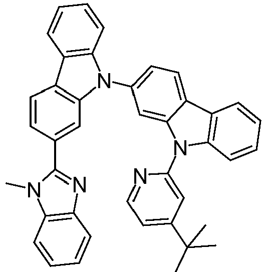 1792967-95-3 | 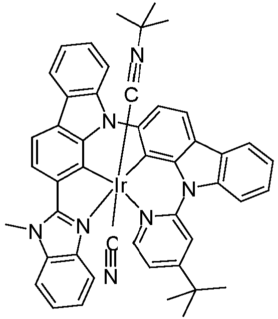 | 25 % |
| | 7188-38-7 | | |
| Ir46 | 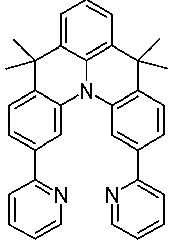 1414372-83-0 | 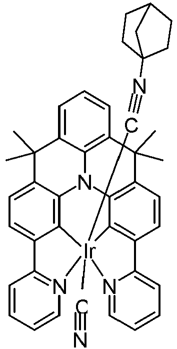 | 26 % |
| | 88523-51-7 | | |
| Ir47 | 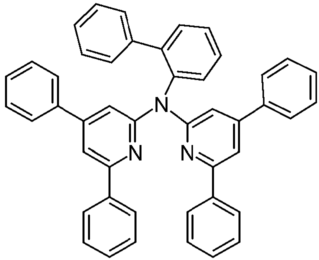 2412026-94-7 | 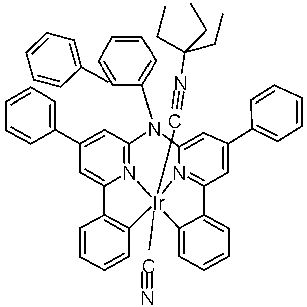 | 21 % |
| | 86559-23-1 | | |
| Ir48 | 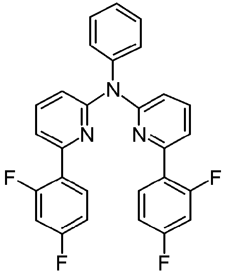 851540-66-4 | 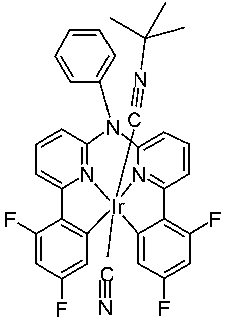 | 23 % |
| | 7188-38-7 | | |
| Ir49 | 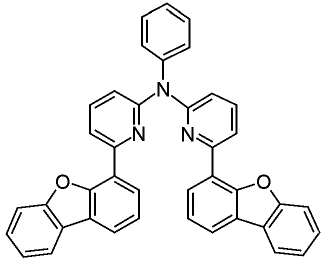 1777012-67-5 | 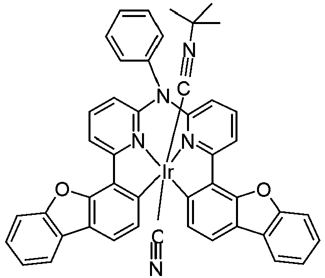 | 31 % |
| | 7188-38-7 | | |
| Ir50 | 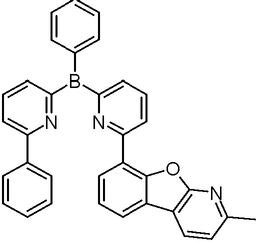 US20160285014 | 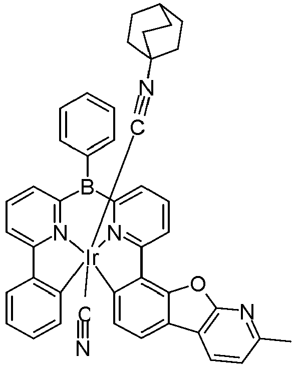 | 29 % |
| | 104876-26-8 | | |
| Ir51 | 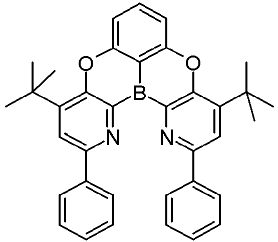 US20200388774 | 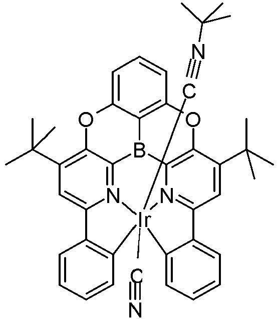 | 17 % |
| | 7188-38-7 | | |
| Ir52 | 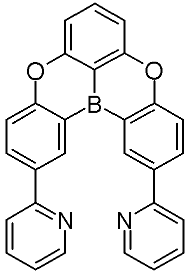 2446054-80-2 | 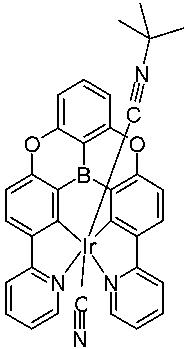 | 22 % |
| | 7188-38-7 | | |
| Ir53 | 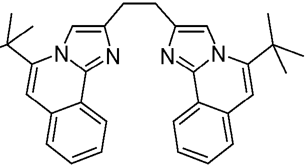 1238293-13-4 | 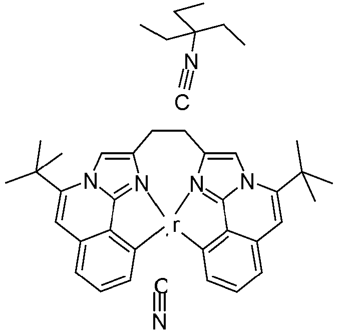 | 33 % |
| | 86559-23-1 | | |
| Ir54 | 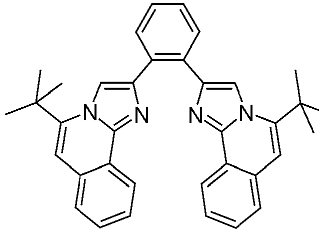 1238293-14-5 | 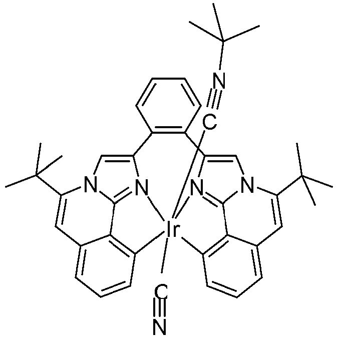 | 27 % |
| | 7188-38-7 | | |
| Ir55 | 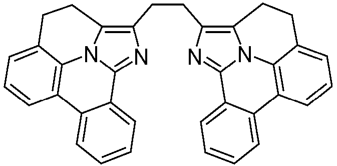 1821646-69-8 | 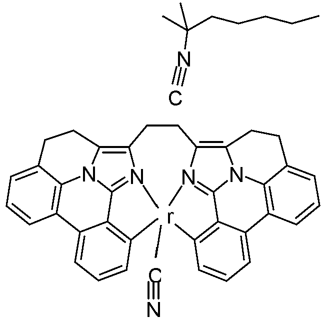 | 24 % |
| | 88523-50-6 | | |
| Ir56 | 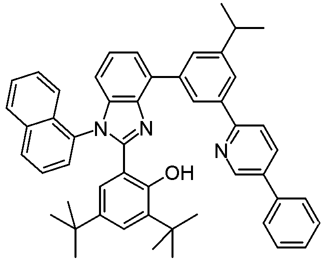 EP3266790 | 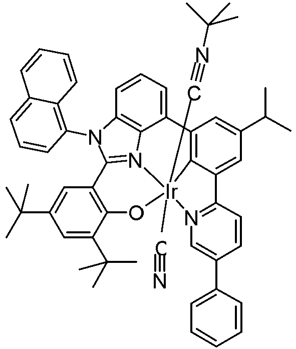 | 28 % |
| | 7188-38-7 | | |
| Ir57 | 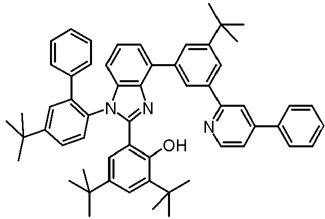 EP3266790 | 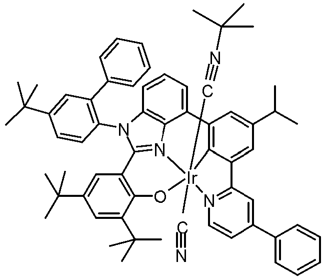 | 32 % |
| | 7188-38-7 | | |
| Ir58 | 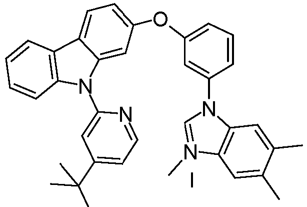 2460489-47-6 | 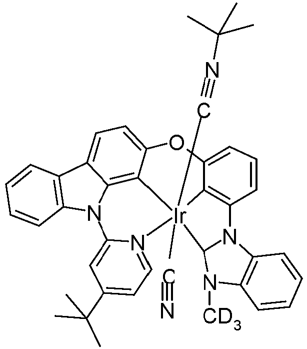 | 23 % |
| | 7188-38-7 | | |
| | Zusatz von 20 mmol NaO-t-Bu | | |
| Ir59 | 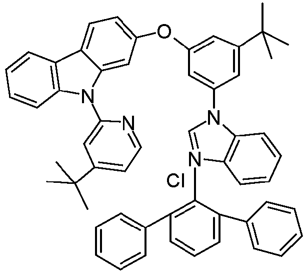 2307700-20-3 | 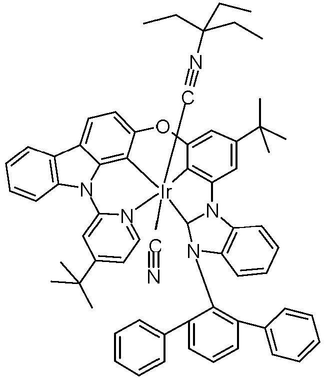 | 21 % |
| | 86559-23-1 | | |
| | Zusatz von 20 mmol NaO-t-Bu | | |

### Iso-Nitrile:

| | | | |
|---|---|---|---|
| 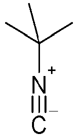 7188-38-7 | 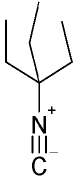 86559-23-1 | 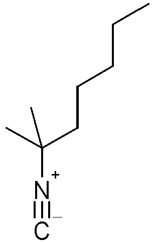 88523-50-6 | 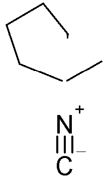 86559-19-5 |
| 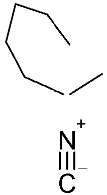 86559-21-9 | 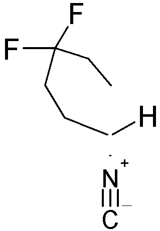 1000698-98-5 | 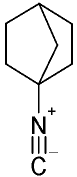 88523-51-7 | 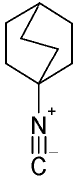 104876-26-8 |
| 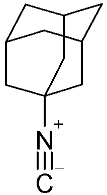 22110-53-8 | 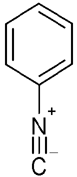 931-54-4 | 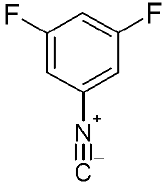 1603834-13-4 | 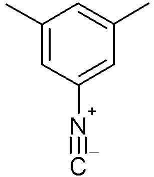 20600-56-0 |
| 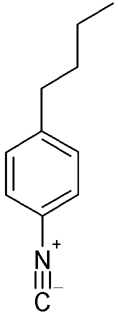 141399-15-7 | 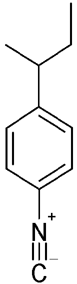 602262-02-2 | 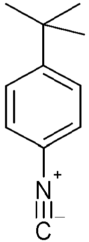 602262-03-3 | 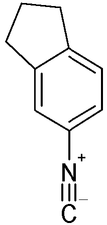 344933-12-6 |

### Herstellung von OLED-Bauteilen

### 1) Vakuum-prozessierte Bauteile:

Die erfindungsgemäßen Verbindungen lassen sich unter anderem als Dotand in der Emissionsschicht in Phosphoreszenz- und in Hyperphosphoreszenz-OLED-Bauteilen einsetzen.

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Gereinigte Glasplättchen (Reinigung in Miele Laborspülmaschine, Reiniger Merck Extran), die mit strukturiertem ITO (Indium Zinn Oxid) der Dicke 50 nm beschichtet sind werden 25 Minuten mit UV-Ozon vorbehandelt (UV-Ozon Generator PR-100, Firma UVP) und innerhalb 30min zur verbesserten Prozessierung mit 20 nm PEDOT:PSS beschichtet (Poly(3,4-ethylen-dioxythiophen)poly(styrolsulfonat), bezogen als CLEVIOS^{™} P VP AI 4083 von Heraeus Precious Metals GmbH Deutschland, aus wässriger Lösung aufgeschleudert) und anschließend bei 180 °C 10 min. lang ausgeheizt. Diese beschichteten Glasplättchen bilden die Substrate, auf welche die OLEDs aufgebracht werden. Nach der Herstellung werden die OLEDs zum Schutz gegen Sauerstoff und Wasserdampf verkapselt. Der genaue Schichtaufbau der elektrolumineszierenden OLEDs ist den Beispielen zu entnehmen. Die zur Herstellung der OLEDs benötigten Materialien sind in Tabelle 8 gezeigt.

Die OLEDs werden standardmäßig charakterisiert. Hierfür werden die Elektrolumineszenzspektren, die Stromeffizienz (gemessen in cd/A), die Leistungseffizienz (gemessen in lm/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik. Die Elektrolumineszenzspektren werden bei einer Leuchtdichte von 100 cd/m² bestimmt und daraus die Emissionsfarbe entnommen.

### Phosphoreszenz-OLED- Bauteile:

Alle Materialien werden in einer Vakuumkammer thermisch aufgedampft. Dabei besteht die Emissionsschicht (EML) aus mindestens einem Matrixmaterial (Hostmaterial, Wirtsmaterial) TMM und einem emittierenden Dotierstoff (Dotand, Emitter) Ir, der dem Matrixmaterial bzw. den Matrixmaterialien durch Co-Verdampfung in einem bestimmten Volumenanteil beigemischt wird. Eine Angabe wie TMM:Ir (92%:8%) bedeutet hierbei, dass das Material TMM in einem Volumenanteil von 92% und der Dotand Ir in einem Volumenanteil von 8% in der Schicht vorliegt. Es kann aber auch eine Mischung von zwei oder mehreren Matrixmaterialien (Hostmaterialien, Wirtsmaterialien) TMM1, TMM2, usw. und einem emittierenden Dotierstoff (Dotand, Emitter) Ir eingesetzt werden (siehe Tabelle 1). Die Matrixmaterialien TMM1, TMM2 können dabei einzeln aus zwei verschiedenen Quellen oder aber als Gemisch aus einer Quelle (premixed Host) verdampft werden. Analog kann auch die Elektronentransportschicht aus einer Mischung zweier Materialien bestehen, z. B. wie hier aus ETM2 (50%) und ETM3 (50%) (siehe Tabelle 1). Die zur Herstellung der OLEDs verwendeten Materialien sind in Tabelle 7 gezeigt.

### Blaue Phosphorezenz-OLED-Bauteile BP:

Die OLEDs haben prinzipiell folgenden Schichtaufbau:
Substrat // Lochinjektionsschicht 1 (HIL1) aus HTM1 dotiert mit 5 % NDP-9 (kommerziell erhältlich von der Fa. Novaled), 20 nm // Lochtransportschicht 1 (HTL1), HTM1, 180 nm // Lochtransportschicht 2 (HTL2), siehe Tabelle 1 // Emissionsschicht (EML), siehe Tabelle 1 // Elektronentransportschicht (ETL1), siehe Tabelle 1 // Elektronentransportschicht (ETL2) aus ETM2 (50%) und ETM3 (50%), 20 nm // Kathode aus Aluminium, 100 nm.

**Tabelle 1: Aufbau Blaue Fluoreszenz-OLED- Bauteile**

| **Bsp.** | **HTL2** | **EML** | **ETL1** |
|---|---|---|---|
| **D-BP1** | HTM2 | TMM1:TMM2:Ir1 (46%:46%:8%) | ETM1 |
| | 20 nm | | 10 nm |
| | | 25 nm | |
| **D-BP2** | HTM2 | TMM1:TMM2:Ir53 (50%:42%:8%) | ETM1 |
| | 20 nm | | 10 nm |
| | | 25 nm | |

**Tabelle 2: Ergebnisse**

| **Bsp.** | **EQE (%) 100 cd/m²** | **Spannung (V) 100 cd/m²** | **Farbe CIE(x/y)** |
|---|---|---|---|
| **D-BP1** | 18.2 | 3.3 | 0.17/0.33 |
| **D-BP2** | 19.3 | 3.5 | 0.15/0.25 |

### Hyperphosphoreszenz-OLED-Bauteile:

Alle Materialien werden in einer Vakuumkammer thermisch aufgedampft. Dabei besteht die Emissionsschicht (EML) bzw. die Emissionsschichten immer aus mindestens einem oder aber mehreren Matrixmaterialien (Hostmaterialien, Wirtsmaterialien) TMM, einem (phosphoreszierenden) Sensitizer Ir und einem fluoreszierenden Emitter FE. Der Sensitizer Ir und der fluoreszierende Emitter FE werden dem/den Hostmaterialien TMM durch Co-Verdampfung in einem bestimmten Volumenanteil beigemischt. Eine Angabe wie TMM:Ir:FE (92%:5%:3%) bedeutet hierbei, dass das Material TMM in einem Volumenanteil von 92%, Ir in einem Volumenanteil von 5% und FE in einem Volumenanteil von 3% in der Schicht vorliegt. Eine Angabe wie TMM1:TMM2:Ir:FE (46%:46%:5%:3%) bedeutet hierbei, dass das Material TMM1 in einem Volumenanteil von 46%, das Material TMM2 in einem Voluemnanteil von 46%, Ir in einem Volumenanteil von 5% und FE in einem Volumenanteil von 3% in der Schicht vorliegt.

### Blaue Hyperphosphoreszenz-OLED-Bauteile BH:

Die OLEDs haben prinzipiell folgenden Schichtaufbau:
Substrat // Lochinjektionsschicht 1 (HIL1) aus HTM1 dotiert mit 5 % NDP-9 (kommerziell erhältlich von der Fa. Novaled), 20 nm // Lochtransportschicht 1 (HTL1), siehe Tabelle 3 // Emissionsschicht (EML), siehe Tabelle 3 // Elektronentransportschicht (ETL1), siehe Tabelle 3 // Elektronentransportschicht (ETL2) aus ETM2 (50%) und ETM3 (50%), 20 nm // Kathode aus Aluminium, 100 nm.

**Tabelle 3: Aufbau blaue Hyperphosphoreszenz-OLED-Bauteile**

| **Bsp.** | **HTL1** | **EML** | **ETL1** |
|---|---|---|---|
| **D-BH1** | HTM2 | TMM1:TMM2:Ir1:FE1 (40%:50%:8%:2%) | ETM1 |
| | 10 nm | | 10 nm |
| | | 25 nm | |
| **D-BH2** | HTM2 | TMM1:TMM2:Ir53:FE2 (60%:32%:6%:2%) | ETM1 |
| | 10 nm | | 10 nm |
| | | 25 nm | |

**Tabelle 4: Ergebnisse**

| **Bsp.** | **EQE (%) 100 cd/m²** | **Spannung (V) 100 cd/m²** | **Farbe CIE(x/y)** |
|---|---|---|---|
| **D-BH1** | 19.9 | 3.4 | 0.16/0.22 |
| **D-BH2** | 17.0 | 3.5 | 0.15/0.08 |

### Grüne Hyperphosphoreszenz-OLED-Bauteile GH:

Die OLEDs haben prinzipiell folgenden Schichtaufbau:
Substrat // Lochinjektionsschicht 1 (HIL1) aus HTM1 dotiert mit 5 % NDP-9 (kommerziell erhältlich von der Fa. Novaled), 20 nm // Lochtransportschicht 1 (HTL1) aus HTM1, 30 nm // Lochtransportschicht 2 (HTL2), siehe Tabelle 5 // Emissionsschicht (EML), siehe Tabelle 5 // Elektronentransportschicht (ETL1), siehe Tabelle 5 // Elektronentransportschicht (ETL2) aus ETM2 (50%) und ETM3 (50%), 30 nm // Kathode aus Aluminium, 100 nm.

**Tabelle 5: Aufbau grüne Hyperphosphoreszenz-OLED-Bauteile**

| **Bsp.** | **HTL2** | **EML** | **ETL2** |
|---|---|---|---|
| **GH1** | HTM2 | TMM1:TMM2:Ir10:FE3 | ETM1 |
| | 10 nm | (40%:50%:9%:1%) | 10 nm |
| | | 20 nm | |

**Tabelle 6: Ergebnisse**

| **Bsp.** | **EQE (%) 100 cd/m²** | **Spannung (V) 100 cd/m²** | **Farbe CIE(x/y)** |
|---|---|---|---|
| **GH1** | 20.6 | 3.2 | 0.32 / 0.65 |

### 2) Lösungs-prozessierte Devices:

### Aus niedermolekularen löslichen Funktionsmaterialien

Die erfindungsgemäßen Verbindungen können auch aus Lösung verarbeitet werden und führen dort zu prozesstechnisch wesentlich einfacheren OLEDs im Vergleich zu vakuumprozessierten OLEDs mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in WO 2004/037887). Der Aufbau setzt sich aus Substrat // ITO // Lochinjektionsschicht, 60 nm // Interlayer, 20 nm // Emissionsschicht, 60 nm // Lochblockierschicht, 10 nm // Elektronentransportschicht, 40 nm // Kathode zusammen. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht (PEDOT:PSS von Clevios^{™}) durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, wobei in diesem Fall HL-X von Merck verwendet wird. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices enthalten eine Emissionsschicht aus TMM3:TMM4:Ir (w%:x%:z%), wobei sich hier die %-Angaben auf Gew.-% beziehen, siehe Tabelle 7. Die Emissionsschicht wird in einer Inertgasatmosphäre, im vorliegenden Fall Argon, aufgeschleudert und 10 min bei 160 °C ausgeheizt. Darüber wird die Lochblockierschicht (10 nm ETM2) und die Elektronentransportschicht (40 nm ETM2 (50%) / ETM3 (50%)) aufgedampft (Aufdampfanlagen von Lesker o.a., typischer Aufdampfdruck 5 x 10⁻⁶ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert. Tabelle 7 fasst die erhaltenen Daten zusammen.

**Tabelle 7: Ergebnisse mit aus Lösung prozessierten Materialien**

| **Bsp.** | **Emissionsschicht** | **EQE** (%) | **Spannung** (V) | **Farbe** |
|---|---|---|---|---|
| | | 100 cd/m² | 100 cd/m² | |
| Sol-D1 | TMM3:TMM4: Ir23 (20%:60%:20%) | 15.7 | 3.9 | rot |
| Sol-D2 | TMM3:TMM4: Ir40 (20%:60%:20%) | 14.1 | 4.1 | rot |
| Sol-D3 | TMM3:TMM4: Ir41 (20%:60%:20%) | 14.5 | 4.2 | rot |
| Sol-D4 | TMM3: TMM4: Ir51 (20%:60%:20%) | 7.0 | 4.9 | rot |
| Sol-D5 | TMM3:TMM4:Ir12 (20%:60%:20%) | 13.2 | 3.8 | gelb |
| Sol-D6 | TMM3:TMM4: Ir13 (20%:60%:20%) | 14.6 | 3.8 | gelb |
| Sol-D7 | TMM3:TMM4: Ir14 (20%:60%:20%) | 17.2 | 3.7 | gelb |
| Sol-D8 | TMM3:TMM4: Ir7 (20%:60%:20%) | 16.8 | 4.3 | grün |

**Tabelle 8: Strukturformeln der verwendeten Materialien**

| | |
|---|---|
| 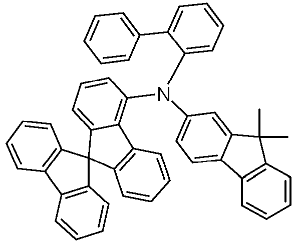 HTM1 **[1450933-44-4]** | 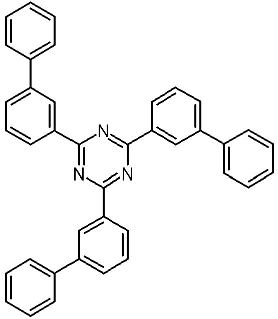 TMM1 / ETM1 [1201800-83-0] |
| 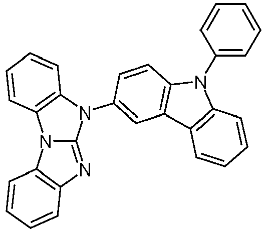 HTM2 / TMM2 [1401068-29-8] | 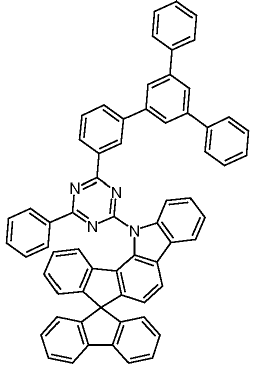 TMM3 [1616231-60-7] |
| 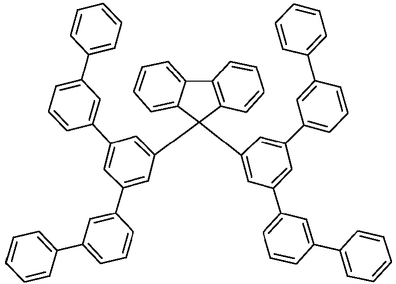 TMM4 1246496-85-4 | 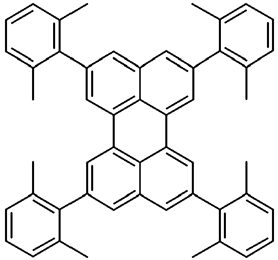 [2247139-17-7] FE1 |
| 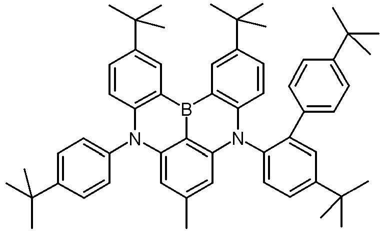 [2182628-29-9] FE2 | 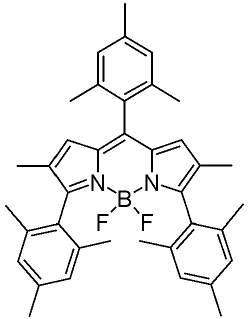 [850219-92-0] FE3 |
| 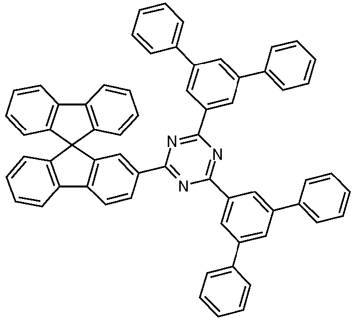 ETM2 [1233200-52-6] | 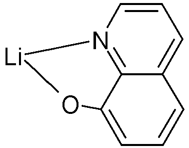 ETM3 [25387-93-3] |

## Patentansprüche

1. Verbindung der Formel (1),
Ir(L)(CN)(CN-R*) Formel (1),
wobei für die verwendeten Symbole gilt:
R* ist eine Alkylgruppe mit 1 bis 20 C-Atomen, die durch einen oder mehrere Reste R¹ substituiert sein kann, oder ein aromatisches oder heteroaromatisches Ringsystem mit 5 bis 30 aromatischen Ringatomen, das durch einen oder mehrere Reste R¹ substituiert sein kann;
L ist ein tetradentater Ligand der Formel (2), 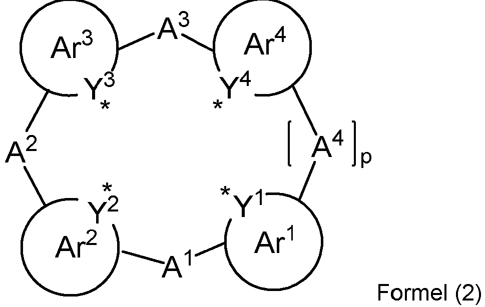
wobei der tetradentate Ligand quadratisch-planar oder näherungsweise quadratisch-planar an das Iridium koordiniert und der Cyanoligand (CN) und der Isonitrilligand (CN-R*)-im (pseudo)oktaedrischen Komplex trans-ständig oberhalb und unterhalb der Ebene, die durch das Iridium und den tetradentaten Liganden gebildet wird, angeordnet sind;
wobei * jeweils die Koordination an das Iridium kennzeichnet und für die Symbole und Indizes gilt:
Y¹, Y², Y³, Y⁴ ist gleich oder verschieden bei jedem Auftreten gewählt aus der Gruppe bestehend aus C, N oder C-O⁻, mit der Maßgabe, dass mindestens eine der Gruppen Y¹, Y², Y³ und Y⁴ für C steht und dass zwei der Gruppen Y¹, Y², Y³ und Y⁴ über ein anionisches Kohlenstoffatom, ein anionisches Stickstoffatom oder C-O⁻ an das Iridium koordinieren und die anderen beiden der Gruppen Y¹, Y², Y³ und Y⁴ über ein neutrales Stickstoffatom oder ein Carbenkohlenstoffatom an das Iridium koordinieren;
Ar¹, Ar², Ar³, Ar⁴ ist gleich oder verschieden bei jedem Auftreten und ist zusammen mit der Gruppe Y¹, Y², Y³ bzw. Y⁴ eine Arylgruppe mit 6 bis 16 aromatischen Ringatomen oder eine Heteroarylgruppe mit 5 bis 16 aromatischen Ringatomen oder ein aliphatisches Carben mit 5 bis 10 Ringatomen, wobei die Aryl- bzw. Heteroarylgruppe bzw. das aliphatische Carben jeweils durch einen oder mehrere Reste R substituiert sein kann;
A¹, A², A³, A⁴ ist gleich oder verschieden bei jedem Auftreten und ist gewählt aus der Gruppe bestehend aus einer Einfachbindung, CR₂, BR, NR, O, S, CR₂-CR₂, CR=CR, einer ortho-verknüpften Phenylengruppe, welche mit einem oder mehreren Resten R substituiert sein kann, C(=CR₂) oder CR=N;
p ist 0 oder 1, wobei p = 0 bedeutet, dass die Gruppe A⁴ nicht anwesend ist und anstelle von A⁴ Reste R in den entsprechenden Positionen von Ar¹ und Ar⁴ gebunden sein können;
R ist bei jedem Auftreten gleich oder verschieden H, D, F, Cl, Br, I, N(R¹)₂, OR¹, SR¹, CN, NO₂, COOH, C(=O)N(R¹)₂, Si(R¹)₃, Ge(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl- , Alkenyl- oder Alkinylgruppe jeweils mit einem oder mehreren Resten R¹ substituiert sein kann und wobei eine oder mehrere nicht benachbarte CH₂-Gruppen durch Si(R¹)₂, C=O, NR¹, O, S oder CONR¹ ersetzt sein können, oder ein aromatisches oder heteroaromatisches Ringsystem mit 5 bis 40 aromatischen Ringatomen, das jeweils durch einen oder mehrere Reste R¹ substituiert sein kann; dabei können zwei Reste R auch miteinander ein mono- oder polycyclisches, aliphatisches, heteroaliphatisches, aromatisches oder heteroaromatisches Ringsystem bilden;
R¹ ist bei jedem Auftreten gleich oder verschieden H, D, F, Cl, Br, I, N(R²)₂, OR², SR², CN, NO₂, Si(R²)₃, Ge(R²)₃, B(OR²)₂, C(=O)R², P(=O)(R²)₂, S(=O)R², S(=O)₂R², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere nicht benachbarte CH₂-Gruppen durch Si(R²)₂, C=O, NR², O, S oder CONR² ersetzt sein können, oder ein aromatisches oder heteroaromatisches Ringsystem mit 5 bis 40 aromatischen Ringatomen, das jeweils durch einen oder mehrere Reste R² substituiert sein kann; dabei können zwei oder mehrere Reste R¹ miteinander ein mono- oder polycyclisches, aliphatisches, heteroaliphatisches, aromatisches oder heteroaromatisches Ringsystem bilden;
R² ist bei jedem Auftreten gleich oder verschieden H, D, F oder ein aliphatischer, aromatischer und/oder heteroaromatischer organischer Rest, insbesondere ein Kohlenwasserstoffrest, mit 1 bis 20 C-Atomen, in dem auch ein oder mehrere H-Atome durch F ersetzt sein können.

2. Verbindung nach Anspruch 1, **dadurch gekennzeichnet, dass** Ar¹ und Ar⁴ neutrale Gruppen und Ar² und Ar³ monoanionische Gruppen sind, oder dass Ar¹ und Ar⁴ monoanionische Gruppen und Ar² und Ar³ neutrale Gruppen sind, oder dass Ar¹ und Ar² monoanionische Gruppen und Ar³ und Ar⁴ neutrale Gruppen sind, oder dass Ar¹ und Ar³ monoanionische Gruppen und Ar² und Ar⁴ neutrale Gruppen sind.

3. Verbindung nach Anspruch 1 oder Anspruch 2, **dadurch gekennzeichnet, dass** Y¹ und Y⁴ anionische Kohlenstoffatome und Y² und Y³ neutrale Stickstoffatome darstellen, oder dass Y¹ und Y⁴ neutrale Stickstoffatome und Y² und Y³ anionische Kohlenstoffatome darstellen, oder dass Y¹ ein neutrales Stickstoffatom und Y² und Y³ anionische Kohlenstoffatome und Y⁴ ein Carben-Kohlenstoffatom darstellen, oder dass Y¹ und Y⁴ Carben-Kohlenstoffatome und Y² und Y³ anionische Kohlenstoffatome darstellen, oder dass Y¹ und Y³ neutrale Stickstoffatome und Y² und Y⁴ anionische Kohlenstoffatome darstellen, oder dass Y¹ und Y³ neutrale Stickstoffatome, Y² ein anionisches Kohlenstoffatom und Y⁴ C-O⁻ darstellen, oder dass Y¹ und Y² neutrale Stickstoffatome, Y³ ein anionisches Kohlenstoffatom und Y⁴ C-O⁻darstellen, oder dass Y¹ ein anionisches Kohlenstoffatom, Y² und Y³ neutrale Stickstoffatome und Y⁴ C-O⁻ darstellen.

4. Verbindung nach einem oder mehreren der Ansprüche 1 bis 3, **dadurch gekennzeichnet, dass** Ar¹, Ar², Ar³ und Ar⁴ zusammen mit der Gruppe Y¹, Y², Y³ bzw. Y⁴ gleich oder verschieden bei jedem Auftreten eine Arylgruppe mit 6 bis 10 aromatischen Ringatomen oder eine Heteroarylgruppe mit 5 bis 13 aromatischen Ringatomen darstellen, wobei die Aryl- bzw. Heteroarylgruppe jeweils durch einen oder mehrere Reste R substituiert sein kann.

5. Verbindung nach einem oder mehreren der Ansprüche 1 bis 4, **dadurch gekennzeichnet, dass** zwei der Gruppen A¹, A² und A³ für Einfachbindungen stehen und die dritte Gruppe für eine Gruppe ungleich einer Einfachbindung steht und der Ligand L ausgewählt ist aus den Liganden (L-1) und (L-2), 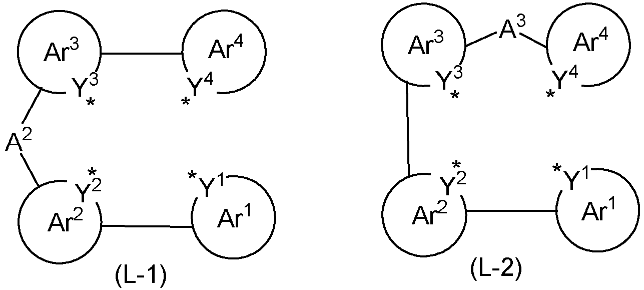
wobei die verwendeten Symbole die in Anspruch 1 genannten Bedeutungen aufweisen, Y¹ bis Y⁴ gleich oder verschieden für C oder N stehen und A² in Formel (L-1) bzw. A³ in Formel (L-2) nicht für eine Einfachbindung stehen;
oder dass eine der Gruppen A¹, A² und A³ für eine Einfachbindung steht und die beiden anderen Gruppen gleich oder verschieden für eine Gruppe ungleich einer Einfachbindung stehen und der Ligand L ausgewählt ist aus den Liganden (L-3) und (L-4), 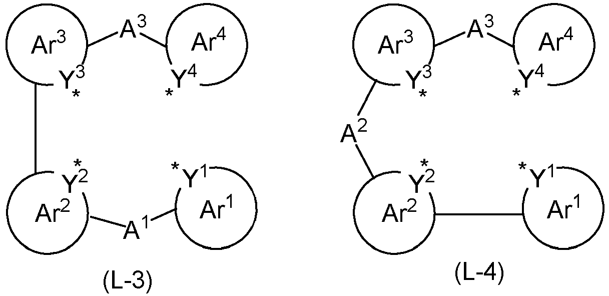
wobei die verwendeten Symbole die in Anspruch 1 genannten Bedeutungen aufweisen und A¹ und A³ in Formel (L-3) bzw. A² und A³ in Formel (L-4) nicht für Einfachbindungen stehen;
oder dass genau eine der Gruppen Y¹ oder Y⁴ für C-O⁻ steht und entweder alle drei Gruppen A¹, A² und A³ für eine Einfachbindung stehen oder A¹ und A³ für eine Einfachbindung stehen und A² für C=CR₂ steht, wobei ein Rest R mit einer benachbarten Gruppe Ar² oder Ar³ einen aromatischen oder heteroaromatischen Ring bildet, und der Ligand ausgewählt ist aus den Formeln (L-5) und (L-6), 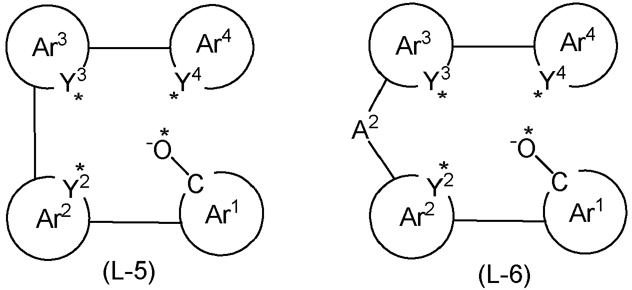
wobei die verwendeten Symbole die in Anspruch 1 genannten Bedeutungen aufweisen und A² in Formel (L-6) für C=CR₂ steht, wobei mindestens ein Rest R mit Ar² oder Ar³ ein aromatisches oder heteroaromatisches Ringsystem bildet, oder A² in Formel (L-6) für CR₂, NR oder O steht;
oder dass keine der Gruppen A¹, A² und A³ für eine Einfachbindung steht und der Ligand ausgewählt ist aus den Liganden (L-7), 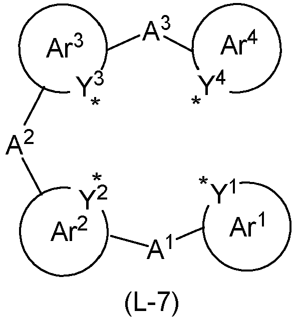
wobei die verwendeten Symbole die in Anspruch 1 genannten Bedeutungen aufweisen und A¹, A² und A³ nicht für Einfachbindungen stehen.

6. Verbindung nach einem oder mehreren der Ansprüche 1 bis 5, **dadurch gekennzeichnet, dass** Ar¹ und Ar⁴ zusammen mit den Gruppen Y¹ bzw. Y⁴ jeweils gewählt sind aus den Gruppen der Formeln (Ar-1) bis (Ar-44), wobei die Gruppe jeweils an der durch # gekennzeichneten Position an A¹ bzw. A³ bindet und an der durch * gekennzeichneten Position an das Iridium koordiniert, 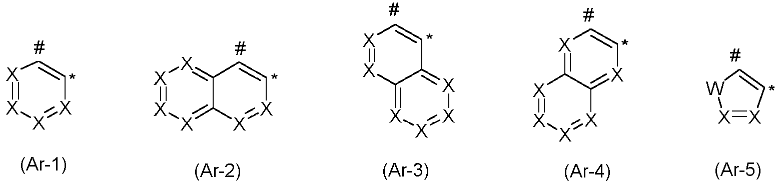 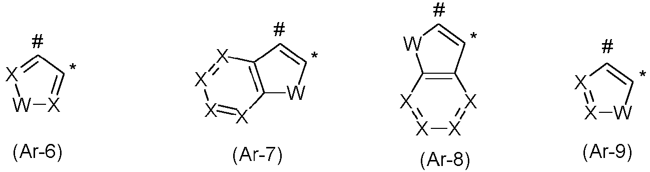 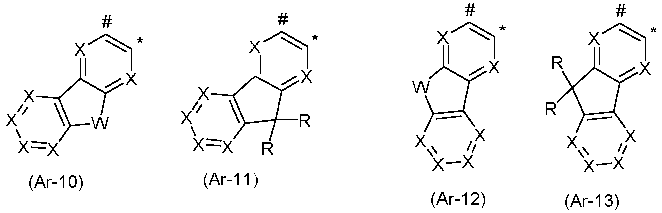 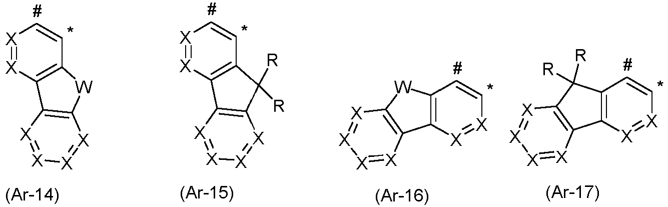 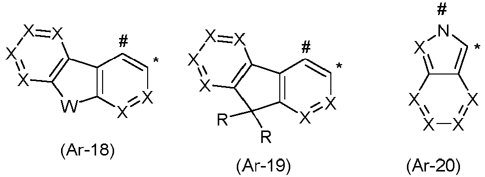 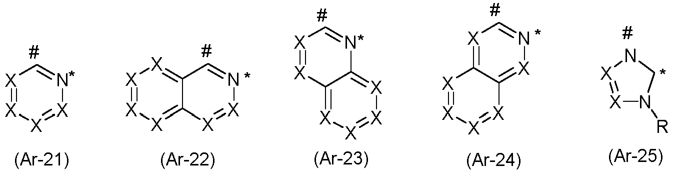 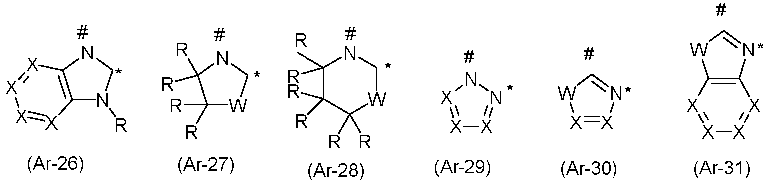 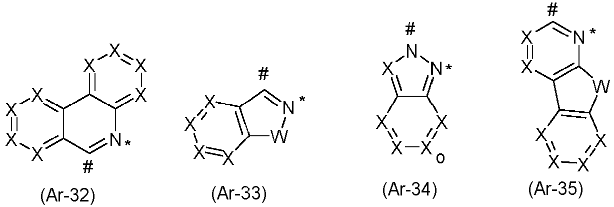 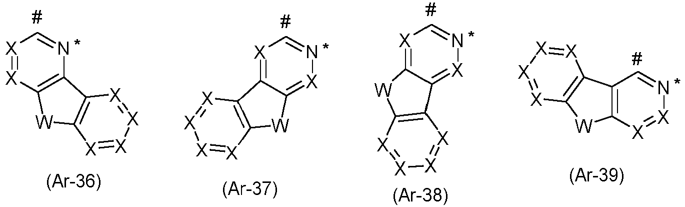 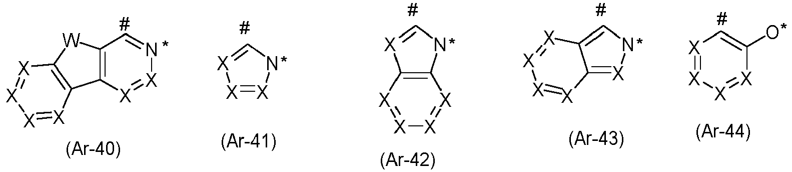
wobei R die in Anspruch 1 genannten Bedeutungen aufweist und für die weiteren verwendeten Symbole gilt:
X ist bei jedem Auftreten gleich oder verschieden CR oder N mit der Maßgabe, dass maximal zwei Symbole X pro Cyclus für N stehen;
W ist bei jedem Auftreten gleich oder verschieden NR, O oder S;
und dass Ar² und Ar³ zusammen mit den Gruppen Y² bzw. Y³ gewählt sind aus den Gruppen der Formeln (Ar-45) bis (Ar-74), wobei die Gruppe jeweils an der durch # gekennzeichneten Position an A¹ und A² bzw. an A² und A³ bindet und an der durch * gekennzeichneten Position an das Iridium koordiniert, 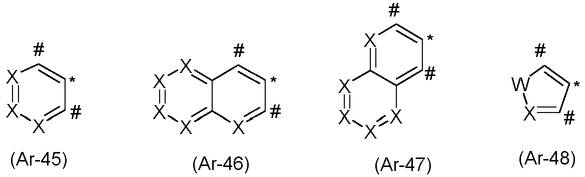 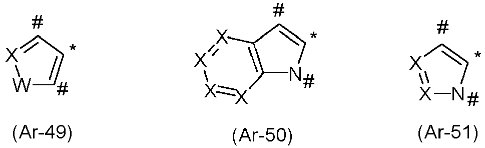 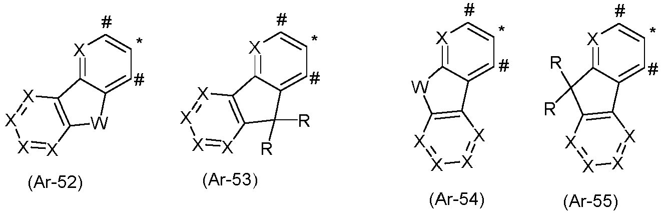 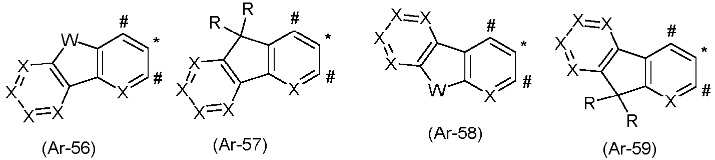 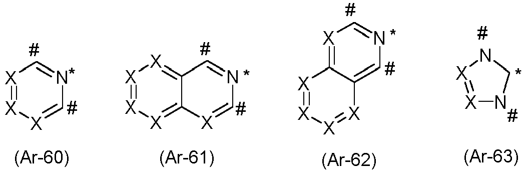 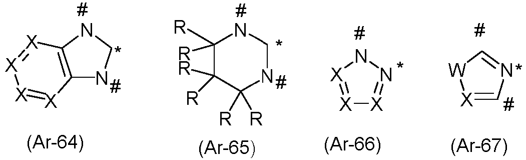 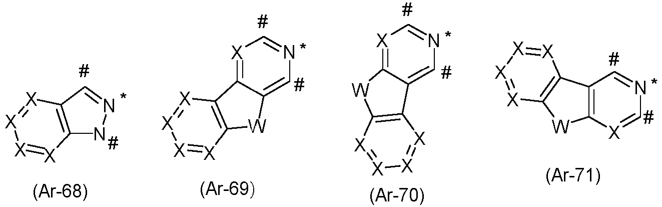 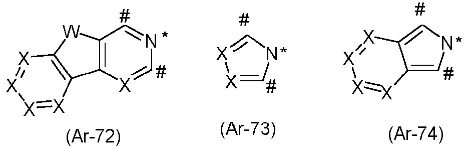
wobei R die in Anspruch 1 aufweist und X und W die oben genannten Bedeutungen aufweisen.

7. Verbindung nach einem oder mehreren der Ansprüche 1 bis 6, **dadurch gekennzeichnet, dass** A¹ und/oder A³ für Einfachbindungen stehen und die so gebildeten bidentaten Teilliganden Ar¹-Ar² bzw. Ar³-Ar⁴ ausgewählt sind aus den Strukturen der Formeln (L¹-1-1) bis (L¹-1-3) und (L¹-2-1) bis (L¹-2-5), die über die beiden mit * gekennzeichneten Positionen an das Iridium koordinieren, 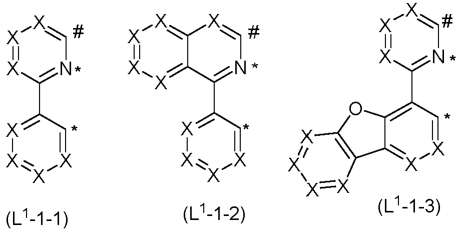 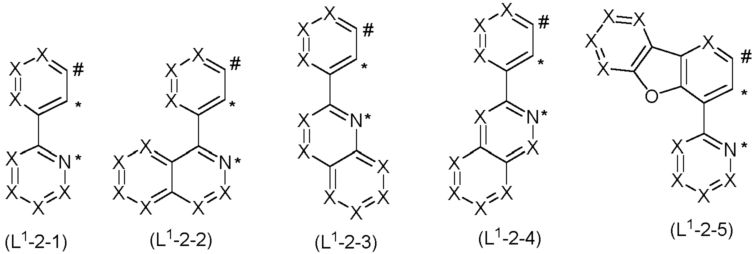 wobei die verwendeten Symbole die in Anspruch 1 und 6 genannten Bedeutungen aufweisen und # die Position der Bindung an A² darstellt.

8. Verbindung nach Anspruch 5, **dadurch gekennzeichnet, dass** die Liganden (L-1) ausgewählt sind aus den Strukturen der Formeln (L-1-1) bis (L-1-4), 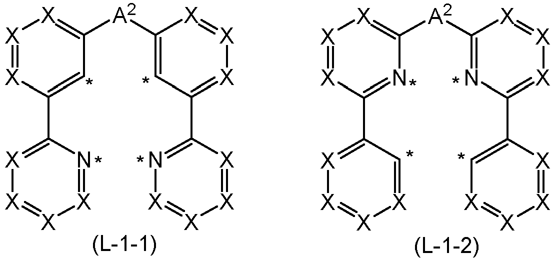 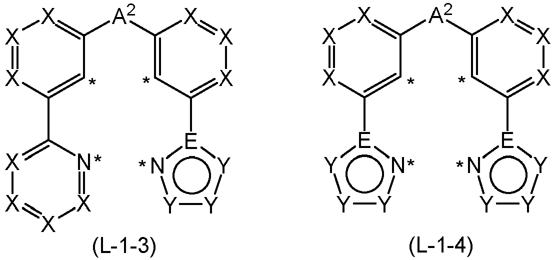
wobei A² und X die in Anspruch 1 und 6 genannten Bedeutungen aufweisen und entweder E für N steht und die Gruppen Y in demselben Cyclus gleich oder verschieden bei jedem Auftreten für CR oder N stehen oder E für C steht und die Gruppen Y in demselben Cyclus gleich oder verschieden bei jedem Auftreten für CR, N, NR, O oder S stehen mit der Maßgabe, dass genau eine Gruppe Y für NR, O oder S steht, und die anderen Gruppen Y gleich oder verschieden für CR oder N;
und dass der Ligand (L-4) ausgewählt ist aus den Liganden (L-4-1) bis (L-4-3), 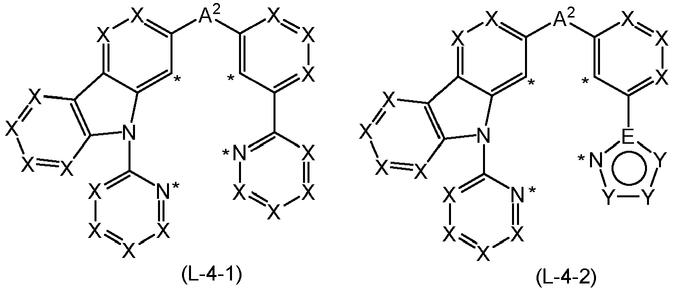 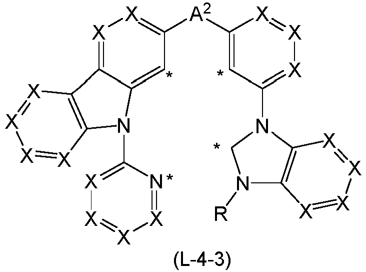
wobei die verwendeten Symbole die in Anspruch 1 und 6 und oben genannten Bedeutungen aufweisen, E und Y die oben genannten Bedeutungen aufweisen und A² nicht für eine Einfachbindung steht;
und dass der Ligand (L-6) ausgewählt ist aus den Liganden der Formel (L-6-1) und (L-6-2), 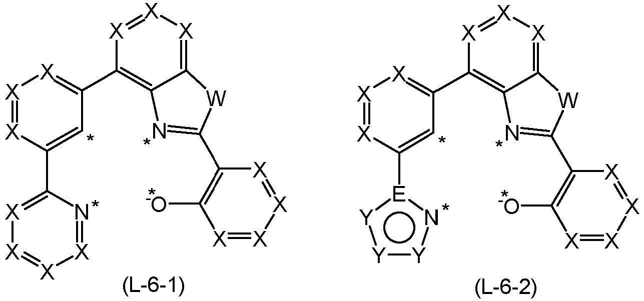
wobei die verwendeten Symbole die in Anspruch 1 und 6 genannten Bedeutungen aufweisen und E und Y die oben genannten Bedeutungen aufweisen;
und dass die Liganden (L-7) ausgewählt sind aus den Liganden der Formel (L-7-1), 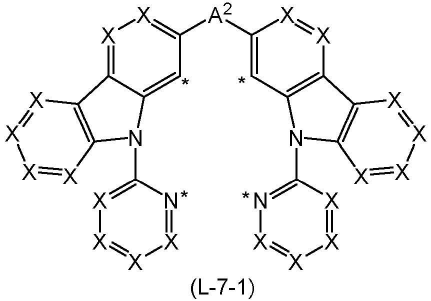
wobei die verwendeten Symbole die in Anspruch 1 und 6 genannten Bedeutungen aufweisen und A² nicht für eine Einfachbindung steht.

9. Verbindung nach Anspruch 8, **dadurch gekennzeichnet, dass** die Liganden (L-1) ausgewählt sind aus den Strukturen (L-1-1a) bis (L-1-4c), 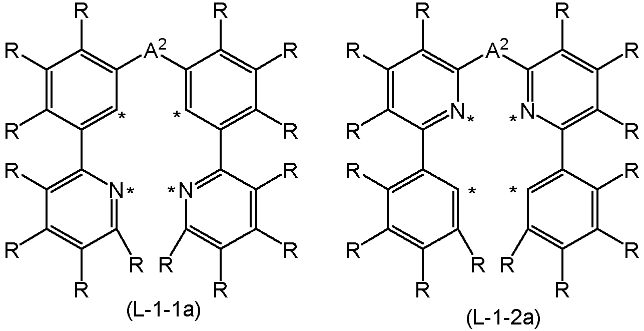 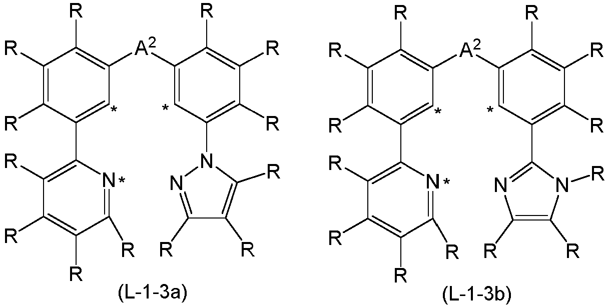 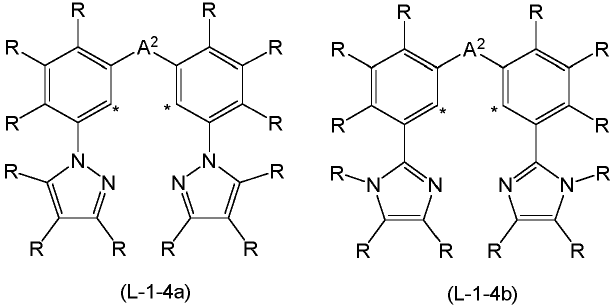 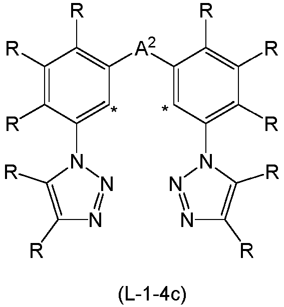
wobei die Symbole die in Anspruch 1 genannten Bedeutungen aufweisen;
und dass die Liganden (L-4) ausgewählt sind aus den Liganden (L-4-1a) bis (L-4-3a), 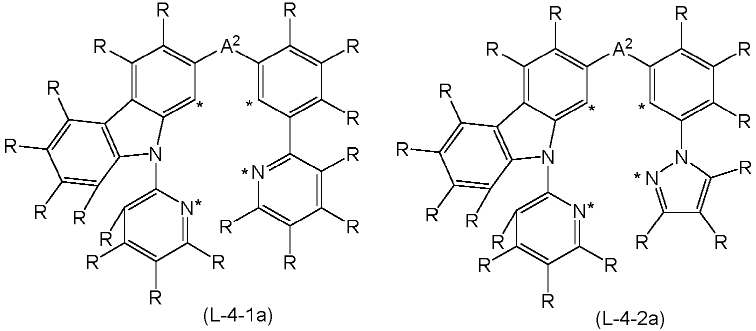 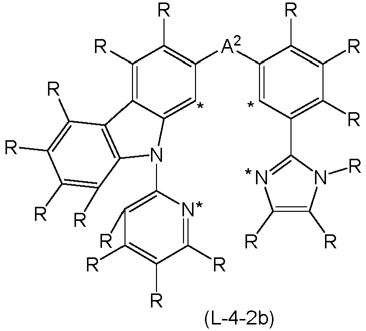 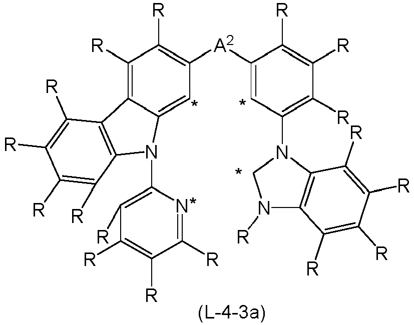
wobei die Symbole die in Anspruch 1 genannten Bedeutungen aufweisen und A² nicht für eine Einfachbindung steht;
und dass die Liganden (L-6) ausgewählt sind aus den Formeln (L-6-1a) und (L-6-2a) bis (L-6-2c), 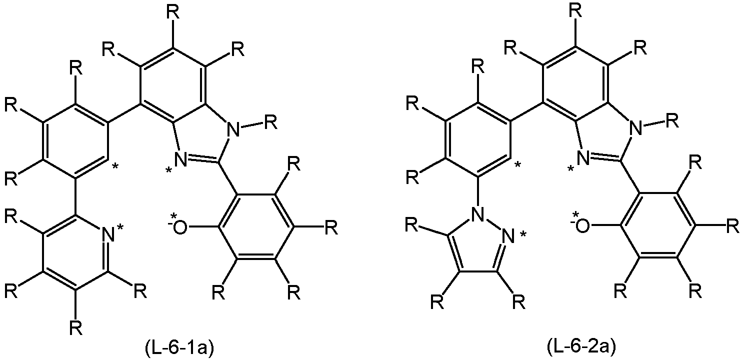 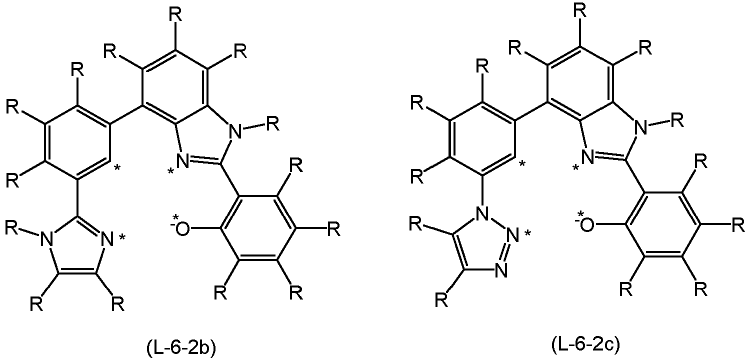
wobei die Symbole die in Anspruch 1 genannten Bedeutungen aufweisen;
und dass die Liganden (L-7) ausgewählt sind aus den Liganden der Formel (L-7-1a), 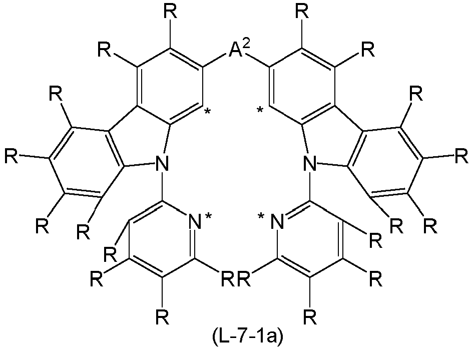
wobei die Symbole die in Anspruch 1 genannten Bedeutungen aufweisen und A² nicht für eine Einfachbindung steht.

10. Verbindung nach einem oder mehreren der Ansprüche 1 bis 9, **dadurch gekennzeichnet, dass** R* für eine Alkylgruppe mit 4 bis 10 C-Atomen steht, in der auch ein oder mehrere H-Atome durch D oder F ersetzt sein können, oder für ein aromatisches Ringsystem mit 6 bis 12 C-Atomen steht, wobei das aromatische Ringsystem durch einen oder mehrere Reste ausgewählt aus F, D oder einer Alkylgruppe mit 1 bis 10 C-Atomen substituiert sein kann, wobei ein oder mehrere H-Atome in der Alkylgruppe durch D oder F ersetzt sein können; dabei können mehrere Alkylgruppen, die als Substituenten an dem aromatischen Ringsystem vorliegen, auch miteinander ein Ringsystem bilden.

11. Formulierung enthaltend mindestens eine Verbindung nach einem oder mehreren der Ansprüche 1 bis 10 und mindestens eine weitere Verbindung und/oder ein Lösemittel.

12. Verwendung einer Verbindung nach einem oder mehreren der Ansprüche 1 bis 10 in einer elektronischen Vorrichtung oder als Sauerstoff-Sensibilisator oder als Photoinitiator oder als Photokatalysator.

13. Elektronische Vorrichtung enthaltend mindestens eine Verbindung nach einem oder mehreren der Ansprüche 1 bis 10.

14. Elektronische Vorrichtung nach Anspruch 13, wobei es sich um eine organische Elektrolumineszenzvorrichtung handelt, **dadurch gekennzeichnet, dass** die Verbindung nach einem oder mehreren der Ansprüche 1 bis 10 in einer oder mehreren emittierenden Schichten als phosphoreszierender Emitter oder als Sensitizer für einen fluoreszierenden Emitter eingesetzt wird.

## Claims

1. A compound of Formula (1),
Ir(L)(CN)(CN-R*) Formula (1),
wherein the following applies to the symbols used:
R* is an alkyl group with 1 to 20 carbon atoms, which may be substituted by one or more radicals R¹, or an aromatic or heteroaromatic ring system with 5 to 30 aromatic ring atoms, which may be substituted by one or more radicals R¹;
L is a tetradentate ligand of Formula (2), 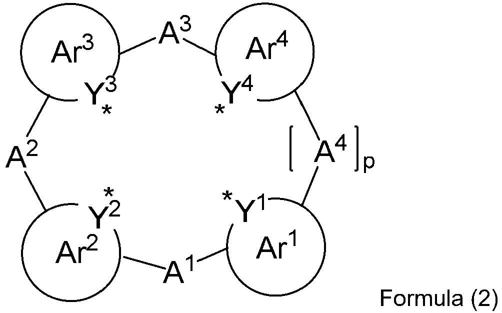
wherein the tetradentate ligand coordinates to the iridium in a square-planar or approximately square-planar manner and the cyano ligand (CN) and the isonitrile ligand (CN-R*) are arranged trans-geometrically above and below the plane formed by the iridiumand the tetradentate ligand in the (pseudo)octahedral complex;
wherein * indicates coordination to the iridium the following applies to the symbols and indices:
Y¹, Y², Y³, Y⁴ are the same or different at each occurrence and are selected from the group consisting of C, N or C-O⁻, with the proviso that at least one of the groups Y¹, Y², Y³ and Y⁴ is C and that two of the groups Y¹, Y², Y³ and Y⁴ coordinate to the iridium via an anionic carbon atom, an anionic nitrogen atom or C-O⁻ and the other two of the groups Y¹, Y², Y³ and Y⁴ coordinate to the iridium via a neutral nitrogen atom or a carbene carbon atom;
Ar¹, Ar², Ar³, Ar⁴ are the same or different at each occurrence and, together with the group Y¹, Y², Y³ or Y⁴, respectively, form an aryl group having 6 to 16 aromatic ring atoms or a heteroaryl group having 5 to 16 aromatic ring atoms, or an aliphatic carbene having 5 to 10 ring atoms, wherein the aryl or heteroaryl group or the aliphatic carbene may each be substituted by one or more radicals R;
A¹, A², A³, A⁴ are the same or different at each occurrence and are selected from the group consisting of a single bond, CR₂, BR, NR, O, S, CR₂-CR₂, CR=CR, an ortho-linked phenylene group which may be substituted with one or more radicals R, C(=CR₂) or CR=N;
p is 0 or 1, wherein p = 0 means that the group A⁴ is not present and instead of A⁴ residues R can be bound in the corresponding positions of Ar¹ and Ar⁴;
R is the same or different at each occurrence, and is H, D, F, Cl, Br, I, N(R¹)₂, OR¹, SR¹, CN, NO₂, COOH, C(=O)N(R¹)₂, Si(R¹)₃, Ge(R¹)₃, B(OR¹)₂, C(=O)R¹, P(=O)(R¹)₂, S(=O)R¹, S(=O)₂R¹, OSO₂R¹, a straight-chain alkyl group having 1 to 20 carbon atoms or an alkenyl or alkynyl group having 2 to 20 carbon atoms, or a branched or cyclic alkyl group having 3 to 20 carbon atoms, wherein the alkyl, alkenyl or alkynyl group may be substituted by one or more radicals R¹, and wherein one or more non-adjacent CH₂ groups may be replaced by Si(R¹)₂, C=O, NR¹, O, S or CONR¹, or an aromatic or heteroaromatic ring system having 5 to 40 aromatic ring atoms, each of which may be substituted by one or more radicals R¹; wherein two radicals R can also form a mono- or polycyclic, aliphatic, heteroaliphatic, aromatic or heteroaromatic ring system with each other;
R¹ is the same or different at each occurrence, and is H, D, F, Cl, Br, I, N(R²)₂, OR², SR², CN, NO₂, Si(R²)₃, Ge(R²)₃, B(OR²)₂, C(=O)R², P(=O)(R²)₂, S(=O)R², S(=O)₂R², OSO₂R², a straight-chain alkyl group having 1 to 20 -carbon atoms or an alkenyl or alkynyl group having 2 to 20 carbon atoms or a branched or cyclic alkyl group having 3 to 20 carbon atoms, wherein the alkyl, alkenyl or alkynyl group may each be substituted by one or more radicals R², and wherein one or more non-adjacent CH₂ groups may be replaced by Si(R²)₂, C=O, NR², O, S or CONR², or an aromatic or heteroaromatic ring system having 5 to 40 aromatic ring atoms, which may each be substituted by one or more radicals R²; and wherein two or more radicals R¹ may together form a mono- or polycyclic, aliphatic, heteroaliphatic, aromatic or heteroaromatic ring system;
R² is the same or different at each occurrence, and is H, D, F or an aliphatic, aromatic and/or heteroaromatic organic radical, in particular a hydrocarbon radical, with 1 to 20 carbon atoms, in which one or more H-atoms may also be replaced by F.

2. The compound according to claim 1, **characterized in that** Ar¹ and Ar⁴ are neutral groups and Ar² and Ar³ are monoanionic groups, or that Ar¹ and Ar⁴ are monoanionic groups and Ar² and Ar³ are neutral groups, or that Ar¹ and Ar² are monoanionic groups and Ar³ and Ar⁴ are neutral groups, or that Ar¹ and Ar³ are monoanionic groups and Ar² and Ar⁴ are neutral groups.

3. The compound according to claim 1 or claim 2, **characterized in that** Y¹ and Y⁴ represent anionic carbon atoms and Y² and Y³ represent neutral nitrogen atoms, or that Y¹ and Y⁴ represent neutral nitrogen atoms and Y² and Y³ represent anionic carbon atoms, or that Y¹ represents a neutral nitrogen atom and Y² and Y³ represent anionic carbon atoms and Y⁴ represents a carbene carbon atom, or that Y¹ and Y⁴ represent carbene carbon atoms and Y² and Y³ represent anionic carbon atoms, or that Y¹ and Y³ represent neutral nitrogen atoms and Y² and Y⁴ represent anionic carbon atoms, or that Y¹ and Y³ represent neutral nitrogen atoms, Y² represents an anionic carbon atom and Y⁴ represents C-O⁻, or that Y¹ and Y² represent neutral nitrogen atoms, Y³ represents an anionic carbon atom and Y⁴ represents C-O⁻, or that Y¹ represents an anionic carbon atom, Y² and Y³ represent neutral nitrogen atoms and Y⁴ represents C-O⁻.

4. The compound according to one or more of claims 1 to 3, **characterized in that** Ar¹, Ar², Ar³ and Ar⁴ together with the group Y¹, Y², Y³ and Y⁴, respectively, represent, identically or differently at each occurrence, an aryl group having 6 to 10 aromatic ring atoms or a heteroaryl group having 5 to 13 aromatic ring atoms, wherein the aryl or heteroaryl group may each be substituted by one or more radicals R.

5. The compound according to one or more of claims 1 to 4, **characterized in that** two of the groups A¹, A² and A³ are single bonds and the third group represents a group other than a single bond, and the ligand L is selected from the ligands (L-1) and (L-2), 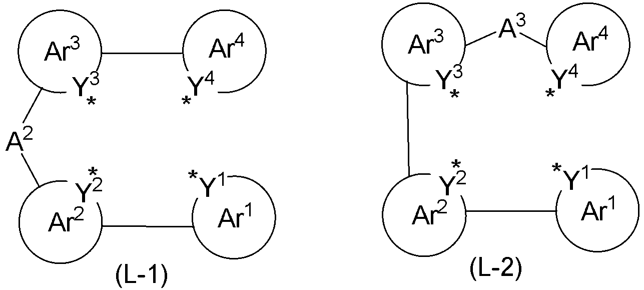
wherein the symbols used have the meanings given in claim 1, Y¹ to Y⁴ are identical or different and represent C or N, and A² in formula (L-1) or A³ in formula (L-2) does not represent a single bond;
or that one of the groups A¹, A² and A³ represents a single bond and the other two groups are identical or different and represent a group other than a single bond and the ligand L is selected from the ligands (L-3) and (L-4), 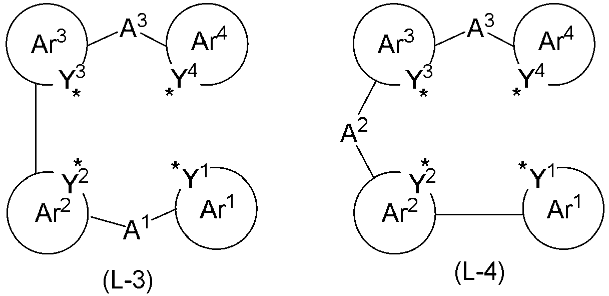
wherein the symbols used have the meanings given in claim 1, and A¹ and A³ in formula (L-3) or A² and A³ in formula (L-4) do not represent single bonds;
or that exactly one of the groups Y¹ or Y⁴ represents C-O⁻ and either all three groups A¹, A² and A³ represent a single bond or A¹ and A³ represent a single bond and A² represents C=CR₂, wherein a radical R forms an aromatic or heteroaromatic ring with an adjacent group Ar² or Ar³, and the ligand is selected from the formulae (L-5) and (L-6), 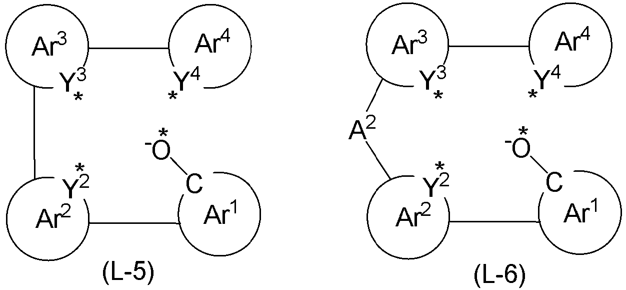
wherein the symbols used have the meanings given in claim 1, and A² in formula (L-6) is C=CR₂, wherein at least one radical R forms an aromatic or heteroaromatic ring system with Ar² or Ar³, or A² in formula (L-6) is CR₂, NR or O;
or that none of the groups A¹, A² and A³ represents a single bond and the ligand is selected from the ligands (L-7), 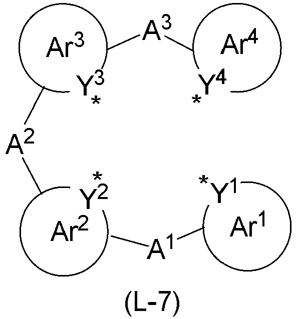
wherein the symbols used have the meanings given in claim 1, and A¹, A² and A³ do not represent single bonds.

6. The compound according to one or more of claims 1 to 5, **characterized in that** Ar¹ and Ar⁴ together with the groups Y¹ and Y⁴, respectively, are each selected from the groups of formulae (Ar-1) to (Ar-44), wherein the group binds to A¹ and A³, respectively, at the position indicated by # and coordinates to the iridium at the position indicated by *, 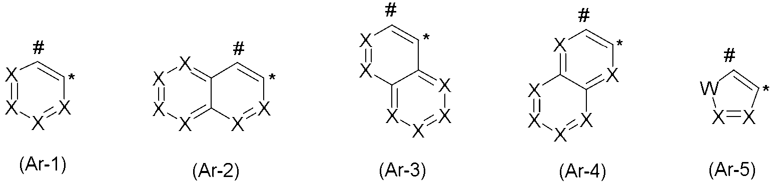 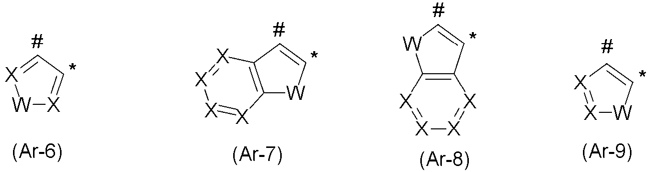 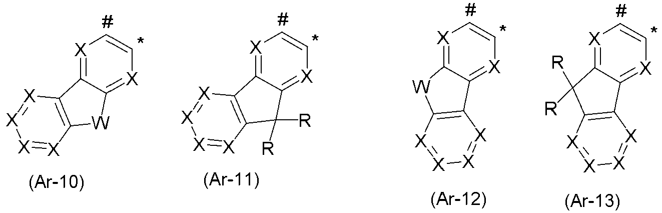 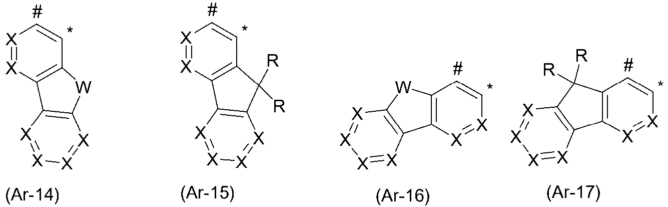 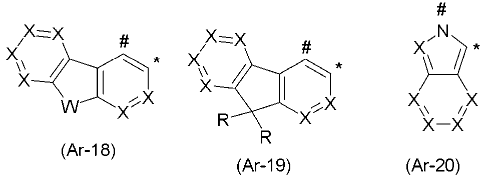 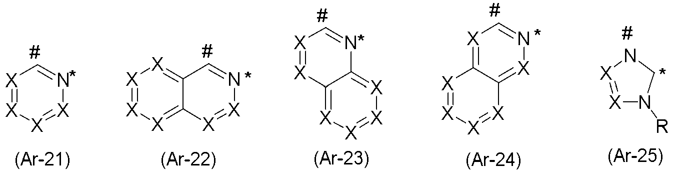 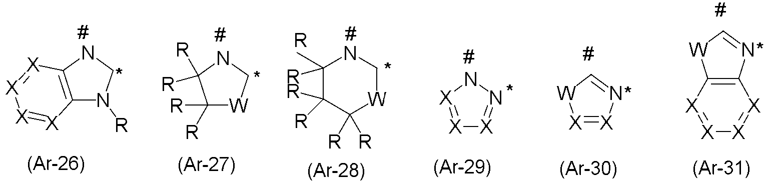 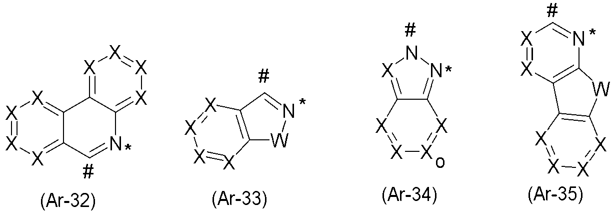 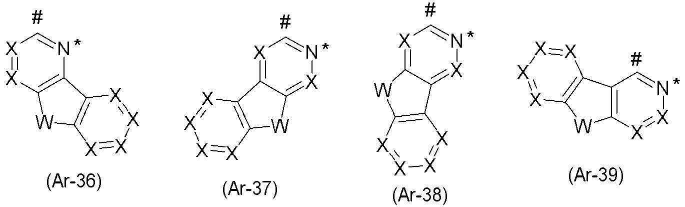 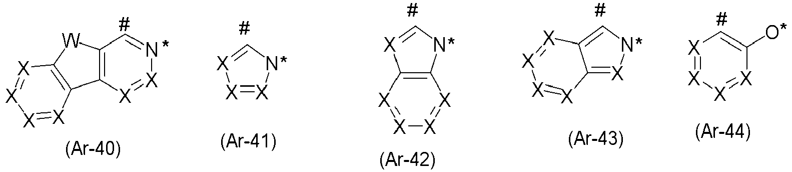
wherein R has the meanings given in claim 1, and the following applies to the other symbols used:
X is the same or different at each occurrence, and is CR or N, with the proviso that a maximum of two symbols X per cycle represent N;
W is the same or different at each occurrence, and is NR, O or S;
and that Ar² and Ar³ together with the groups Y² and Y³ are selected from the groups of the formulae (Ar-45) to (Ar-74), wherein the group binds to A¹ and A² or to A² and A³ at the position indicated by # and coordinates to the iridium at the position indicated by *, 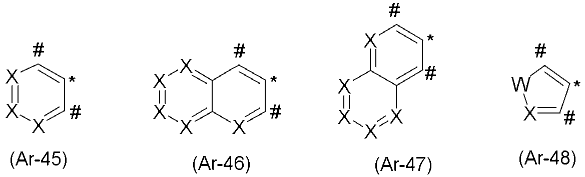 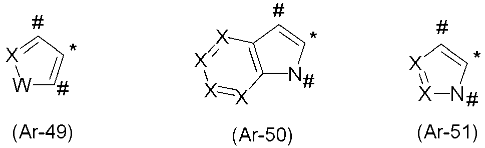 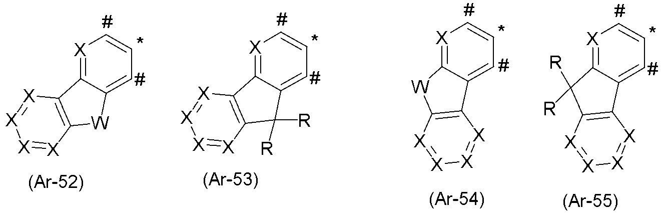 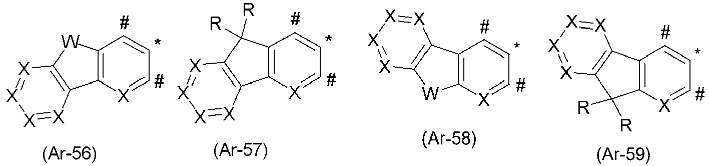 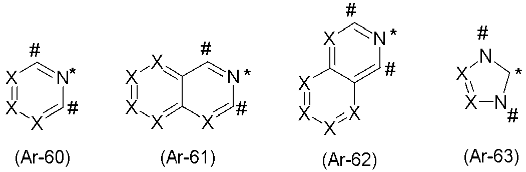 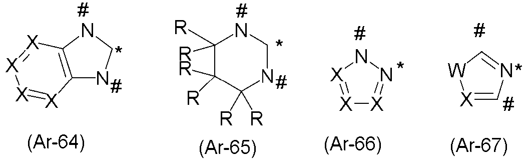 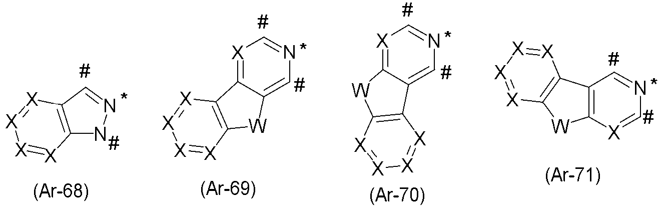 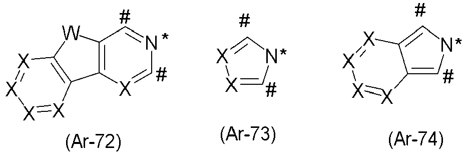
wherein R is as defined in claim 1 and X and W have the meanings given above.

7. The compound according to one or more of claims 1 to 6, **characterized in that** A¹ and/or A³ represent single bonds and the bidentate partial ligands Ar¹-Ar² and Ar³-Ar⁴ formed in this way are selected from the structures of the formulae (L'-1-1) to (L'-1-3) and (L¹-2-1) to (L¹-2-5), which coordinate to the iridium via the two positions indicated with *, 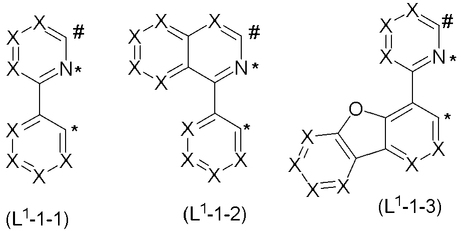 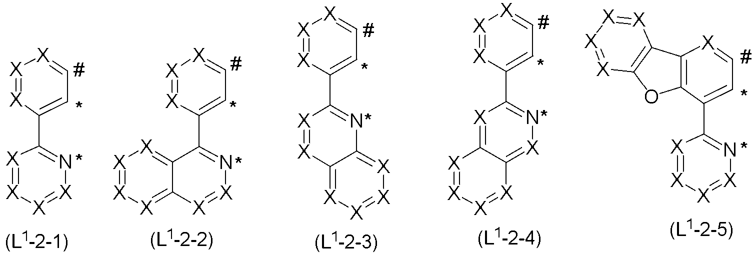 wherein the symbols used have the meanings given in claims 1 and 6 and # represents the position of the bond to A².

8. The compound according to claim 5, **characterized in that** the ligands (L-1) are selected from the structures of formulae (L-1-1) to (L-1-4), 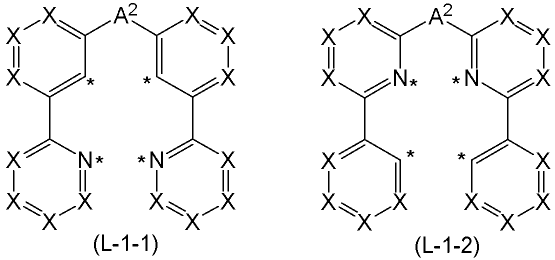 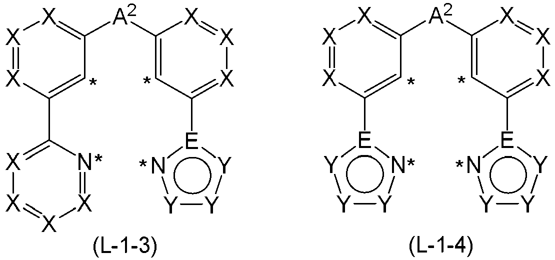
wherein A² and X have the meanings given in claims 1 and 6, and either E is N and the groups Y in the same cycle are the same or different at each occurrence and represent CR or N, or E is C and the groups Y in the same cycle are the same or different at each occurrence and represent CR, N, NR, O or S, with the proviso that exactly one group Y is NR, O or S and the other groups Y are the same or different, and are CR or N;
and that the ligand (L-4) is selected from the ligands (L-4-1) to (L-4-3), 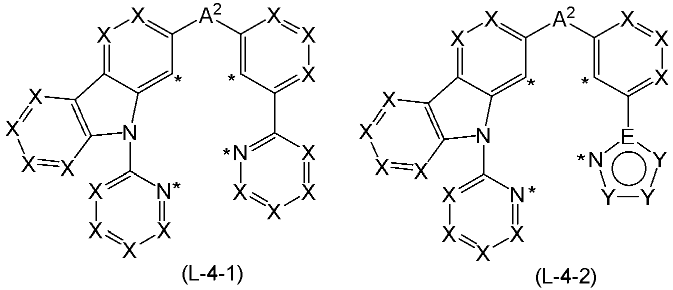 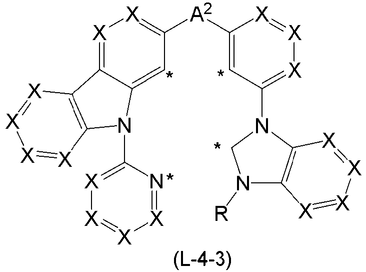
wherein the symbols used have the meanings given in claims 1 and 6 and above, E and Y have the meanings given above, and A² does not represent a single bond;
and that the ligand (L-6) is selected from the ligands of the formula (L-6-1) and (L-6-2), 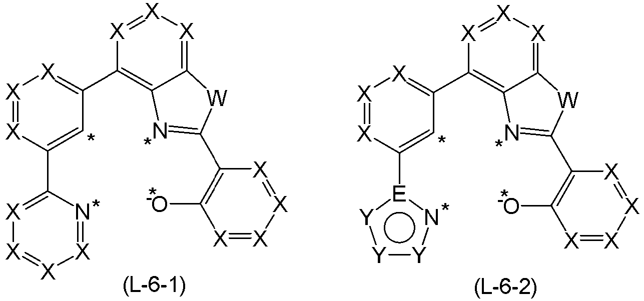
wherein the symbols used have the meanings given in claims 1 and 6, and E and Y have the meanings given above;
and that the ligands (L-7) are selected from the ligands of formula (L-7-1), 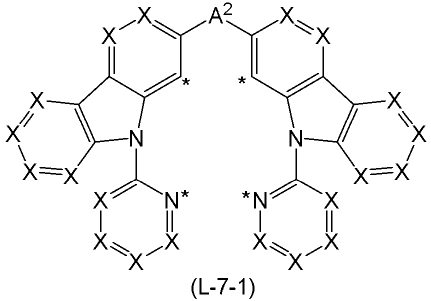
wherein the symbols used have the meanings given in claims 1 and 6, and A² does not represent a single bond.

9. The compound according to claim 8, **characterized in that** the ligands (L-1) are selected from the structures (L-1-1a) to (L-1-4c), 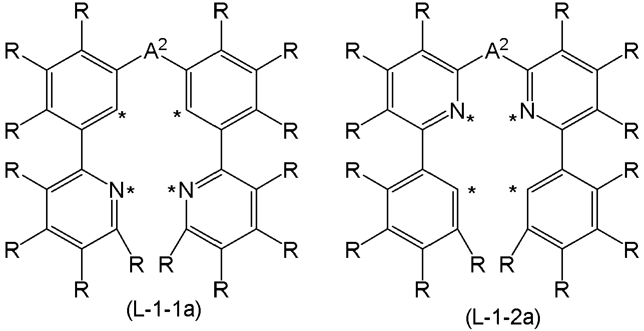 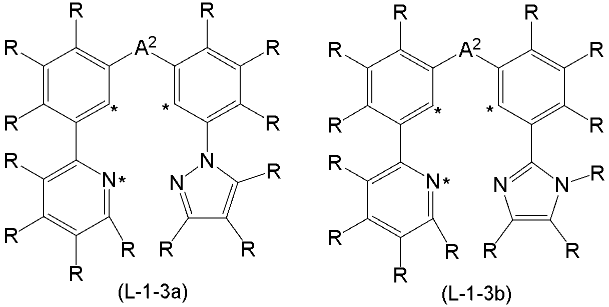 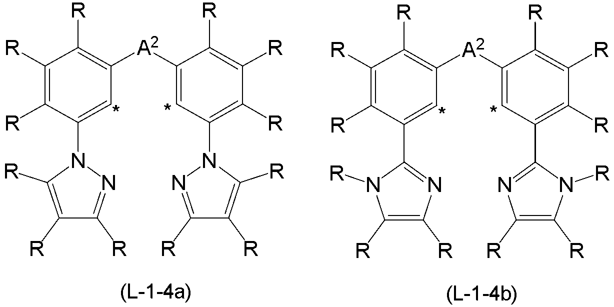 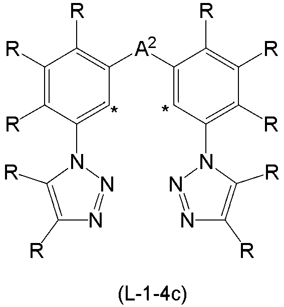
wherein the symbols have the meanings given in claim 1;
and that the ligands (L-4) are selected from the ligands (L-4-1a) to (L-4-3a), 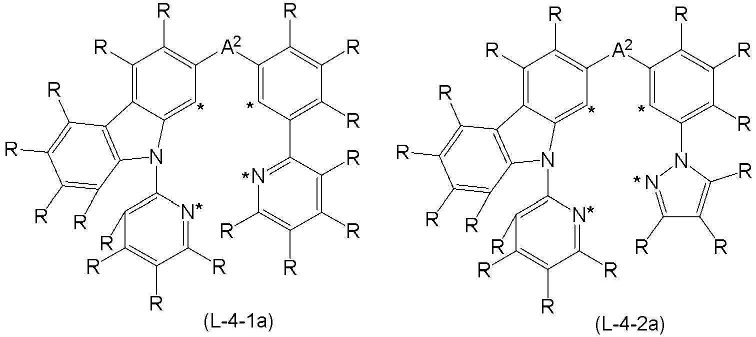 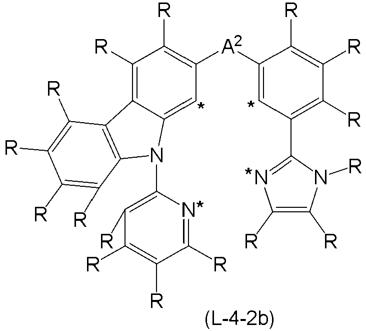 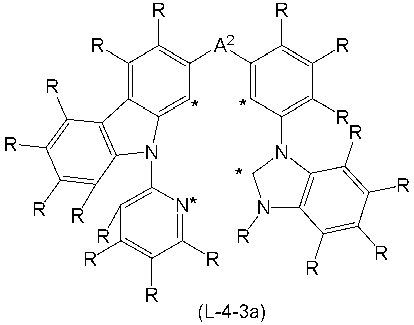
wherein the symbols have the meanings given in claim 1, and A² does not represent a single bond;
and that the ligands (L-6) are selected from the formulae (L-6-1a) and (L-6-2a) to (L-6-2c), 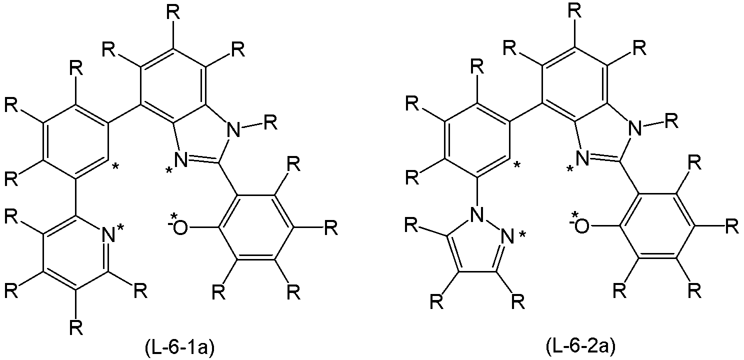 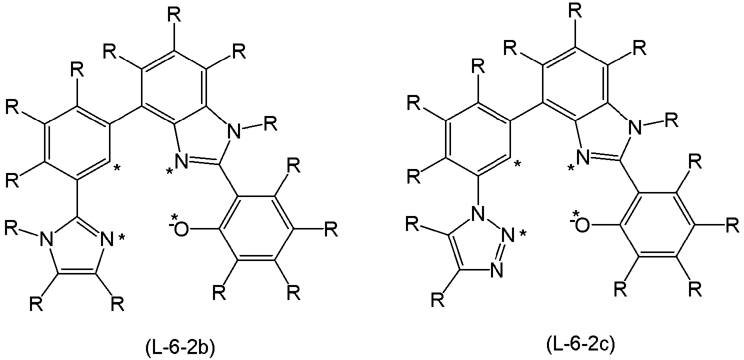
wherein the symbols have the meanings given in claim 1;
and that the ligands (L-7) are selected from the ligands of formula (L-7-1a), 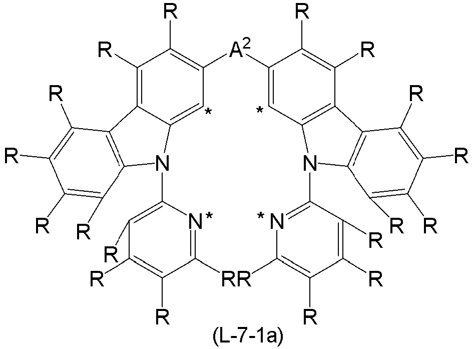
wherein the symbols have the meanings given in claim 1 and A² does not represent a single bond.

10. The compound according to one or more of claims 1 to 9, **characterized in that** R* is an alkyl group having 4 to 10 carbon atoms, in which one or more H atoms may also be replaced by D or F, or represents an aromatic ring system having 6 to 12 carbon atoms, wherein the aromatic ring system may be substituted by one or more radicals selected from F, D or an alkyl group having 1 to 10 carbon atoms, wherein one or more H atoms in the alkyl group may be replaced by D or F; wherein several alkyl groups present as substituents on the aromatic ring system may also form a ring system with each other.

11. A formulation comprising at least one compound according to one or more of claims 1 to 10 and at least one further compound and/or a solvent.

12. Use of a compound according to one or more of claims 1 to 10 in an electronic device or as an oxygen sensitizer or as a photoinitiator or as a photocatalyst.

13. An electronic device comprising at least one compound according to one or more of claims 1 to 10.

14. The electronic device according to claim 13, wherein it is an organic electroluminescent device, **characterized in that** the compound according to one or more of claims 1 to 10 is used in one or more emitting layers as a phosphorescent emitter or as a sensitizer for a fluorescent emitter.

## Revendications

1. Composé de formule (1),
Ir(L)(CN)(CN-R*) Formule (1),
dans lequel les symboles utilisés ont la signification suivante :
R* est un groupe alkyle comportant 1 à 20 atomes de carbone, qui peut être substitué par un ou plusieurs radicaux R¹, ou un système cyclique aromatique ou hétéroaromatique comportant 5 à 30 atomes cycliques aromatiques, qui peut être substitué par un ou plusieurs radicaux R¹;
L est un ligand tétradenté de formule (2), 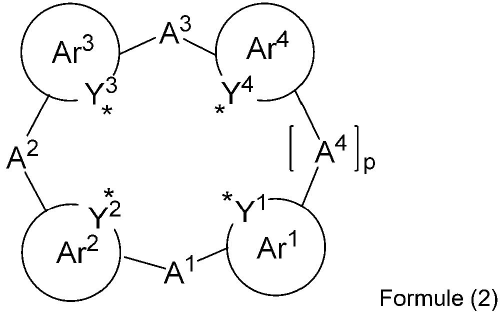
dans laquelle le ligand tétradenté est coordonné de manière quadratique-planaire ou approximativement quadratique-planaire à l'iridium et le ligand cyano (CN) et le ligand isonitrile (CN-R*) sont disposés dans le complexe (pseudo)octaédrique en position trans au-dessus et au-dessous du plan formé par l'iridium et le ligand tétradenté ;
où * désigne la coordination à l'iridium et où les symboles et indices sont les suivants:
Y1, Y2, Y3, Y4 est identique ou différent dans chaque occurrence, choisi dans le groupe constitué de C, N ou C-O-, à condition qu'au moins l'un des groupes Y1, Y2, Y3 et Y4 représente C et que deux des groupes Y1, Y2, Y3 et Y4 se coordonnent à l'iridium via un atome de carbone anionique, un atome d'azote anionique ou C-O- et les deux autres des groupes Y1, Y2, Y3 et Y4 se coordonnent à l'iridium via un atome d'azote neutre ou un atome de carbone carbène ;
Ar¹, Ar², Ar³, Ar⁴ est identique ou différent dans chaque occurrence et conjointement avec le groupe Y1, Y2, Y3 ou Y4 est un groupe aryle comportant 6 à 16 atomes cycliques aromatiques ou un groupe hétéroaryle comportant 5 à 16 atomes cycliques aromatiques ou un carbène aliphatique comportant 5 à 10 atomes cycliques, dans lequel le groupe aryle ou hétéroaryle ou le carbène aliphatique peuvent chacun être substitué par un ou plusieurs radicaux R ;
A¹, A², A³, A⁴ est identique ou différent dans chaque occurrence et est choisi dans le groupe constitué d'une liaison simple, CR2, BR, NR, O, S, CR2-CR2, CR=CR, un groupe phénylène lié en ortho qui peut être substitué par un ou plusieurs radicaux R, C(=CR2) ou CR=N ;
p est égal à 0 ou 1, où p = 0 signifie que le groupe A⁴ n'est pas présent et qu'à la place de A⁴, des radicaux R peuvent être liés aux positions correspondantes de Ar¹ et Ar⁴ ;
R est identique ou différent dans chaque occurrence et représente H, D, F, Cl, Br, I, N(R¹)2 , OR¹, SR¹, CN, NO₂ , COOH, C(=O)N(R¹)₂, Si(R¹)₃ , Ge(R¹)₃ , B(OR¹)₂, C(=O)R¹, P(=O)(R¹)₂ , S(=O)R¹ , S(=O)₂ R¹, OSO2 R¹, un groupe alkyle à chaîne linéaire comportant 1 à 20 atomes de carbone ou un groupe alcényle ou alcynyle comportant 2 à 20 atomes de carbone ou un groupe alkyle ramifié ou cyclique comportant 3 à 20 atomes de carbone, dans lequel le groupe alkyle, alcényle ou alcynyle peut être substitué dans chaque cas par un ou plusieurs radicaux R¹ et dans lequel un ou plusieurs groupes CH₂ non adjacents peuvent être remplacés par Si(R¹)₂, C=O, NR¹, O, S ou CONR¹, ou un système cyclique aromatique ou hétéroaromatique comportant 5 à 40 atomes cycliques aromatiques, chacun pouvant être substitué par un ou plusieurs radicaux R¹; dans lequel deux radicaux R peuvent former ensemble un système cyclique mono- ou polycyclique, aliphatique, hétéro-aliphatique, aromatique ou hétéroaromatique ;
R¹ est identique ou différent dans chaque occurrence et représente H, D, F, Cl, Br, I, N(R²)₂ , OR² , SR², CN, NO₂, Si(R²)₃ , Ge(R²)₃ , B(OR²)₂ , C(=O)R², P(=O)(R²)₂, S(=O)R² , S(=O)₂ R², OSO₂R², un groupe alkyle à chaîne linéaire comportant 1 à 20 atomes de carbone ou un groupe alcényle ou alcynyle comportant 2 à 20 atomes de carbone ou un groupe alkyle ramifié ou cyclique comportant 3 à 20 atomes de carbone, dans lequel le groupe alkyle, alcényle ou alcynyle peut être substitué sans chaque cas par un ou plusieurs radicaux R² et dans lequel un ou plusieurs groupes CH₂ non adjacents peuvent être remplacés par Si(R²)₂ , C=O, NR², O, S ou CONR², ou un système cyclique aromatique ou hétéroaromatique comportant 5 à 40 atomes cycliques aromatiques, chacun pouvant être substitué par un ou plusieurs radicaux R²; dans lequel deux ou plusieurs radicaux R¹ peuvent former ensemble un système cyclique mono- ou polycyclique, aliphatique, hétéro-aliphatique, aromatique ou hétéroaromatique ;
R² est identique ou différent dans chaque occurrence et représente H, D, F ou un radical organique aliphatique, aromatique et/ou hétéroaromatique, en particulier un radical hydrocarboné, comportant 1 à 20 atomes de carbone, dans lequel un ou plusieurs atomes d'hydrogène peuvent également être remplacés par F.

2. Composé selon la revendication 1, **caractérisé en ce que** Ar¹ et Ar⁴ sont des groupes neutres et Ar² et Ar³ sont des groupes monoanioniques, ou **en ce que** Ar¹ et Ar⁴ sont des groupes monoanioniques et Ar² et Ar³ sont des groupes neutres, ou **en ce que** Ar¹ et Ar² sont des groupes monoanioniques et Ar³ et Ar⁴ sont des groupes neutres, ou **en ce que** Ar¹ et Ar³ sont des groupes monoanioniques et Ar² et Ar⁴ sont des groupes neutres.

3. Composé selon la revendication 1 ou 2, **caractérisé en ce que** Y¹ et Y⁴ représentent des atomes de carbone anioniques et Y² et Y³ représentent des atomes d'azote neutres, ou **en ce que** Y¹ et Y⁴ représentent des atomes d'azote neutres et Y² et Y³ représentent des atomes de carbone anioniques, ou **en ce que** Y¹ représente un atome d'azote neutre et Y² et Y³ représentent des atomes de carbone anioniques et Y⁴ représente un atome de carbone carbène, ou **en ce que** Y¹ et Y⁴ représentent des atomes de carbone carbène et Y² et Y³ représentent des atomes de carbone anioniques, ou **en ce que** Y¹ et Y³ représentent des atomes d'azote neutres et Y² et Y⁴ représentent des atomes de carbone anioniques, ou que Y¹ et Y³ représentent des atomes d'azote neutres, Y² représente un atome de carbone anionique et Y⁴ représente C-O⁻, ou **en ce que** Y¹ et Y² représentent des atomes d'azote neutres, Y³ représente un atome de carbone anionique et Y⁴ représente C-O⁻, ou que Y¹ représente un atome de carbone anionique, Y² et Y³ représentent des atomes d'azote neutres et Y⁴ représente C-O⁻.

4. Composé selon une ou plusieurs des revendications 1 à 3, **caractérisé en ce que** Ar¹, Ar², Ar³ et Ar⁴ conjointement avec le groupe Y¹, Y², Y³ et Y⁴, qu'il soit identique ou différent, représentent, dans chaque occurrence, un groupe aryle comportant 6 à 10 atomes cycliques aromatiques ou un groupe hétéroaryle comportant 5 à 13 atomes cycliques aromatiques, dans lequel le groupe aryle ou hétéroaryle peut être substitué par un ou plusieurs radicaux R.

5. Composé selon une ou plusieurs des revendications 1 à 4, **caractérisé en ce que** deux des groupes A¹, A² et A³ représentent des liaisons simples et le troisième groupe représente un groupe différent d'une liaison simple et le ligand L est choisi parmi les ligands (L-1) et (L-2), 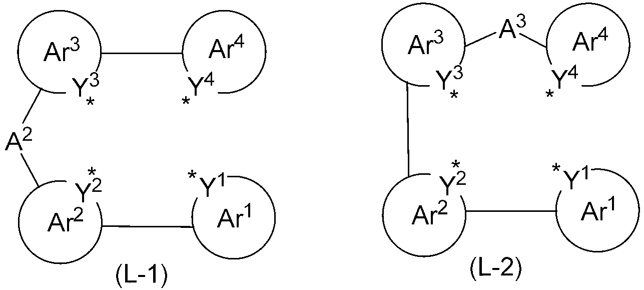
dans lesquels les symboles utilisés sont tels que définis dans la revendication 1, Y¹ à Y⁴ représentent de manière identique ou différente C ou N et A² dans la formule (L-1) ou A³ dans la formule (L-2) ne représentent pas une liaison simple ;
ou que l'un des groupes A¹, A² et A³ représente une liaison simple et les deux autres groupes représentent de manière identique ou différente un groupe différent d'une liaison simple et que le ligand L est choisi parmi les ligands (L-3) et (L-4), 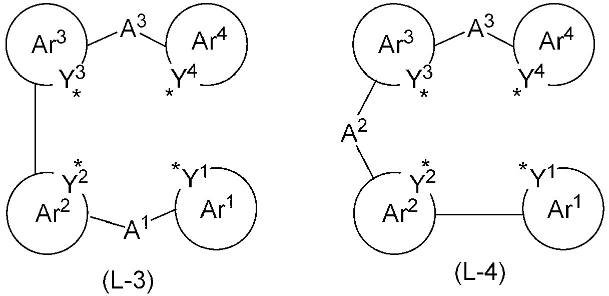
dans lesquels les symboles utilisés sont tels que définis dans la revendication 1 et A¹ et A³ dans la formule (L-3) ou A² et A³ dans la formule (L-4) ne représentent pas des liaisons simples ;
ou qu'exactement l'un des groupes Y¹ ou Y⁴ représente C-O⁻ et que soit les trois groupes A¹, A² et A³ représentent une liaison simple, soit A¹ et A³ représentent une liaison simple et A² représente C=CR₂, où un radical R forment avec un groupe voisin Ar² ou Ar³ un cycle aromatique ou hétéroaromatique, et le ligand est choisi parmi les formules (L-5) et (L-6), 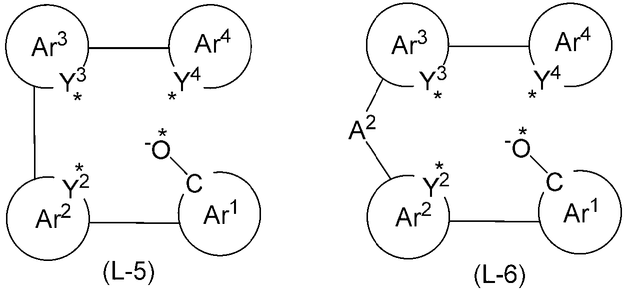
dans lesquels les symboles utilisés sont tels que définis dans la revendication 1 et A² dans la formule (L-6) représentent C=CR₂, où au moins un radical R forment avec Ar² ou Ar³ un système cyclique aromatique ou hétéroaromatique, ou A² dans la formule (L-6) représentent CR₂, NR ou O ;
ou qu'aucun des groupes A¹, A² et A³ ne représente une liaison simple et que le ligand est choisi parmi les ligands (L-7), 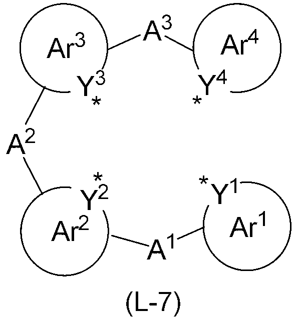
dans lesquels les symboles utilisés sont tels que définis dans la revendication 1 et A¹, A² et A³ ne représentent pas des liaisons simples.

6. Composé selon une ou plusieurs des revendications 1 à 5, **caractérisé en ce que** Ar¹ et Ar⁴ ainsi que les groupes Y¹ et Y⁴ sont choisis respectivement parmi les groupes de formules (Ar-1) à (Ar-44), dans lequel le groupe se lie à A¹ et A³ respectivement à la position marquée par # et se coordonnent à l'iridium à la position marquée par *, 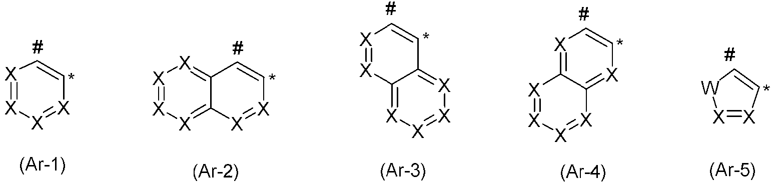 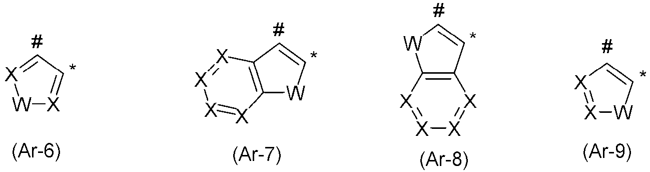 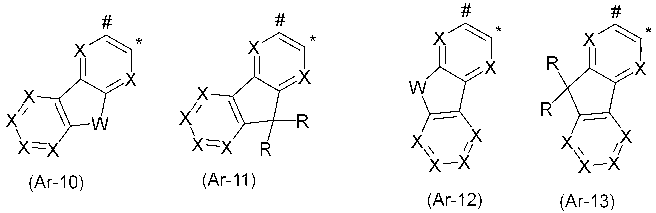 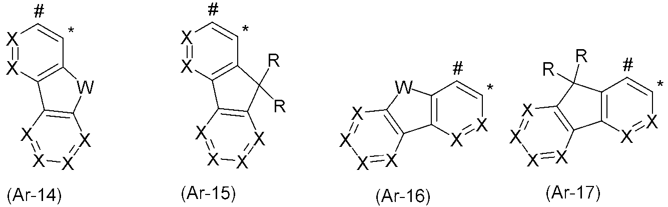 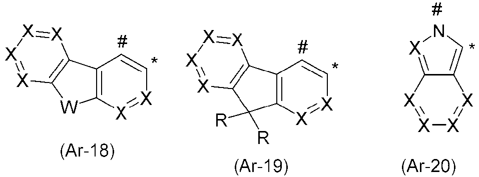 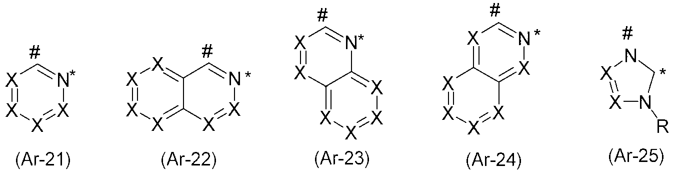 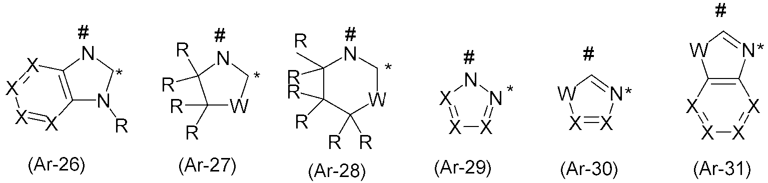 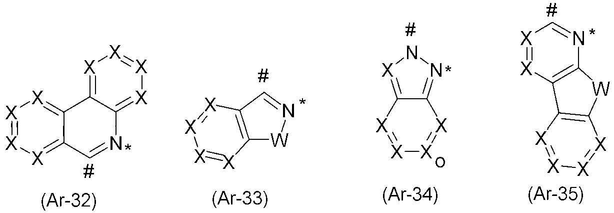 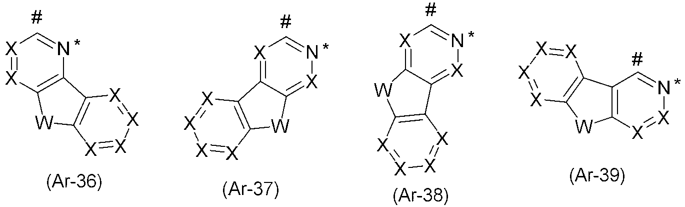 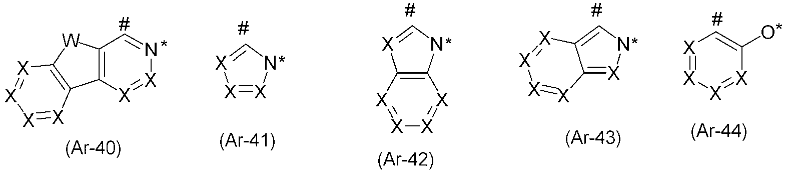
dans lesquels R est tel que défini dans la revendication 1 et les autres symboles utilisés ont la signification suivante :
X est identique ou différent à CR ou N dans chaque occurrence, à condition que deux symboles X au maximum par cycle représentent N ; W est identique ou différent à NR, O ou S dans chaque occurrence ;
et que Ar² et Ar³ ainsi que les groupes Y² et Y³ sont choisis respectivement parmi les groupes de formules (Ar-45) à (Ar-74), dans lequel le groupe se lient à A¹ et A² ou à A² et A³ respectivement à la position marquée par # et se coordonnent à l'iridium à la position marquée par *. 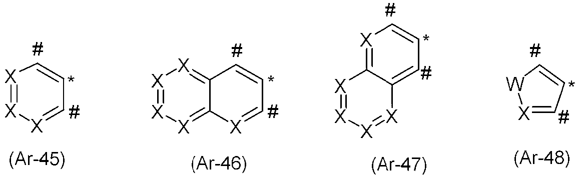 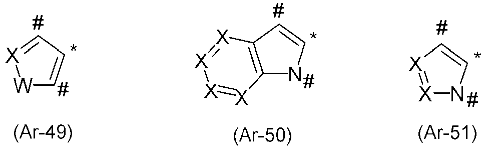 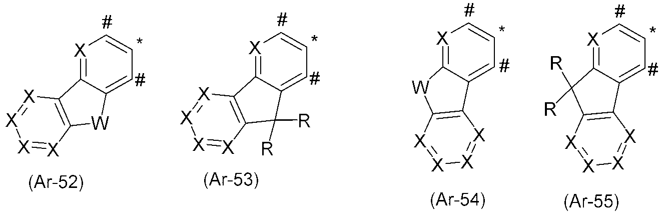 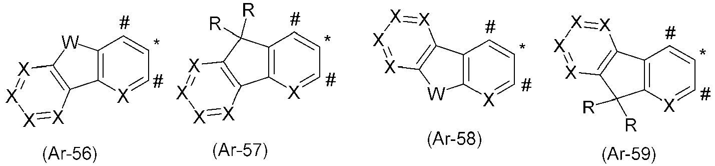 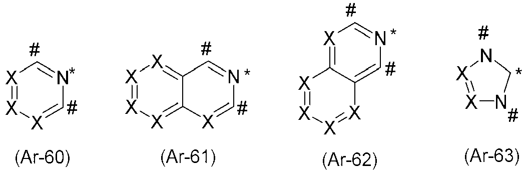 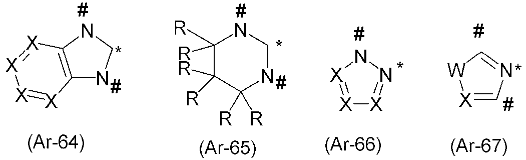 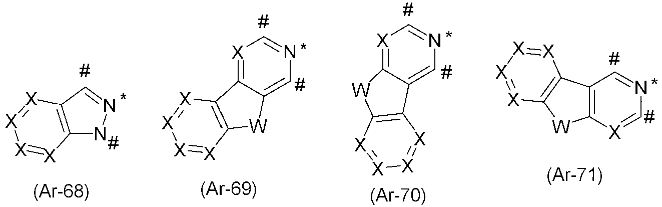 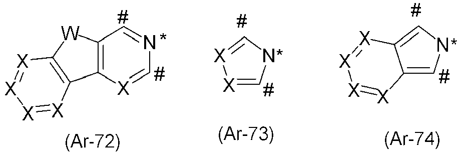
où R est tel que défini dans la revendication 1 et X et W ont les significations indiquées ci-dessus.

7. Composé selon une ou plusieurs des revendications 1 à 6, **caractérisé en ce que** A¹ et/ou A³ représentent des liaisons simples et les ligands partiels bidentés Ar¹-Ar² et Ar³- Ar⁴ ainsi formés sont choisis parmi les structures des formules (L¹-1-1) à (L¹-1-3) et (L¹-2-1) à (L¹-2-5), qui se coordonnent à l'iridium via les deux positions marquées d'un *, 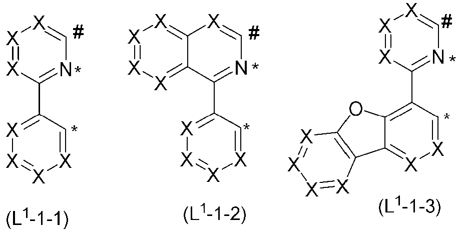 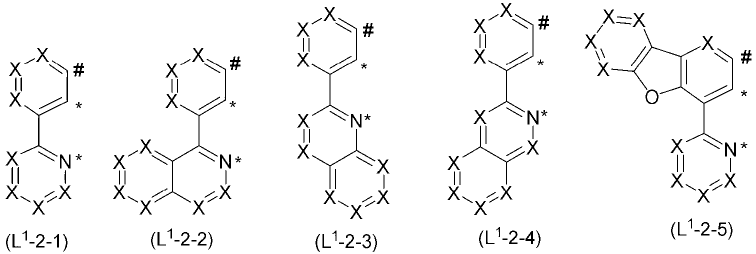 dans lesquels les symboles utilisés sont tels que définis dans les revendications 1 et 6 et # représentant la position de la liaison à A².

8. Composé selon la revendication 5, **caractérisé en ce que** les ligands (L-1) sont choisis parmi les structures de formules (L-1-1) à (L-1-4), 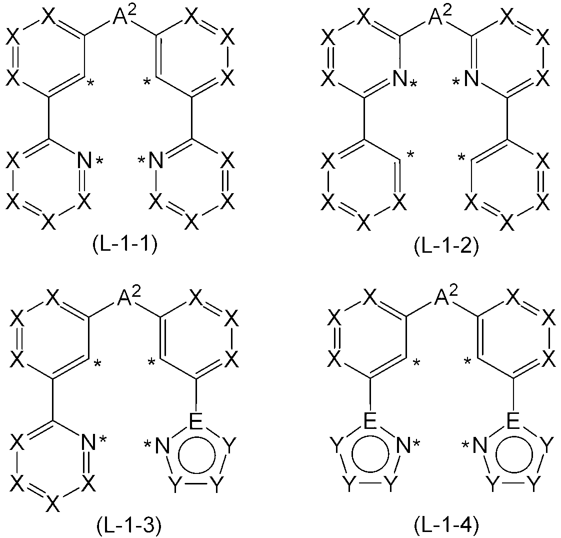
dans lesquels A² et X sont tels que définis dans les revendications 1 et 6 et soit E représente N et les groupes Y du même cycle identiques ou différents dans chaque occurrence représentent CR ou N, soit E représente C et les groupes Y du même cycle identiques ou différents dans chaque occurrence représentent CR, N, NR, O ou S, à condition qu'un seul groupe Y représente NR, O ou S et que les autres groupes Y qu'ils soient identiques ou différents représentent CR ou N ;
et que le ligand (L-4) est choisi parmi les ligands (L-4-1) à (L-4-3), 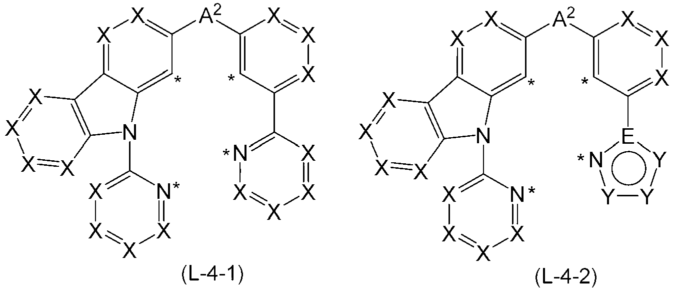 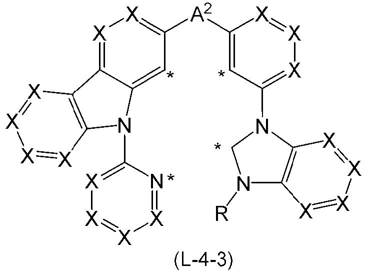
dans lesquels les symboles utilisés sont tels que définis dans les revendications 1 et 6 et ci-dessus, E et Y ont les significations indiquées ci-dessus et A² ne représente pas une liaison simple ;
et que le ligand (L-6) est choisi parmi les ligands de formule (L-6-1) et (L-6-2), 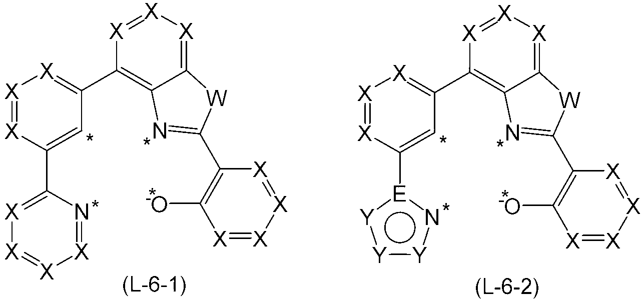
dans lesquels les symboles utilisés sont tels que définis dans les revendications 1 et 6, et E et Y ont les significations indiquées ci-dessus ;
et que les ligands (L-7) sont choisis parmi les ligands de formule (L-7-1), 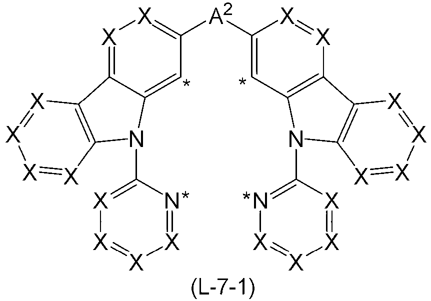
dans lesquels les symboles utilisés sont tels que définis dans les revendications 1 et 6 et A² ne représentent pas une liaison simple.

9. Composé selon la revendication 8, **caractérisé en ce que** les ligands (L-1) sont choisis parmi les structures (L-1-1a) à (L-1-4c), 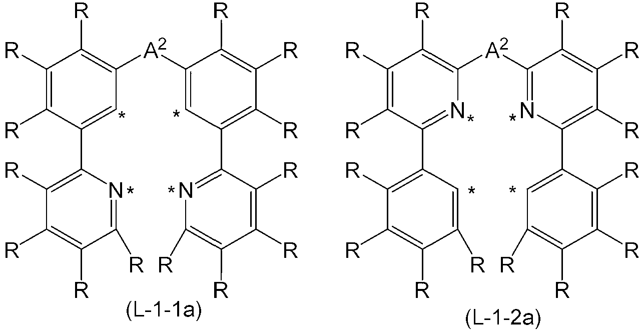 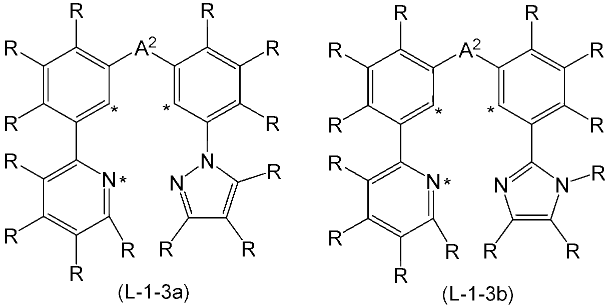 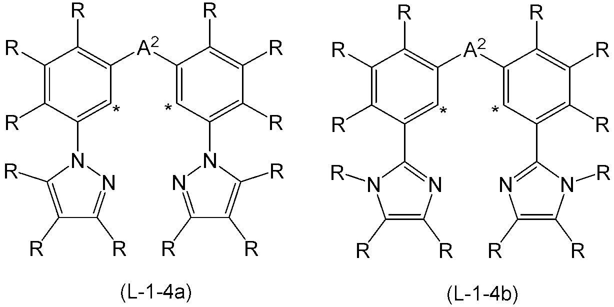 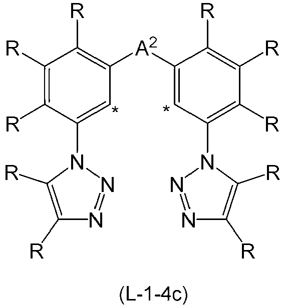
dans lesquels les symboles sont tels que définis dans la revendication 1 ;
et que les ligands (L-4) sont choisis parmi les ligands (L-4-1a) à (L-4-3a), 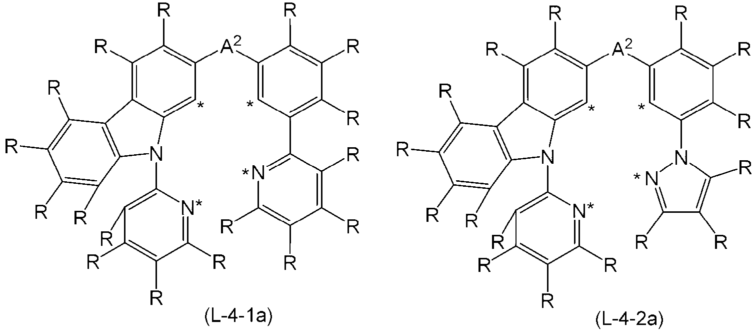 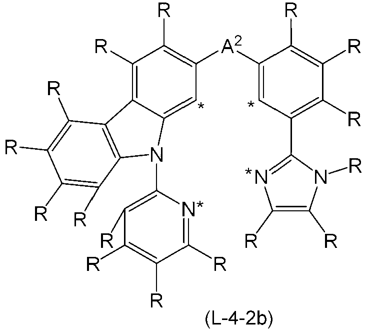 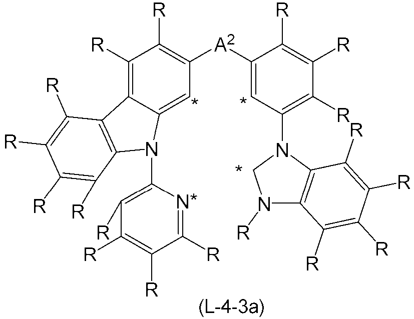
dans lesquels les symboles sont tels que définis dans la revendication 1 et A² ne représentent pas une liaison simple ;
et que les ligands (L-6) sont choisis parmi les formules (L-6-1a) et (L-6-2a) à (L-6-2c), 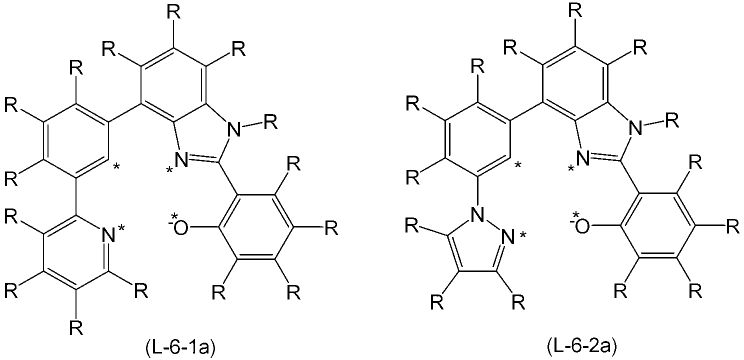 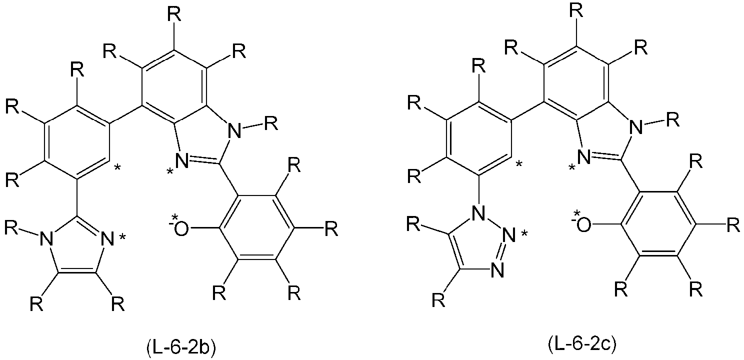
dans lesquels les symboles sont tels que définis dans la revendication 1 ;
et que les ligands (L-7) sont choisis parmi les ligands de formule (L-7-1a), 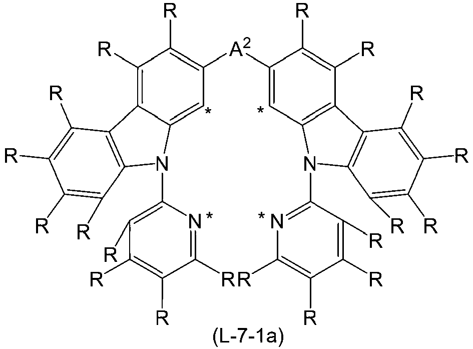
dans lesquels les symboles sont tels que définis dans la revendication 1 et A² ne représentent pas une liaison simple.

10. Composé selon une ou plusieurs des revendications 1 à 9, **caractérisé en ce que** R* représente un groupe alkyle comportant 4 à 10 atomes de carbone, dans lequel un ou plusieurs atomes d'hydrogène peuvent également être remplacés par D ou F, ou un système cyclique aromatique comportant 6 à 12 atomes de carbone, dans lequel le système cyclique aromatique peut être substitué par un ou plusieurs radicaux choisis parmi F, D ou un groupe alkyle comportant 1 à 10 atomes de carbone, dans lequel un ou plusieurs atomes d'hydrogène dans le groupe alkyle peuvent être remplacés par D ou F ; plusieurs groupes alkyles présents en tant que substituants sur le système cyclique aromatique peuvent également former entre eux un système cyclique.

11. Formulation comprenant au moins un composé selon une ou plusieurs des revendications 1 à 10 et au moins un autre composé et/ou un solvant.

12. Utilisation d'un composé selon une ou plusieurs des revendications 1 à 10 dans un dispositif électronique ou comme sensibilisateur à l'oxygène ou comme photo-initiateur ou comme photocatalyseur.

13. Dispositif électronique comprenant au moins un composé selon une ou plusieurs des revendications 1 à 10.

14. Dispositif électronique selon la revendication 13, dans lequel il s'agit d'un dispositif électroluminescent organique, **caractérisé en ce que** le composé selon une ou plusieurs des revendications 1 à 10 est utilisé dans une ou plusieurs couches émettrices comme émetteur phosphorescent ou comme sensibilisateur pour un émetteur fluorescent.
